(19) Europäisches Patentamt
European Patent Office
Office européen des brevets

(11) **EP 4 410 072 B1**

(12) **EUROPÄISCHE PATENTSCHRIFT**

(45) Veröffentlichungstag und Bekanntmachung des Hinweises auf die Patenterteilung:
**29.10.2025 Patentblatt 2025/44**

(21) Anmeldenummer: **22777264.7**

(22) Anmeldetag: **28.09.2022**

(51) Internationale Patentklassifikation (IPC):
***H10K 85/60*** *(2023.01)* *H10K 50/11* *(2023.01)*
*H10K 101/10* *(2023.01)* *H10K 101/00* *(2023.01)*

(52) Gemeinsame Patentklassifikation (CPC):
**H10K 85/636; H10K 85/633; H10K 85/654; H10K 85/6572; H10K 85/6574; H10K 85/6576;**
H10K 50/11; H10K 85/342; H10K 2101/10; H10K 2101/90

(86) Internationale Anmeldenummer:
**PCT/EP2022/076884**

(87) Internationale Veröffentlichungsnummer:
**WO 2023/052376 (06.04.2023 Gazette 2023/14)**

(54) **ORGANISCHE ELEKTROLUMINESZIERENDE VORRICHTUNG**
ORGANIC ELECTROLUMINESCENT APPARATUS
APPAREIL ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.09.2021 EP 21200281**

(43) Veröffentlichungstag der Anmeldung:
**07.08.2024 Patentblatt 2024/32**

(73) Patentinhaber: **Merck Patent GmbH**
**64293 Darmstadt (DE)**

(72) Erfinder:
- **PARHAM, Amir Hossain**
  **64293 Darmstadt (DE)**
- **EHRENREICH, Christian**
  **64293 Darmstadt (DE)**
- **EICKHOFF, Christian**
  **64293 Darmstadt (DE)**
- **KROEBER, Jonas Valentin**
  **64293 Darmstadt (DE)**

(74) Vertreter: **Merck Patent Association**
**Merck Patent GmbH**
**64271 Darmstadt (DE)**

(56) Entgegenhaltungen:
**WO-A1-2017/148565**
**WO-A1-2021/122535**
**WO-A1-2021/180614**
**US-A1- 2021 028 370**
**US-A1- 2021 119 135**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

Technisches Gebiet

Die vorliegende Erfindung betrifft eine organische elektrolumineszierende Vorrichtung enthaltend eine Mischung, die ein elektronentransportierendes Hostmaterial und ein lochtransportierendes Hostmaterial umfasst, sowie eine Formulierung enthaltend eine Mischung der Hostmaterialien und eine Mischung enthaltend die Hostmaterialien. Das elektronentransportierende Hostmaterial entspricht einer Verbindung der Formel (1) aus der Klasse von Verbindungen enthaltend eine durch ein Dibenzofuran oder Dibenzothiophen substituierte Pyridin-, Pyrimidin- oder Triazin-Einheit und das lochtransportierende Hostmaterial entspricht einem deuterierten Monoamin der Formel (2).

Stand der Technik

Der Aufbau organischer Elektrolumineszenzvorrichtungen (z.B. OLEDs - organic light emitting diodes oder OLECs - organic light emitting electrochemical cells), in denen organische Halbleiter als funktionelle Materialien eingesetzt werden, ist seit Langem bekannt. Als emittierende Materialien werden hierbei neben fluoreszierenden Emittern zunehmend metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfach gesteigerte Energie- und Leistungseffizienz möglich. Generell gibt es bei OLEDs, insbesondere auch bei OLEDs die Triplettemission (Phosphoreszenz) zeigen, jedoch immer noch Verbesserungsbedarf, beispielsweise im Hinblick auf Effizienz, Betriebsspannung und Lebensdauer.

Die Eigenschaften organischer elektrolumineszierender Vorrichtungen werden nicht nur durch die eingesetzten Emitter bestimmt. Hier sind insbesondere auch die anderen verwendeten Materialien, wie Host- und Matrixmaterialien, Lochblockiermaterialien, Elektronentransportmaterialien, Lochtransportmaterialien und Elektronen- bzw. Exzitonenblockiermaterialien von besonderer Bedeutung, und davon insbesondere die Host- bzw. Matrixmaterialien. Verbesserungen dieser Materialien können zu deutlichen Verbesserungen elektrolumineszierender Vorrichtungen führen.

Hostmaterialien zur Verwendung in organischen elektronischen Vorrichtungen sind dem Fachmann gut bekannt. Im Stand der Technik wird häufig auch der Begriff Matrixmaterial verwendet, wenn ein Hostmaterial für phosphoreszierende Emitter gemeint ist. Diese

Verwendung des Begriffs gilt auch für die vorliegende Erfindung. Mittlerweile wurde eine Vielzahl von Hostmaterialien sowohl für fluoreszierende als auch für phosphoreszierende elektronische Vorrichtungen entwickelt.

Eine weitere Möglichkeit, die Leistungsdaten elektronischer Vorrichtungen, insbesondere von organischen Elektrolumineszenzvorrichtungen, zu verbessern, besteht darin, Kombinationen aus zwei oder mehr Materialien, insbesondere Hostmaterialien bzw. Matrixmaterialien, zu verwenden. Im Stand der Technik hat sich die Verwendung einer Mischung bestehend aus einem Elektronentransportmaterial, einem Lochtransportmaterial und einem phosphoreszierenden Emitter in der Emissionsschicht einer OLED etabliert, wobei die Emissionsschicht noch weitere Materialien enthalten kann.

Gemäß WO2015169412 und WO2016015810 können beispielsweise Triazin-Dibenzofuran-Carbazolderivate und Triazin-Dibenzothiophen-Carbazolderivate in einer lichtemittierenden Schicht als Hostmaterialien verwendet werden.

In WO17204556 und WO19190101 werden jeweils spezielle Aryldiamine beschrieben, die unsubstituiert oder teilweise deuteriert sein können, und deren Verwendung in einer elektrolumineszierenden Vorrichtung, insbesondere in einer emittierenden Hilfsschicht.

In US2017186969 wird eine organische lichtemittierende Vorrichtung beschrieben, wobei in der organischen Schicht spezielle Monoarylamine enthalten sind, die unsubstituiert oder teilweise deuteriert sein können, insbesondere enthalten in einer emittierenden Hilfsschicht.

In WO18026197, WO19151682, WO20226300, WO20231197 und WO21096228 wird jeweils eine organische lichtemittierende Vorrichtung beschrieben, wobei in der organischen Schicht zwei Klassen von Verbindungen enthalten sind, ausgewählt aus jeweils speziellen Monoarylaminen, die unsubstituiert oder teilweise deuteriert sein können, und speziellen Triazinen.

Spezielle Monoarylamine, die unsubstituiert oder teilweise deuteriert sein können, werden in den Offenlegungsschriften WO2015022051, WO2017148564, WO2018083053 CN112375053, WO2021156323 und WO21107728 beschrieben. Weitere lichtemittierende Vorrichtungen werden in WO 2021/122535 A1, WO 2021/180614 A1, WO 2017/148565 A1 und US 2021/028370 A1 beschrieben.

Allerdings besteht bei Verwendung dieser Materialien oder bei der Verwendung von Mischungen der Materialien noch Verbesserungsbedarf, insbesondere in Bezug auf Effizienz, Betriebsspannung und/oder Lebensdauer der organischen elektrolumineszierenden Vorrichtung.

Aufgabe der vorliegenden Erfindung ist daher die Bereitstellung einer Kombination von Hostmaterialien, welche

sich für den Einsatz in einer organischen elektrolumineszierenden Vorrichtung, insbesondere in einer fluoreszierenden oder phosphoreszierenden OLED eignen und zu guten Device-Eigenschaften insbesondere im Hinblick auf eine verbesserte Lebensdauer, führen, sowie die Bereitstellung der entsprechenden elektrolumineszierenden Vorrichtung.

Es wurde nun gefunden, dass die Kombination mindestens einer Verbindung der Formel (1) als erstes Hostmaterial und mindestens einer lochtransportierenden Verbindung der Formel (2) als zweites Hostmaterial in einer Licht emittierenden Schicht einer organischen elektrolumineszierenden Vorrichtung, diese Aufgabe lösen und die Nachteile aus dem Stand der Technik beseitigen. Die Verwendung einer derartigen Materialkombination zur Herstellung der lichtemittierenden Schicht in einer organischen elektrolumineszierenden Vorrichtung führt zu sehr guten Eigenschaften dieser Vorrichtungen, insbesondere hinsichtlich der Lebensdauer, insbesondere bei gleicher oder verbesserter Effizienz und/oder Betriebsspannung. Die Vorteile zeigen sich insbesondere auch bei Anwesenheit einer lichtemittierenden Komponente in der Emissionsschicht, insbesondere bei Kombination mit Emittern der Formeln (IIIa), (I) bis (VIII) bei Konzentrationen zwischen 2 und 15 Gew.-%. Die Vorteile zeigen sich insbesondere bei Anwesenheit einer lichtemittierenden Komponente der Formel (IIIa), wie nachfolgend beschrieben, bei Konzentrationen zwischen 2 und 15 Gew.-%.

Zusammenfassung der Erfindung

Ein erster Gegenstand der vorliegenden Erfindung ist daher eine organische elektrolumineszierende Vorrichtung umfassend eine Anode, eine Kathode und mindestens eine organische Schicht, enthaltend mindestens eine lichtemittierende Schicht, wobei die mindestens eine lichtemittierende Schicht mindestens eine Verbindung der Formel (1) als Hostmaterial 1 und mindestens eine Verbindung der Formel (2) als Hostmaterial 2 enthält,

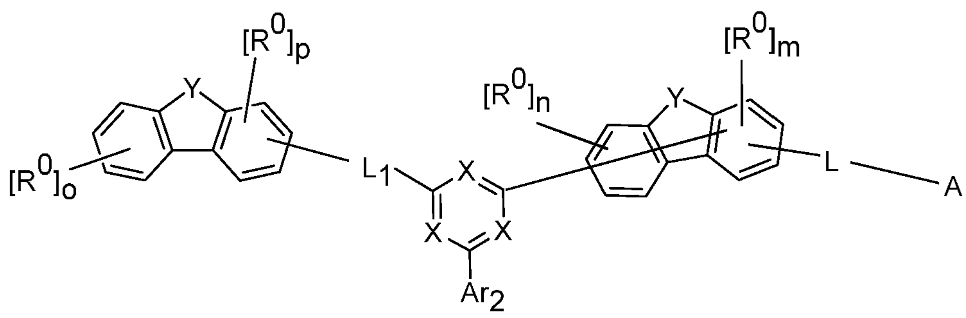

Formel (1) ,

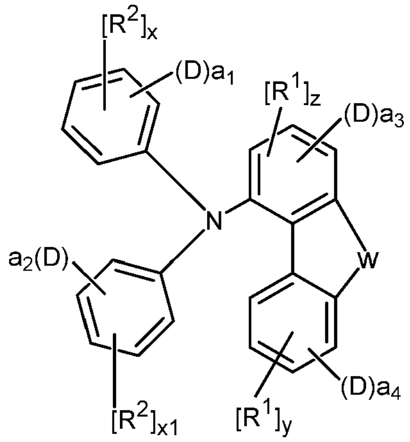

Formel (2),

wobei für die verwendeten Symbole und Indizes gilt:

A ist

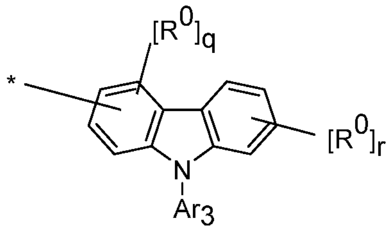

oder

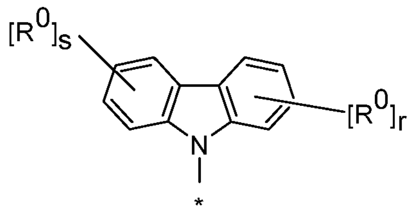

,

X ist bei jedem Auftreten gleich oder verschieden $CR^0$ oder N, wobei mindestens ein Symbol X für N steht;

Y ist bei jedem Auftreten gleich oder verschieden ausgewählt aus O oder S;

* kennzeichnet die Bindungsstelle an die Formel (1);

L und $L_1$ sind bei jedem Auftreten gleich oder verschieden eine Einfachbindung oder ein aromatisches oder heteroaromatisches Ringsystem mit 5 bis 30 aromatischen Ringatomen;

W ist O, S oder $C(R)_2$;

R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;

$R^0$ ist bei jedem Auftreten unabhängig voneinander D, ein unsubstituiertes oder teilweise oder vollständig deuteriertes aromatisches Ringsystem mit 6 bis 18 C-Atomen oder ein unsubstituiertes oder teilweise oder vollständig deuteriertes Dibenzofuran, Dibenzothiophen, oder über C gebundenes N-Aryl-Carbazol;

$Ar_1$ ist bei jedem Auftreten gleich oder verschieden ein aromatisches oder heteroaromatisches Ringsystem mit 5 bis 30 aromatischen Ringatomen, das mit einem oder mehreren nicht-aromatischen Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$Ar_2$ ist jeweils unabhängig voneinander bei jedem Auftreten eine Aryl- oder Heteroarylgruppe mit 5 bis 40 aromatischen Ringatomen, die mit einem oder mehreren Resten R' substituiert sein kann;

$Ar_3$ ist jeweils unabhängig voneinander bei jedem Auftreten ein aromatisches Ringsystem mit 6 bis 40 aromatischen Ringatomen oder ein heteroaromatisches Ringsystem mit 5 bis 40 aromatischen Ringatomen, das mit einem oder mehreren Resten R' substituiert sein kann;

Aryl ist bei jedem Auftreten gleich oder verschieden ein aromatisches oder heteroaromatisches Ringsystem mit 5 bis 30 aromatischen Ringatomen, das mit einem oder mehreren nicht-aromatischen Resten R' substituiert sein kann;

R' ist bei jedem Auftreten gleich oder verschieden ausgewählt aus der Gruppe bestehend aus D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten R' ein monocyclisches oder polycyclisches, aliphatisches, aromatisches oder heteroaromatisches Ringsystem bilden können, das mit einem oder mehreren Resten $R^3$ substituiert sein kann;

$R^1$ ist bei jedem Auftreten gleich oder verschieden ausgewählt aus der Gruppe bestehend aus F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, die jeweils mit einem oder mehreren Resten R' substituiert sein kann, wobei eine oder mehrere nicht-benachbarte $CH_2$-Gruppen durch R'C=CR', $Si(R')_2$, C=O, C=S, C=NR', P(=O)(R'), SO, $SO_2$, NR', O, S oder CONR' ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

$R^3$ ist bei jedem Auftreten gleich oder verschieden ausgewählt aus der Gruppe bestehend aus D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

n, m, p, q sind jeweils unabhängig voneinander 0, 1, 2 oder 3;

o, r, s sind jeweils unabhängig voneinander 0, 1, 2, 3 oder 4;

x, x1 sind bei jedem Auftreten unabhängig 0, 1, 2, 3 oder 4;

y, z sind jeweils unabhängig voneinander 0, 1 oder 2;

a1, a2 sind jeweils unabhängig voneinander 1, 2, 3, 4 oder 5;

a3 ist 0, 1, 2 oder 3;

a4 ist 0, 1, 2, 3 oder 4; und

a1+a2+a3+a4 ist 3, 4, 5, 6, 7, 8, 9, 10, 11, 12, 13, 14, 15, 16 oder 17.

Weitere Gegenstände der Erfindung umfassen ein Verfahren zur Herstellung der organischen elektrolumineszierenden Vorrichtungen sowie Mischungen enthaltend mindestens eine Verbindung der Formel (1) und mindestens eine Verbindung der Formel (2), spezielle Materialkombinationen und Formulierungen, die derartige Mischungen bzw. Materialkombinationen enthalten. Die entsprechenden bevorzugten Ausführungsformen, wie nachfolgend beschrieben, sind ebenfalls Gegenstand der vorliegenden Erfindung. Die überraschenden und vorteilhaften Effekte werden durch spezifische Selektion der Verbindungen der Formel (1) und der Verbindungen der Formel (2) erreicht.

Beschreibung der Erfindung

Die erfindungsgemäße organische elektrolumineszierende Vorrichtung ist beispielsweise ein organischer lichtemittierender Transistor (OLET), ein organisches Feld-Quench-Device (OFQD), eine organische lichtemittierende elektrochemische Zelle (OLEC, LEC, LEEC), eine organische Laserdiode (O-Laser) oder eine organische lichtemittierende Diode (OLED). Die erfindungsgemäße organische elektrolumineszierende Vorrichtung ist insbesondere eine organische lichtemittierende Diode oder eine organische lichtemittierende elektrochemische Zelle. Besonders bevorzugt ist die erfindungsgemäße Vorrichtung eine OLED.

Die organische Schicht der erfindungsgemäßen Vorrichtung, die die lichtemittierende Schicht enthaltend die Materialkombination aus mindestens einer Verbindung der Formel (1) und mindestens einer Verbindung der Formel (2) enthält, wie zuvor beschrieben oder nachfolgend beschrieben, enthält bevorzugt neben dieser lichtemittierenden Schicht (EML), eine Lochinjektionsschicht (HIL), eine Lochtransportschicht (HTL), eine Elektronentransportschicht (ETL), eine Elektroneninjektionsschicht (EIL) und/oder eine Lochblockierschicht (HBL). Es können in der erfindungsgemäßen Vorrichtung auch mehrere Schichten dieser Gruppe ausgewählt aus EML, HIL, HTL, ETL, EIL und HBL enthalten sein.

Die Vorrichtung kann aber auch anorganische Materialien enthalten oder auch Schichten, welche vollständig aus anorganischen Materialien aufgebaut sind.

Es ist bevorzugt, dass die lichtemittierende Schicht enthaltend mindestens eine Verbindung der Formel (1) und mindestens eine Verbindung der Formel (2) eine phosphoreszierende Schicht ist, die dadurch gekennzeichnet ist, dass sie zusätzlich zu der Hostmaterialienkombination der Verbindungen der Formel (1) und Formel (2), wie zuvor beschrieben, mindestens einen phosphoreszierenden Emitter enthält. Eine geeignete Auswahl an Emittern und bevorzugte Emitter werden nachfolgend beschrieben.

In der vorliegenden Patentanmeldung bezeichnet "D" oder "D-Atom" Deuterium.

Eine Arylgruppe im Sinne dieser Erfindung enthält 6 bis 40 aromatische Ringatome, bevorzugt C-Atome. Eine Heteroarylgruppe im Sinne dieser Erfindung enthält 5 bis 40 aromatische Ringatome, wobei die Ringatome C-Atome und mindestens ein Heteroatom umfassen, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Phenyl, abgeleitet von Benzol, bzw. ein einfacher heteroaromatischer Cyclus, beispielsweise abgeleitet von Pyridin, Pyrimidin oder Thiophen, oder eine kondensierte Aryl- oder Heteroarylgruppe, beispielsweise abgeleitet von Naphthalin, Anthracen, Phenanthren, Chinolin oder Isochinolin, verstanden. Eine Arylgruppe mit 6 bis 18 C-Atomen ist daher vorzugsweise Phenyl, Naphthyl, Phenanthryl oder Triphenylenyl, wobei die Anbindung der Arylgruppe als Substituent dabei nicht eingeschränkt ist. Die Aryl- oder Heteroarylgruppe im Sinne dieser Erfindung kann einen oder mehrere Reste R' tragen, wobei der Substituent R' nachfolgend beschrieben wird.

Ein aromatisches Ringsystem im Sinne dieser Erfindung enthält 6 bis 40 C-Atome im Ringsystem. Das aromatisches Ringsystem umfasst auch Arylgruppen, wie zuvor beschrieben.

Ein aromatisches Ringsystem mit 6 bis 18 C-Atomen wird vorzugsweise aus Phenyl, vollständig deuteriertes Phenyl, Biphenyl, Naphthyl, Phenanthryl und Triphenylenyl ausgewählt.

Ein heteroaromatisches Ringsystem im Sinne dieser Erfindung enthält 5 bis 40 Ringatome und mindestens ein Heteroatom. Ein bevorzugtes heteroaromatisches Ringsystem hat 10 bis 40 Ringatome und mindestens ein Heteroatom. Das heteroaromatische Ringsystem umfasst auch Heteroarylgruppen, wie zuvor beschrieben. Die Heteroatome im heteroaromatischen Ringsystem sind bevorzugt ausgewählt aus N, O und/oder S.

Unter einem aromatischen oder heteroaromatischen Ringsystem im Sinne dieser Erfindung wird ein System verstanden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C- oder O-Atom oder eine Carbonylgruppe, unterbrochen sein können. So sollen beispielsweise auch Systeme wie 9,9'-Spirobifluoren, 9,9-Diarylfluoren, Diarylether, Stilben, etc. als aromatische bzw. heteroaromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sind Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls von der Definition des aromatischen bzw. heteroaromatischen Ringsystems umfasst.

Unter einem aromatischen oder heteroaromatischen Ringsystem mit 5 - 40 aromatischen Ringatomen, welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die Abkürzung $Ar_1$ bedeutet bei jedem Auftreten gleich oder verschieden ein aromatisches oder heteroaromatisches Ringsystem mit 5 bis 40 aromatischen Ringatomen, das mit einem oder mehreren nicht-aromatischen Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein, wobei der

Rest $R^3$ oder die Substituenten $R^3$ eine Bedeutung hat/haben, wie zuvor oder nachfolgend beschrieben. Eine bevorzugte Bedeutung von $Ar_1$ wird nachfolgend beschrieben.

Die Abkürzung "Aryl" bedeutet bei jedem Auftreten gleich oder verschieden ein aromatisches oder heteroaromatisches Ringsystem mit 5 bis 40 aromatischen Ringatomen, das mit einem oder mehreren nicht-aromatischen Resten R' substituiert sein kann, wobei der Rest R' oder die Substituenten R' eine Bedeutung hat/haben, wie zuvor oder nachfolgend beschrieben. Eine bevorzugte Bedeutung von "Aryl" wird nachfolgend beschrieben.

Die Abkürzung $Ar_2$ bedeutet jeweils unabhängig voneinander bei jedem Auftreten eine Aryl- oder Heteroarylgruppe mit 5 bis 40 aromatischen Ringatomen, die mit einem oder mehreren Resten R' substituiert sein kann, wobei der Rest R' oder die Substituenten R' eine Bedeutung hat/haben, wie zuvor oder nachfolgend beschrieben. Die genannten Ausführungen für die Aryl- und Heteroarylgruppen mit 5 bis 40 aromatischen Ringatomen gelten hier entsprechend.

Die Abkürzung $Ar_3$ bedeutet jeweils unabhängig voneinander bei jedem Auftreten ein aromatisches Ringsystem mit 6 bis 40 aromatischen Ringatomen oder ein heteroaromatisches Ringsystem mit 5 bis 40 aromatischen Ringatomen, das mit einem oder mehreren Resten R' substituiert sein kann, wobei der Rest R' oder die Substituenten R' eine Bedeutung hat/haben, wie zuvor oder nachfolgend beschrieben. Die genannten Ausführungen für die Aryl- und Heteroarylgruppen mit 5 bis 40 aromatischen Ringatomen gelten hier entsprechend.

Unter einer cyclischen Alkyl-, Alkoxy- oder Thioalkylgruppe im Sinne dieser Erfindung wird eine monocyclische, eine bicyclische oder eine polycyclische Gruppe verstanden.

Im Rahmen der vorliegenden Erfindung werden unter einer geradkettigen, verzweigten oder cyclischen $C_1$- bis $C_{20}$-Alkylgruppe beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden.

Unter einer geradkettigen oder verzweigten $C_1$- bis $C_{20}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einer geradkettigen $C_1$- bis $C_{20}$-Thioalkylgruppe werden beispielsweise S-Alkylgruppen verstanden, beispielsweise Thiomethyl, 1-Thioethyl, 1-Thio-i-propyl, 1-Thio-n-propoyl, 1-Thio-i-butyl, 1-Thio-n-butyl oder 1-Thio-t-butyl.

Eine Aryloxy- oder Heteroaryloxygruppe mit 5 bis 40 aromatischen Ringatomen bedeutet O-Aryl oder O-Heteroaryl und bedeutet, dass die Aryl- bzw. Heteroarylgruppe über ein Sauerstoffatom gebunden wird, wobei die Aryl- bzw. Heteroarylgruppe eine Bedeutung hat, wie zuvor beschrieben.

Ein phosphoreszierender Emitter im Sinne der vorliegenden Erfindung ist eine Verbindung, die Lumineszenz aus einem angeregten Zustand mit höherer Spinmultiplizität zeigt, also einem Spinzustand > 1, insbesondere aus einem angeregten Triplettzustand. Im Sinne dieser Anmeldung sollen alle lumineszierenden Komplexe mit Übergangsmetallen oder Lanthaniden als phosphoreszierende Emitter angesehen werden. Eine genauere Definition erfolgt nachfolgend.

Wenn die Hostmaterialien der lichtemittierenden Schicht umfassend mindestens eine Verbindung der Formel (1), wie zuvor beschrieben oder nachfolgend bevorzugt beschrieben, und mindestens eine Verbindung der Formel (2), wie zuvor beschrieben oder nachfolgend beschrieben, für einen phosphoreszierenden Emitter eingesetzt wird, ist es bevorzugt, wenn deren Triplettenergie nicht wesentlich kleiner als die Triplettenergie des phosphoreszierenden Emitters ist. Dabei gilt bevorzugt für das Triplettniveau $T_1$(Emitter) - $T_1$(Matrix) $\leq$ 0.2 eV, besonders bevorzugt $\leq$ 0.15 eV, ganz besonders bevorzugt $\leq$ 0.1 eV. Dabei ist $T_1$(Matrix) das Triplettniveau des Matrixmaterials in der Emissionsschicht, wobei diese Bedingung für jedes der beiden Matrixmaterialien gilt, und $T_1$(Emitter) ist das Triplettniveau des phosphoreszierenden Emitters. Enthält die Emissionsschicht mehr als zwei Matrixmaterialien, so gilt die oben genannte Beziehung bevorzugt auch für jedes weitere Matrixmaterial.

Im Folgenden wird das Hostmaterial 1 und dessen bevorzugte Ausführungsformen beschrieben, welches/welche in der erfindungsgemäßen Vorrichtung enthalten ist/sind. Die bevorzugten Ausführungsformen des Hostmaterials 1 der Formel (1) gelten auch für die erfindungsgemäße Mischung und/oder Formulierung.

Bevorzugte Verbindungen der Formel (1) sind die Verbindungen (1A), (1B), (1C), (1D), (1E), (1F), (1G) und (1H),

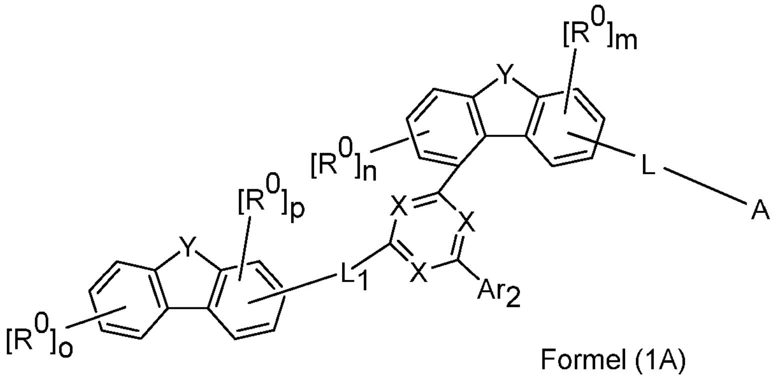

Formel (1A)

,

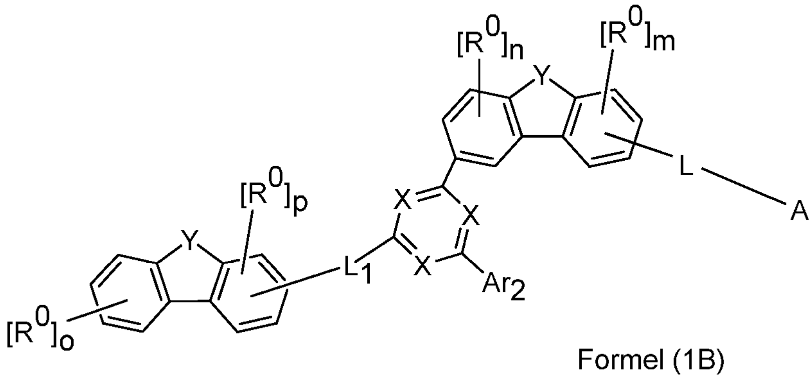

Formel (1B)

,

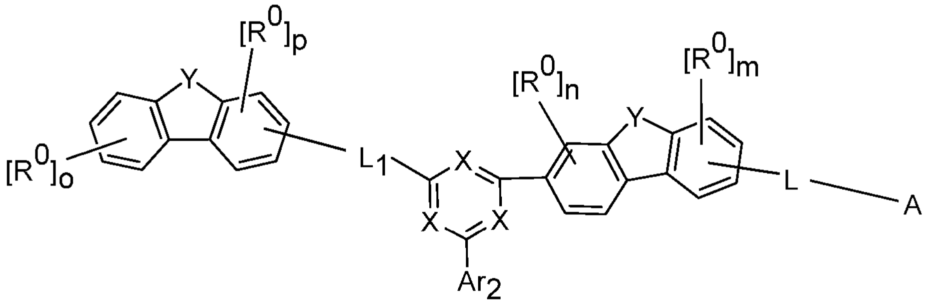

Formel (1C)

,

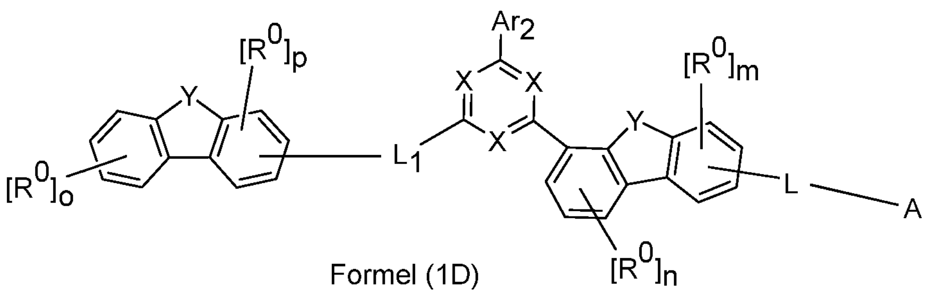

Formel (1D)

,

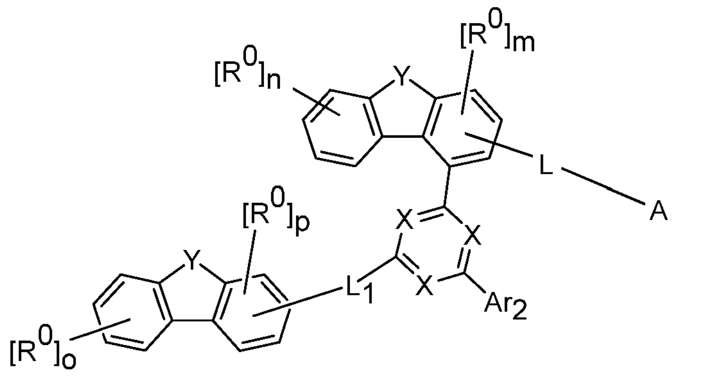

Formel (1E)

,

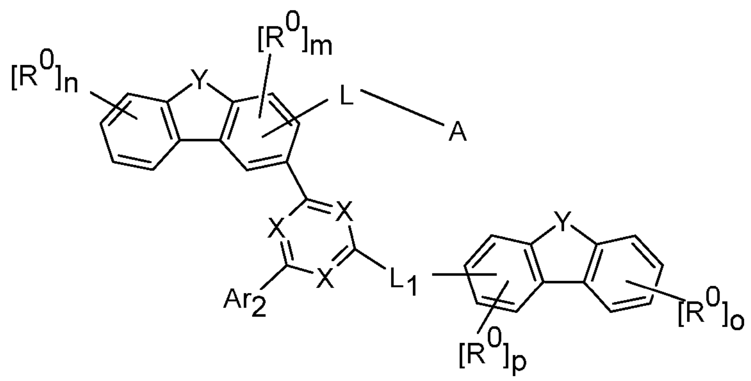

Formel (1F)

,

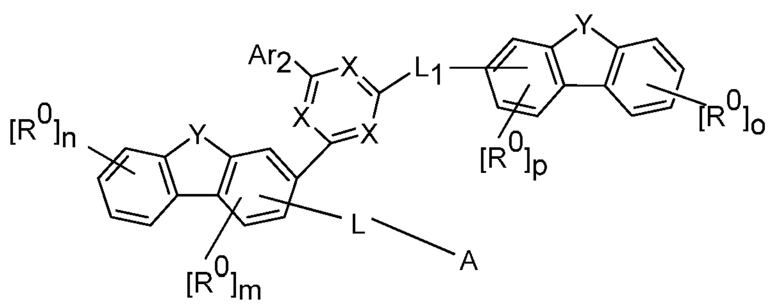

Formel (1G)

,

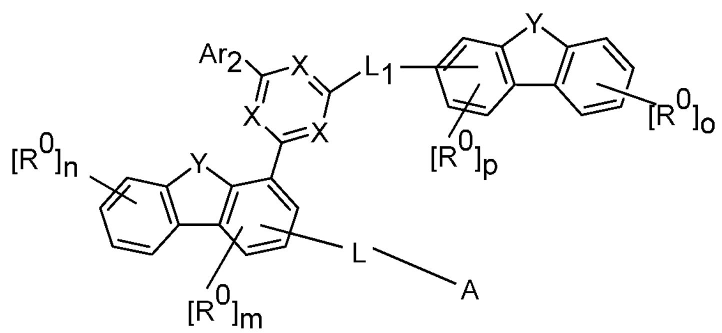

Formel (1H)

,

wobei A, L, $L_1$, Y, X, $Ar_2$, $R^0$, n, m, o und p eine zuvor angegebene Bedeutung haben oder eine nachfolgend bevorzugt

genannte Bedeutung haben.

In Verbindungen der Formel (1) oder bevorzugten Verbindungen der Formel (1), wie zuvor beschrieben, insbesondere der Formel (1A), steht das Symbol L als Linker für eine Einfachbindung oder ein aromatisches oder heteroaromatisches Ringsystem mit 5 bis 30 aromatischen Ringatomen.

In Verbindungen der Formel (1) oder bevorzugten Verbindungen der Formel (1), wie zuvor beschrieben, insbesondere der Formel (1A), steht das Symbol L bevorzugt für eine Bindung oder einen Linker ausgewählt aus der Gruppe L-1 bis L-33,

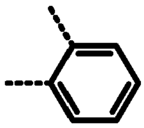
L-1

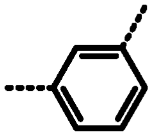
L-2

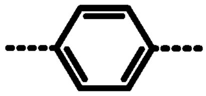
L-3

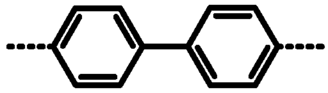
L-4

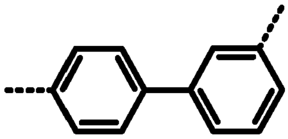
L-5

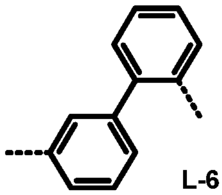
L-6

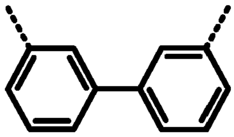
L-7

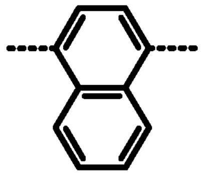
L-8

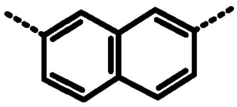
L-9

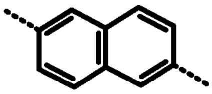
L-10

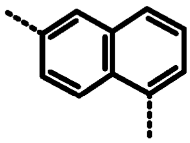
L-11

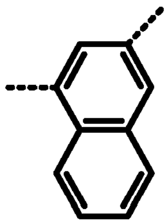
L-12

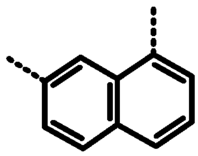
L-13

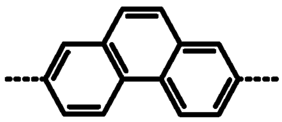
L-14

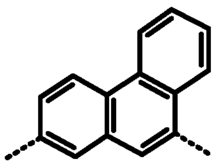
L-15

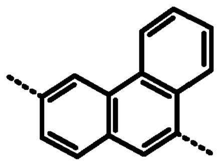
L-16

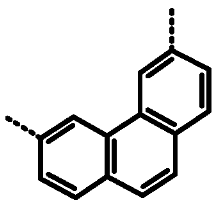
L-17

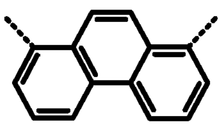
L-18

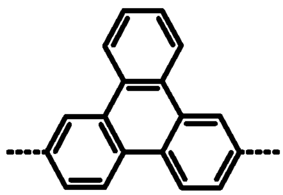
L-19

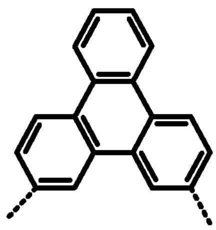
L-20

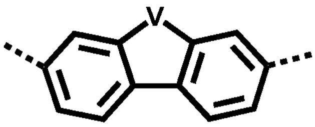

L-21

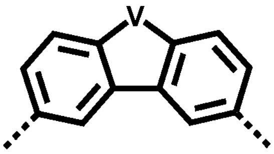

L-22

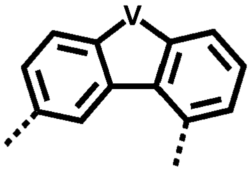

L-23

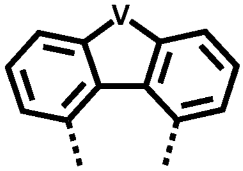

L-24

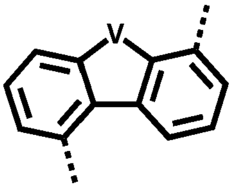

L-25

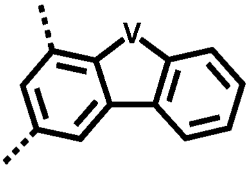

L-26

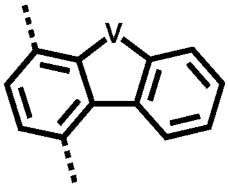

L-27

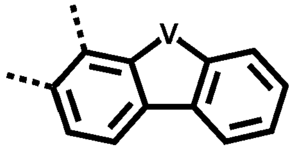

L-28

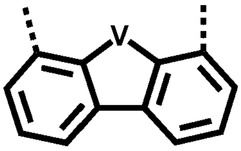

L-29

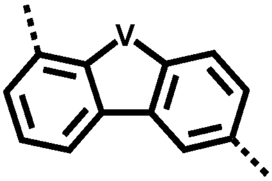

L-30

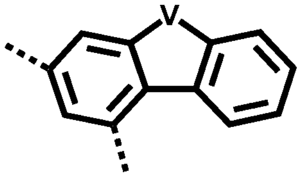

L-31

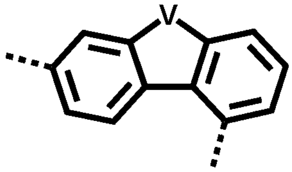

L-32

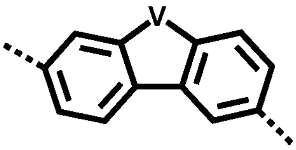

L-33 ,

wobei V jeweils unabhängig voneinander O oder S bedeutet.

Ein weiterer Gegenstand der Erfindung ist daher die elektrolumineszierende Vorrichtung, wie zuvor beschrieben, wobei der Linker L im Hostmaterial 1 ausgewählt wird aus einer Bindung oder den Linkern der Gruppe L-1 bis L-33, wie zuvor beschrieben.

In Verbindungen der Formel (1) oder bevorzugten Verbindungen der Formel (1), wie zuvor beschrieben, insbesondere der Formel (1A), steht das Symbol L in einer Ausführungsform besonders bevorzugt für eine Bindung oder einen Linker ausgewählt aus L-1 bis L-3, L-7, L-21, L-22, L-23, L-25 bis L-27 und L-30 bis L-33, wobei V jeweils unabhängig voneinander O oder S bedeutet. V ist besonders bevorzugt O. In Verbindungen der Formel (1) steht das Symbol L in einer weiteren Ausführungsform besonders bevorzugt für eine Bindung oder einen Linker ausgewählt aus L-2 bis L-20, bevorzugt L-2 oder L-3. L ist ganz besonders bevorzugt eine Einfachbindung.

Verbindungen der Formel (1A), in denen L bevorzugt eine Einfachbindung bedeutet, können durch die Formel (1a) beschrieben werden,

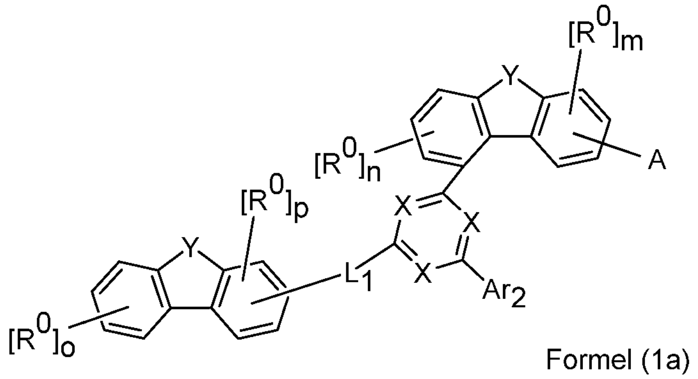

Formel (1a) ,

wobei Y, A, $L_1$, X, $Ar_2$, $R^0$, n, m, o und p eine zuvor genannte oder nachfolgend bevorzugt genannte Bedeutung haben.

In Verbindungen der Formel (1) oder bevorzugten Verbindungen der Formel (1), wie zuvor beschrieben, insbesondere der Formel (1A), steht das Symbol $L_1$ als Linker für eine Einfachbindung oder ein aromatisches oder heteroaromatisches Ringsystem mit 5 bis 30 aromatischen Ringatomen.

In Verbindungen der Formel (1) oder bevorzugten Verbindungen der Formel (1), wie zuvor beschrieben, insbesondere der Formel (1A), steht das Symbol $L_1$ bevorzugt für eine Einfachbindung oder einen Linker ausgewählt aus der Gruppe L-1 bis L-33, wie zuvor beschrieben. In Verbindungen der Formel (1) oder bevorzugten Verbindungen der Formel (1), wie zuvor beschrieben, insbesondere in Verbindungen der Formel (1A) oder (1a) steht das Symbol $L_1$ bevorzugt für eine Einfachbindung oder einen Linker L-2 oder L-3, wie zuvor beschrieben, oder besonders bevorzugt für eine Einfachbindung.

Verbindungen der Formel (1A), in denen $L_1$ bevorzugt eine Einfachbindung bedeutet, können durch die Formel (1b) beschrieben werden,

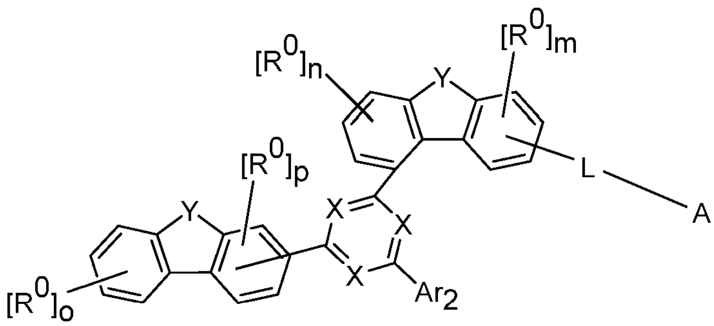

Formel (1b) ,

wobei Y, A, L, X, $Ar_2$, $R^0$, n, m, o und p eine zuvor genannte oder nachfolgend bevorzugt genannte Bedeutung haben.

Ein weiterer Gegenstand der Erfindung ist daher eine elektrolumineszierende Vorrichtung, wie zuvor beschrieben, wobei $L_1$ im Hostmaterial 1 eine Einfachbindung bedeutet.

In einer bevorzugten Ausführungsform der Erfindung steht in Verbindungen der Formeln (1), (1A), (1B), (1C), (1D), (1E), (1F), (1G), (1H), (1a) und (1b) oder bevorzugten Ausführungsformen des Hostmaterials der Formeln (1), (1A), (1B), (1C), (1D), (1E), (1F), (1G), (1H), (1a) und (1b), wie zuvor oder nachfolgend beschrieben, die Abkürzung A für

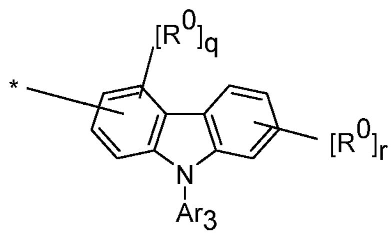

,

wobei $Ar_3$, $R^0$, q und r sowie die Kennzeichnung * eine zuvor genannte oder nachfolgend bevorzugt genannte Bedeutung haben.

In einer besonders bevorzugten Ausführungsform der Erfindung steht in Verbindungen der Formeln (1), (1A), (1B), (1C), (1D), (1E), (1F), (1G), (1H), (1a) und (1b) oder bevorzugten Ausführungsformen des Hostmaterials der Formeln (1), (1A), (1B), (1C), (1D), (1E), (1F), (1G), (1H), (1a) und (1b), wie zuvor oder nachfolgend beschrieben, die Abkürzung A für

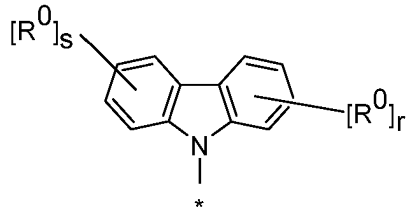

,

wobei $R^0$, s und r sowie die Kennzeichnung * eine zuvor genannte oder nachfolgend bevorzugt genannte Bedeutung haben.

In Verbindungen der Formeln (1), (1A), (1B), (1C), (1D), (1E), (1F), (1G), (1H), (1a) und (1b) oder bevorzugten Ausführungsformen des Hostmaterials der Formeln (1), (1A), (1B), (1C), (1D), (1E), (1F), (1G), (1H), (1a) und (1b) steht das Symbol X für $CR^0$ oder N, wobei mindestens eine Gruppe X N bedeutet.

Der Substituent

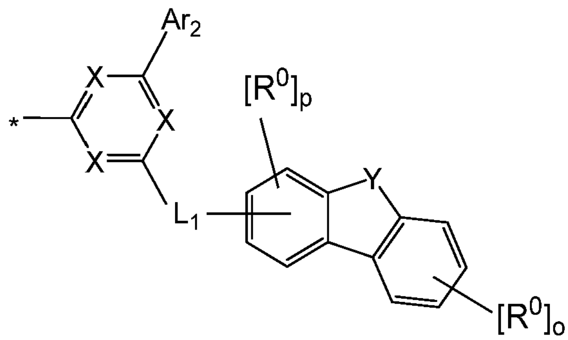

hat daher die folgenden Bedeutungen, wobei * die Verknüpfungsstelle mit dem Dibenzofuran bzw. Dibenzothiophen kennzeichnet und $L_1$, $R^0$, o, p, Y und $Ar_2$ eine zuvor angegebene Bedeutung oder eine bevorzugt angegebene Bedeutung haben:

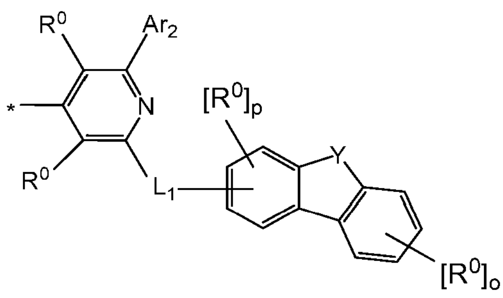

,

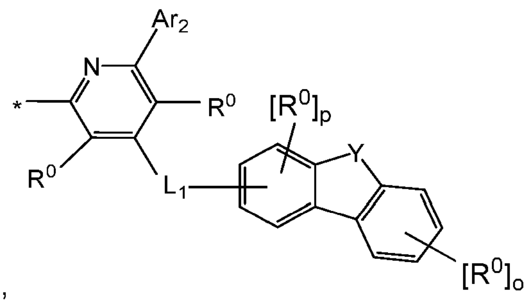

,

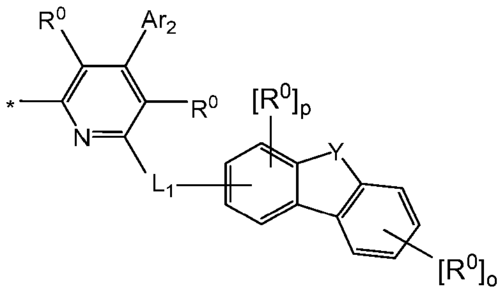,

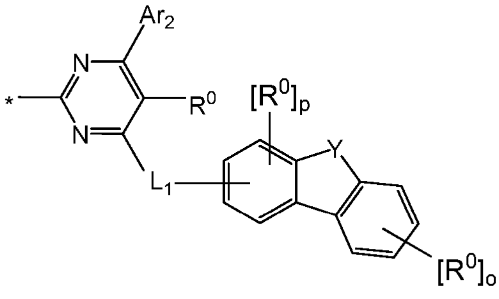,

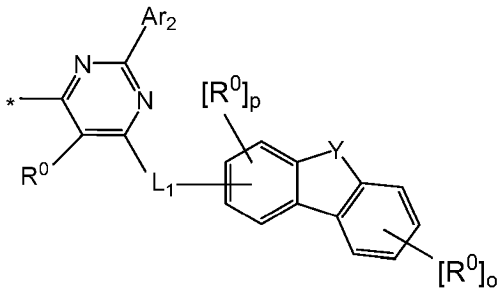,

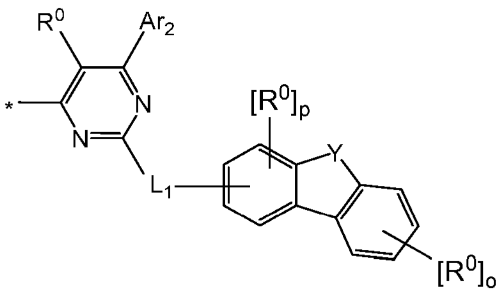,

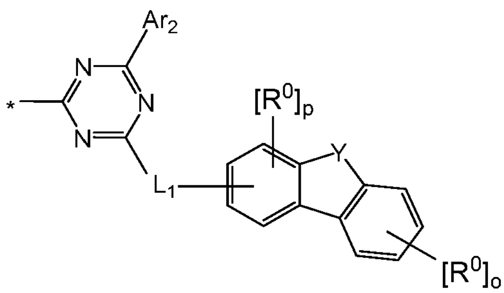.

In diesen vorstehend genannten Substituenten ist Y bevorzugt O.

In Hostmaterial 1 steht X bevorzugt zwei Mal für N und ein X steht für $CR^0$ oder alle X sind N. In Hostmaterial 1 stehen besonders bevorzugt alle X für N, wobei $R^0$ eine zuvor genannte oder nachfolgend genannte Bedeutung hat.

Bevorzugte Hostmaterialien 1 entsprechen demzufolge den Verbindungen der Formeln (1), (1A), (1B), (1C), (1D), (1E), (1F), (1G), (1H), (1a), (1b), (1c), (1d), (1e) oder (1f),

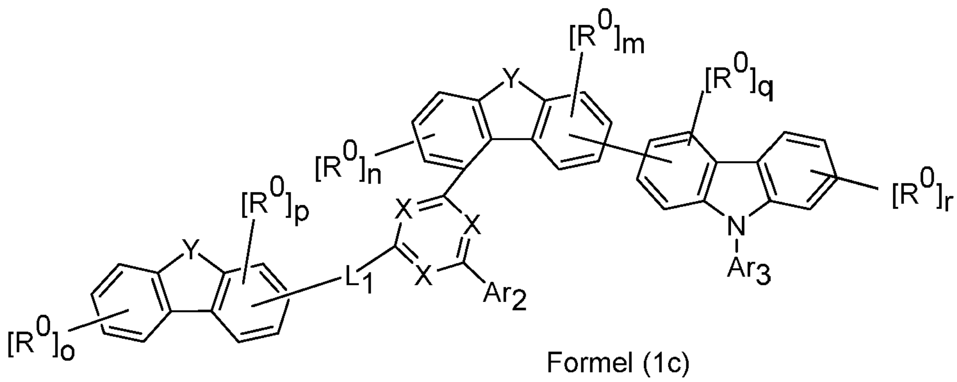

Formel (1c)

,

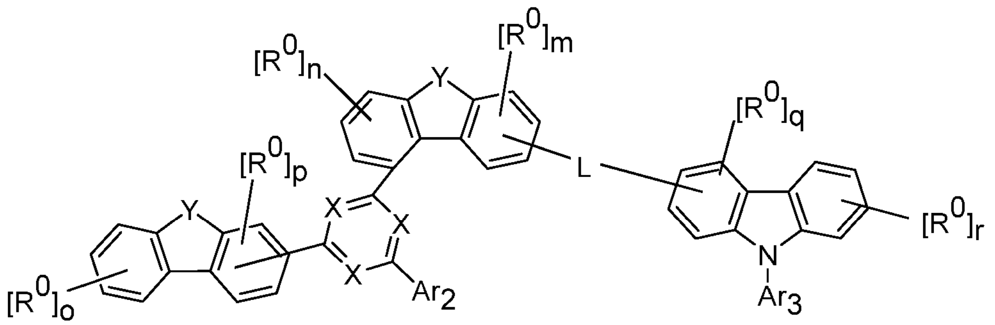

Formel (1d)

,

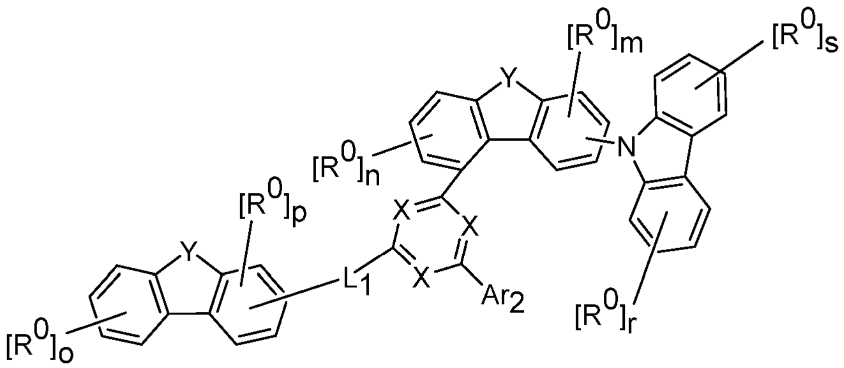

Formel (1e)

,

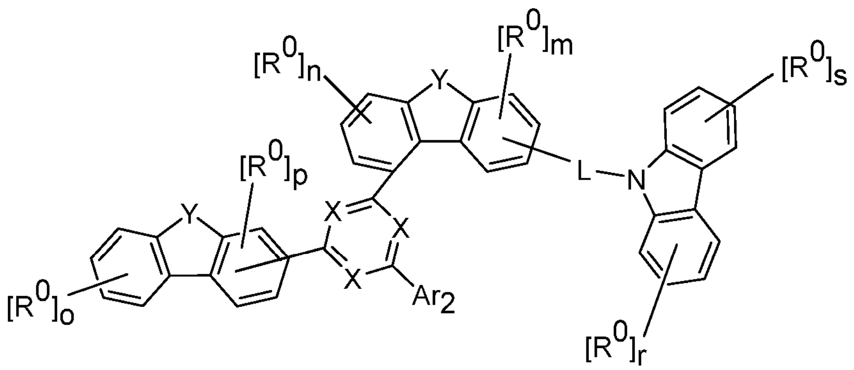

Formel (1f)

,

wobei Y, L, $L_1$, X, $X_1$, $Ar_2$, $R^0$, $Ar_3$, o, p, n, m, q, r und s eine zuvor genannte oder zuvor oder nachfolgend bevorzugt genannte Bedeutung haben. In Verbindungen der Formeln (1), (1A), (1B), (1C), (1D), (1E), (1F), (1G), (1H), (1a), (1b), (1c), (1d), (1e) oder (1f) stehen bevorzugt alle X für N. Verbindungen der Formeln (1e) und (1f) sind besonders bevorzugt.

$R^0$ ist bei jedem Auftreten unabhängig voneinander D, ein unsubstituiertes oder teilweise oder vollständig deuteriertes aromatisches Ringsystem mit 6 bis 18 C-Atomen oder ein unsubstituiertes oder teilweise oder vollständig deuteriertes Dibenzofuran, Dibenzothiophen oder über C gebundenes N-Aryl-Carbazol, wobei "Aryl" eine zuvor oder nachfolgend angegebene Bedeutung hat.

$R^0$ ist bei jedem Auftreten bevorzugt D oder ein unsubstituiertes oder teilweise oder vollständig deuteriertes aromatisches Ringsystem mit 6 bis 18 C-Atomen. $R^0$ ist bei jedem Auftreten besonders bevorzugt D.

Im C-gebundenen N-Aryl-Carbazol bedeutet "Aryl" bevorzugt ein aromatisches Ringsystem mit 6 bis 30 aromatischen Ringatomen oder ein heteroaromatisches Ringsystem mit 5 bis 30 aromatischen Ringatomen, das mit einem oder mehreren Resten R' substituiert sein kann. Besonders bevorzugt ist "Aryl" unsubstituiert, teilweise deuteriert, einmal mit einem Substituenten R' substituiert, der von H und D verschieden ist, oder vollständig deuteriert und wird ausgewählt aus den bevorzugten Gruppen Ar-1 bis Ar-12, wie nachfolgend beschrieben, wobei R' eine zuvor angegebene

oder nachfolgend bevorzugt angegebene Bedeutung hat.

Besonders bevorzugt steht "Aryl" im C-gebundenen N-Aryl-Carbazol für Ar-1 bis Ar-4, wobei R' eine zuvor angegebene oder nachfolgend bevorzugt angegebene Bedeutung hat.

In Verbindungen der Formeln (1), (1A), (1B), (1C), (1D), (1E), (1F), (1G), (1H), (1a), (1b), (1c), (1d), (1e) und (1f) ist o bevorzugt 4, wenn $R^0$ D bedeutet. Wenn $R^0$ eine andere Bedeutung als D hat, wie zuvor beschrieben, dann ist o bevorzugt 1 oder 2, besonders bevorzugt 1. In einer bevorzugten Ausführungsform, in der o 4 bedeutet, sind drei Substituenten $R^0$ bevorzugt D und ein Substituent $R^0$ ist ein unsubstituiertes oder teilweise oder vollständig deuteriertes aromatisches Ringsystem mit 6 bis 18 C-Atomen. In einer weiteren Ausführungsform der Erfindung ist o bevorzugt 0.

In einer weiteren Ausführungsform der Erfindung ist o bevorzugt 1, 2 oder 3, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1c), (1d), (1e) und (1f) ist p bevorzugt 3, wenn $R^0$ D bedeutet. Wenn $R^0$ eine andere Bedeutung als D hat, wie zuvor beschrieben, dann ist p bevorzugt 1. In einer bevorzugten Ausführungsform, in der p 3 bedeutet, sind zwei Substituenten $R^0$ bevorzugt D und ein Substituent $R^0$ ist ein unsubstituiertes oder teilweise oder vollständig deuteriertes aromatisches Ringsystem mit 6 bis 18 C-Atomen.

In einer weiteren Ausführungsform der Erfindung ist p bevorzugt 0.

In einer weiteren Ausführungsform der Erfindung ist p bevorzugt 1 oder 2, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1c), (1d), (1e) und (1f) ist m bevorzugt 3, wenn $R^0$ D bedeutet. Wenn $R^0$ eine andere Bedeutung als D hat, wie zuvor beschrieben, dann ist m bevorzugt 1. In einer bevorzugten Ausführungsform, in der m 3 bedeutet, sind zwei Substituenten $R^0$ bevorzugt D und ein Substituent $R^0$ ist ein unsubstituiertes oder teilweise oder vollständig deuteriertes aromatisches Ringsystem mit 6 bis 18 C-Atomen.

In einer weiteren Ausführungsform der Erfindung ist m bevorzugt 0.

In einer weiteren Ausführungsform der Erfindung ist m bevorzugt 1 oder 2, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1c), (1d), (1e) und (1f) ist n bevorzugt 3, wenn $R^0$ D bedeutet. Wenn $R^0$ eine andere Bedeutung als D hat, wie zuvor beschrieben, dann ist n bevorzugt 1. In einer bevorzugten Ausführungsform, in der n 3 bedeutet, sind zwei Substituenten $R^0$ bevorzugt D und ein Substituent $R^0$ ist ein unsubstituiertes oder teilweise oder vollständig deuteriertes aromatisches Ringsystem mit 6 bis 18 C-Atomen.

In einer weiteren Ausführungsform der Erfindung ist n bevorzugt 0.

In einer weiteren Ausführungsform der Erfindung ist n bevorzugt 1 oder 2, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1c) und (1d) ist q bevorzugt 3, wenn $R^0$ D bedeutet. Wenn $R^0$ eine andere Bedeutung als D hat, wie zuvor beschrieben, dann ist q bevorzugt 1. In einer bevorzugten Ausführungsform, in der q 3 bedeutet, sind zwei Substituenten $R^0$ bevorzugt D und ein Substituent $R^0$ ist ein unsubstituiertes oder teilweise oder vollständig deuteriertes aromatisches Ringsystem mit 6 bis 18 C-Atomen oder ein unsubstituiertes oder teilweise oder vollständig deuteriertes Dibenzofuran, Dibenzothiophen oder über C gebundenes N-Aryl-Carbazol, wobei "Aryl" eine zuvor angegebene Bedeutung hat.

In einer weiteren Ausführungsform der Erfindung ist q bevorzugt 0.

In einer weiteren Ausführungsform der Erfindung ist q bevorzugt 1 oder 2, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1c), (1d), (1e) und (1f) ist r bevorzugt 4, wenn $R^0$ D bedeutet. Wenn $R^0$ eine andere Bedeutung als D hat, wie zuvor beschrieben, dann ist r bevorzugt 1. In einer bevorzugten Ausführungsform, in der r 4 bedeutet, sind drei Substituenten $R^0$ bevorzugt D und ein Substituent $R^0$ ist ein unsubstituiertes oder teilweise oder vollständig deuteriertes aromatisches Ringsystem mit 6 bis 18 C-Atomen oder ein unsubstituiertes oder teilweise oder vollständig deuteriertes Dibenzofuran, Dibenzothiophen oder über C gebundenes N-Aryl-Carbazol, wobei "Aryl" eine zuvor angegebene Bedeutung hat.

In einer weiteren Ausführungsform der Erfindung ist r bevorzugt 0.

In einer weiteren Ausführungsform der Erfindung ist r bevorzugt 1, 2 oder 3, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1e) und (1f) ist s bevorzugt 4, wenn $R^0$ D bedeutet. Wenn $R^0$ eine andere Bedeutung als D hat, wie zuvor beschrieben, dann ist s bevorzugt 1. In einer bevorzugten Ausführungsform, in der r 4 bedeutet, sind drei Substituenten $R^0$ bevorzugt D und ein Substituent $R^0$ ist ein unsubstituiertes oder teilweise oder vollständig deuteriertes aromatisches Ringsystem mit 6 bis 18 C-Atomen oder ein unsubstituiertes oder teilweise oder vollständig deuteriertes Dibenzofuran, Dibenzothiophen oder über C gebundenes N-Aryl-Carbazol, wobei "Aryl" eine zuvor angegebene Bedeutung hat.

In einer weiteren Ausführungsform der Erfindung ist s bevorzugt 0.

In einer weiteren Ausführungsform der Erfindung ist s bevorzugt 1, 2 oder 3, wobei $R^0$ eine zuvor angegebene oder bevorzugt angegebene Bedeutung hat.

In Verbindungen der Formeln (1), (1A), (1B), (1C), (1D), (1E), (1F), (1G), (1H), (1a), (1b), (1c), (1d), (1e) und (1f) ist die Summe o+p+m+n bevorzugt 0, 1, 2 oder 3, besonders bevorzugt 0, 1 oder 2. In einer bevorzugten Ausführungsform ist die Summe o+p+m+n+q+r 20 und die Substituenten $R^0$ bedeuten jeweils D.

In einer weiteren Ausführungsform der Erfindung ist die Summe o+p+m+n+q+r bevorzugt 0, 1, 2 oder 3, bevorzugt 0 oder 3.

In einer bevorzugten Ausführungsform ist die Summe o+p+m+n+r+s 21 und die Substituenten $R^0$ bedeuten jeweils D.

In einer weiteren Ausführungsform der Erfindung ist die Summe o+p+m+n+r+s bevorzugt 0, 1, 2 oder 3, bevorzugt 0 oder 3.

In Verbindungen der Formeln (1), (1A), (1B), (1C), (1D), (1E), (1F), (1G), (1H), (1a), (1b), (1c), (1d), (1e) oder (1f) stehen bevorzugt beide Symbole Y für O.

In Verbindungen der Formeln (1), (1A), (1B), (1C), (1D), (1E), (1F), (1G), (1H), (1a), (1b), (1c), (1d), (1e) und (1f) oder bevorzugt beschriebenen Verbindungen der Formeln (1), (1A), (1B), (1C), (1D), (1E), (1F), (1G), (1H), (1a), (1b), (1c), (1d), (1e) und (1f), steht $Ar_2$ jeweils unabhängig voneinander bevorzugt für eine Arylgruppe mit 6 bis 40 aromatischen Ringatomen, wie zuvor beschrieben oder bevorzugt beschrieben, die mit einem oder mehreren Resten R' substituiert sein kann oder für eine Heteroarylgruppe mit 10 bis 40 aromatischen Ringatomen, wie zuvor beschrieben, die mit einem oder mehreren Resten R' substituiert sein kann. Dabei können mehrere Reste R', die an dasselbe Kohlenstoffatom oder an benachbarte Kohlenstoffatome gebunden sind, ein monocyclisches oder polycyclisches, aliphatisches, aromatisches oder heteroaromatisches Ringsystem bilden, das mit einem oder mehreren Resten $R^3$ substituiert sein kann. Die Verknüpfung der Arylgruppe oder der Heteroarylgruppe ist dabei nicht eingeschränkt und kann über ein C-Atom oder über ein Heteroatom, beispielsweise ein N-Atom, erfolgen.

$Ar_2$ kann bevorzugt aus folgenden Gruppen Ar-1 bis Ar-17 ausgewählt werden, wobei R' und $Ar_1$ eine zuvor angegebene oder bevorzugt angegebene Bedeutung haben und wobei ausgeschlossen ist, dass durch R' oder $Ar_1$ zwei Heteroatome direkt miteinander verbunden sind:

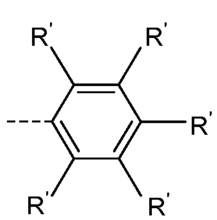
Ar-1

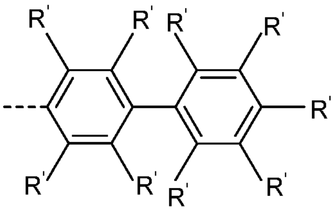
Ar-2

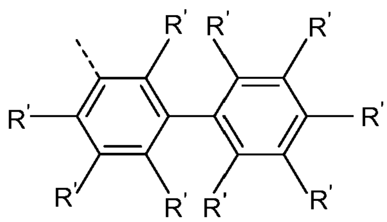
Ar-3

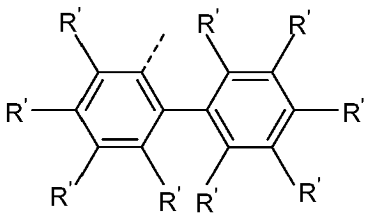
Ar-4

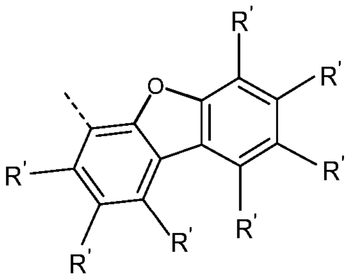
Ar-5

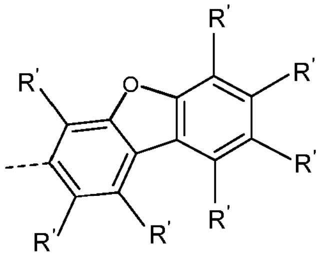
Ar-6

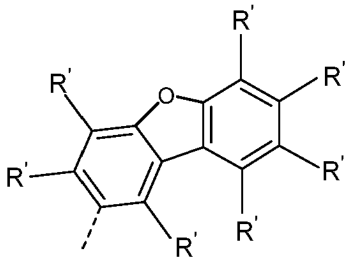
Ar-7

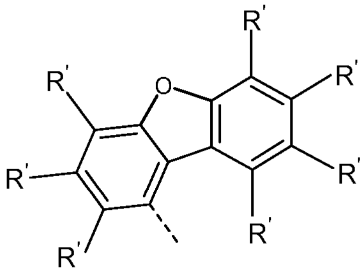
Ar-8

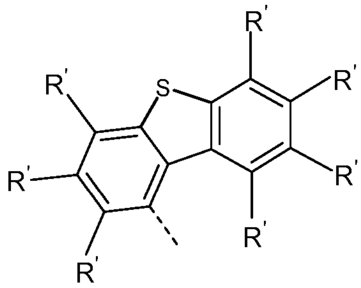
Ar-9

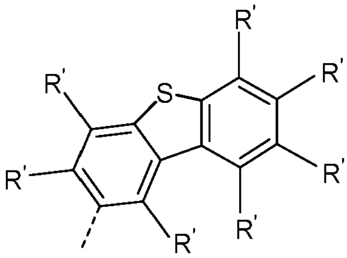
Ar-10

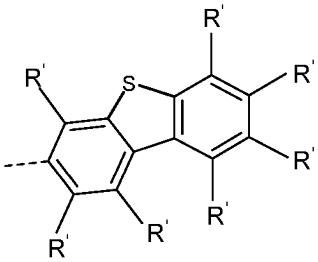
Ar-11

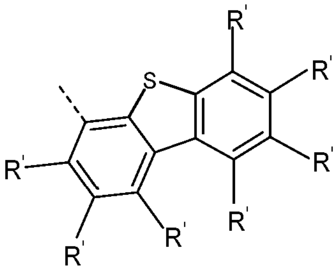
Ar-12

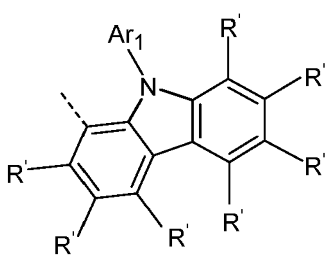
Ar-13

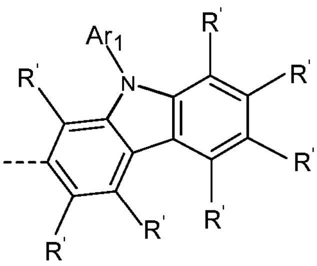
Ar-14

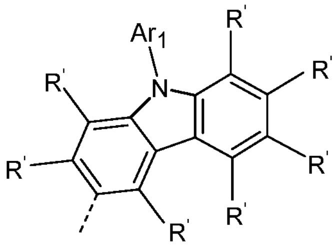
Ar-15

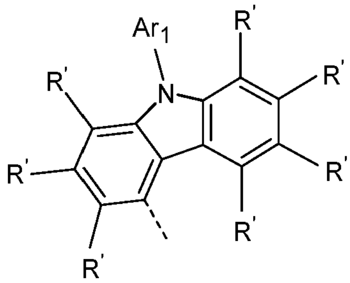
Ar-16

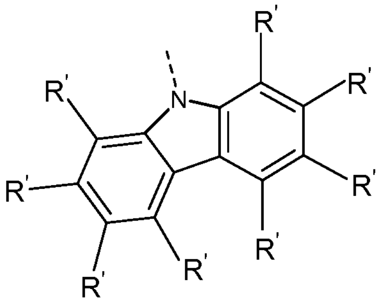
Ar-17

.

Die gestrichelte Linie kennzeichnet die Bindungsstelle an den Rest der Formeln (1), (1A), (1B), (1C), (1D), (1E), (1F), (1G), (1H), (1a), (1b), (1c), (1d), (1e) oder (1f).

Besonders bevorzugt steht $Ar_2$ für Ar-1, Ar-5, Ar-6, Ar-9, Ar-17, besonders bevorzugt für Ar-1, wobei R' eine zuvor angegebene oder nachfolgend bevorzugt angegebene Bedeutung hat.

R' in Substituenten der Formeln Ar-1 bis Ar-17, wie zuvor beschrieben, wird bevorzugt ausgewählt aus der Gruppe H, D, CN, einem aromatischen oder heteroaromatischen Ringsystem mit 5 bis 40 aromatischen Ringatomen, das jeweils mit einem oder mehreren Resten $R^3$ substituiert sein kann.

$Ar_1$ in Substituenten der Formeln Ar-13 bis Ar-16, wie zuvor beschrieben, ist bevorzugt Phenyl oder deuteriertes Phenyl.

Besonders bevorzugt ist $Ar_2$ unsubstituiert, teilweise deuteriert, einmal mit einem Substituenten R' substituiert, der von H und D verschieden ist, oder vollständig deuteriert.

Die Verknüpfung der über den Linker $L_1$ gebundenen Dibenzofuran- oder Dibenzothiophengruppe in den Verbindungen der Formeln (1), (1A), (1B), (1C), (1D), (1E), (1F), (1G), (1H), (1a), (1b), (1c), (1d), (1e) und (1f) oder bevorzugten Verbindungen der Formeln (1), (1A), (1B), (1C), (1D), (1E), (1F), (1G), (1H), (1a), (1b), (1c), (1d), (1e) und (1f) ist dabei nicht eingeschränkt und kann über jedes beliebige C-Atom erfolgen. Besonders bevorzugt ist die Dibenzofuran- oder Dibenzothiophengruppe in Position 2, 3 oder 4 über den Linker $L_1$ and den Rest der Formeln (1), (1A), (1B), (1C), (1D), (1E), (1F), (1G), (1H), (1a), (1b), (1c), (1d), (1e) und (1f) gebunden. Ganz besonders bevorzugt ist die Dibenzofuran- oder Dibenzothiophengruppe in Position 3 über den Linker $L_1$ and den Rest der Formeln (1), (1A), (1B), (1C), (1D), (1E), (1F), (1G), (1H), (1a), (1b), (1c), (1d), (1e) und (1f) gebunden.

In Verbindungen der Formeln (1), (1A), (1B), (1C), (1D), (1E), (1F), (1G), (1H), (1a), (1b), (1c) und (1d) oder bevorzugt beschriebenen Verbindungen der Formeln (1), (1A), (1B), (1C), (1D), (1E), (1F), (1G), (1H), (1a), (1b), (1c) und (1d), steht $Ar_3$ jeweils unabhängig voneinander bevorzugt für eine Arylgruppe mit 6 bis 40 aromatischen Ringatomen, wie zuvor beschrieben oder bevorzugt beschrieben, die mit einem oder mehreren Resten R' substituiert sein kann oder für eine Heteroarylgruppe mit 10 bis 40 aromatischen Ringatomen, wie zuvor beschrieben, die mit einem oder mehreren Resten R' substituiert sein kann.

In Verbindungen der Formeln (1), (1A), (1B), (1C), (1D), (1E), (1F), (1G), (1H), (1a), (1b), (1c) und (1d) oder bevorzugt beschriebenen Verbindungen der Formeln (1), (1A), (1B), (1C), (1D), (1E), (1F), (1G), (1H), (1a), (1b), (1c) und (1d), steht $Ar_3$ jeweils unabhängig voneinander bevorzugt für eine Arylgruppe mit 6 bis 18 aromatischen Ringatomen, wie zuvor beschrieben oder bevorzugt beschrieben, die mit einem oder mehreren Resten R' substituiert sein kann oder für eine Heteroarylgruppe mit 10 bis 40 C-Atomen enthaltend ein O-Atom oder ein S-Atom, wie zuvor beschrieben, die mit einem oder mehreren Resten R' substituiert sein kann.

Die Verknüpfung der Arylgruppe oder der Heteroarylgruppe ist dabei nicht eingeschränkt, erfolgt jedoch jeweils über ein C-Atom.

Besonders bevorzugt ist $Ar_3$ unsubstituiert, teilweise deuteriert, einmal mit einem Substituenten R' substituiert, der von H und D verschieden ist, oder vollständig deuteriert und wird ausgewählt aus den bevorzugten Gruppen Ar-1 bis Ar-12, wobei R' eine zuvor angegebene oder nachfolgend bevorzugt angegebene Bedeutung hat.

Besonders bevorzugt steht $Ar_3$ für Ar-1 bis Ar-4, wobei R' eine zuvor angegebene oder nachfolgend bevorzugt angegebene Bedeutung hat.

R' in Substituenten der Formeln Ar-1 bis Ar-12 für $Ar_3$, wie zuvor beschrieben, wird bevorzugt ausgewählt aus der Gruppe H, D, CN, einem aromatischen oder heteroaromatischen Ringsystem mit 5 bis 40 aromatischen Ringatomen, das jeweils mit einem oder mehreren Resten $R^3$ substituiert sein kann. Besonders bevorzugt ist $Ar_3$ unsubstituiert, teilweise oder vollständig deuteriert.

$R^3$ in Verbindungen der Formeln (1), (1A), (1B), (1C), (1D), (1E), (1F), (1G), (1H), (1a), (1b), (1c), (1d), (1e) und (1f), wie zuvor beschrieben oder bevorzugt beschrieben, wird bei jedem Auftreten unabhängig voneinander bevorzugt ausgewählt aus der Gruppe H, CN, einem aromatischen oder heteroaromatischen Ringsystem mit 5 bis 40 aromatischen Ringatomen, in dem ein oder mehrere H-Atome durch D oder CN ersetzt sein können. $R^3$ in Verbindungen der Formeln (1), (1A), (1B), (1C), (1D), (1E), (1F), (1G), (1H), (1a), (1b), (1c), (1d), (1e) und (1f), wie zuvor beschrieben oder bevorzugt beschrieben, wird bei jedem Auftreten unabhängig voneinander besonders bevorzugt ausgewählt aus H, D, Phenyl oder deuteriertem Phenyl.

Beispiele für geeignete Hostmaterialien der Formeln (1), (1A), (1B), (1C), (1D), (1E), (1F), (1G), (1H), (1a), (1b), (1c), (1d), (1e) und (1f), die erfindungsgemäß ausgewählt werden, und bevorzugt in Kombination mit mindestens einer Verbindung der Formel (2) in der erfindungsgemäßen elektrolumineszierenden Vorrichtung verwendet werden, sind die nachstehend genannten Strukturen der Tabelle 1.

Tabelle 1:

| | | |
|---|---|---|
| 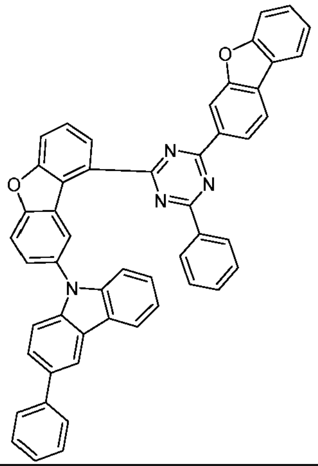 | 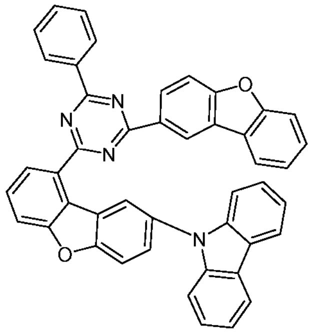 | 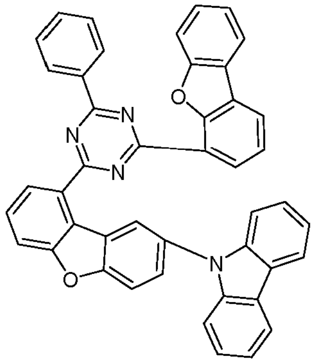 |

| | | |
|---|---|---|
| 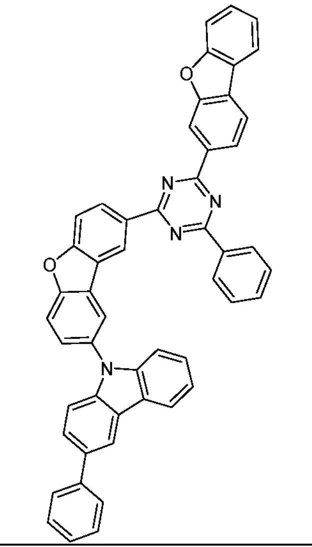 | 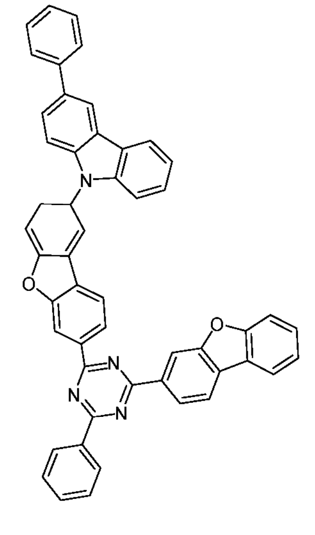 | 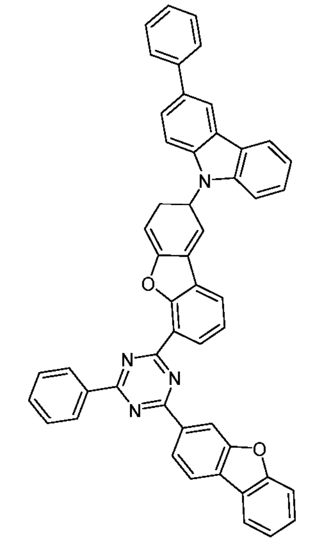 |
| 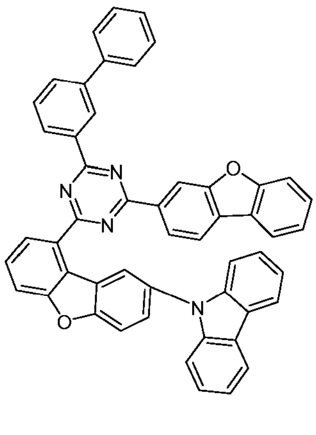 | 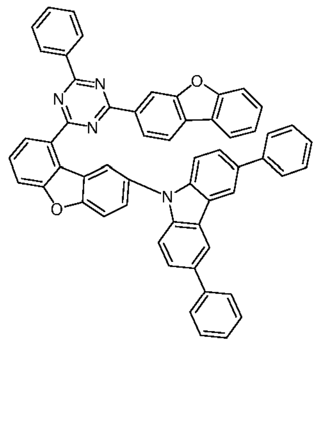 | 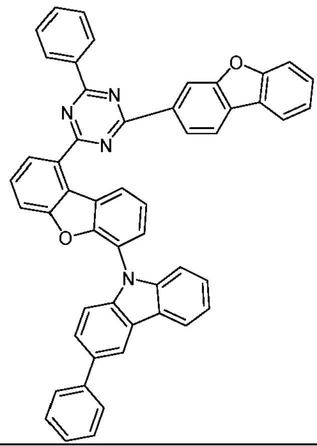 |
| 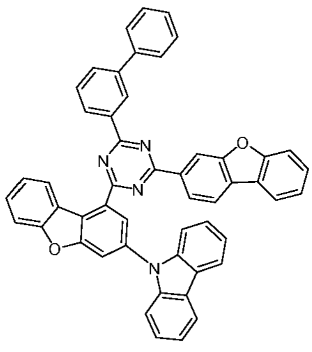 | 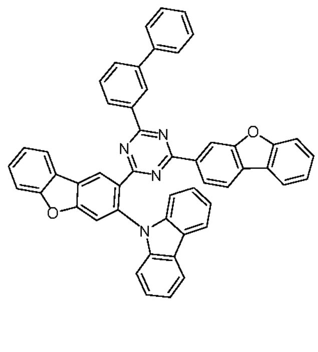 | 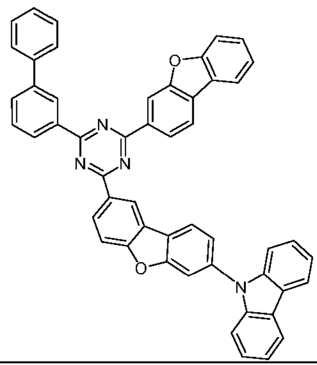 |
| 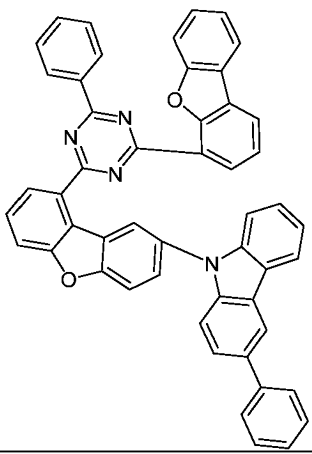 | 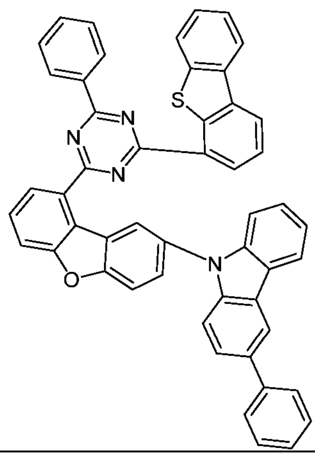 | 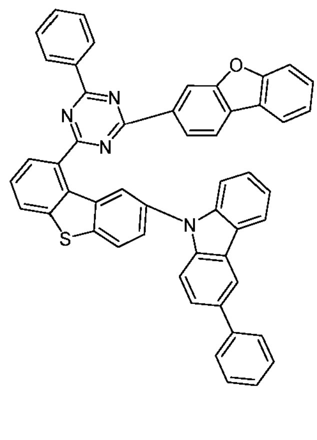 |

| | | |
|---|---|---|
| 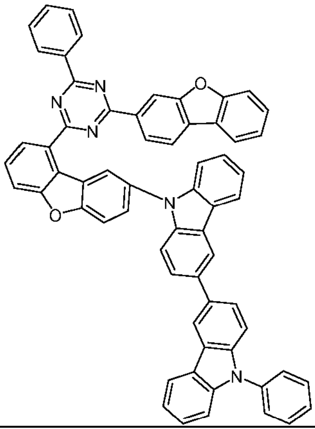 | 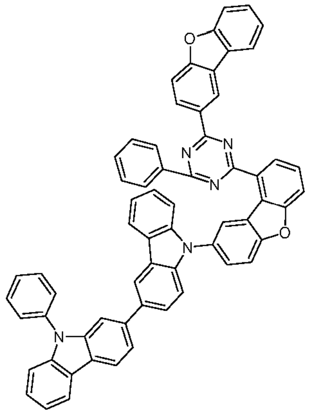 | 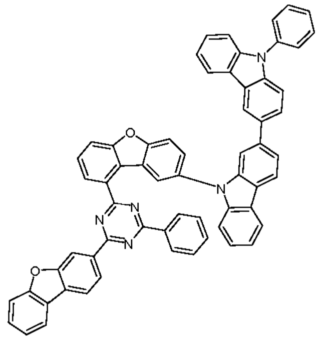 |
| 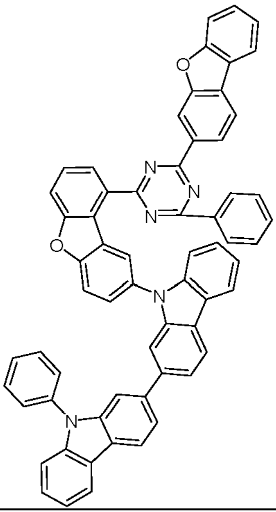 | 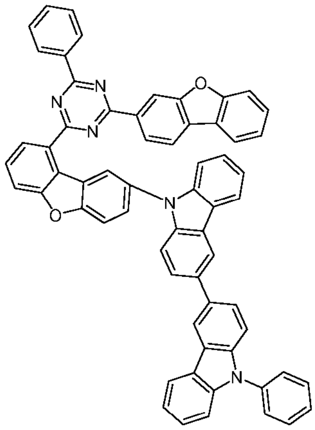 | 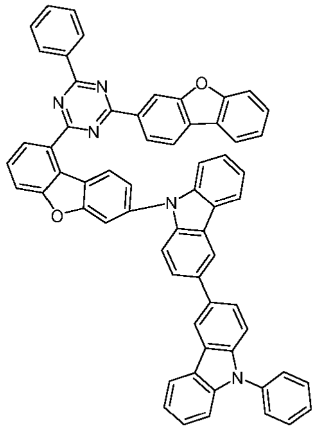 |
| 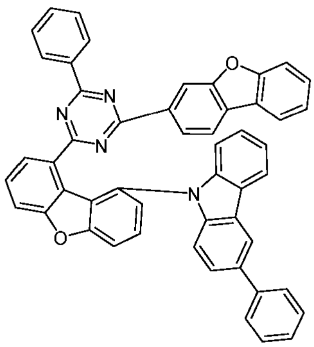 | 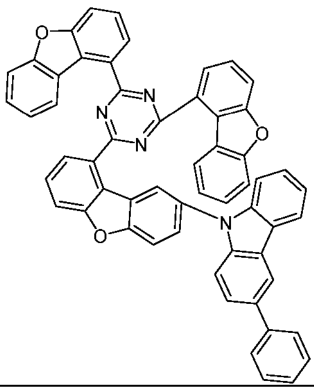 | 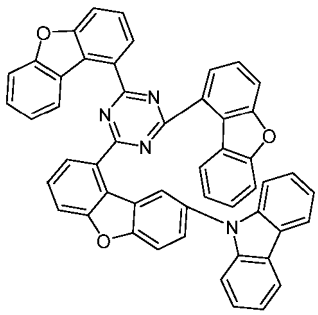 |
| 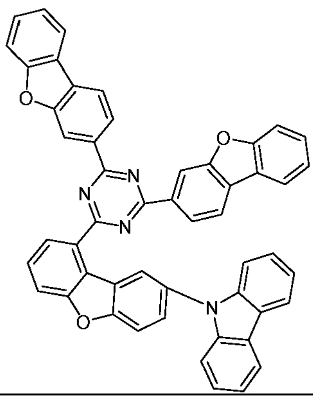 | 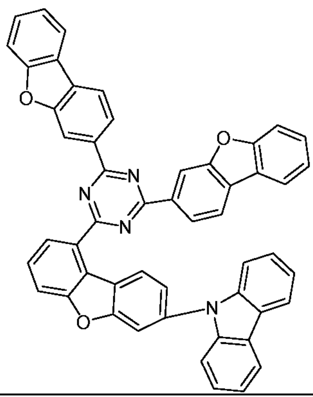 | 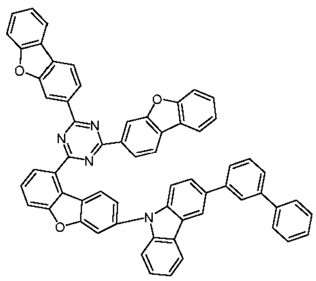 |

| | | |
|---|---|---|
| 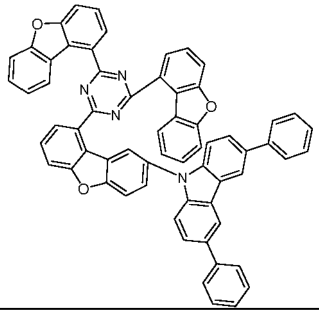 | 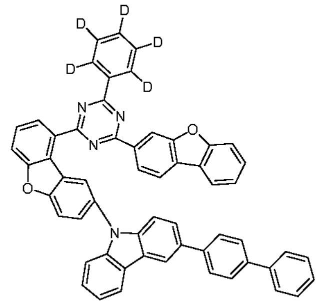 | 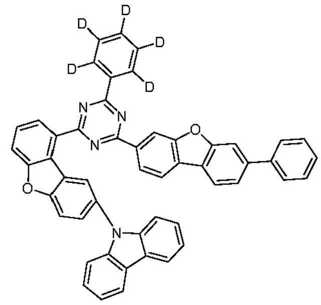 |
| 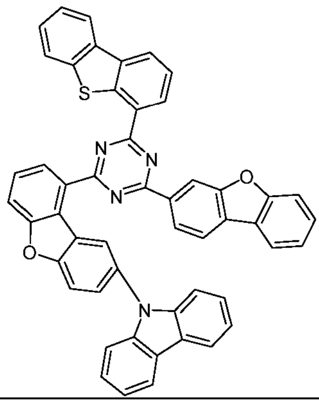 | 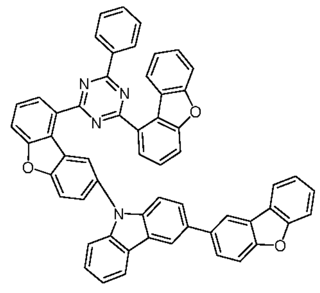 | 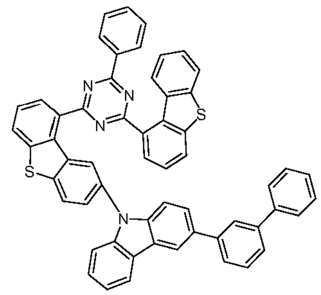 |
| 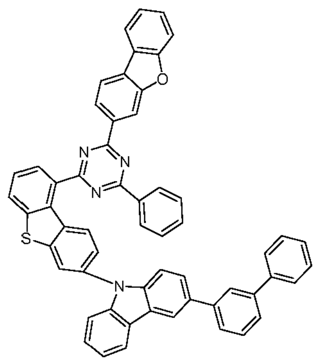 | 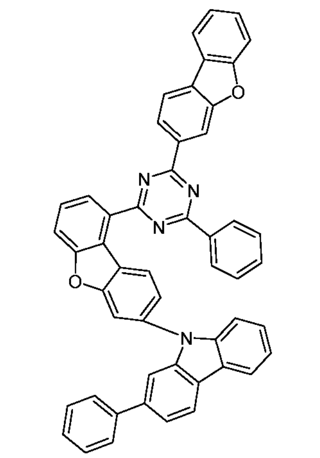 | 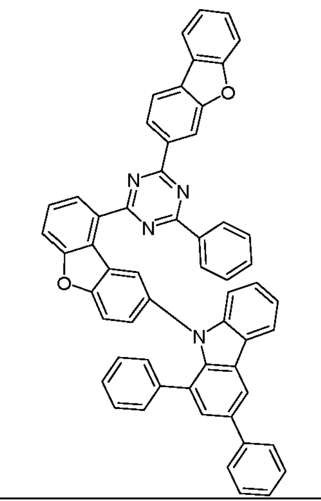 |
| 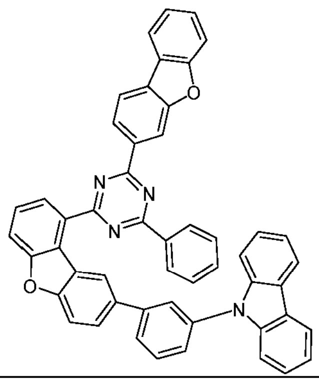 | 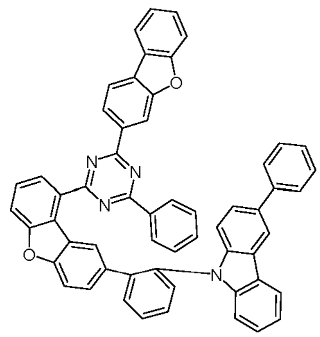 | 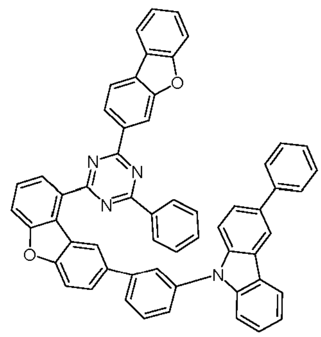 |

| | | |
|---|---|---|
| 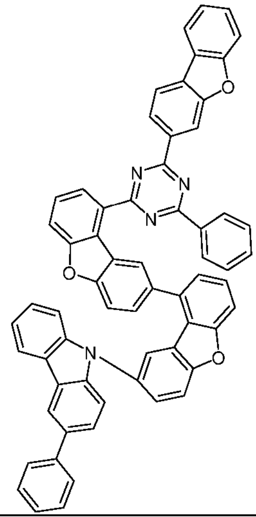 | 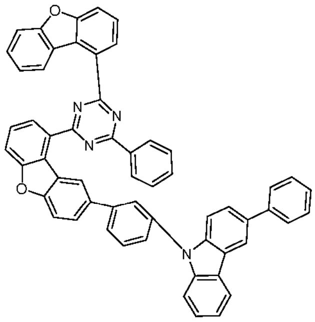 | 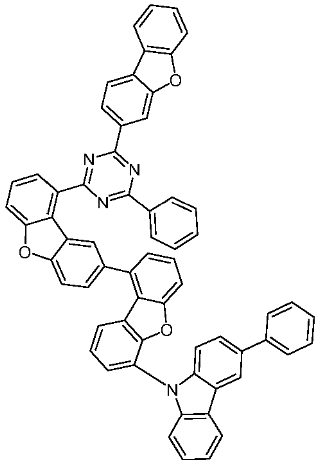 |
| 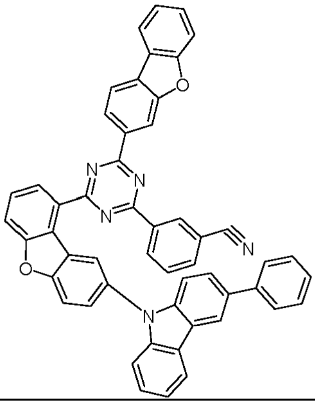 | 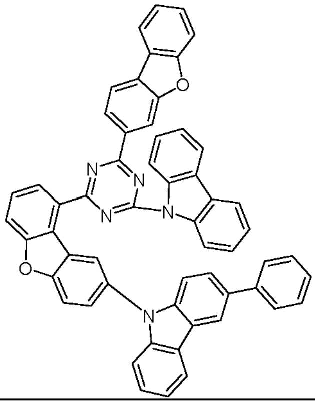 | 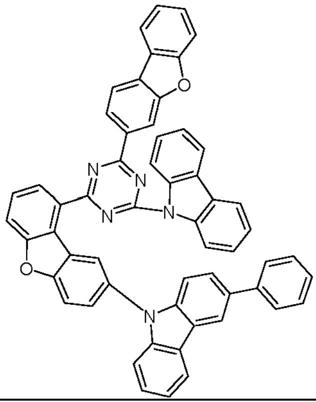 |
| 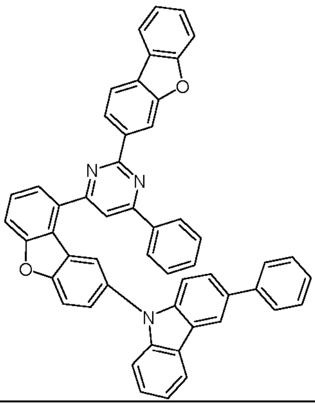 | 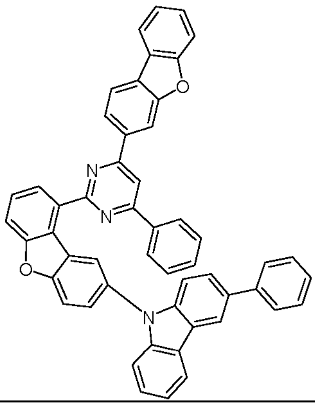 | |

Bevorzugt ist das Hostmaterial 1, wie zuvor beschrieben oder zuvor oder nachfolgend bevorzugt beschrieben teilweise deuteriert oder vollständig deuteriert.

Besonders geeignete Verbindungen der Formeln (1), (1a), (1b), (1c), (1d), (1e) und (1f), die bevorzugt in Kombination mit mindestens einer Verbindung der Formel (2) in der erfindungsgemäßen elektrolumineszierenden Vorrichtung verwendet werden, sind die Verbindungen E1 bis E51 der Tabelle 2.

Tabelle 2:

| | | |
|---|---|---|
| 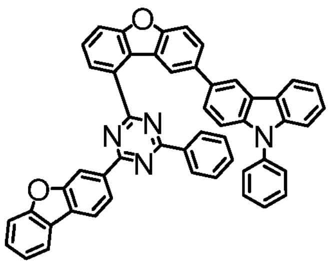 | 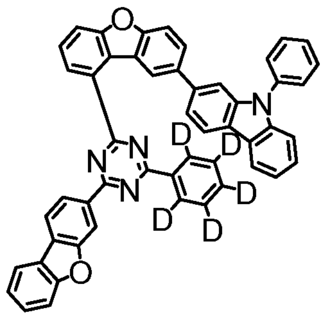 | 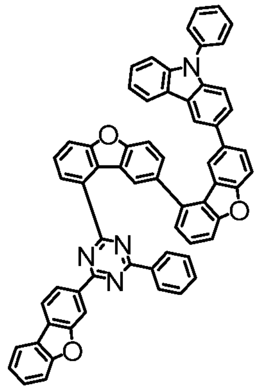 |
| E1 | E2 | E3 |
| 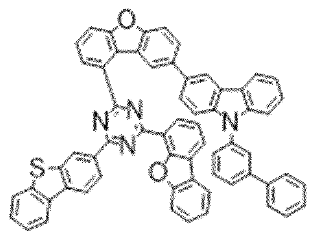 | 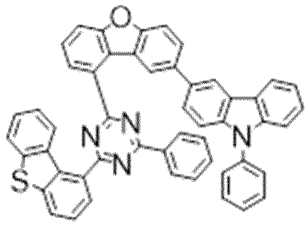 | 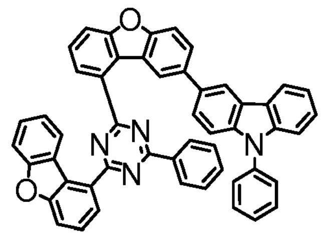 |
| E4 | E5 | E6 |
| 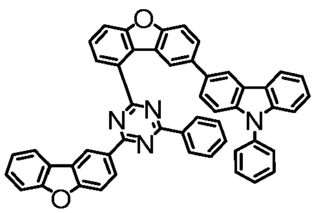 | 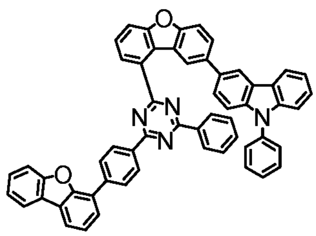 | 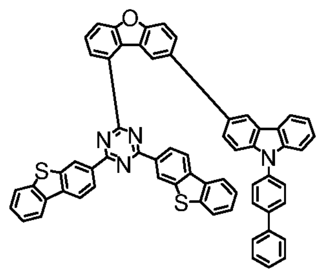 |
| E7 | E8 | E9 |
| 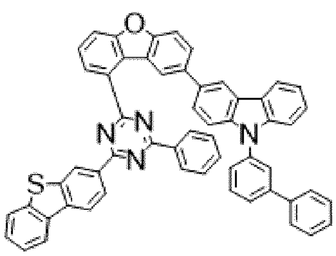 | 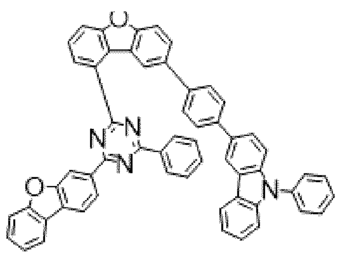 | 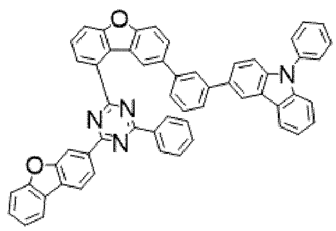 |
| E10 | E11 | E12 |
| 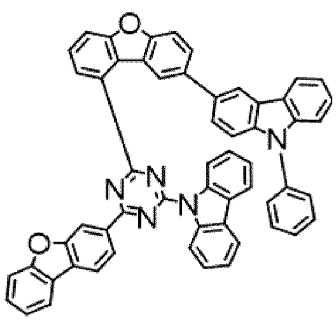 | 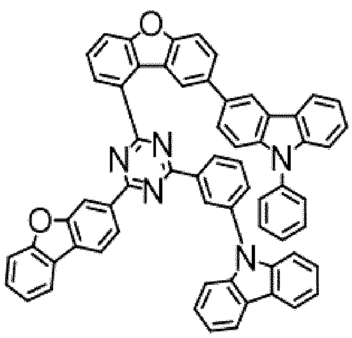 | 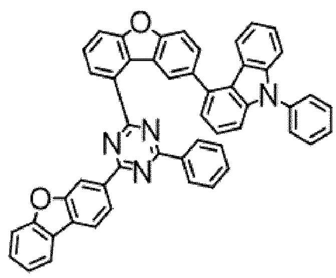 |

(fortgesetzt)

| E13 | E14 | E15 |
|---|---|---|
| 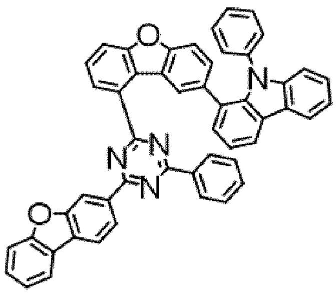 | 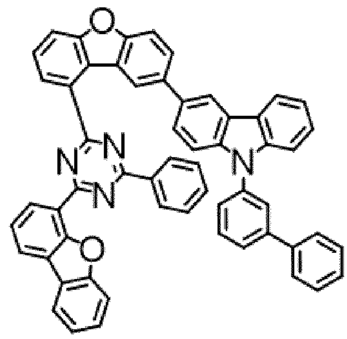 | 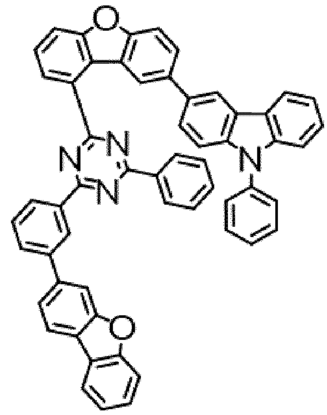 |
| E16 | E17 | E18 |
| 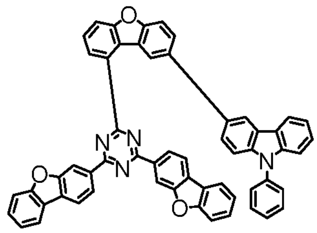 | 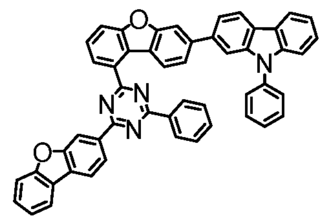 | 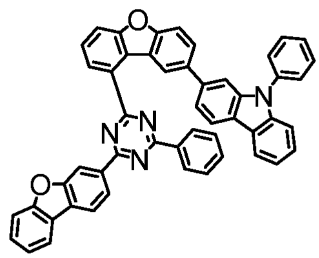 |
| E19 | E20 | E21 |
| 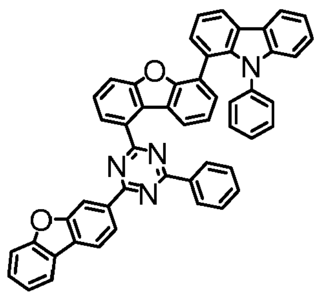 | 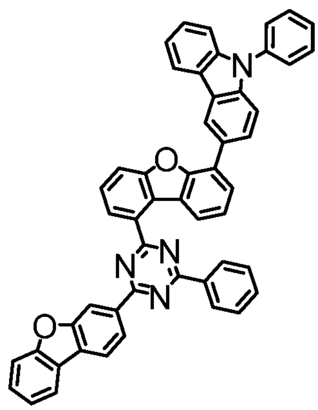 | 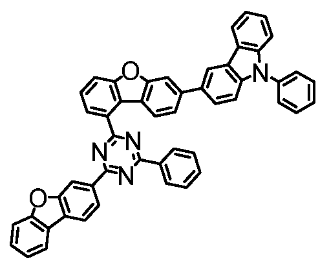 |
| E22 | E23 | E24 |
| 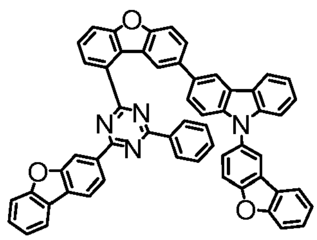 | 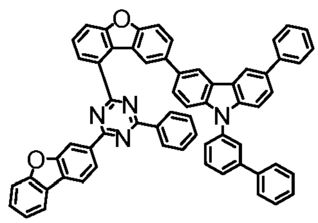 | 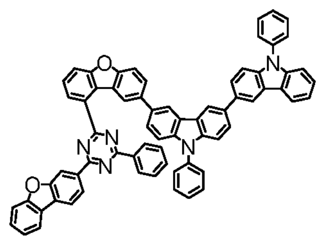 |
| E25 | E26 | E27 |

(fortgesetzt)

| | | |
|---|---|---|
| 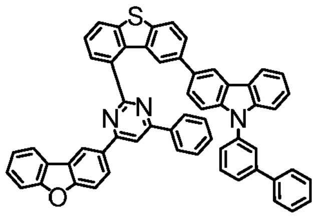 | 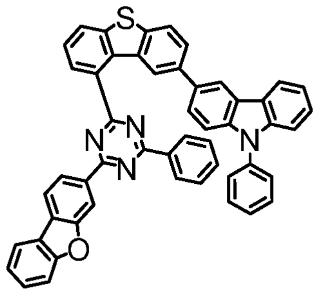 | 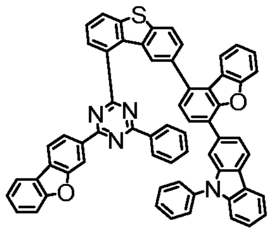 |
| E28 | E29 | E30 |
| 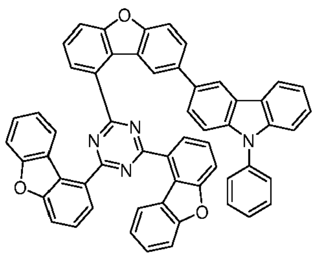 | 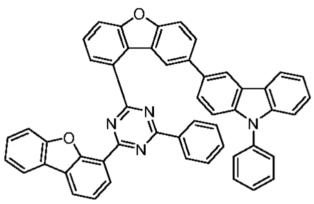 | 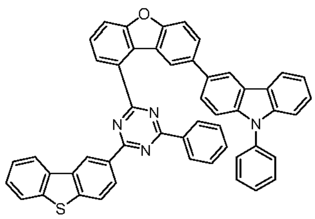 |
| E31 | E32 | E33 |
| 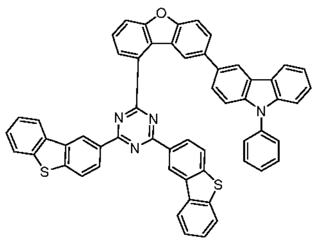 | 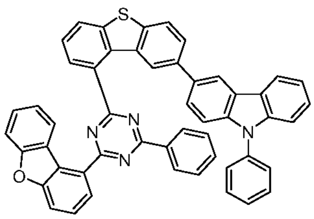 | 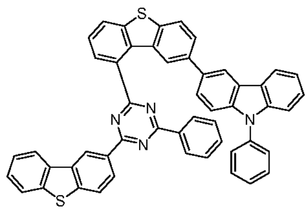 |
| E34 | E35 | E36 |
| 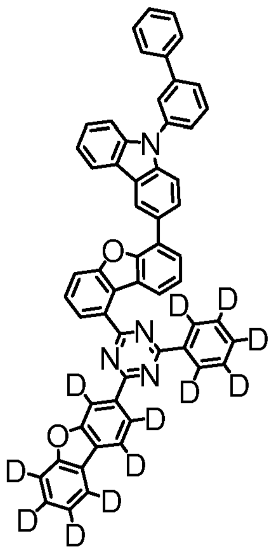 | 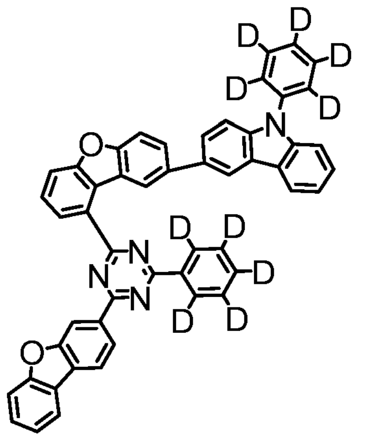 | 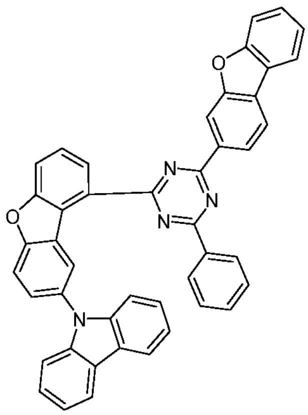 |
| E37 | E38 | E39 |

(fortgesetzt)

| | | |
|---|---|---|
| 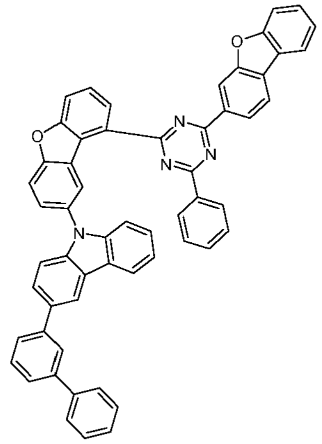 | 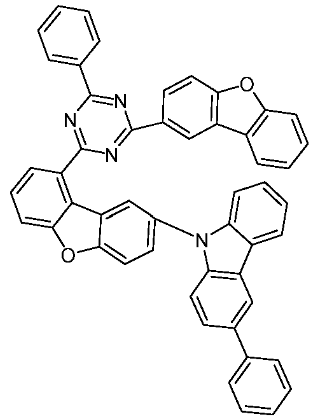 | 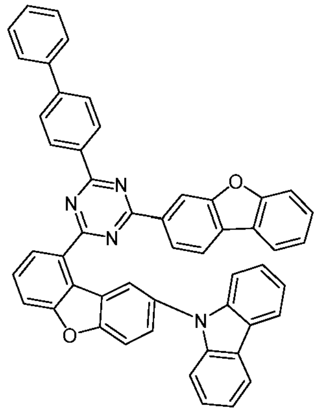 |
| E40 | E41 | E42 |
| 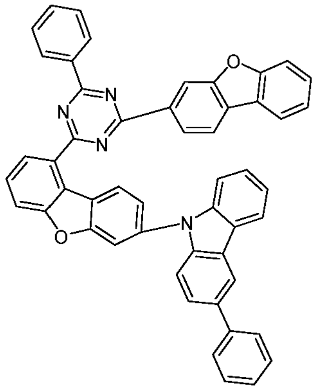 | 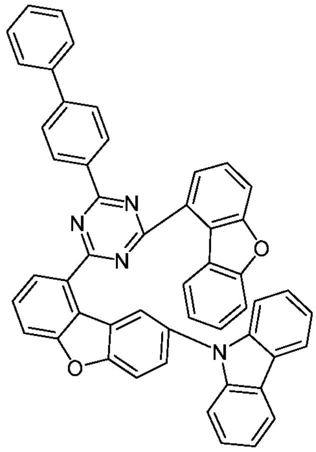 | 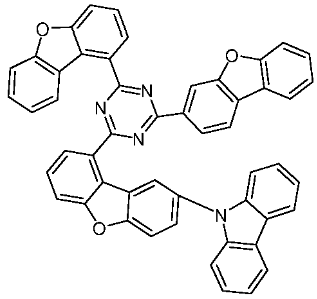 |
| E43 | E44 | E45 |
| 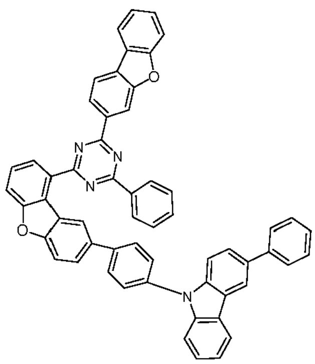 | 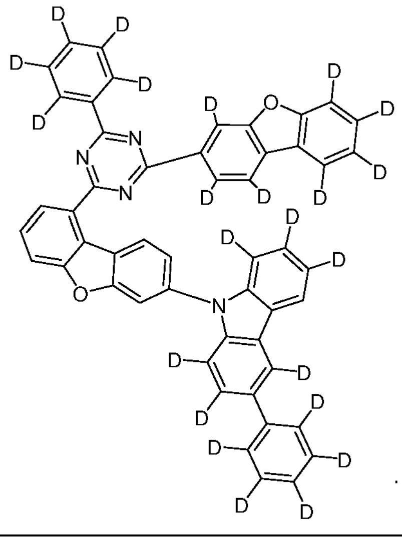 | 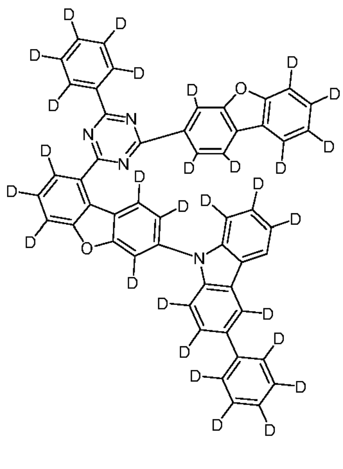 |
| E46 | E47 | E48 |

(fortgesetzt)

| | | |
|---|---|---|
| 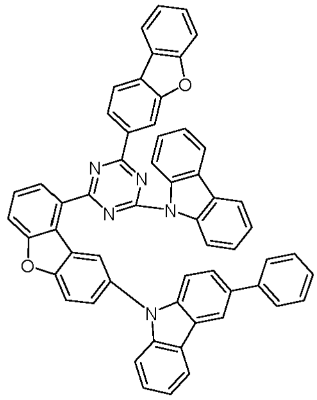 | 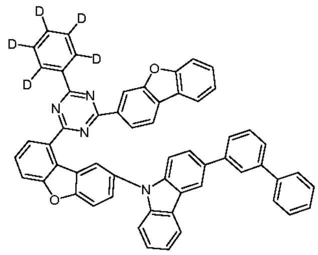 | 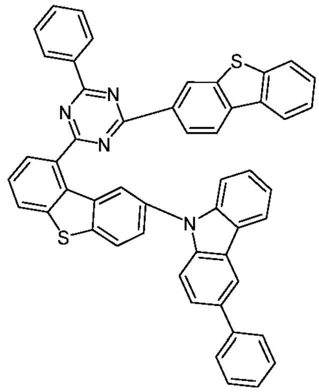 |
| E49 | E50 | E51. |

Die Herstellung der Verbindungen der Formel (1) oder der bevorzugten Verbindungen der Tabelle 1 sowie der Verbindungen E1 bis E51 ist dem Fachmann bekannt. Die Verbindungen können nach dem Fachmann bekannten Syntheseschritten, wie z. B. Bromierung, Suzuki-Kupplung, Ullmann-Kupplung, Hartwig-Buchwald-Kupplung, etc., dargestellt werden. Ein geeignetes Syntheseverfahren ist allgemein in den folgenden Schemata 1, 2 und 3 dargestellt, wobei die verwendeten Symbole und Indizes die oben genannten Bedeutungen aufweisen, wobei jedoch zur Vereinfachung die Darstellung der möglichen Substituenten $R^0$ weggelassen wurden, wie in den Verbindungen der Formeln (1), (1A), (1B), (1C), (1D), (1E), (1F), (1G), (1H), (1a), (1b), (1c), (1d), (1e) und (1f) beschrieben. Dem Fachmann bereitet es keine Schwierigkeiten, die Lehre der Herstellung auf diese Verbindungen der Formeln (1), (1A), (1B), (1C), (1D), (1E), (1F), (1G), (1H), (1a), (1b), (1c), (1d), (1e) und (1f) anzupassen.

Schema 1:

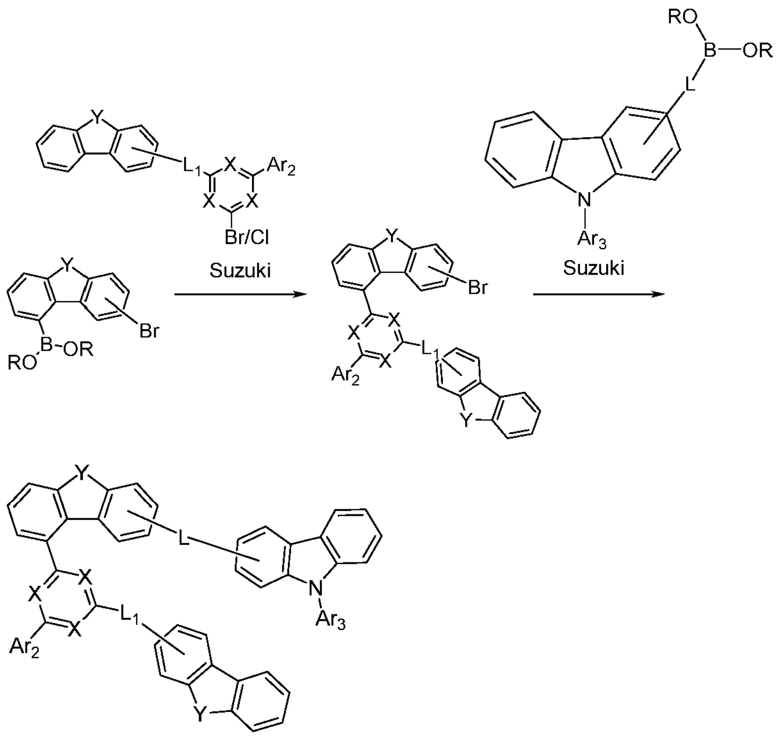

Schema 2:

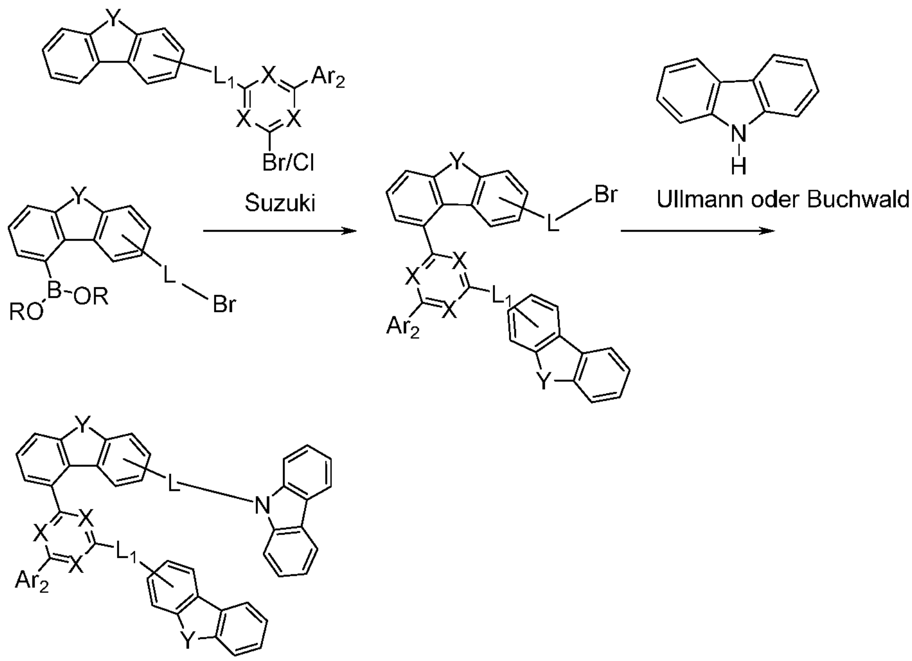


Schema 3

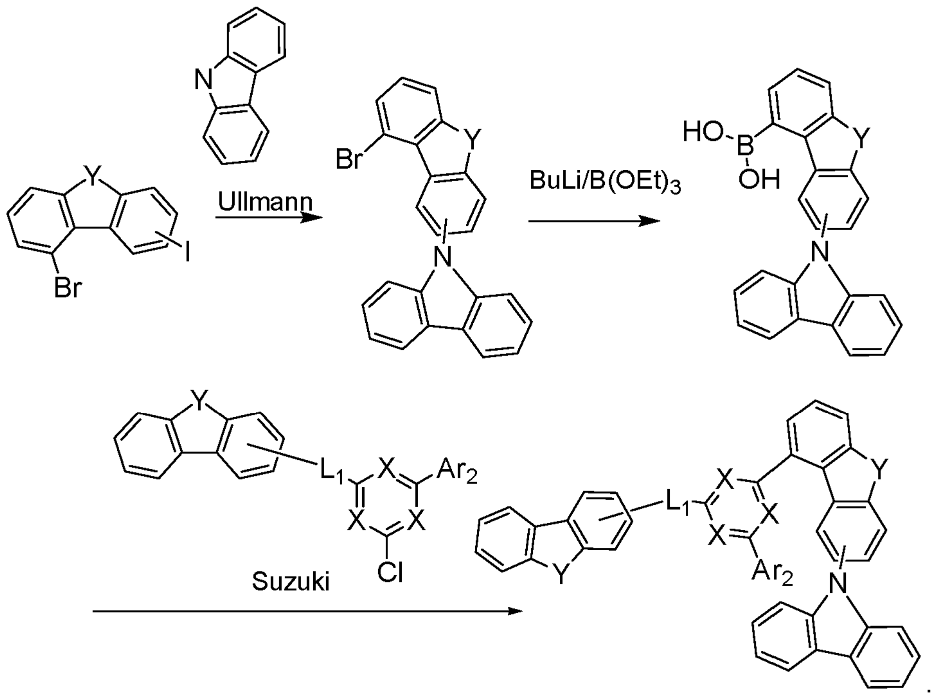


Im Folgenden wird das Hostmaterial 2 und dessen bevorzugte Ausführungsformen beschrieben, welches/welche in der erfindungsgemäßen Vorrichtung enthalten ist/sind. Die bevorzugten Ausführungsformen des Hostmaterials 2 der Formel (2) gelten auch für die erfindungsgemäße Mischung und/oder Formulierung.

In einer Ausführungsform der Erfindung werden für die erfindungsgemäße Vorrichtung Verbindungen der Formel (2) ausgewählt, wie zuvor beschrieben, die mit Verbindungen der Formel (1), wie zuvor beschrieben oder bevorzugt beschrieben, oder mit den Verbindungen der Tabelle 1 oder den Verbindungen **E1** bis **E51,** in der lichtemittierenden Schicht verwendet werden.

In Verbindungen der Formel (2), wie zuvor beschrieben, ist die Summe der Indizes $a_1$+$a_2$+$a_3$+$a_4$ ausgewählt aus 3, 4, 5, 6, 7, 8, 9, 10, 11, 12, 13, 14, 15, 16 oder 17. Das Hostmaterial 2 ist demzufolge an jedem N-gebundenen

Substituenten mindestens teilweise deuteriert. In einer bevorzugten Ausführungsform sind zwei der N-gebundenen Substituenten in Hostmaterial 2 teilweise deuteriert und der dritte N-gebundene Substituent ist vollständig deuteriert. In einer weiteren bevorzugten Ausführungsform sind zwei der N-gebundenen Substituenten in Hostmaterial 2 vollständig deuteriert und der dritte N-gebundene Substituent ist teilweise deuteriert. In einer weiteren bevorzugten Ausführungsform ist jeder N-gebundenen Substituent in Hostmaterial 2 vollständig deuteriert.

In einer bevorzugten Ausführungsform des Hostmaterials 2 ist dieses ein Gemisch aus deuterierten Verbindungen der Formel (2), wie zuvor beschrieben oder nachfolgend bevorzugt beschrieben, wobei der Deuterierungsgrad der Verbindungen der Formel (2) mindestens 50% bis 90% beträgt, bevorzugt 70% bis 100 % beträgt. Entsprechende Deuterierungsmethoden sind nachfolgend beschrieben.

Ein weiterer Gegenstand der Erfindung ist demzufolge eine organische lumineszierende Vorrichtung, wie zuvor beschrieben oder bevorzugt beschrieben, wobei das Hostmaterial 2, wie zuvor beschrieben oder nachfolgend als bevorzugt beschrieben, vollständig deuteriert ist.

In Verbindungen der Formel (2), oder den im Folgenden offenbarten Verbindungen der Formeln (2a), (2b), (2c), (2d) und (2e), steht x bevorzugt für 1 oder 2, wobei $R^2$ bei jedem Auftreten gleich oder verschieden bevorzugt ausgewählt wird aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten.

Steht in Verbindungen der Formel (2), oder den im Folgenden offenbarten Verbindungen der Formeln (2a), (2b), (2c), (2d) und (2e), x für 1 und $a_1$ für 1, 2, 3 oder 4, so wird der Substituent $R^2$ bevorzugt aus der Gruppe der folgenden Substituenten R2-1 bis R2-221 ausgewählt, wobei die Substituenten R2-1 bis R-221 auch teilweise deuteriert oder vollständig deuteriert sein können, sofern nicht schon als Solches beschrieben:

| | | |
|---|---|---|
| 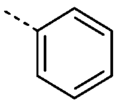 | 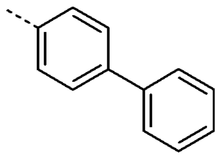 | 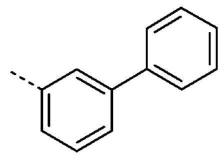 |
| R2-1 | R2-2 | R2-3 |
| 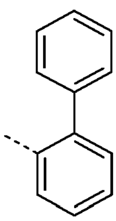 | 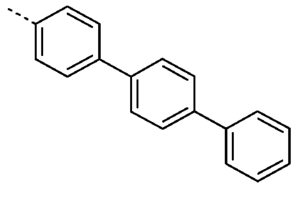 | 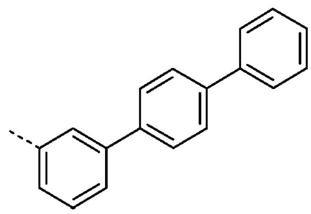 |
| R2-4 | R2-5 | R2-6 |
| 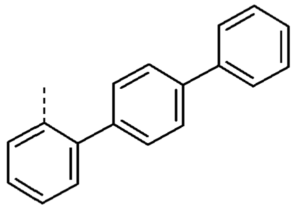 | 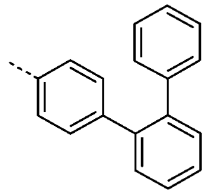 | 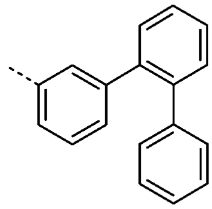 |
| R2-7 | R2-8 | R2-9 |

(fortgesetzt)

| | | |
|---|---|---|
| 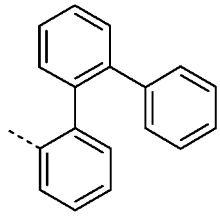 | 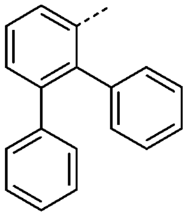 | 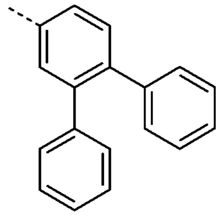 |
| R2-10 | R2-11 | R2-12 |
| 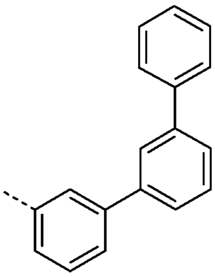 | 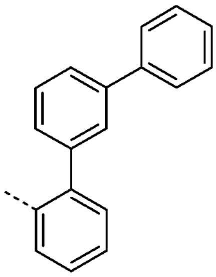 | 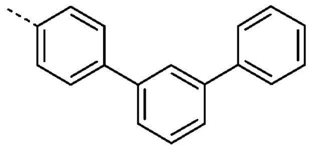 |
| R2-13 | R2-14 | R2-15 |
| 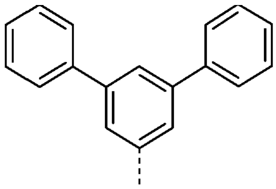 | 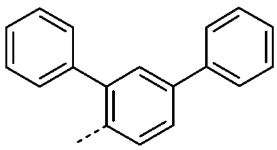 | 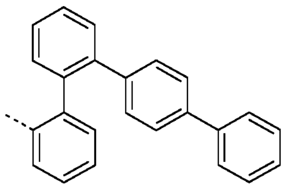 |
| R2-16 | R2-17 | R2-18 |
| | 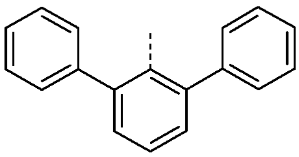 | |
| | R2-19 | |
| 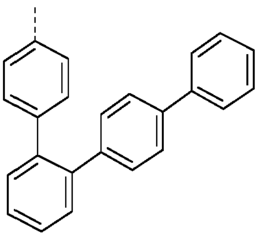 | 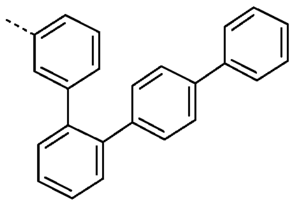 | 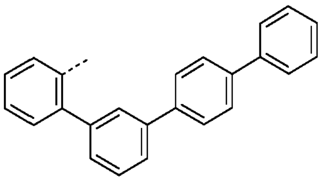 |
| R2-20 | R2-21 | R2-22 |
| 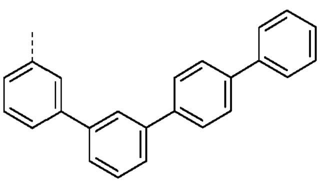 | 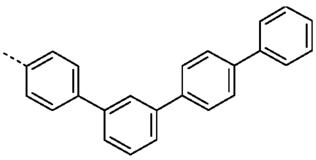 | 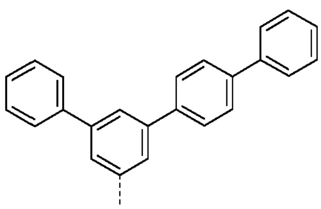 |
| R2-23 | R2-24 | R2-25 |

(fortgesetzt)

| | | |
|---|---|---|
| 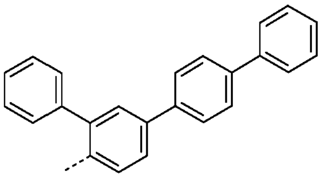 | 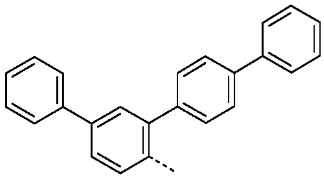 | 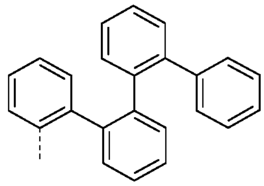 |
| R2-26 | R2-27 | R2-28 |
| 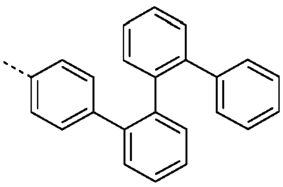 | 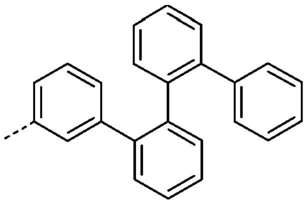 | 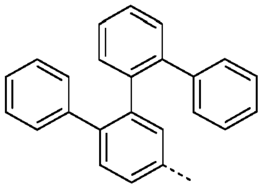 |
| R2-29 | R2-30 | R2-31 |
| 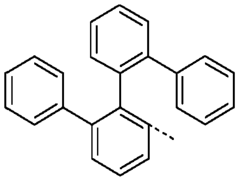 | 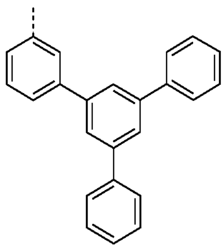 | 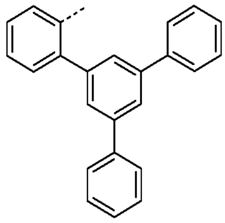 |
| R2-32 | R2-33 | R2-34 |
| 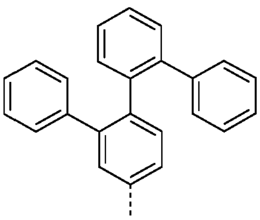 | 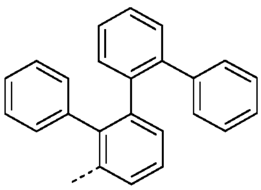 | 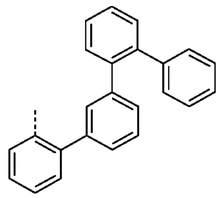 |
| R2-35 | R2-36 | R2-37 |
| 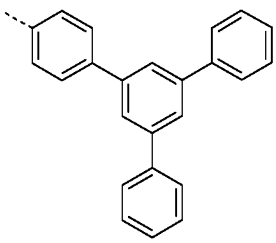 | 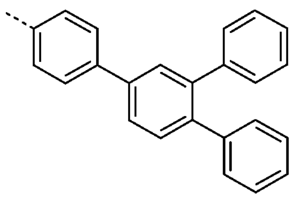 | 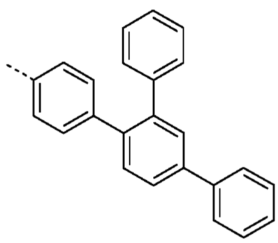 |
| R2-38 | R2-39 | R2-40 |
| 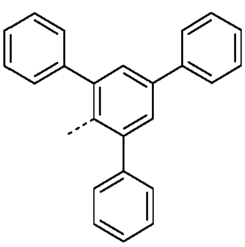 | 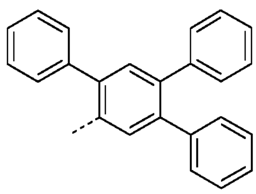 | 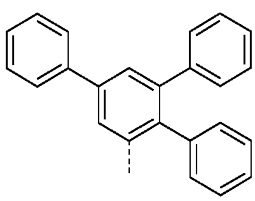 |
| R2-41 | R2-42 | R2-43 |

(fortgesetzt)

| | | |
|---|---|---|
| 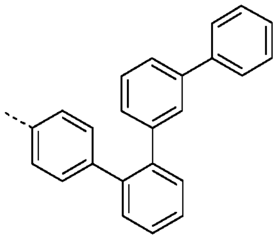 | 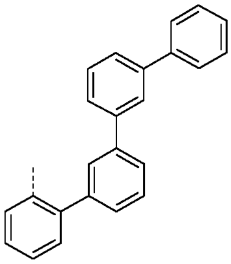 | 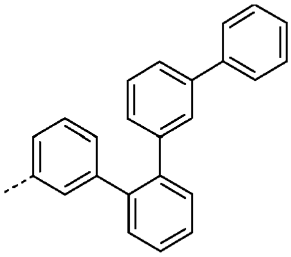 |
| R2-44 | R2-45 | R2-46 |
| 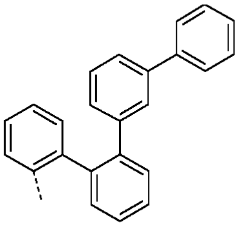 | | |
| R2-47 | | |
| 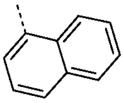 | 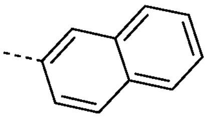 | 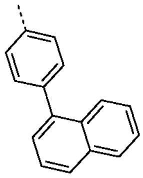 |
| R2-48 | R2-49 | R2-50 |
| 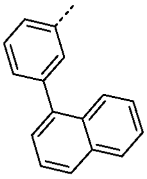 | 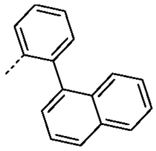 | 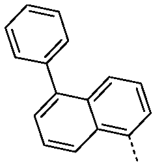 |
| R2-51 | R2-52 | R2-53 |
| 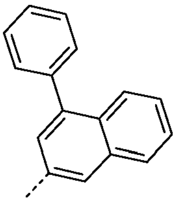 | 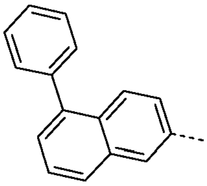 | 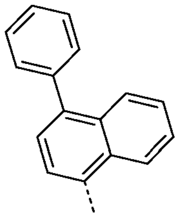 |
| R2-54 | R2-55 | R2-56 |
| 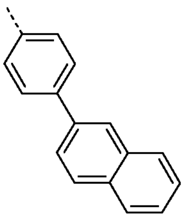 | 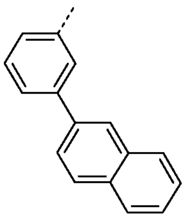 | 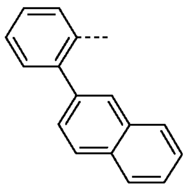 |
| R2-57 | R2-58 | R2-59 |

(fortgesetzt)

| | | |
|---|---|---|
| 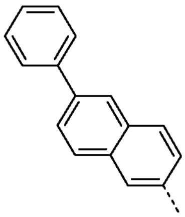 | 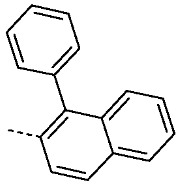 | 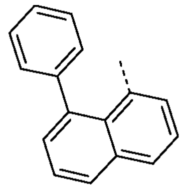 |
| R2-60 | R2-61 | R2-62 |
| 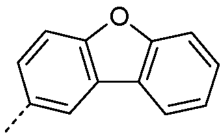 | 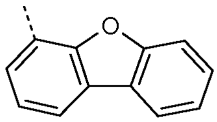 | 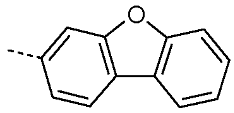 |
| R2-63 | R2-64 | R2-65 |
| 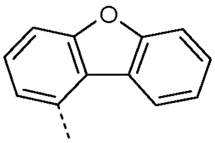 | 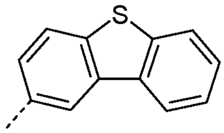 | 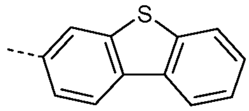 |
| R2-66 | R2-67 | R2-68 |
| 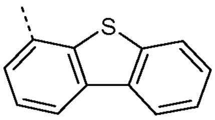 | 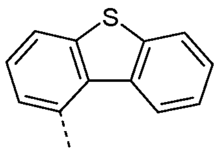 | 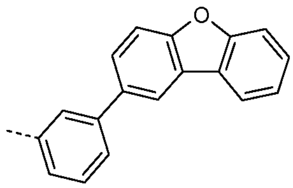 |
| R2-69 | R2-70 | R2-71 |
| 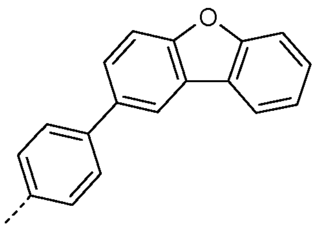 | 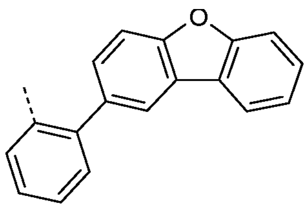 | 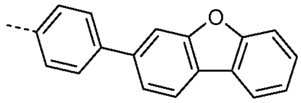 |
| R2-72 | R2-73 | R2-74 |
| 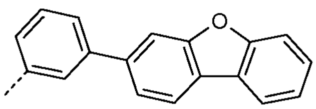 | 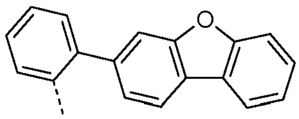 | 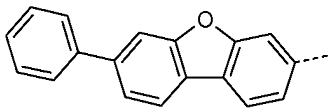 |
| R2-75 | R2-76 | R2-77 |
| 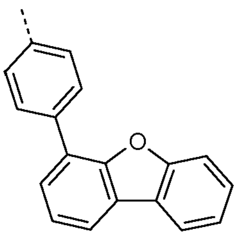 | 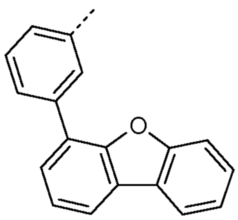 | 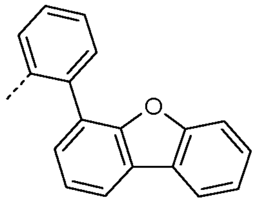 |
| R2-78 | R2-79 | R2-80 |

(fortgesetzt)

| | | |
|---|---|---|
| 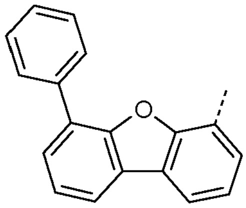 | 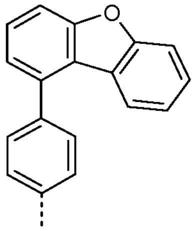 | 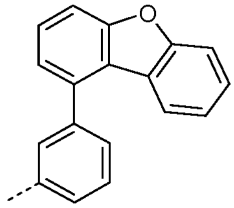 |
| R2-81 | R2-82 | R2-83 |
| 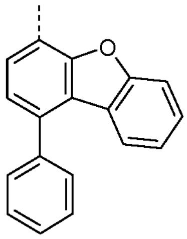 | 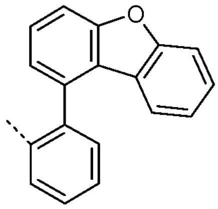 | 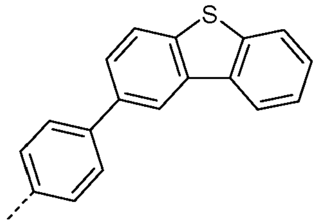 |
| R2-84 | R2-85 | R2-86 |
| 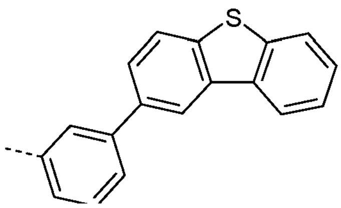 | 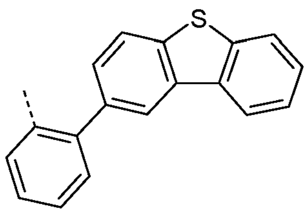 | 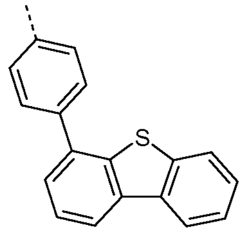 |
| R2-87 | R2-88 | R2-89 |
| 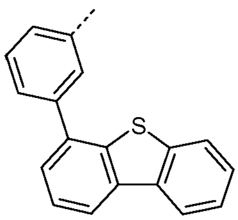 | 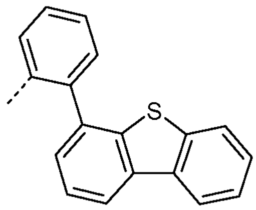 | 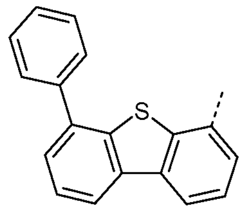 |
| R2-90 | R2-91 | R2-92 |
| 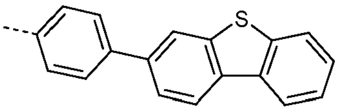 | 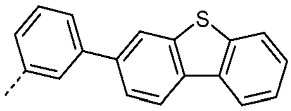 | 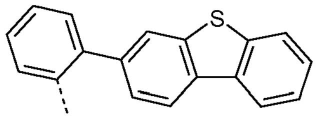 |
| R2-93 | R2-94 | R2-95 |
| 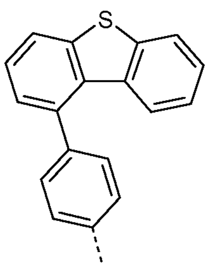 | 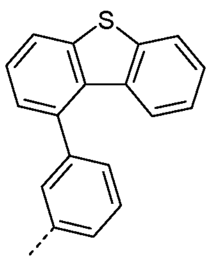 | 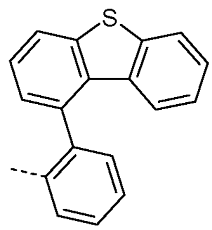 |
| R2-96 | R2-97 | R2-98 |

(fortgesetzt)

| | | |
|---|---|---|
| 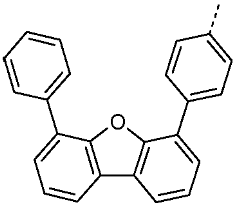 | 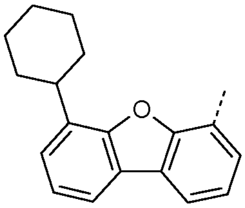 | 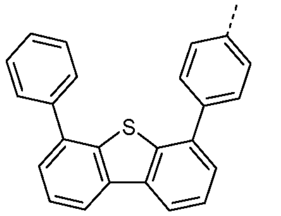 |
| R2-99 | R2-100 | R2-101 |
| 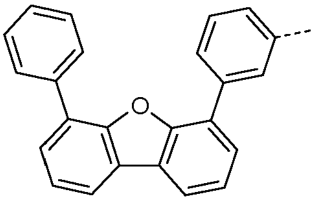 | 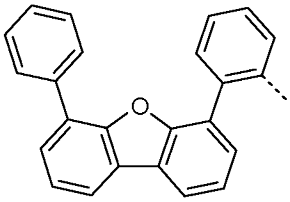 | 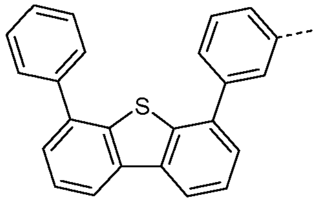 |
| R2-102 | R2-103 | R2-104 |
| 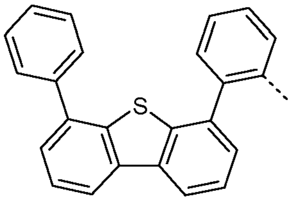 | | |
| R2-105 | | |
| 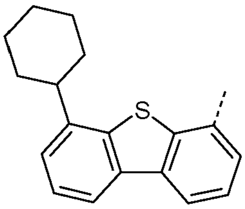 | 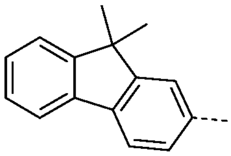 | 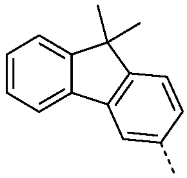 |
| R2-106 | R2-107 | R2-108 |
| 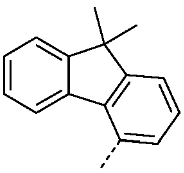 | 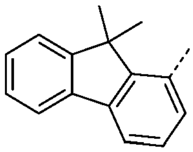 | 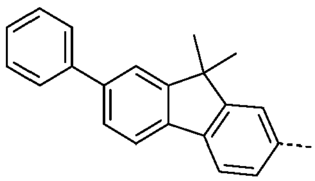 |
| R2-109 | R2-110 | R2-111 |
| 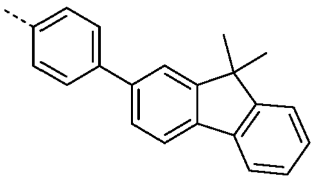 | 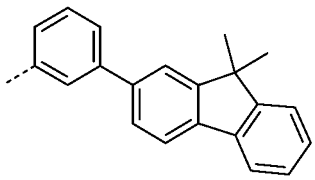 | |
| R2-112 | R2-113 | |

(fortgesetzt)

| | | |
|---|---|---|
| 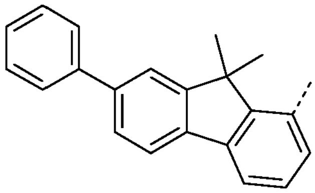 | 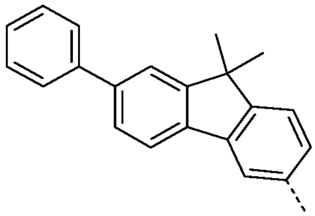 | 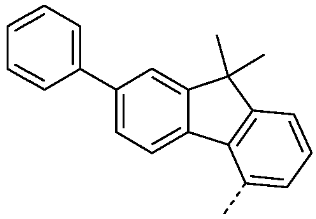 |
| R2-114 | R2-115 | R2-116 |
| 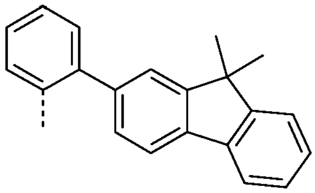 | 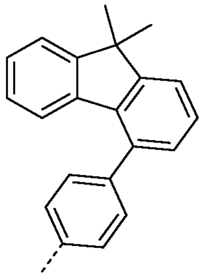 | 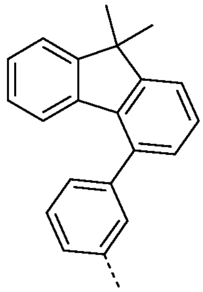 |
| R2-117 | R2-118 | R2-119 |
| 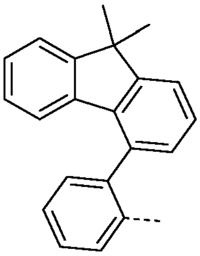 | 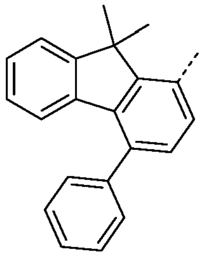 | 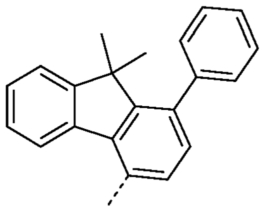 |
| R2-120 | R2-121 | R2-122 |
| 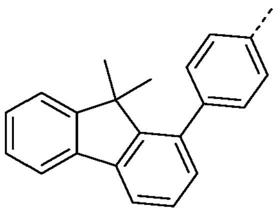 | 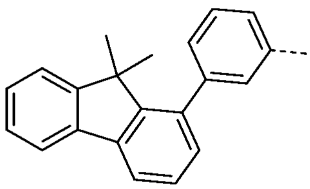 | 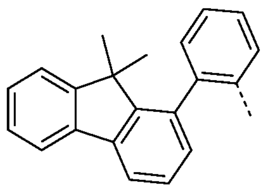 |
| R2-123 | R2-124 | R2-125 |
| 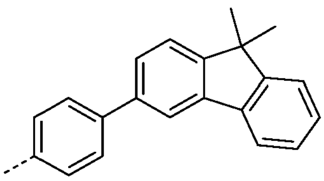 | 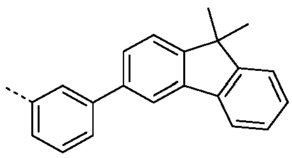 | 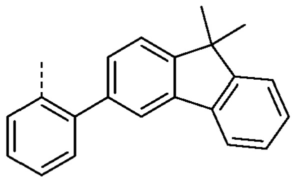 |
| R2-126 | R2-127 | R2-128 |
| 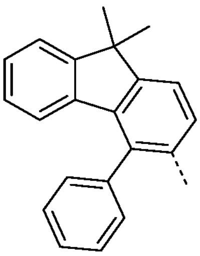 | 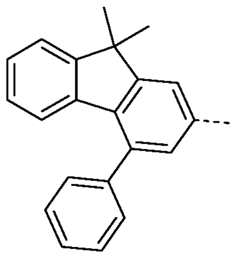 | 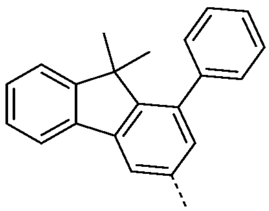 |

(fortgesetzt)

| | | |
|---|---|---|
| R2-129 | R2-130 | R2-131 |
| 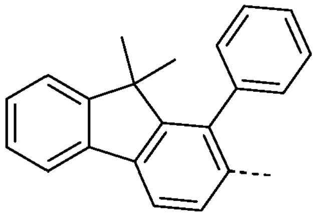 | 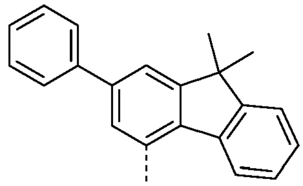 | |
| R2-132 | R2-133 | |
| 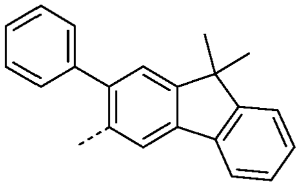 | 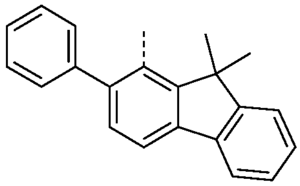 | 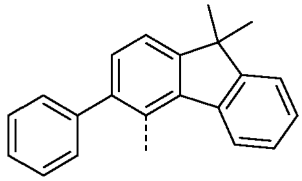 |
| R2-134 | R2-135 | R2-136 |
| 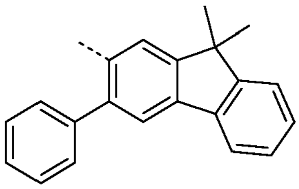 | 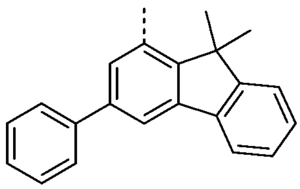 | 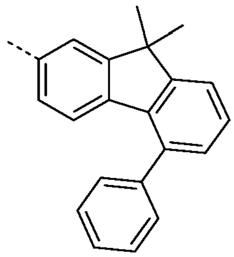 |
| R2-137 | R2-138 | R2-139 |
| 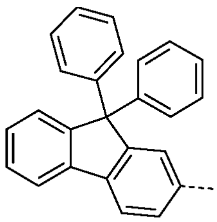 | 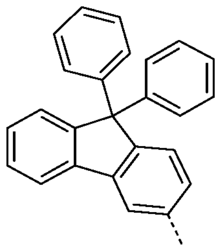 | 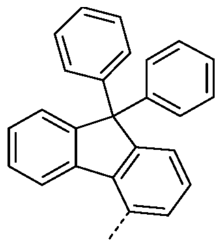 |
| R2-140 | R2-141 | R2-142 |
| 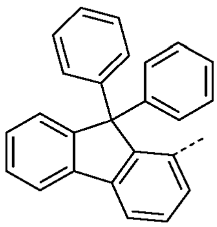 | 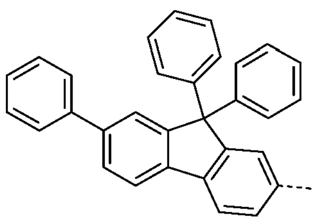 | 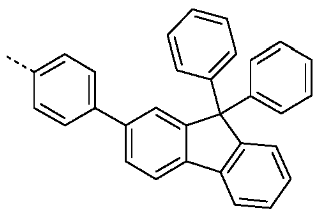 |
| R2-143 | R2-144 | R2-145 |
| 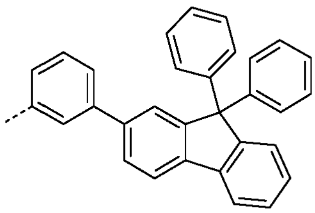 | 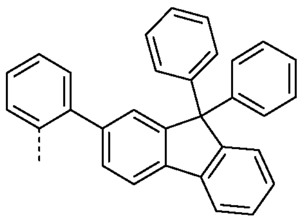 | 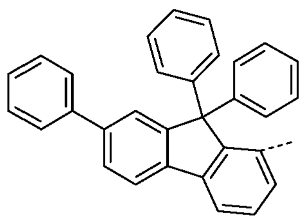 |
| R2-146 | R2-147 | R2-148 |

(fortgesetzt)

| | | |
|---|---|---|
| 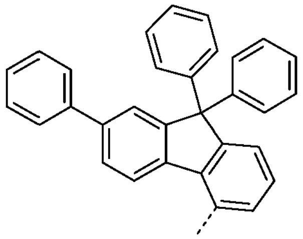 | 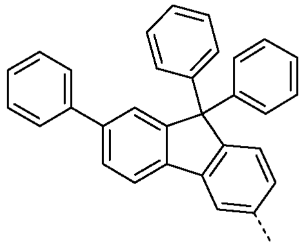 | 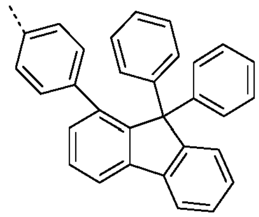 |
| R2-149 | R2-150 | R2-151 |
| 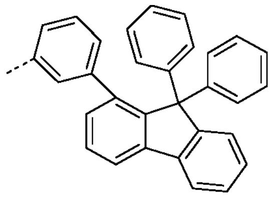 | 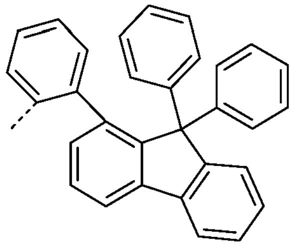 | 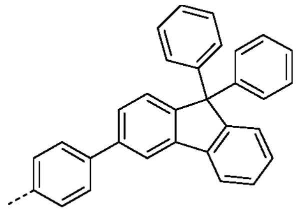 |
| R2-152 | R2-153 | R2-154 |
| 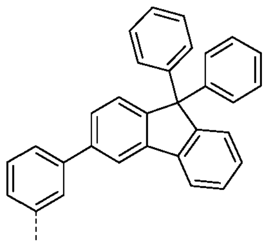 | 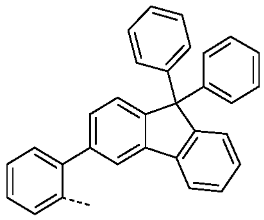 | 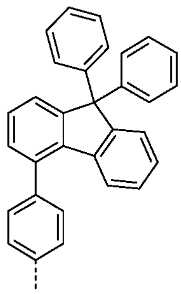 |
| R2-155 | R2-156 | R2-157 |
| 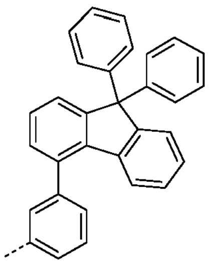 | 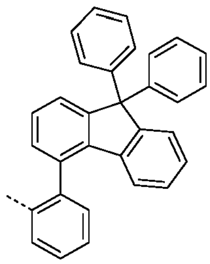 | 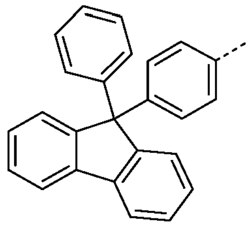 |
| R2-158 | R2-159 | R2-160 |
| 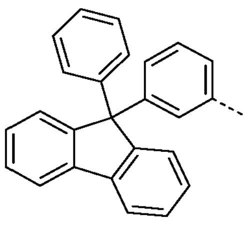 | 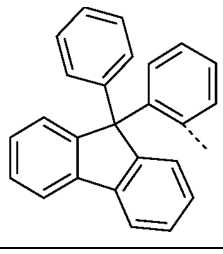 | 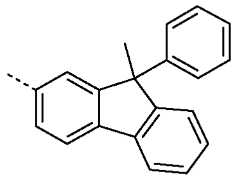 |
| R2-161 | R2-162 | R2-163 |

(fortgesetzt)

| | | |
|---|---|---|
| 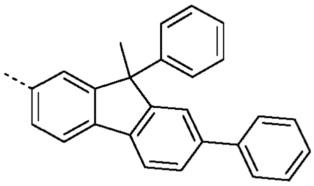 | 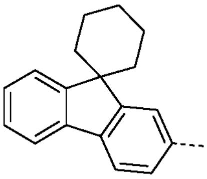 | 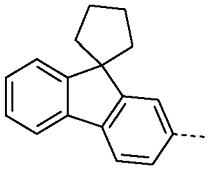 |
| R2-164 | R2-165 | R2-166 |
| 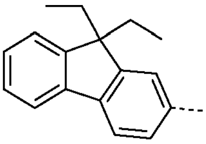 | 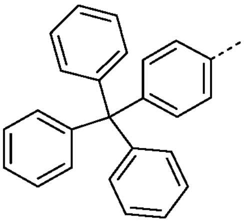 | 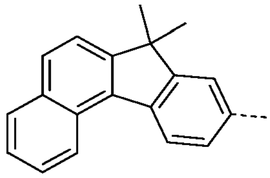 |
| R2-167 | R2-168 | R2-169 |
| 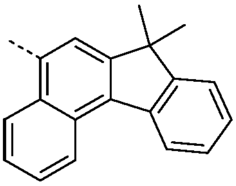 | 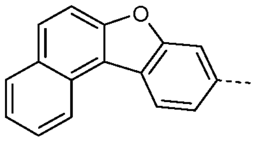 | 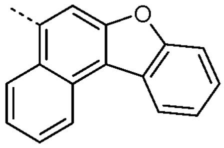 |
| R2-170 | R2-171 | R2-172 |
| 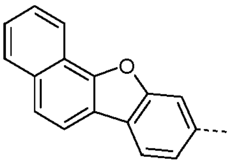 | 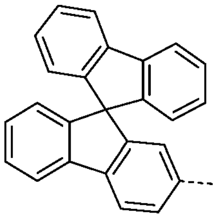 | 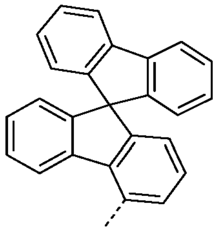 |
| R2-173 | R2-174 | R2-175 |
| 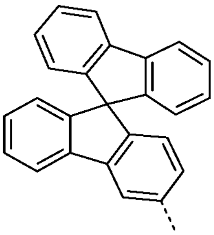 | 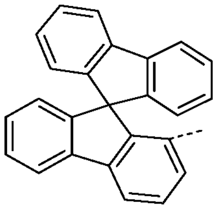 | 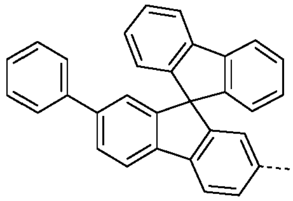 |
| R2-176 | R2-177 | R2-178 |
| 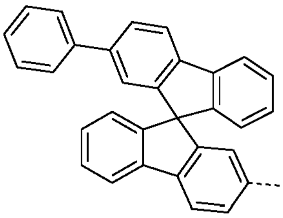 | 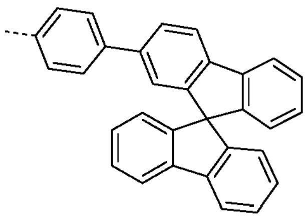 | 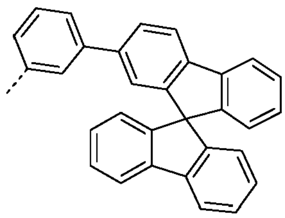 |
| R2-179 | R2-180 | R2-181 |

(fortgesetzt)

| | | |
|---|---|---|
| 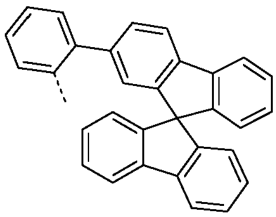 | 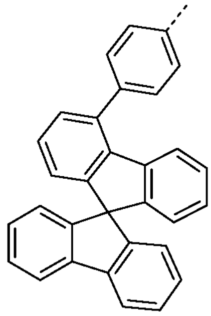 | 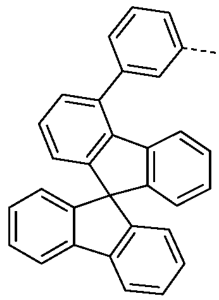 |
| R2-182 | R2-183 | R2-184 |
| 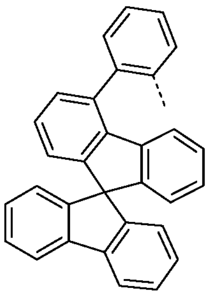 | 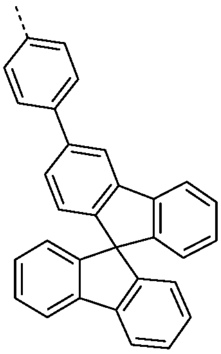 | 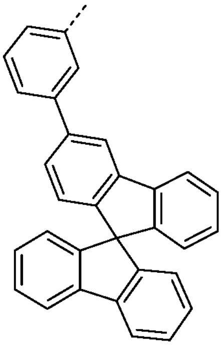 |
| R2-185 | R2-186 | R2-187 |
| 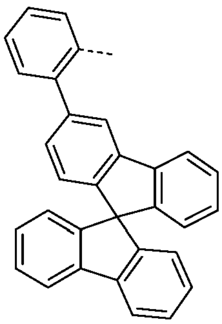 | 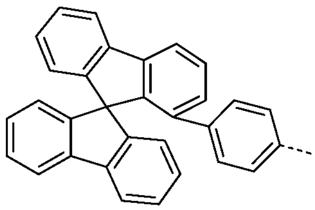 | 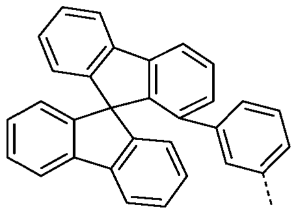 |
| R2-188 | R2-189 | R2-190 |
| 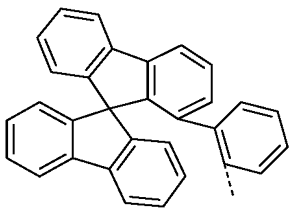 | | |
| R2-191 | | |
| 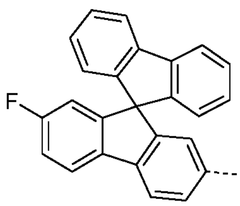 | 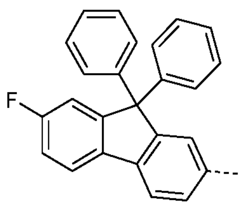 | 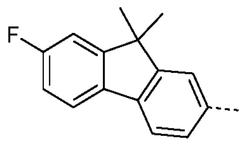 |
| R2-192 | R2-193 | R2-194 |

(fortgesetzt)

| | | |
|---|---|---|
| 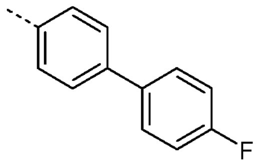 | 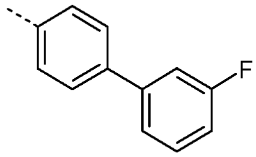 | 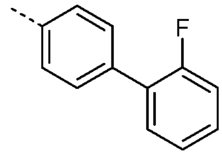 |
| R2-195 | R2-196 | R2-197 |
| 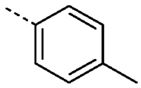 | 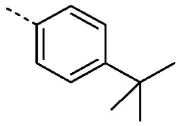 | 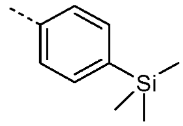 |
| R2-198 | R2-199 | R2-200 |
| 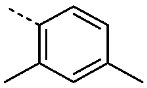 | 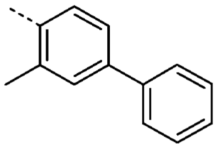 | 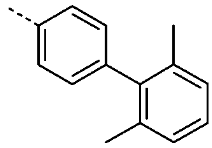 |
| R2-201 | R2-202 | R2-203 |
| 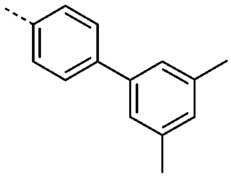 | 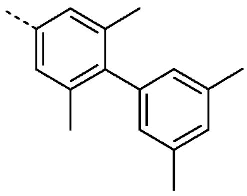 | 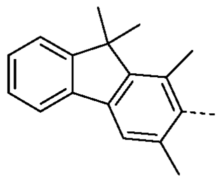 |
| R2-204 | R2-205 | R2-206 |
| 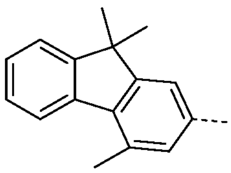 | 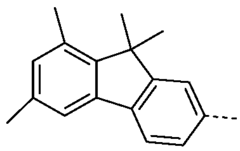 | 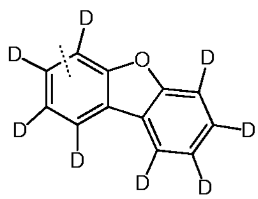 |
| R2-207 | R2-208 | R2-209 |
| 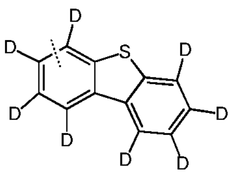 | 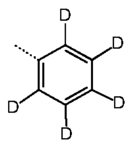 | 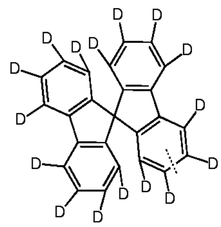 |
| R2-210 | R2-211 | R2-212 |
| 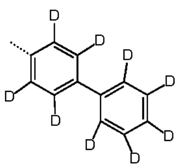 | 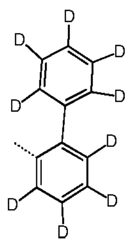 | 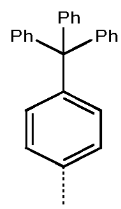 |
| R2-213 | R2-214 | R2-215 |

(fortgesetzt)

| | | |
|---|---|---|
| 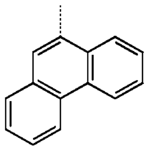 | 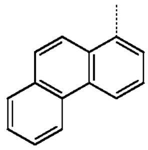 | 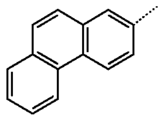 |
| R2-216 | R2-217 | R2-218 |
| 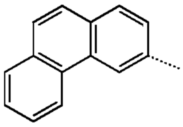 | 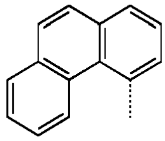 | 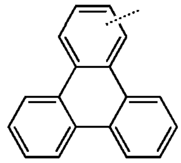 |
| R2-219 | R2-220 | R2-221, |

wobei die gestrichelte Linie die Bindung an den Rest der Formel (2) darstellt. Bevorzugt sind die Substituenten R2-1 bis R2-221 teilweise deuteriert oder vollständig deuteriert.

Steht in Verbindungen der Formel (2) x für 2 und $a_1$ für 1, 2 oder 3, so bilden die beiden Substituenten $R^2$ in einer bevorzugten Ausführungsform ein monocyclisches oder polycyclisches, aliphatisches, aromatisches oder heteroaromatisches Ringsystem, das mit einem oder mehreren Resten $R^3$ substituiert sein kann, mit der Bedingung, dass das Ringsystem und daran gebundene Substituenten keine Carbazolgruppe enthalten.

In einer bevorzugten Ausführungsform steht das Hostmaterial 2 der Formel (2) für mindestens eine Verbindung der Formel (3),

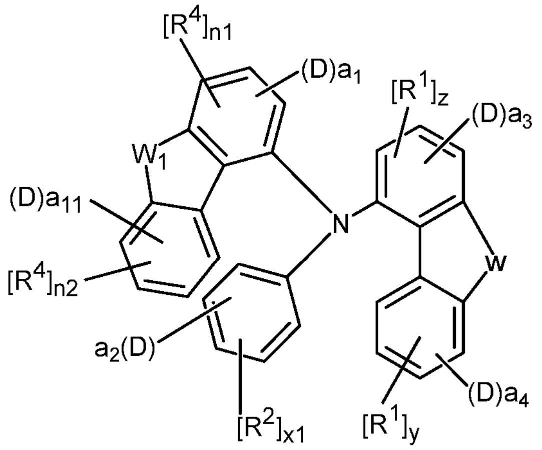

Formel (3),

wobei W, $R^1$, $R^2$, $a_1$, $a_2$, $a_3$, $a_4$, x, x1, y und z eine zuvor angegebene oder nachfolgend angegebene Bedeutung haben und für die verwendeten Symbole und Indizes gilt:

$W_1$ ist O, S oder $C(R)_2$, wobei R eine zuvor angegebene Bedeutung hat;

$R^4$ ist bei jedem Auftreten gleich oder verschieden ausgewählt aus der Gruppe bestehend aus F, Cl, Br, I, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br oder I ersetzt sein können, einem aromatischen oder heteroaromatischen Ringsystem mit 5 bis 60 aromatischen Ringatomen, das jeweils mit einem oder mehreren Resten $R^3$ substituiert sein kann, wobei optional zwei oder mehr benachbarte Substituenten $R^4$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^4$ und daran gebundene Substituenten keine Carbazolgruppe enthalten;

$a_{11}$ ist 0, 1, 2, 3 oder 4;

n1 ist 0, 1 oder 2; und
n2 ist 0, 1, 2, 3 oder 4.

In Verbindungen der Formel (3) ist $a_{11}$ bevorzugt 1, 2, 3 oder 4.

In Verbindungen der Formel (3) ist $a_1+a_2+a_3+a_4+a_{11}$ bevorzugt ausgewählt aus 3, 4, 5, 6, 7, 8, 9, 10, 11, 12, 13, 14, 15, 16, 17, 18 oder 19.

In Verbindungen der Formel (3) ist n1 bevorzugt 0 oder 1.

In Verbindungen der Formel (3) ist n2 bevorzugt 0 oder 1.

In Verbindungen der Formel (3) ist n1+n2 bevorzugt 0 oder 1.

In Verbindungen der Formel (3) ist n1+n2 bevorzugt 0.

Bei Auftreten des Substituenten $R^4$ in Verbindungen der Formel (3), wie zuvor beschrieben, oder in Verbindungen der Formeln (3a), (3b), (3c), (3d) und (3e), wie nachfolgend beschrieben, wird dieser bevorzugt ausgewählt aus der Gruppe F, einer geradkettigen oder verzweigten Alkylgruppe mit 1 bis 20 C-Atomen, die jeweils mit einem oder mehreren Resten $R^3$ substituiert sein kann, den Substituenten R2-1 bis R2-221, wie zuvor beschrieben, wobei die Substituenten R2-1 bis R-221 auch teilweise deuteriert oder vollständig deuteriert sein können, sofern nicht schon als Solches beschrieben und wobei die gestrichelte Linie die Bindung an den Rest der Formeln (3), (3a), (3b), (3c), (3d) oder (3e) darstellt oder zwei oder mehr benachbarte Substituenten $R^4$ bilden ein monocyclisches oder polycyclisches, aromatisches oder heteroaromatisches Ringsystem, das mit einem oder mehreren Resten $R^3$ substituiert sein kann, mit der Bedingung, dass $R^3$ und daran gebundene Substituenten keine Carbazolgruppe enthalten.

Bei Auftreten des Substituenten $R^4$ in Verbindungen der Formeln (3), (3a), (3b), (3c), (3d), (3e), wie zuvor oder nachfolgend beschrieben, wird dieser besonders bevorzugt ausgewählt aus der Gruppe F, einer geradkettigen oder verzweigten Alkylgruppe mit 1 bis 10 C-Atomen, die jeweils mit einem oder mehreren Resten $R^3$ substituiert sein kann oder den Substituenten R2-1 bis R2-3, R2-63 bis R2-70, R2-107 bis R2-111, R2-114 bis R2-116, R2-122, R2-129 bis R2-139 und R2-206 bis R2-215 und R2-221, wie zuvor beschrieben, die teilweise deuteriert oder vollständig deuteriert sind.

Ein weiterer Gegenstand der Erfindung ist demzufolge eine organische lumineszierende Vorrichtung, wie zuvor beschrieben oder bevorzugt beschrieben, wobei das Hostmaterial 2 mindestens einer Verbindung der Formel (3) entspricht, wie zuvor beschrieben.

In Verbindungen der Formeln (2) oder (3), wie zuvor beschrieben oder als bevorzugt beschrieben, steht W für O, S oder $C(R)_2$, wobei R jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen ist, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten. Bevorzugt steht W für O oder $C(R)_2$. Besonders bevorzugt steht W für $C(R)_2$, wobei R eine zuvor genannte oder nachfolgend bevorzugt genannte Bedeutung hat.

In Verbindungen der Formeln (2) oder (3), wie zuvor beschrieben oder als bevorzugt beschrieben, steht R bevorzugt für eine Methyl oder Phenylgruppe, die teilweise oder vollständig deuteriert sein können, oder zwei Substituenten R bilden mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten.

Bevorzugte Verbindungen der Formeln (2) oder (3) werden durch die Formeln (2a) bis (2e) und (3a) bis (3e) dargestellt,

| | |
|---|---|
| 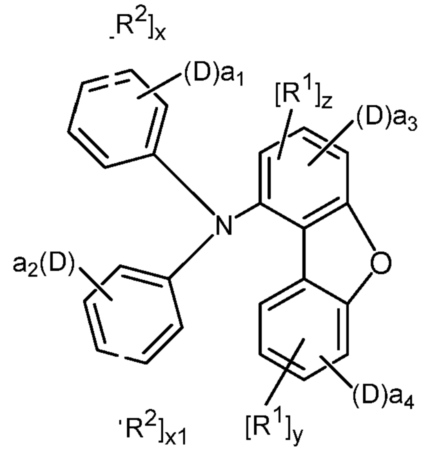 | 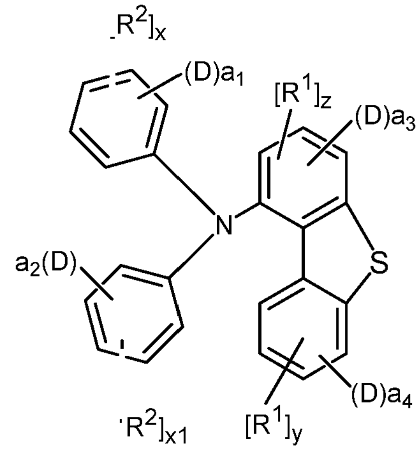 |
| Formel (2a) | Formel (2b) |
| 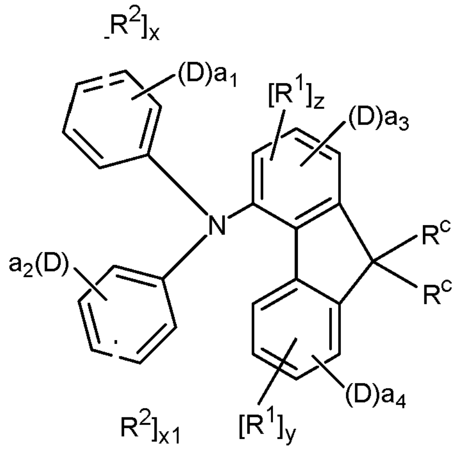 | 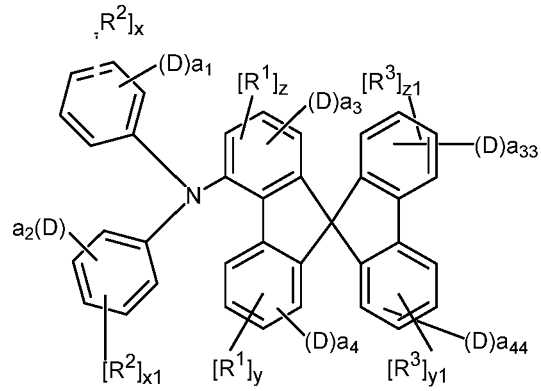 |
| Formel (2c) | Formel (2d) |
| 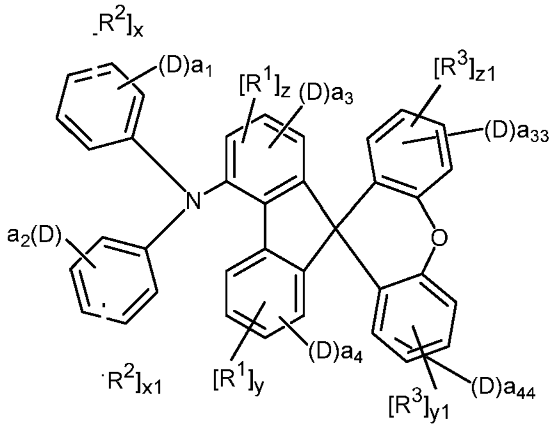 | 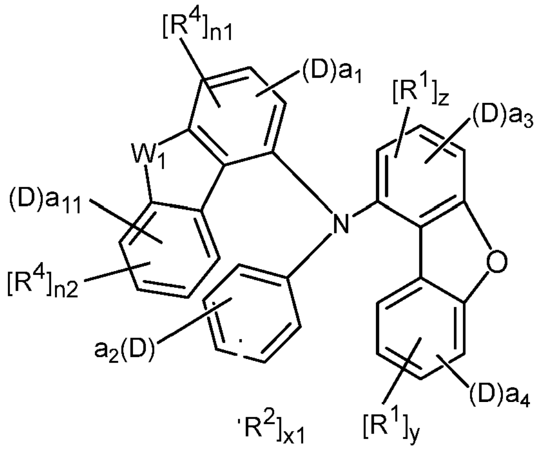 |
| Formel (2e) | Formel (3a) |

(fortgesetzt)

| 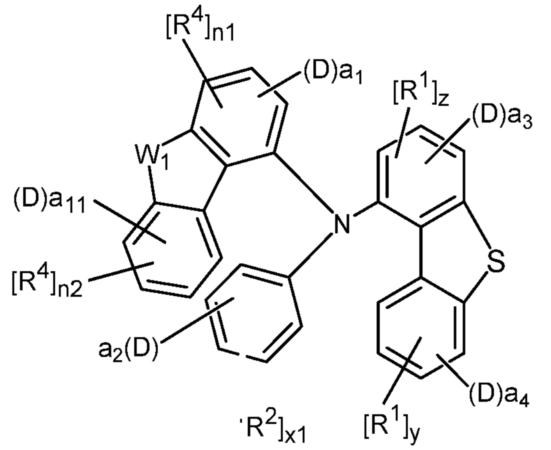 | 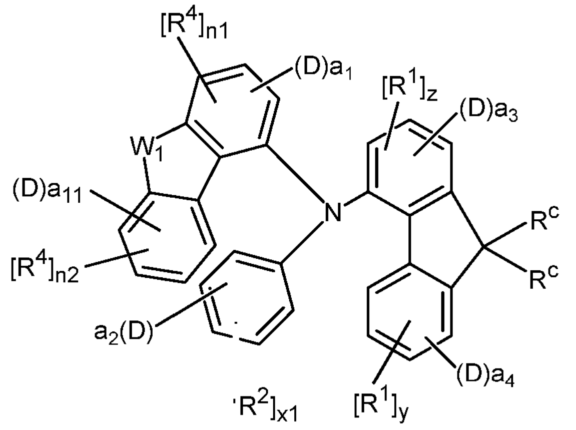 |
|---|---|
| Formel (3b) | Formel (3c) |
| 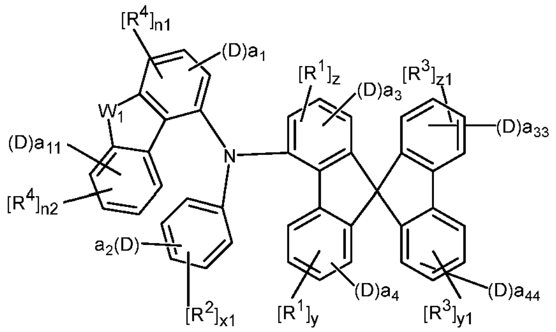 | 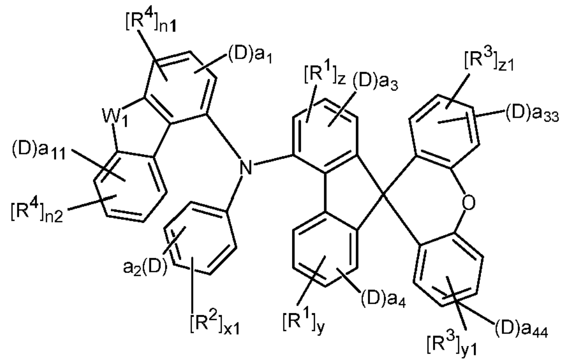 |
| Formel (3d) | Formel (3e), |

wobei $a_1$, $a_2$, $a_3$, $a_4$, $a_{11}$, $R^2$, x, x1, y, z, $R^1$, $R^3$, $R^4$ und $W_1$ eine zuvor genannte oder zuvor oder nachfolgend bevorzugt genannte Bedeutung haben und

$R^c$ jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen ist;

y1, z1 sind jeweils unabhängig voneinander 0, 1 oder 2; und

$a_{33}$, $a_{44}$ sind jeweils unabhängig voneinander 0, 1, 2, 3 oder 4, mit der Bedingung, dass $R^3$ und daran gebundene Substituenten keine Carbazolgruppe enthalten.

In Verbindungen der Formeln (2c) und (3c), wie zuvor beschrieben, oder in Verbindungen der Formeln (3h), (3l), (3n), (3o), (4) und (5), wie nachfolgend beschrieben, ist $R^c$ bevorzugt gleich und eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes Phenyl. In Verbindungen der Formeln (2c) und (3c), wie zuvor beschrieben, oder in Verbindungen der Formeln (3h), (3l), (3n), (3o), (4) und (5), wie nachfolgend beschrieben, ist $R^c$ bevorzugt gleich und jeweils $CD_3$.

In Verbindungen der Formeln (2d) und (2e) ist $a_{33}$ bevorzugt 1, 2, 3 oder 4. In Verbindungen der Formeln (2d) und (2e) ist $a_{44}$ bevorzugt 1, 2, 3 oder 4. In Verbindungen der Formeln (2d) und (2e) sind y1 und z1 bevorzugt 0.

In Verbindungen der Formel (2d) und (2e) ist $a_1+a_2+a_3+a_4+a_{33}+a_{44}$ bevorzugt ausgewählt aus 3, 4, 5, 6, 7, 8, 9, 10, 11, 12, 13, 14, 15, 16, 17, 18, 19, 20, 21, 22, 23, 24 oder 25.

In Verbindungen der Formeln (3a), (3b), (3c), (3d) und (3e) und den nachfolgend genannten Verbindungen der Formeln ((3f), (3g), (3h), (3i), (3j), (3k), (3l), (3m), (3n), (3o), (4), (5), (6), (7), (8) und (9), ist $a_{11}$ bevorzugt 1, 2, 3 oder 4.

In Verbindungen der Formel (3d) und (3e) und den nachfolgend genannten Verbindungen der Formeln (6), (7), (8) und (9) ist $a_{33}$ bevorzugt 1, 2, 3 oder 4. In Verbindungen der Formel (3d) und (3e) und den nachfolgend genannten Verbindungen der Formeln (6), (7), (8) und (9) ist $a_{44}$ bevorzugt 1, 2, 3 oder 4. In Verbindungen der Formel (3d) und (3f) sind y1 und z1 bevorzugt 0.

In Verbindungen der Formeln (3a), (3b) und (3c) ist $a_1+a_2+a_3+a_4+a_{11}$ bevorzugt ausgewählt aus 3, 4, 5, 6, 7, 8, 9, 10, 11, 12, 13, 14, 15, 16, 17, 18 oder 19. In Verbindungen der Formel (3d) und (3e) ist $a_1+a_2+a_3+a_4+a_{11}+a_{33}+a_{44}$ bevorzugt ausgewählt aus 3, 4, 5, 6, 7, 8, 9, 10, 11, 12, 13, 14, 15, 16, 17, 18, 19, 20, 21, 22, 23, 24, 25, 26 oder 27.

Bei Auftreten des Substituenten $R^3$ in Verbindungen der Formeln (2d), (2e), (3d) und (3e), wie zuvor beschrieben, oder in Verbindungen der Formeln (3i), (3m), (5), (6), (7), (8) und (9), wie nachfolgend beschrieben, wird dieser bevorzugt ausgewählt aus der Gruppe F, einer geradkettigen oder verzweigten Alkylgruppe mit 1 bis 20 C-Atomen, in dem ein oder mehrere H-Atome durch D, F, Cl, Br, I oder CN ersetzt sein kann/können oder den Substituenten R2-1 bis R2-221, wie zuvor beschrieben, wobei die Substituenten R2-1 bis R-221 auch teilweise deuteriert oder vollständig deuteriert sein können, sofern nicht schon als Solches beschrieben und wobei die gestrichelte Linie die Bindung an den Rest der Formeln (2d), (2e), (3d), (3e), (3i), (3m), (5), (6), (7), (8) und (9) darstellt.

Bei Auftreten des Substituenten $R^3$ in Verbindungen der Formeln (2d), (2e), (3d) und (3e), wie zuvor beschrieben, oder in Verbindungen der Formeln (3i), (3m), (5), (6), (7), (8) und (9), wie nachfolgend beschrieben wird dieser besonders bevorzugt ausgewählt aus der Gruppe F, einer geradkettigen oder verzweigten Alkylgruppe mit 1 bis 10 C-Atomen, in dem ein oder mehrere H-Atome durch D ersetzt ist/sind oder den Substituenten R2-1 bis R2-3, R2-63 bis R2-70, R2-107 bis R2-111, R2-114 bis R2-116, R2-122, R2-129 bis R2-139 und R2-206 bis R2-215 und R2-221, wie zuvor beschrieben, die teilweise deuteriert oder vollständig deuteriert sind, sofern nicht schon als Solches beschrieben.

In einer bevorzugten Ausführungsform der Verbindungen der Formeln (3), (3a), (3b), (3c), (3d) und (3e), wie zuvor beschrieben oder als bevorzugt beschrieben, steht $W_1$ für O, S oder $C(R)_2$, wobei R jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen ist, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten. Bevorzugt steht $W_1$ für O oder $C(R)_2$. Besonders bevorzugt steht $W_1$ für $C(R)_2$, wobei R eine zuvor genannte oder zuvor bevorzugt genannte Bedeutung hat.

Bevorzugte Verbindungen der Formeln (3), (3a), (3b), (3c) und (3d), werden durch die Formeln (3f), (3g), (3h), (3i), (3j), (3k), (3l), (3m), (3n), (3o), (4), (5), (6), (7), (8) und (9) dargestellt,

| | |
|---|---|
| 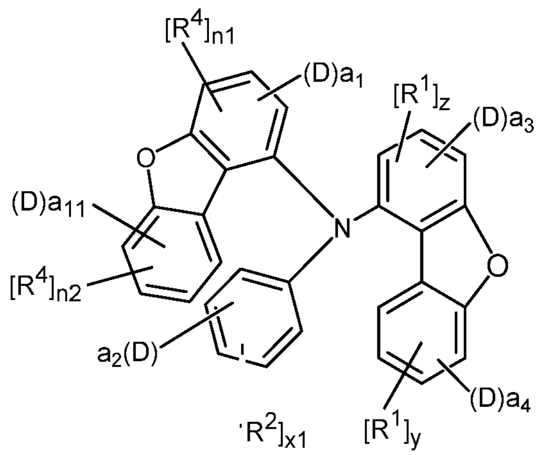 | 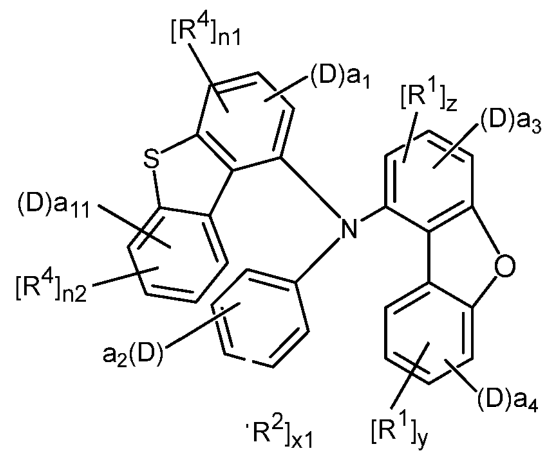 |
| Formel (3f) | Formel (3g) |

(fortgesetzt)

| | |
|---|---|
| 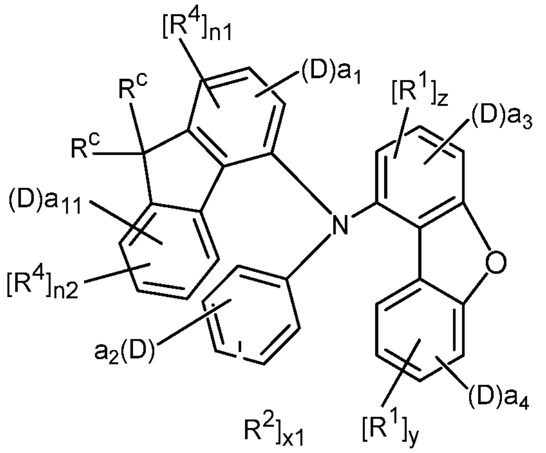 | 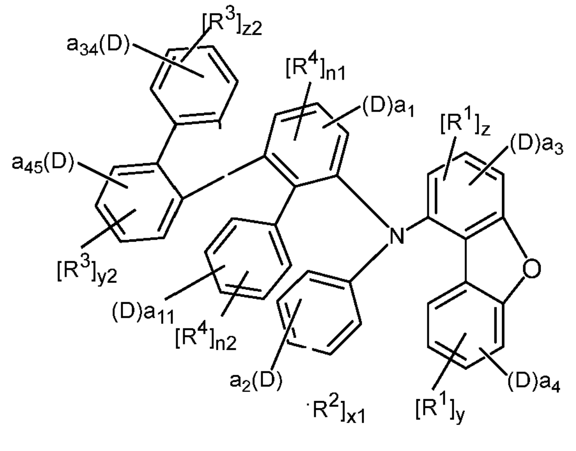 |
| Formel (3h) | Formel (3i) |
| 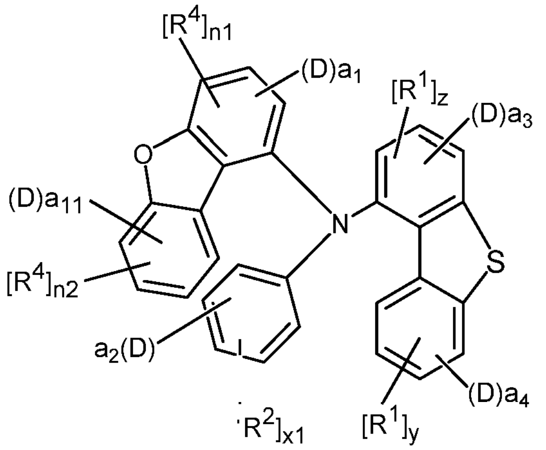 | 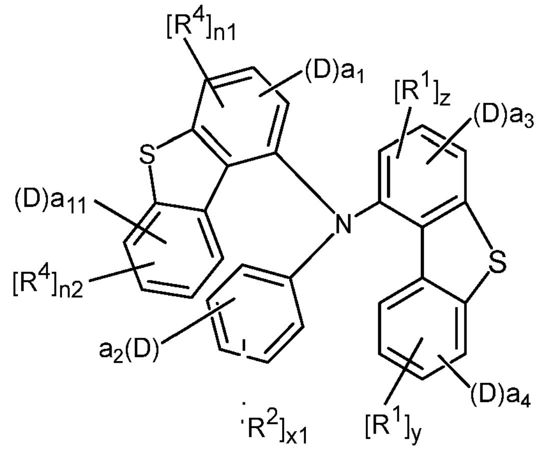 |
| Formel (3j) | Formel (3k) |
| 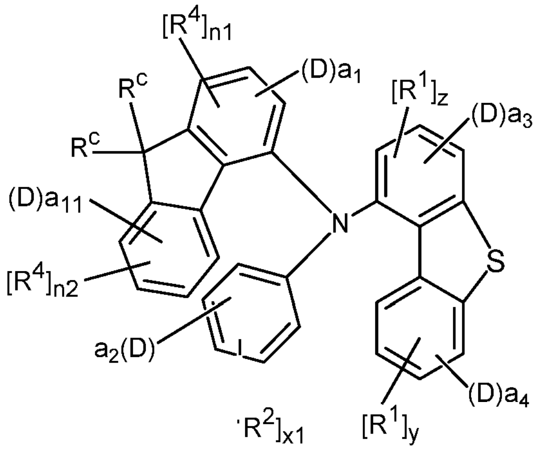 | 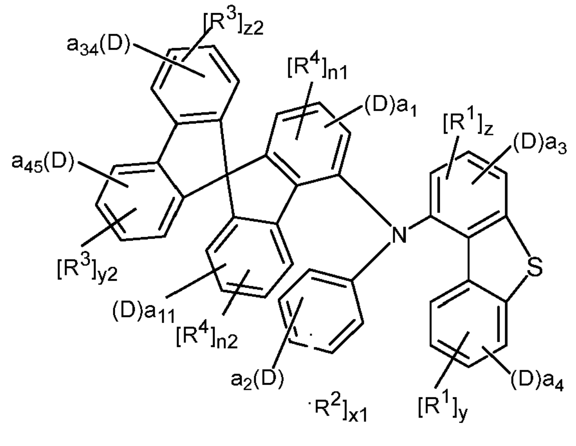 |
| Formel (3l) | Formel (3m) |

(fortgesetzt)

| | |
|---|---|
| 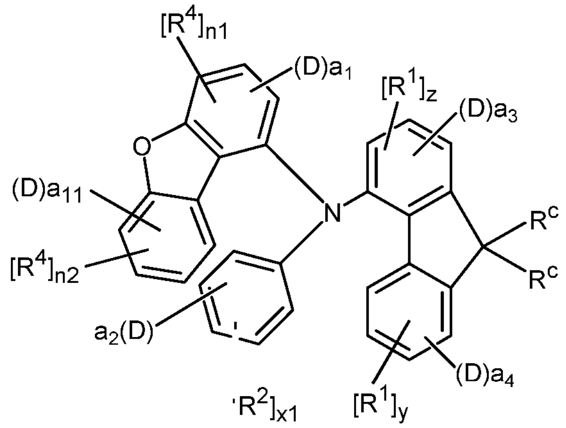 | 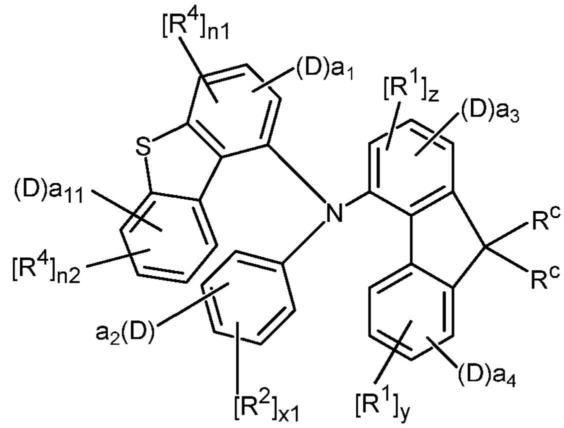 |
| Formel (3n) | Formel (3o) |
| 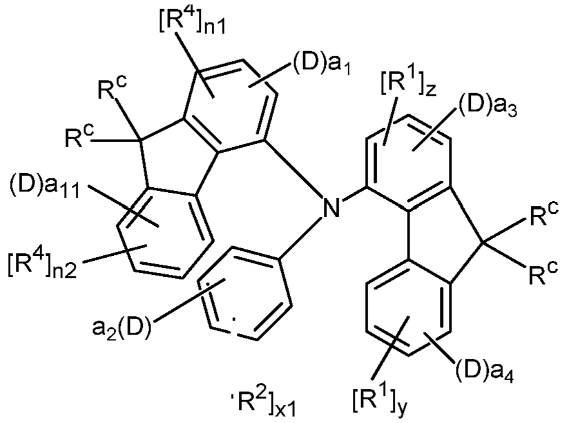 | 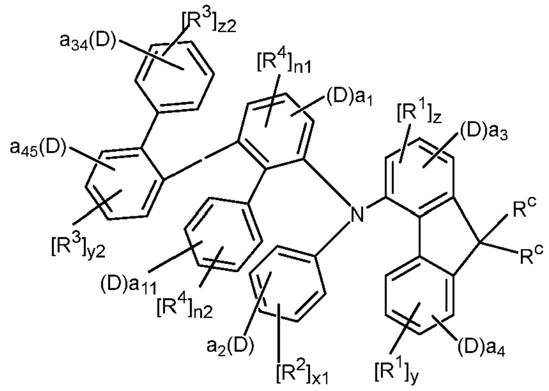 |
| Formel (4) | Formel (5) |
| 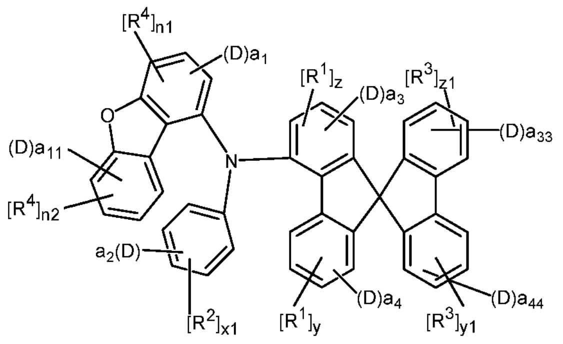 | 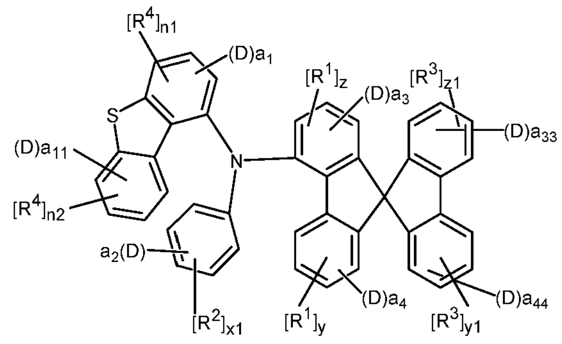 |
| Formel (6) | Formel (7) |
| 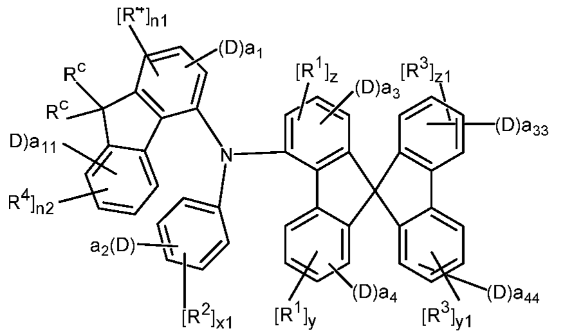 | 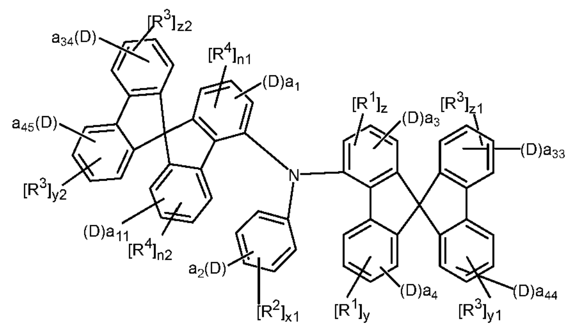 |
| Formel (8) | Formel (9), |

wobei $a_1$, $a_2$, $a_3$, $a_4$, $a_{11}$, $a_{33}$, $a_{44}$, $R^2$, x, x1, y, y1, z, z1, $R^1$, $R^3$, $R^c$ und $R^4$ eine zuvor genannte oder zuvor oder nachfolgend bevorzugt genannte Bedeutung haben und

y2, z2 sind jeweils unabhängig voneinander 0, 1 oder 2; und

$a_{34}$, $a_{45}$ sind jeweils unabhängig voneinander 0, 1, 2, 3 oder 4.

In Verbindungen der Formeln (3f), (3g), (3h), (3j), (3k), (3l), (3n), (3o) und (4) ist

$a_1+a_2+a_3+a_4+a_{11}$ bevorzugt ausgewählt aus 3, 4, 5, 6, 7, 8, 9, 10, 11, 12, 13, 14, 15, 16, 17, 18 oder 19. In Verbindungen der Formeln (6), (7) und (8) ist

$a_1+a_2+a_3+a_4+a_{11}+a_{33}+a_{44}$ bevorzugt ausgewählt aus 3, 4, 5, 6, 7, 8, 9, 10, 11, 12, 13, 14, 15, 16, 17, 18, 19, 20, 21, 22, 23, 24, 25, 26 oder 27.

In Verbindungen der Formeln (3i), (3m) und (5) ist $a_1+a_2+a_3+a_4+a_{11}+a_{34}+a_{45}$ bevorzugt ausgewählt aus 3, 4, 5, 6, 7, 8, 9, 10, 11, 12, 13, 14, 15, 16, 17, 18, 19, 20, 21, 22, 23, 24, 25, 26 oder 27.

In Verbindungen der Formeln (9) ist $a_1+a_2+a_3+a_4+a_{11}+a_{33}+a_{44}+a_{34}+a_{45}$ bevorzugt ausgewählt aus 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34 oder 35.

In Verbindungen der Formeln (3i), (3m), (5) und (9) sind y2 und z2 bevorzugt 0.

In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist y bevorzugt 0 oder 1. In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist z bevorzugt 0 oder 1. In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist y+z bevorzugt 0 oder 1. In einer bevorzugten Ausführungsform der Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), ist y+z bevorzugt 0.

Bei Auftreten des Substituenten $R^1$ in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser bevorzugt ausgewählt aus der Gruppe F, einer geradkettigen, verzweigten oder cyclischen Alkylgruppe mit 1 bis 20 C-Atomen, in dem ein oder mehrere H-Atome durch D, F, Cl, Br, I oder CN ersetzt sein kann/können.

Bei Auftreten des Substituenten $R^1$ in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser besonders bevorzugt ausgewählt aus der Gruppe F, einer geradkettigen oder verzweigten Alkylgruppe mit 1 bis 10 C-Atomen, in dem ein oder mehrere H-Atome durch D ersetzt sein kann/können.

Bei Auftreten des Substituenten $R^1$ in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser ganz besonders bevorzugt ausgewählt aus der Gruppe einer geradkettigen oder verzweigten Alkylgruppe mit 1 bis 10 C-Atomen, in dem ein oder mehrere H-Atome durch D ersetzt ist/sind.

Besonders bevorzugt werden Verbindungen der Formeln (4), (5), (6), (7), (8) oder (9) als Hostmaterial 2 in der erfindungsgemäßen Vorrichtung verwendet, wobei die genannten Symbole und Indizes eine zuvor genannte oder jeweils zuvor bevorzugt genannte oder eine jeweils nachfolgend bevorzugt genannte Bedeutung haben.

Ganz besonders bevorzugt werden Verbindungen der Formeln (5), (8) oder (9) als Hostmaterial 2 in der erfindungsgemäßen Vorrichtung verwendet, wobei die genannten Symbole und Indizes eine zuvor genannte oder jeweils zuvor bevorzugt genannte oder eine jeweils nachfolgend bevorzugt genannte Bedeutung haben.

Ein weiterer Gegenstand der Erfindung ist demzufolge eine organische elektrolumineszierende Vorrichtung, wie zuvor beschrieben oder bevorzugt beschrieben, wobei die mindestens eine Verbindung der Formel (2) einer Verbindung der Formeln (5), (8) oder (9) entspricht.

In Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) steht x1 bevorzugt für 1 oder 2, wobei $R^2$ bei jedem Auftreten gleich oder verschieden bevorzugt ausgewählt wird aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C{=}^CR^3$, C=C, $Si(R^3)_2$, $Ge(R^3)_2$, $Sn(R^3)_2$, C=O, C=S, C=Se, $C{=}NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten.

Steht in Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) x1 für 1 und $a_1$ für 1, 2, 3 oder 4, so wird der Substituent $R^2$ bevorzugt aus der Gruppe der Substituenten R2-1 bis R2-221 ausgewählt, wobei die Substituenten R2-1 bis R-221 in diesem Fall mit einem oder mehreren Resten $R^5$ substituiert sein kann/können, in dem ein oder mehrere H-Atome oder D-Atome durch $R^5$ ersetzt würde(n), wobei $R^5$ bei jedem Auftreten gleich oder verschieden ausgewählt ist aus der Gruppe bestehend aus F, CN, $N(Ar_1)_2$, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^5$ miteinander ein mono- oder polycyclisches, aliphatisches, aromatisches oder heteroaromatisches Ringsystem bilden, mit der Bedingung, dass das Ringsystem und daran gebundene Substituenten keine Carbazolgruppe enthalten.

Bei Auftreten des Substituenten $R^5$ in Substituenten R2-1 bis R2-221 von Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird dieser bevorzugt ausgewählt aus der Gruppe F, $N(Ar_1)_2$, einer geradkettigen oder verzweigten Alkylgruppe mit 1 bis 10 C-Atomen, in dem ein oder mehrere H-Atome durch D ersetzt sein kann/können oder einem aromatischen oder heteroaromatischen Ringsystem mit 5 bis 18 aromatischen Ringatomen, in dem ein oder mehrere H-Atome durch D ersetzt sein können, wobei $Ar_1$ eine zuvor angegebene Bedeutung hat, mit der Bedingung, dass das Ringsystem und daran gebundene Substituenten keine Carbazolgruppe enthalten oder zwei oder mehr benachbarte Substituenten $R^5$ bilden miteinander ein mono- oder polycyclisches, aliphatisches, aromatisches oder heteroaromatisches Ringsystem, mit der Bedingung, dass das Ringsystem und daran gebundene Substituenten keine Carbazolgruppe enthalten.

Bei Auftreten des Substituenten $N(Ar_1)_2$ wird $Ar_1$ jeweils unabhängig voneinander bevorzugt ausgewählt aus der Gruppe R2-1 bis R2-221, wie zuvor beschrieben, die teilweise deuteriert oder vollständig deuteriert sein können und mit der Bedingung, dass das Ringsystem und daran gebundene Substituenten keine Carbazolgruppe enthalten, wobei die gestrichelte Linie an das N-Atom bindet.

In einer bevorzugten Ausführungsform des Hostmaterials 2, repräsentiert durch die Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9), wie zuvor beschrieben, wird der N-gebundene Substituent der Teilformel (2-0),

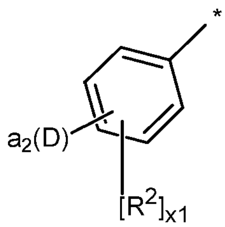

Formel (2-0)

,

aus der Gruppe der Substituenten R2-1 bis R2-221 ausgewählt, wobei mindestens ein H-Atom der Substituenten R2-1 bis R2-221 durch D ersetzt ist, wobei die Substituenten R2-1 bis R-221 in diesem Fall mit einem oder mehreren Resten $R^5$ substituiert sein kann/können, in dem ein oder mehrere H-Atome oder D-Atome, jedoch nicht das mindestens eine D-Atom, durch $R^5$ ersetzt würde(n), wobei $R^5$ eine zuvor genannte oder bevorzugt genannte Bedeutung hat, mit der Bedingung, dass das Ringsystem und daran gebundene Substituenten keine Carbazolgruppe enthalten und * die Anbindung an den Rest der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) bedeutet.

In dieser Ausführungsform ist es bevorzugt, wenn der N-gebundene Substituent der Teilformel (2-0) aus der Gruppe der Substituenten R2-2 bis R2-47, R2-63 bis R2-98, R2-107 bis R2-139, R2-174 bis R2-197, R2-206 bis R2-214 und R2-221 ausgewählt wird, wobei mindestens ein H-Atom durch D ersetzt ist, d.h. die Substituenten teilweise deuteriert oder vollständig deuteriert sind, wobei die genannten Substituenten in diesem Fall mit einem oder mehreren Resten $R^5$ substituiert sein kann/können, in dem ein oder mehrere H-Atome oder D-Atome, jedoch nicht das mindestens eine D-Atom, durch $R^5$ ersetzt würde(n), wobei $R^5$ eine zuvor genannte oder bevorzugt genannte Bedeutung hat, mit der Bedingung, dass das Ringsystem und daran gebundene Substituenten keine Carbazolgruppe enthalten und die gestrichelte Linie die Anbindung an den Rest der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) bedeutet.

In dieser Ausführungsform ist es besonders bevorzugt, wenn der N-gebundene Substituent der Teilformel (2-0) aus der Gruppe der Substituenten R2-174 bis R2-197 und R2-212 ausgewählt wird, wobei mindestens ein H-Atom durch D

ersetzt ist, d.h. die Substituenten teilweise deuteriert oder vollständig deuteriert sind, wobei die Substituenten R2-174 bis R-297 und R2-212 in diesem Fall mit einem oder mehreren Resten $R^5$ substituiert sein kann/können, in dem ein oder mehrere H-Atome oder D-Atome, jedoch nicht das mindestens eine D-Atom, durch $R^5$ ersetzt würde(n), wobei $R^5$ eine zuvor genannte oder bevorzugt genannte Bedeutung hat, mit der Bedingung, dass das Ringsystem und daran gebundene Substituenten keine Carbazolgruppe enthalten und die gestrichelte Linie die Anbindung an den Rest der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) und (9) bedeutet. Bevorzugt sind die Substituenten R2-1 bis R2-221 als Teilformel (2-0) teilweise deuteriert oder vollständig deuteriert.

Beispiele für geeignete Hostmaterialien der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9), die erfindungsgemäß ausgewählt werden, und bevorzugt in Kombination mit mindestens einer Verbindung der Formel (1) in der erfindungsgemäßen elektrolumineszierenden Vorrichtung verwendet werden, sind die nachstehend genannten Strukturen der Tabelle 3:

Tabelle 3:

| | | |
|---|---|---|
| 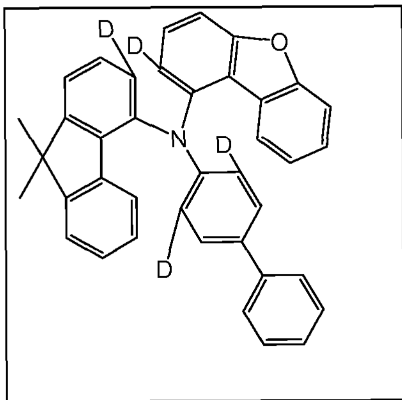 | 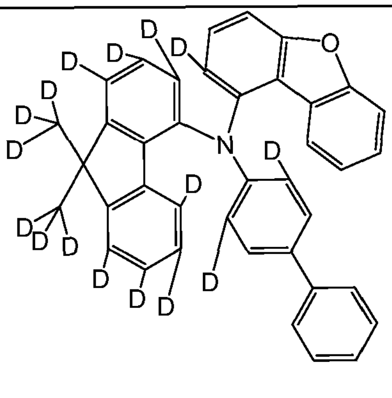 | 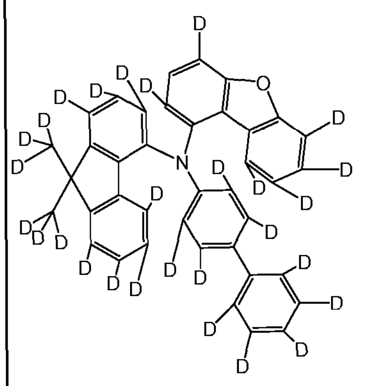 |
| 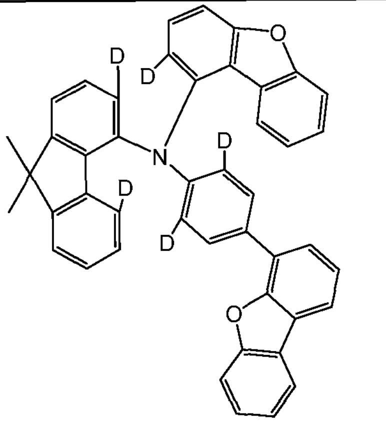 | 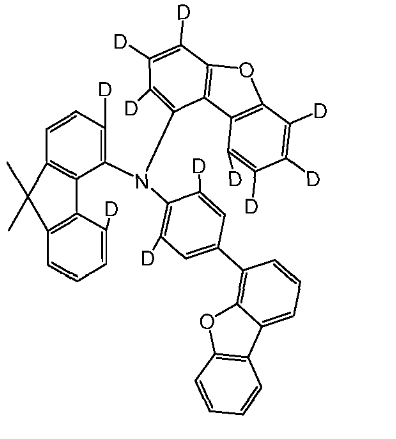 | 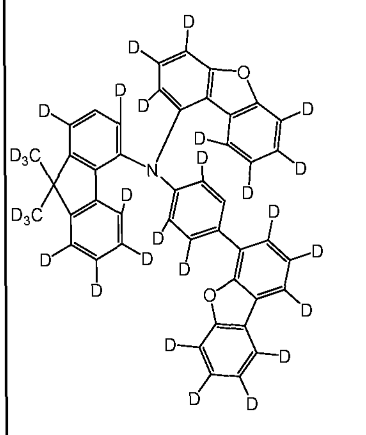 |
| 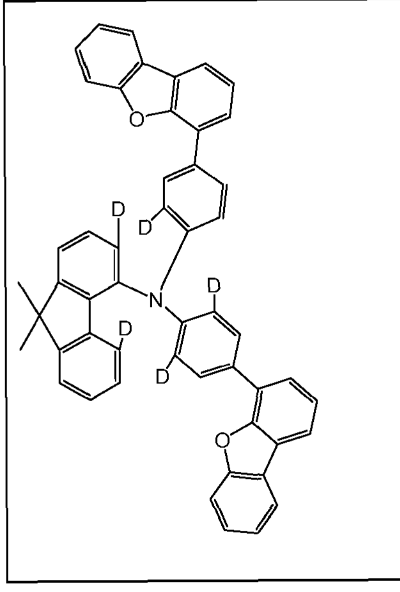 | 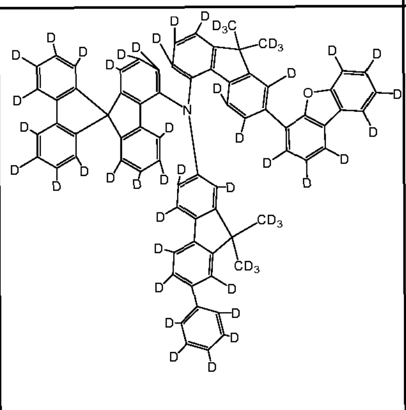 | 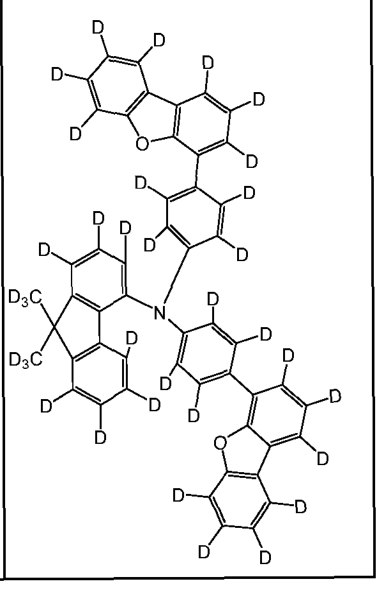 |

| | | |
|---|---|---|
| 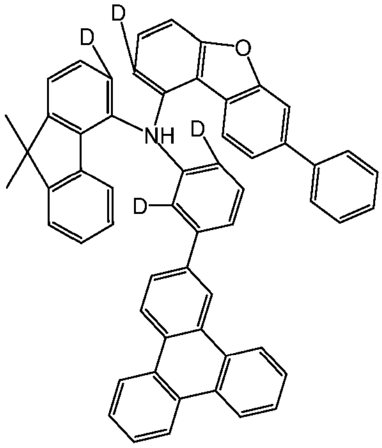 | 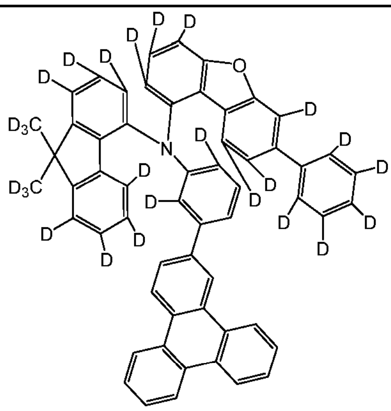 | 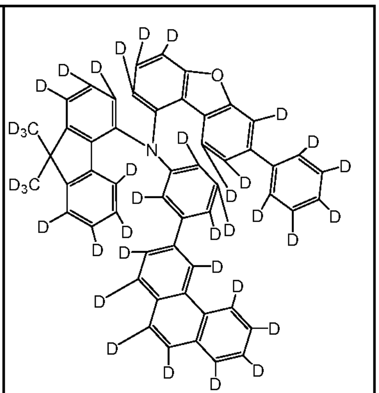 |
| 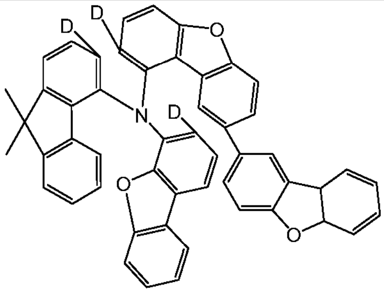 | 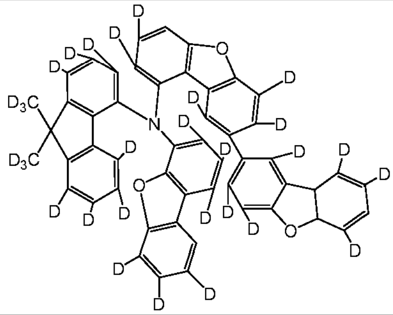 | 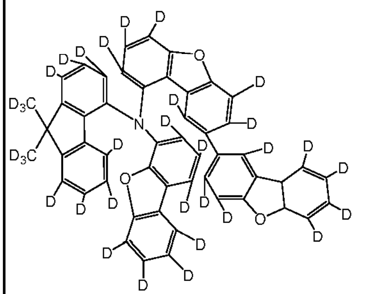 |
| 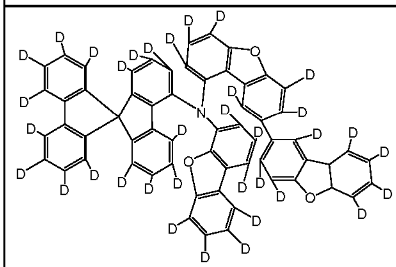 | 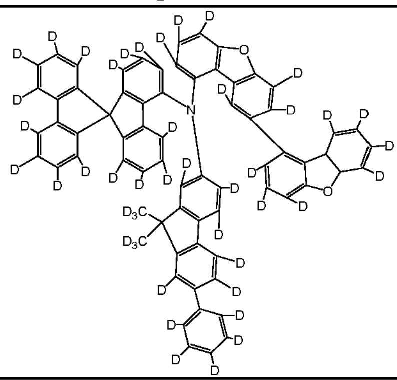 | 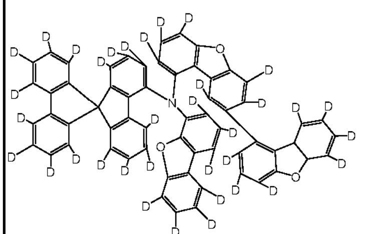 |
| 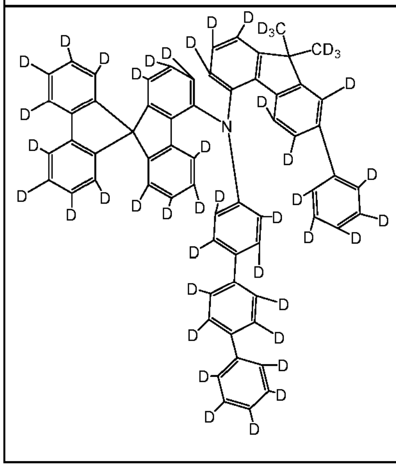 | 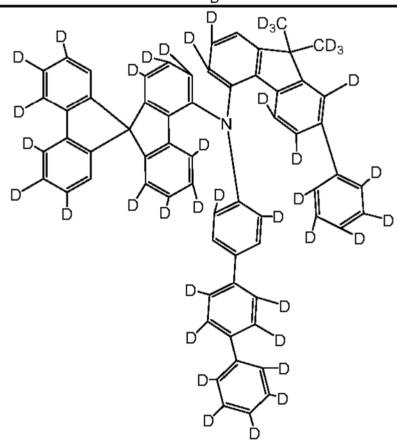 | 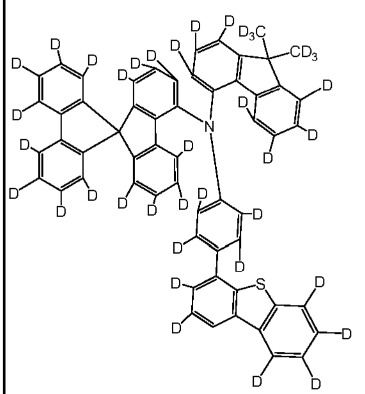 |

| | | |
|---|---|---|
| 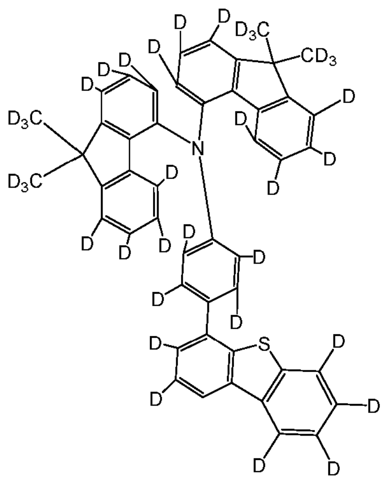 | 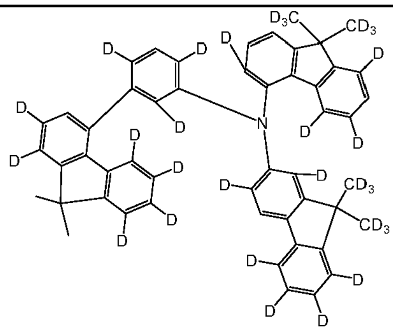 | 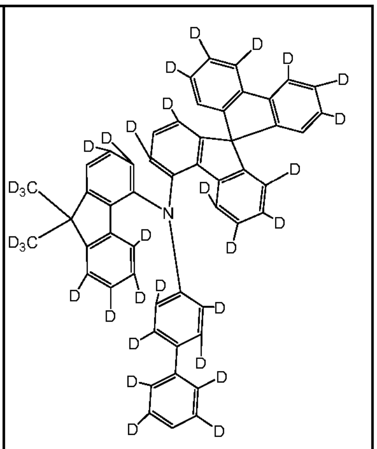 |
| 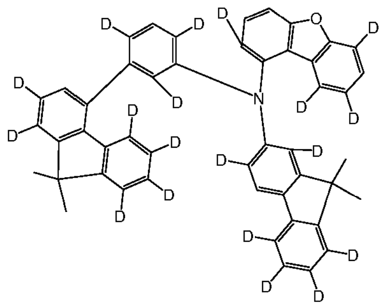 | 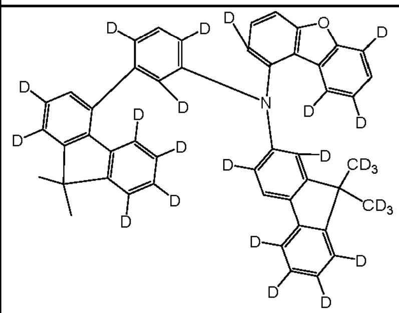 | 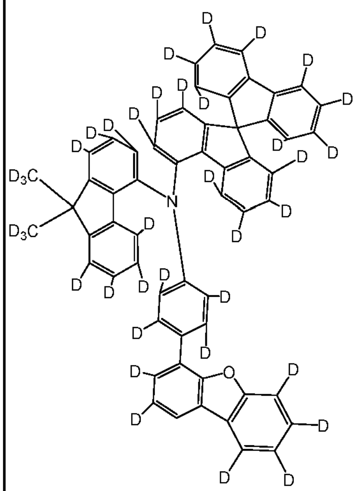 |
| 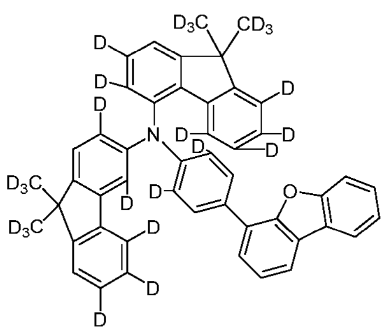 | 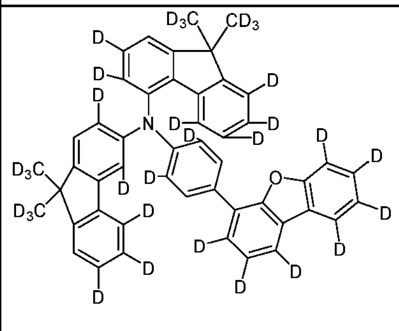 | 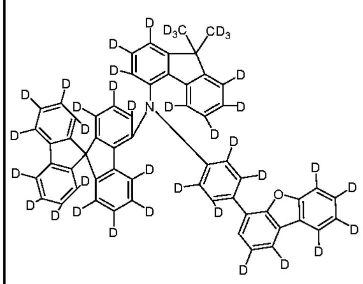 |
| 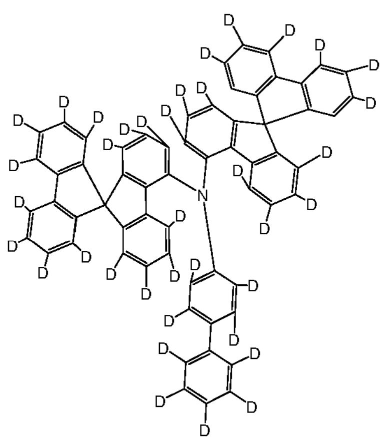 | 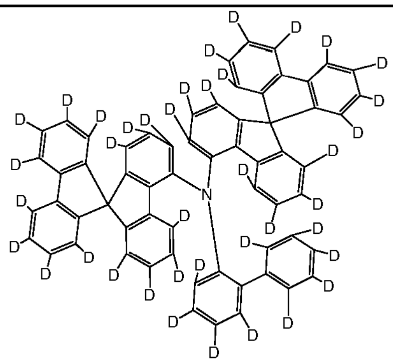 | 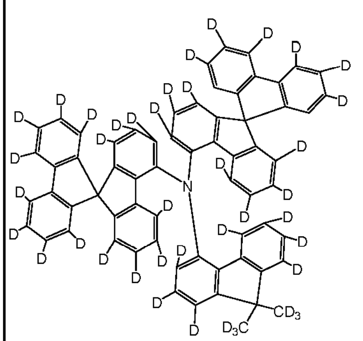 |

| | | |
|---|---|---|
| 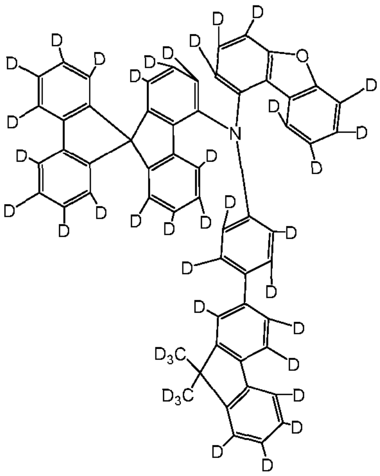 | 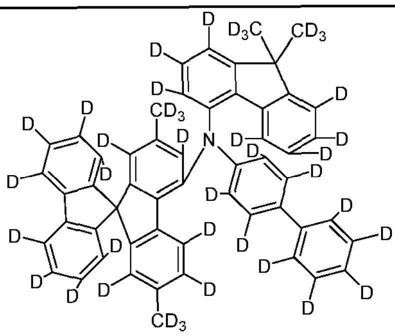 | 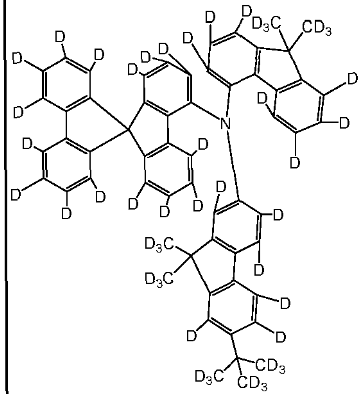 |
| 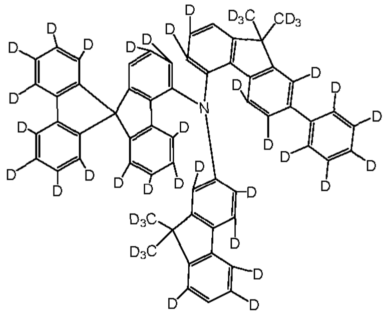 | 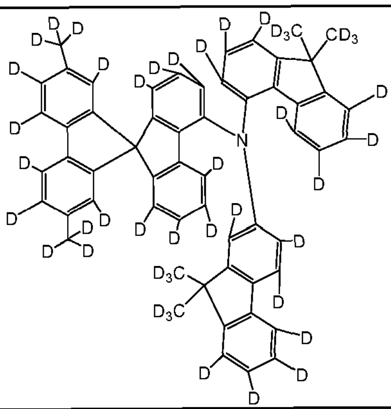 | 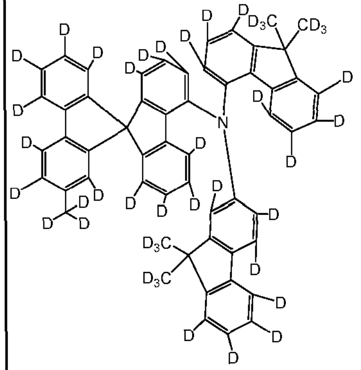 |
| 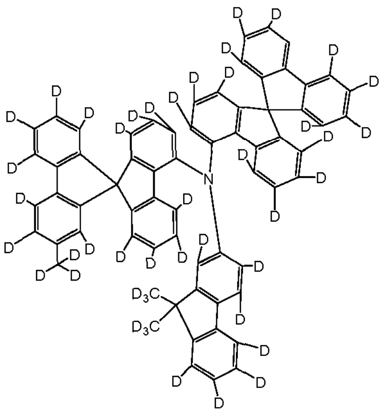 | 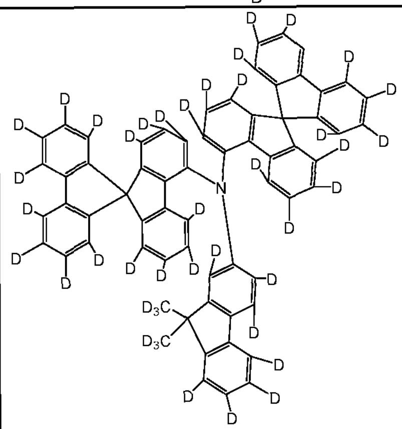 | 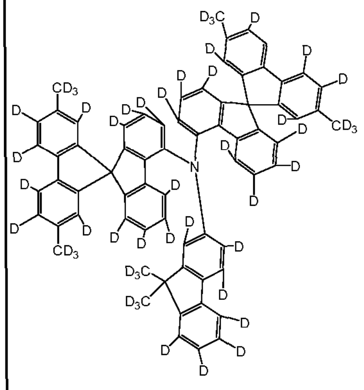 |
| 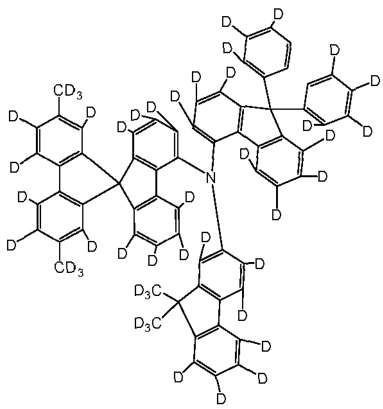 | 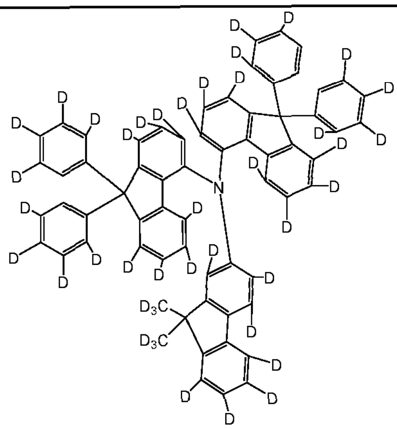 | 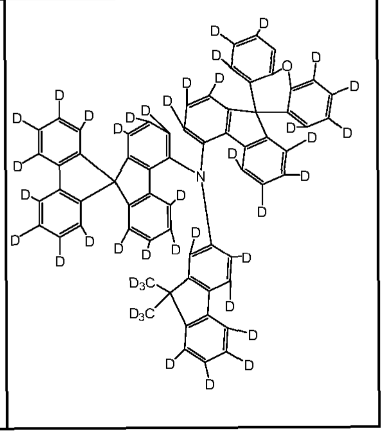 |

| | | |
|---|---|---|
| 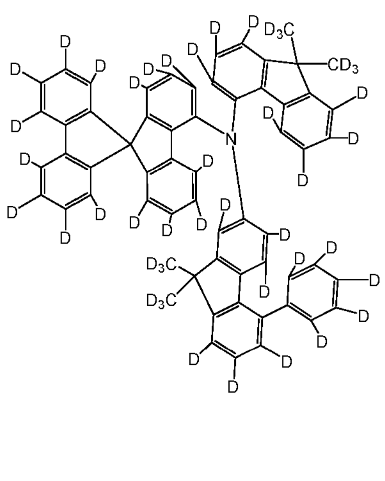 | 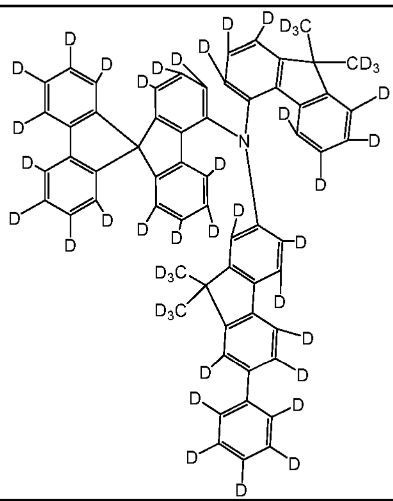 | 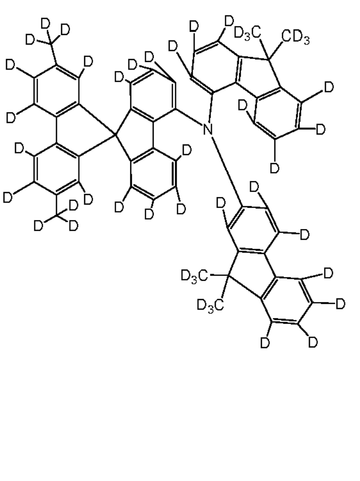 |
| 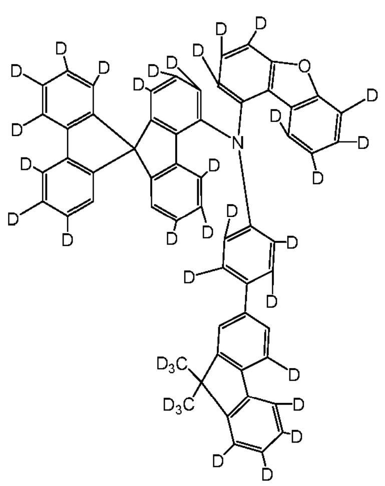 | 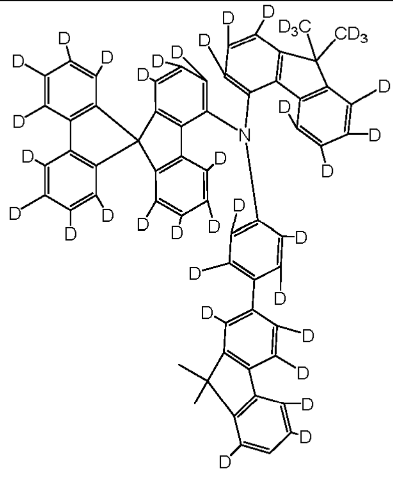 | 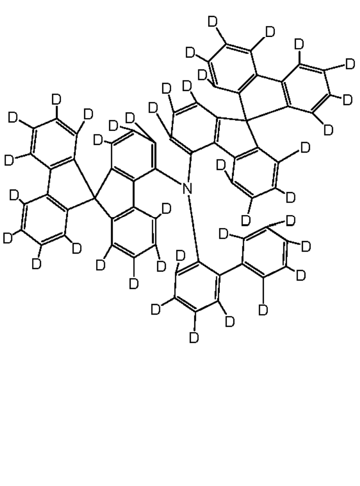 |
| 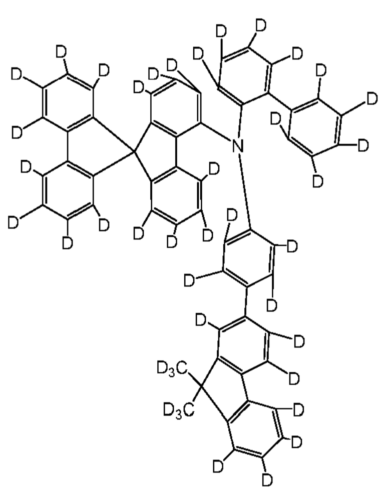 | 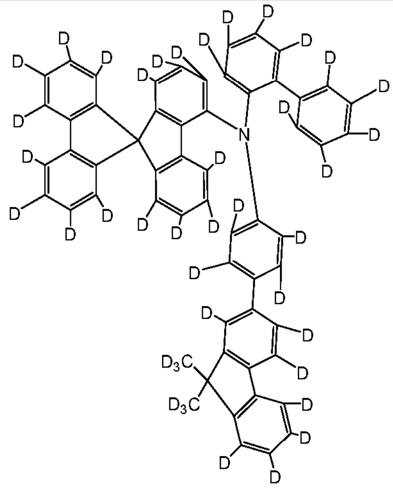 | 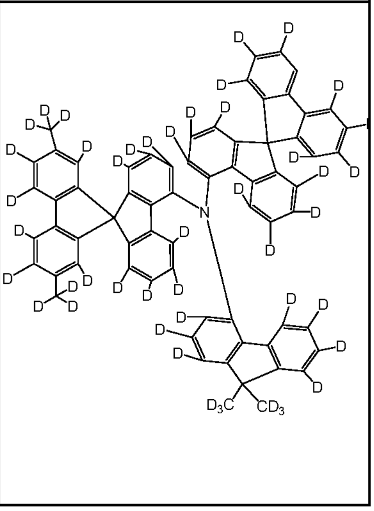 |

| | | |
|---|---|---|
| 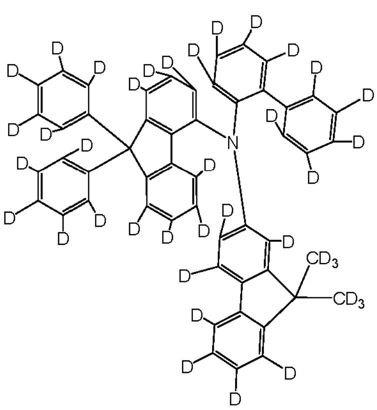 | 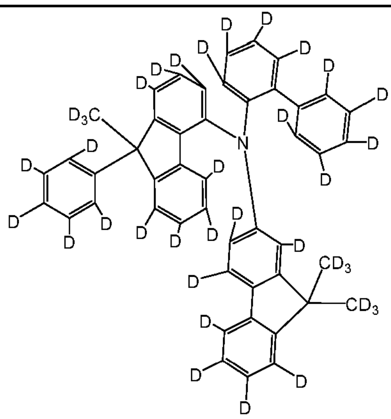 | 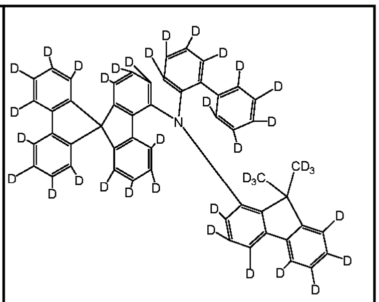 |
| 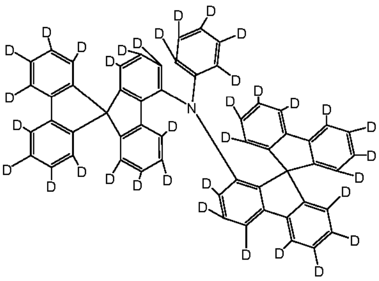 | 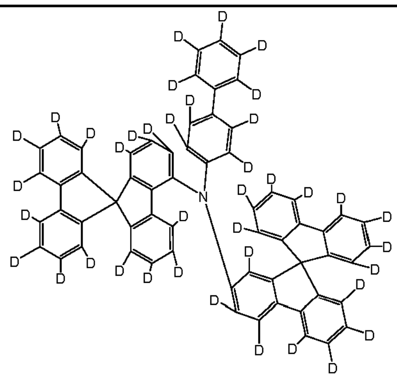 | 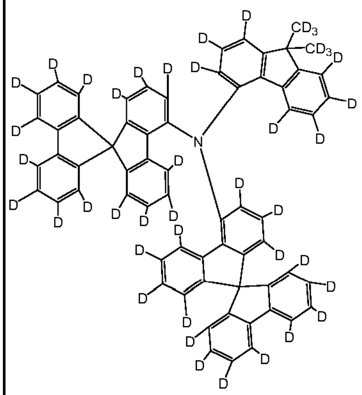 |
| 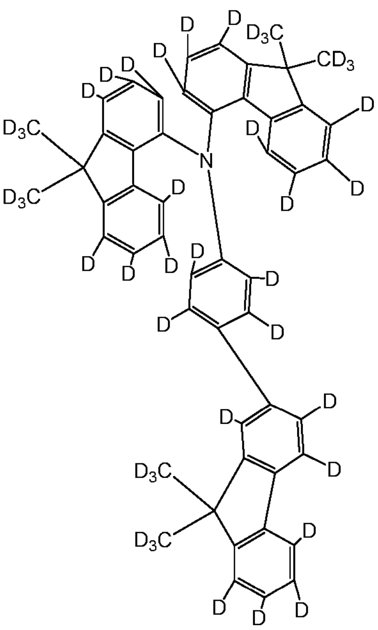 | 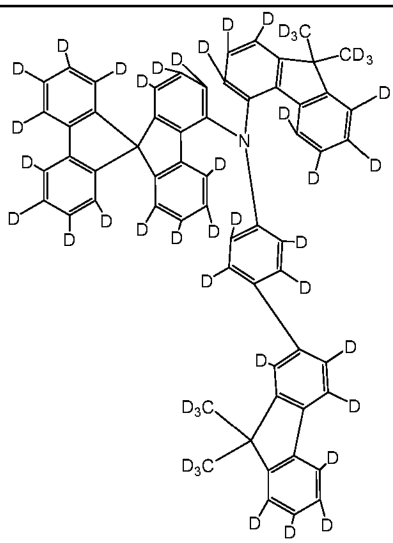 | 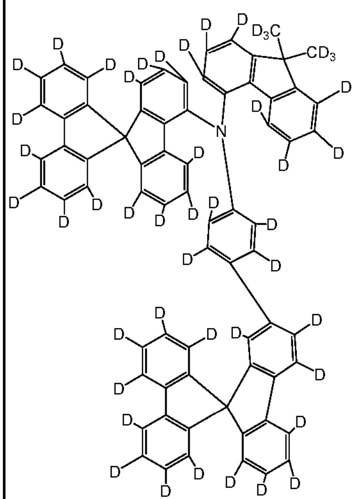 |

| | | |
|---|---|---|
| 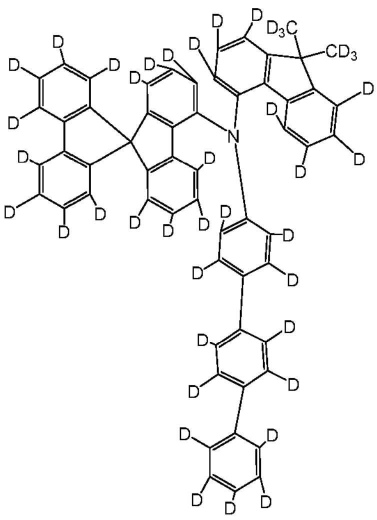 | 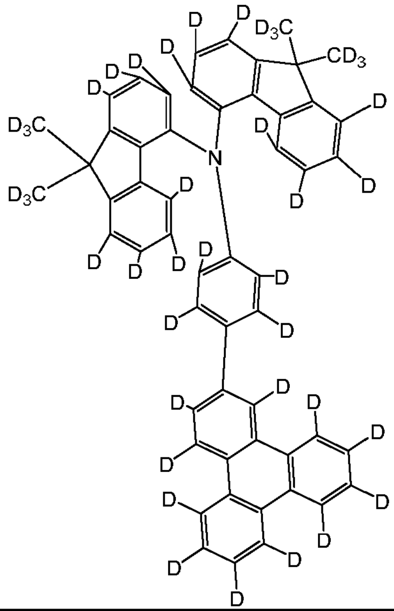 | 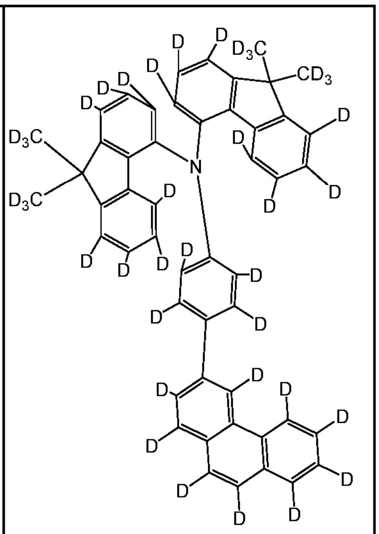 |
| 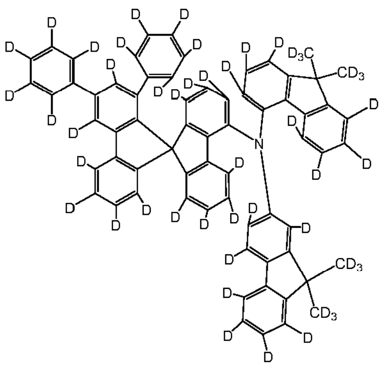 | 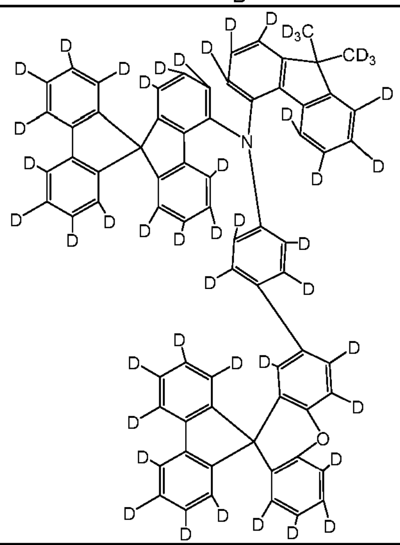 | 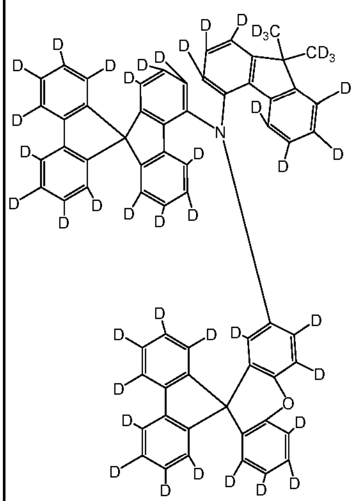 |
| 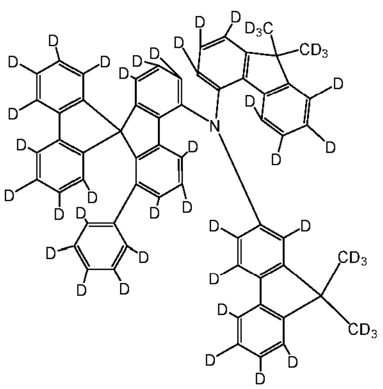 | 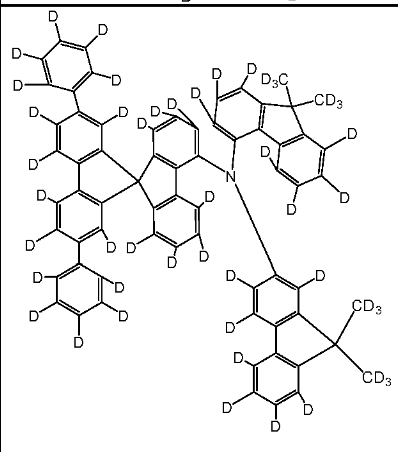 | 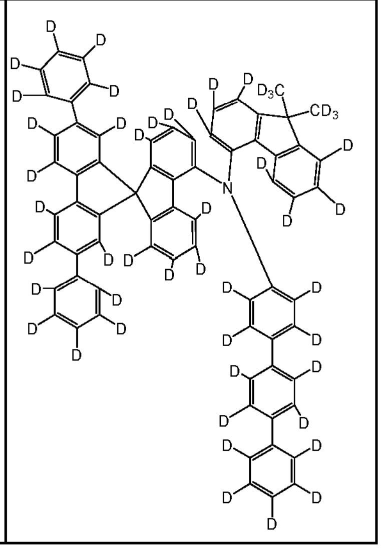 |

| | | |
|---|---|---|
| 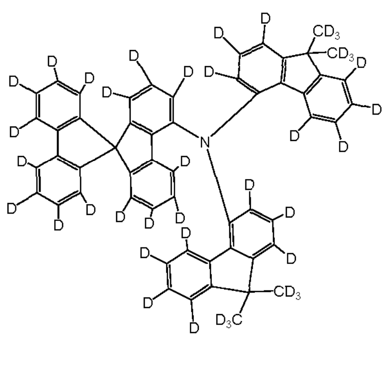 | 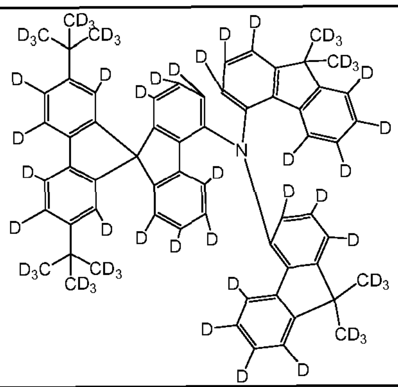 | 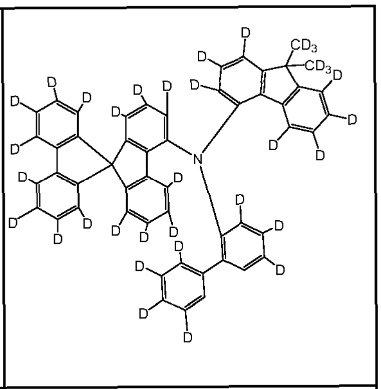 |
| 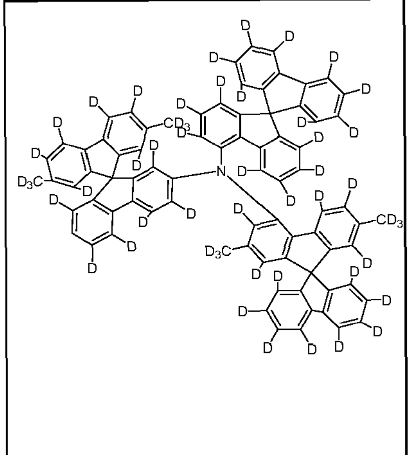 | 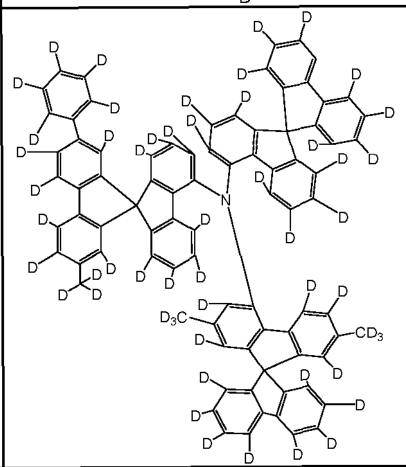 | 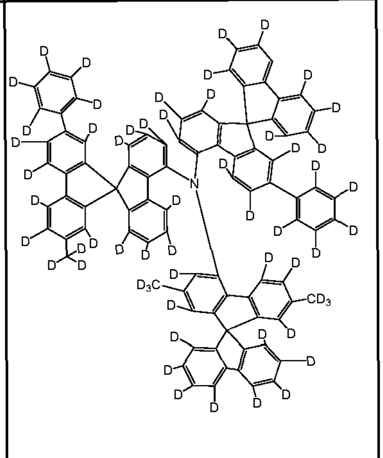 |
| 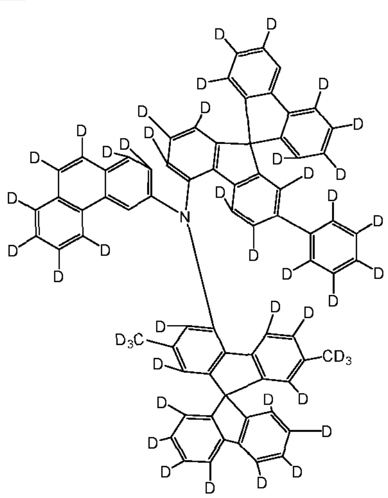 | 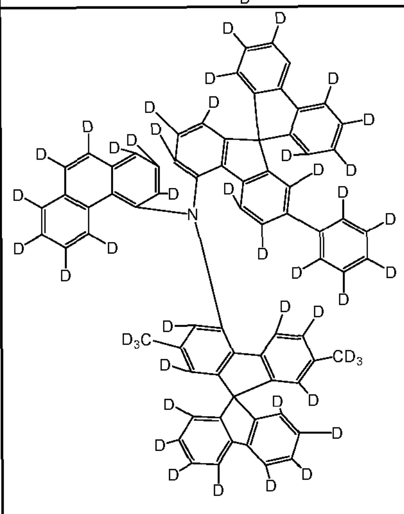 | 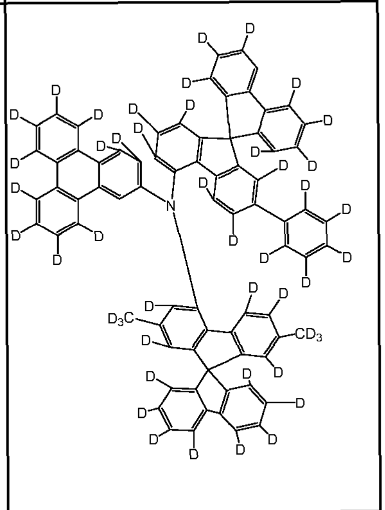 |
| 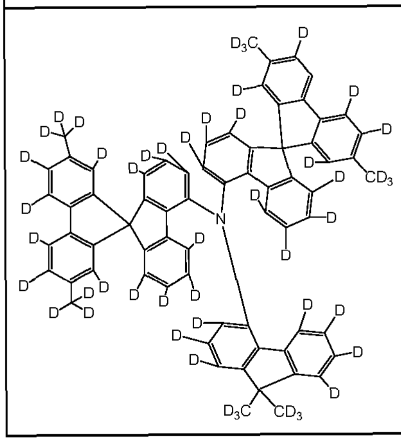 | 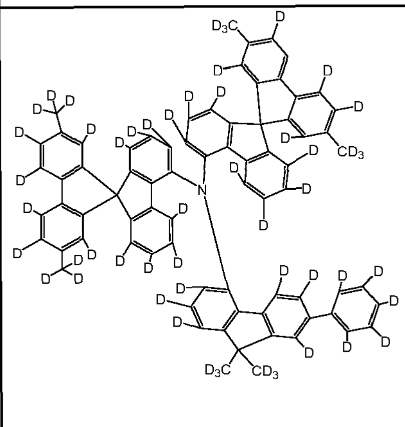 | 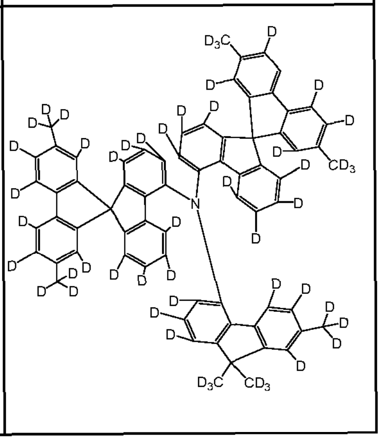 |

| | | |
|---|---|---|
| 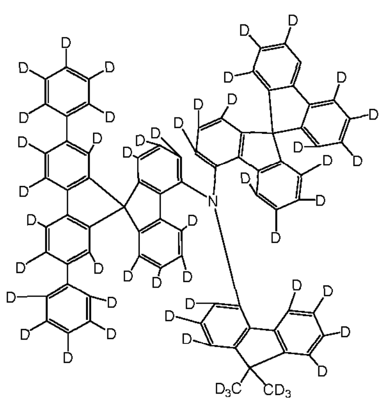 | 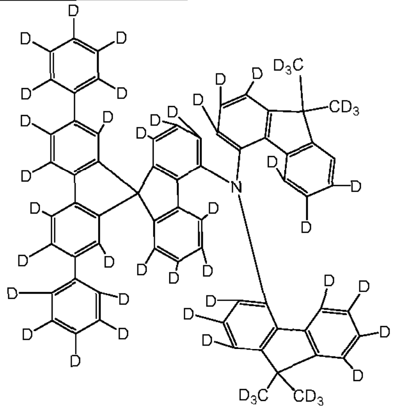 | 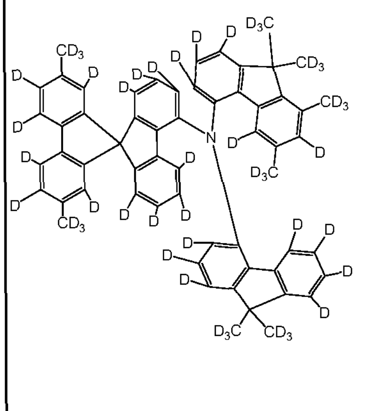 |
| 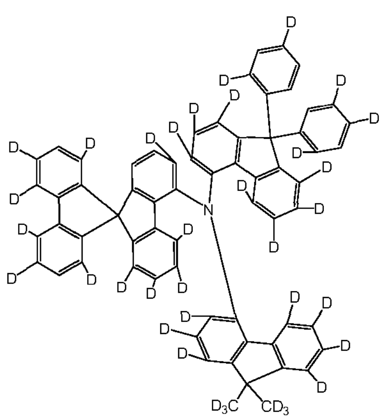 | 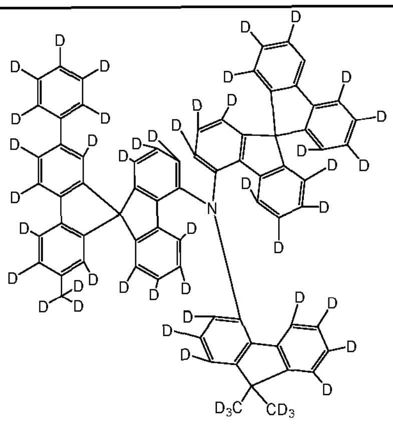 | 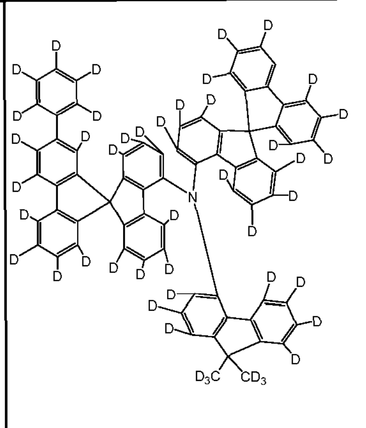 |
| 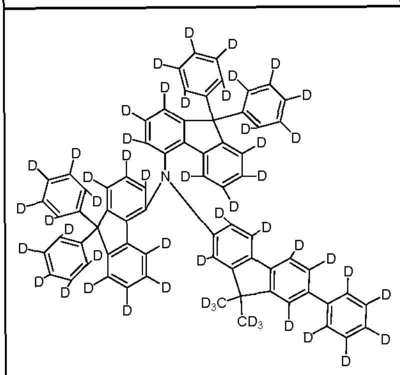 | 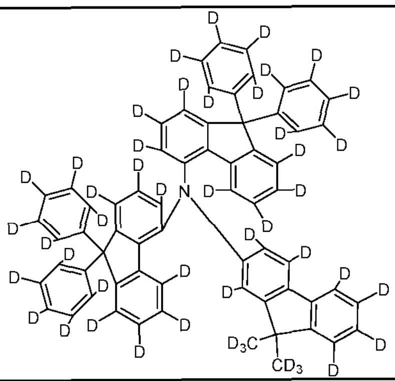 | 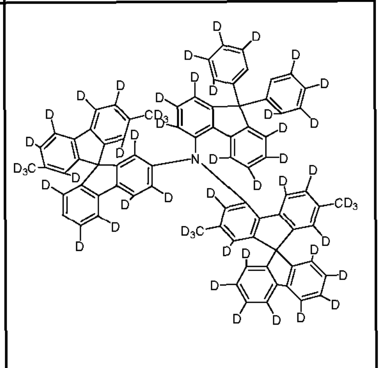 |
| 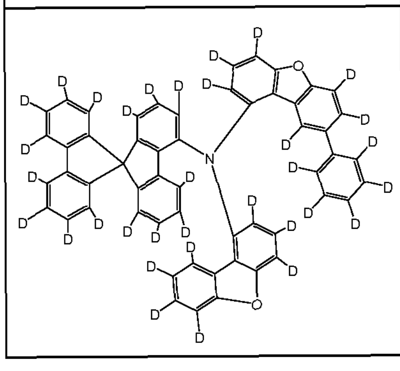 | 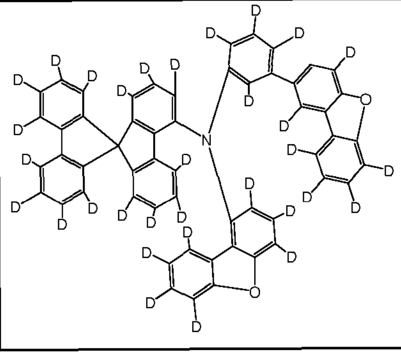 | 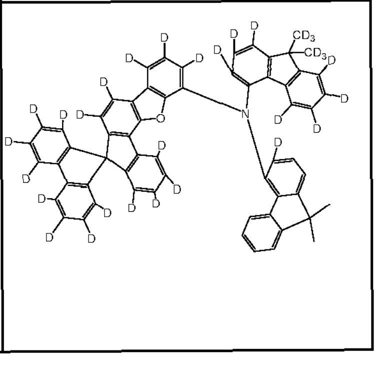 |

| | | |
|---|---|---|
| 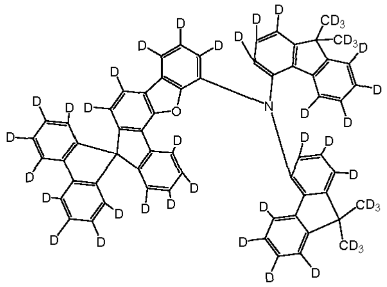 | 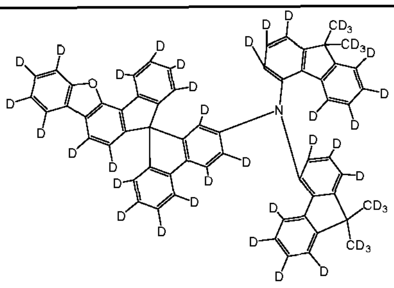 | 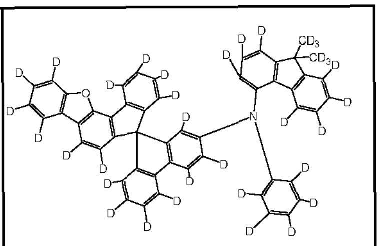 |
| 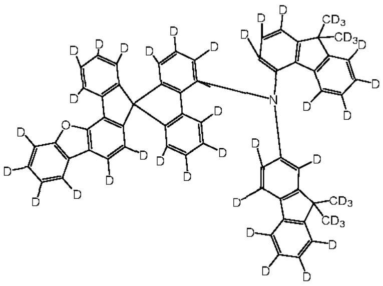 | 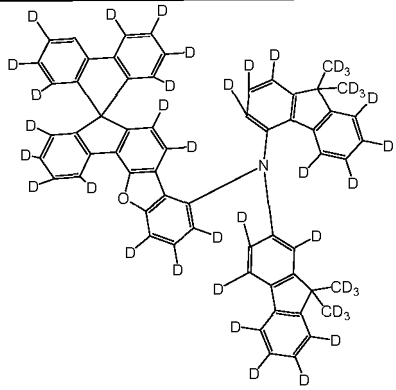 | 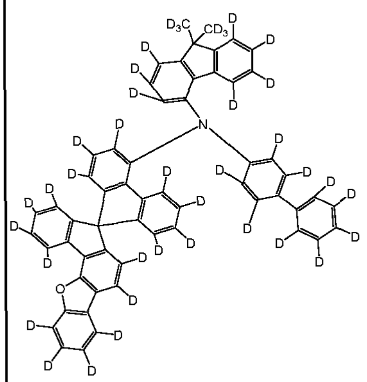 |
| 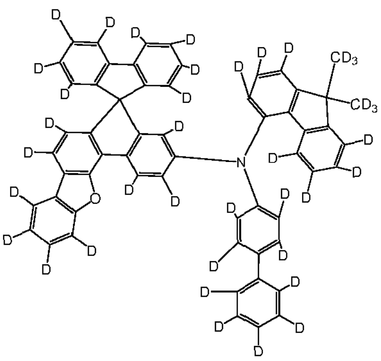 | 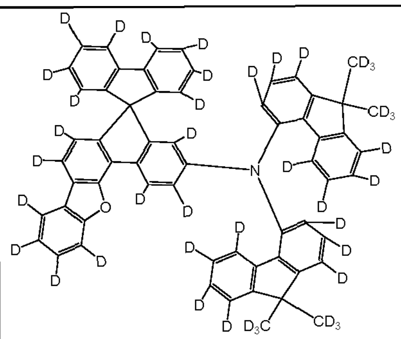 | 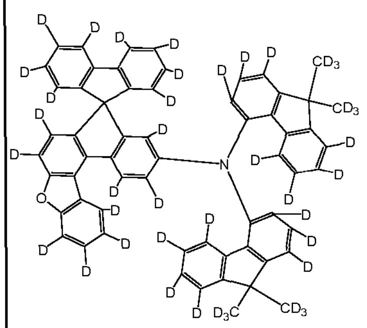 |
| 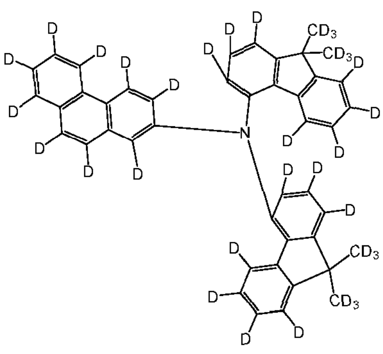 | 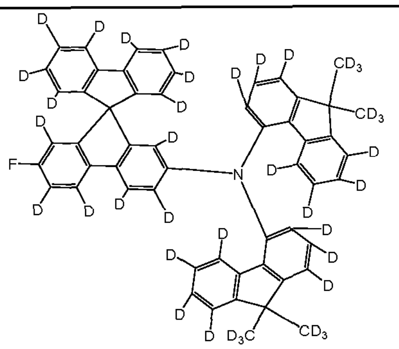 | 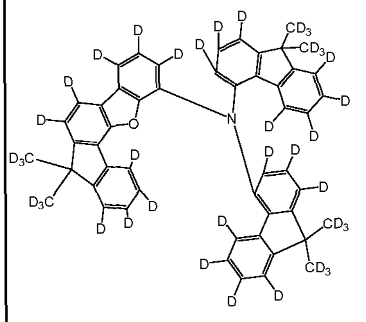 |
| 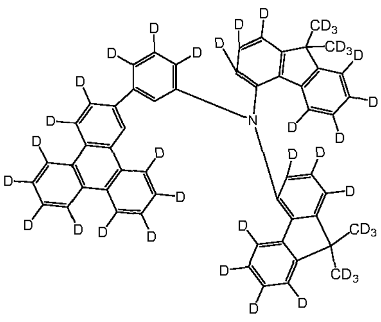 | 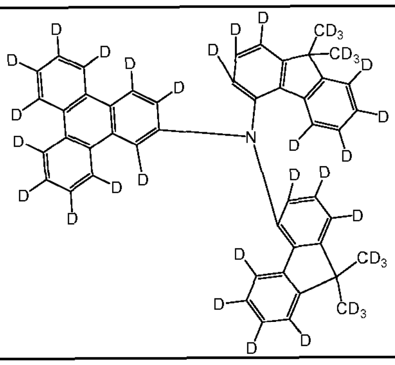 | 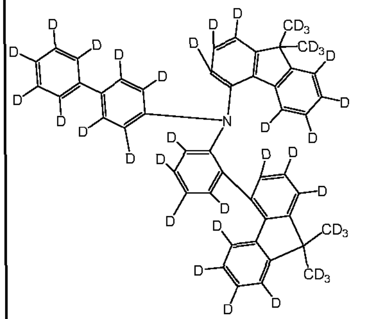 |

| | | |
|---|---|---|
| 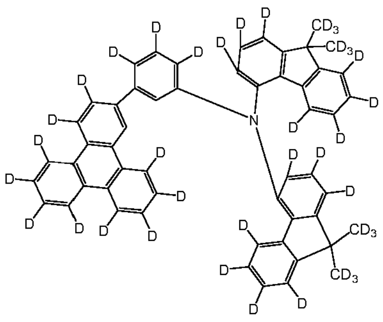 | 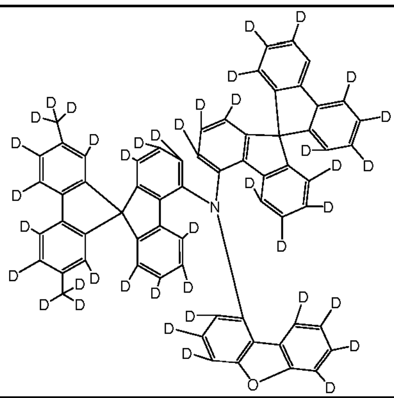 | 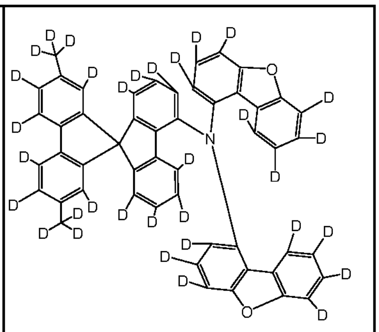 |
| 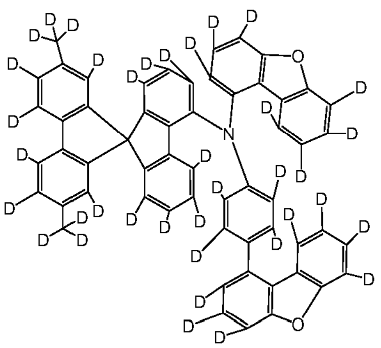 | 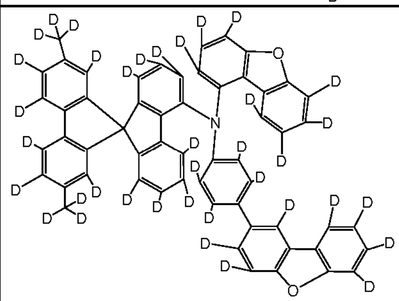 | 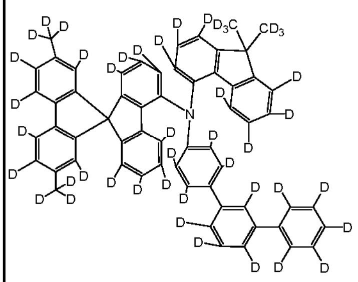 |
| 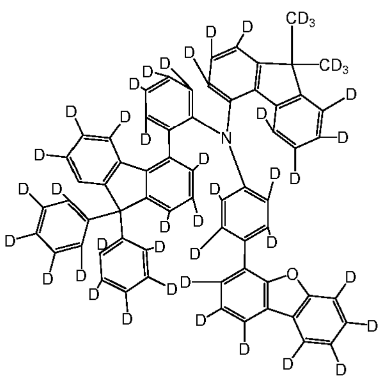 | 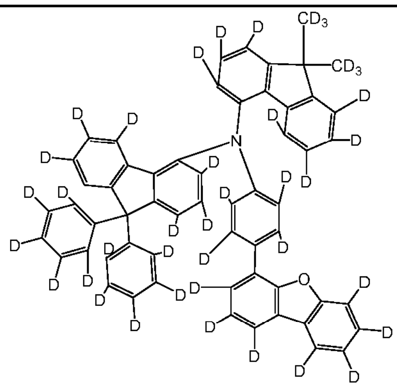 | 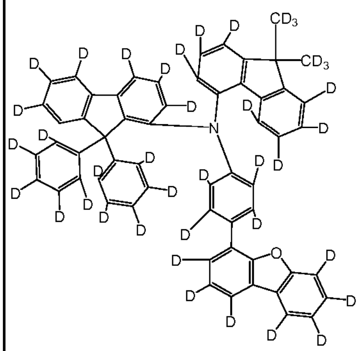 |
| 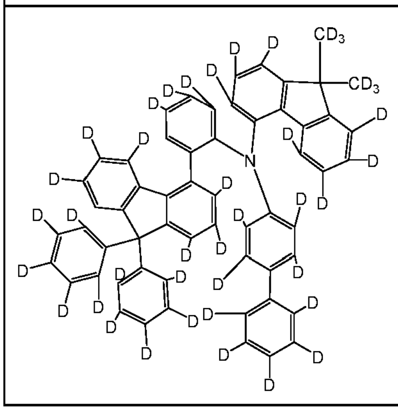 | 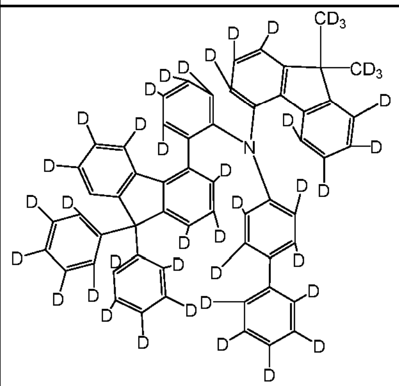 | 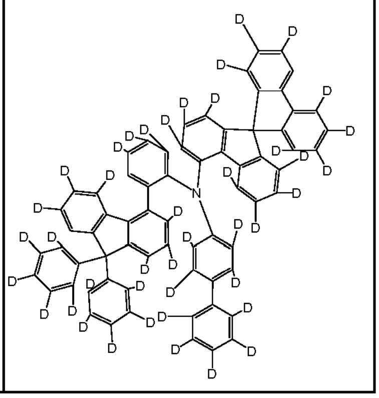 |

| | | |
|---|---|---|
| 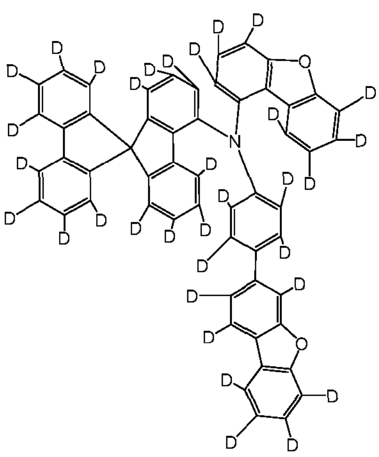 | 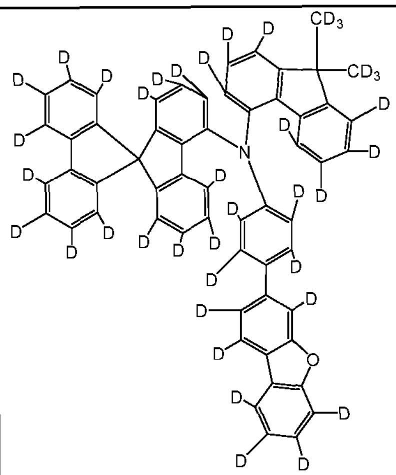 | 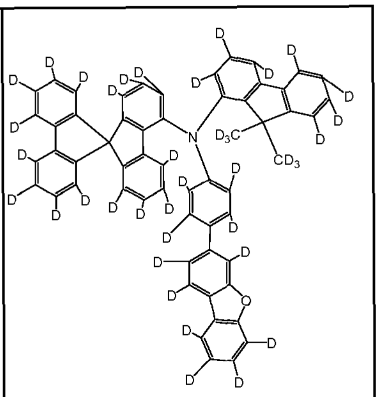 |
| 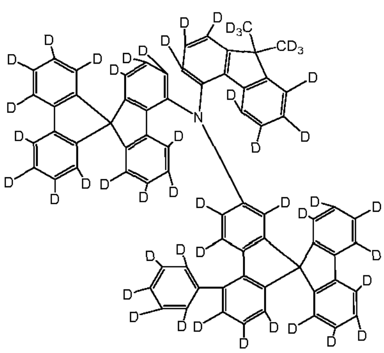 | 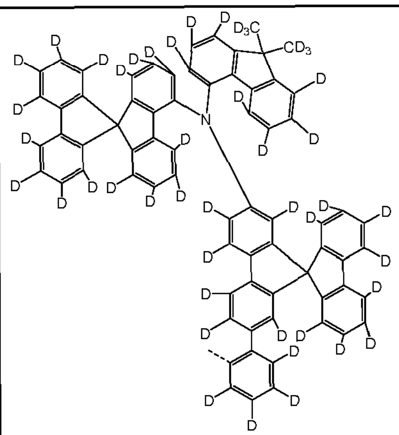 | 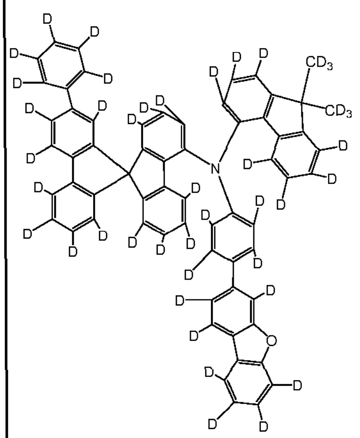 |
| 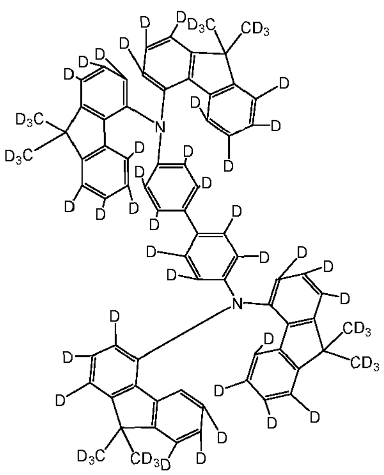 | 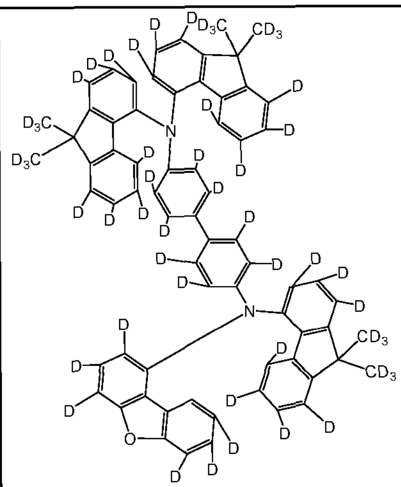 | 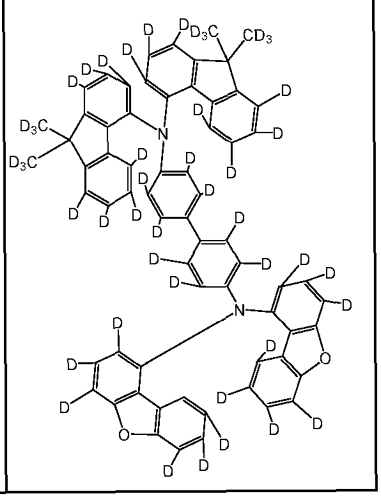 |

| | | |
|---|---|---|
| 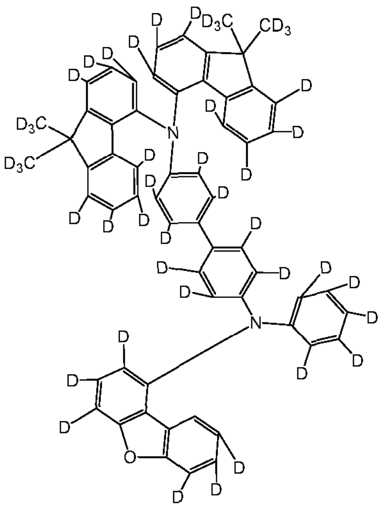 | 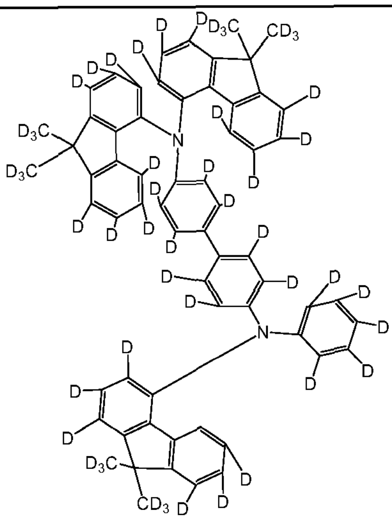 | 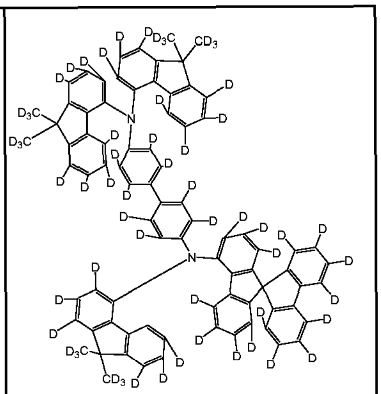 |
| 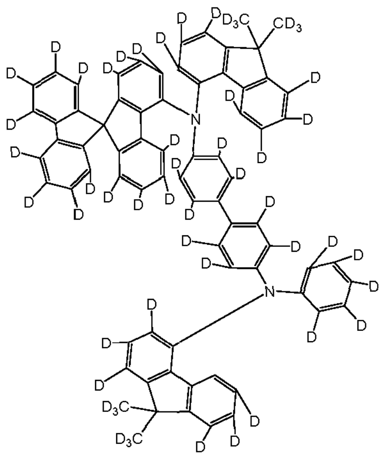 | 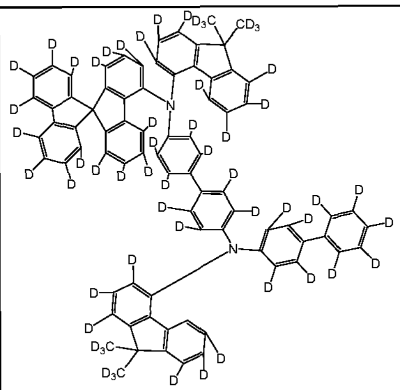 | 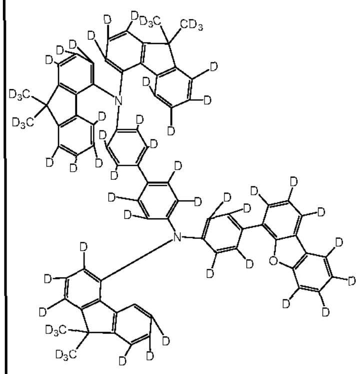 |
| 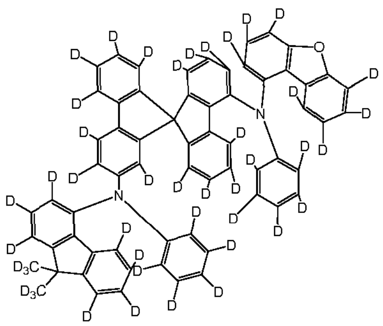 | 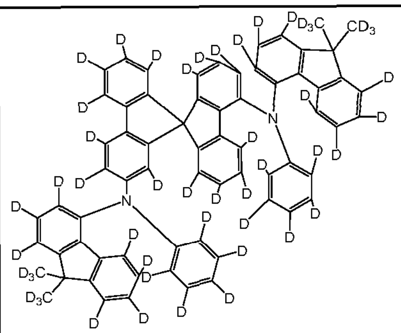 | 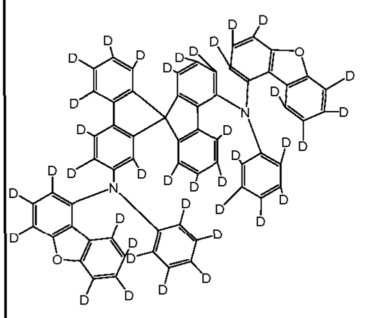 |
| 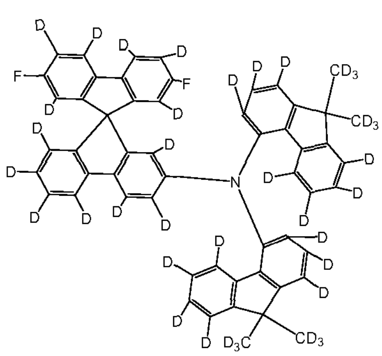 | 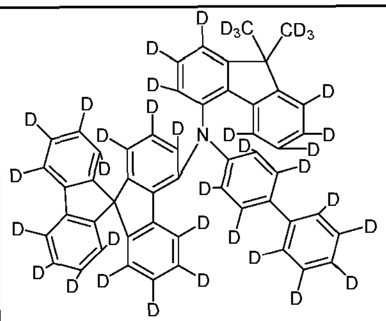 | |

Besonders geeignete Verbindungen der Formeln (2), (2a), (2b), (2c), (2d), (2e), (3), (3a), (3b), (3c), (3d), (3e),

(3f), (3g), (3h), (3i), (3j), (3k), (3l), (3m), (3n), (3o), (4), (5), (6), (7), (8) oder (9), die erfindungsgemäß ausgewählt werden, und bevorzugt in Kombination mit mindestens einer Verbindung der Formel (1) in der erfindungsgemäßen elektrolumineszierenden Vorrichtung verwendet werden, sind die Verbindungen H1 bis H15 der Tabelle 4.

Tabelle 4:

| | |
|---|---|
| 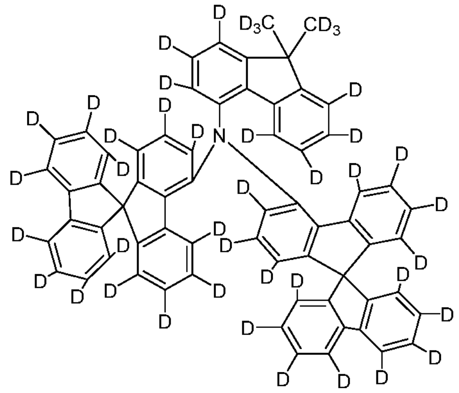 | 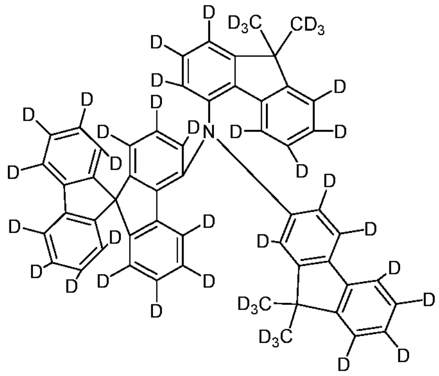 |
| H1 | H2 |
| 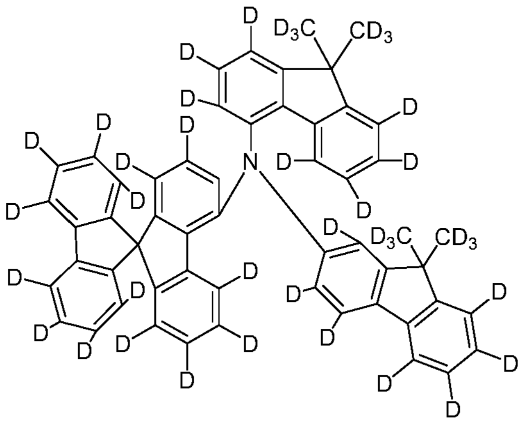 | 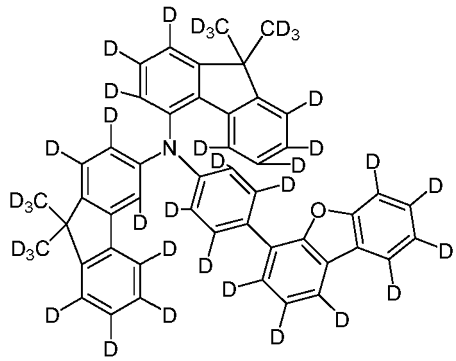 |
| H3 | H4 |
| 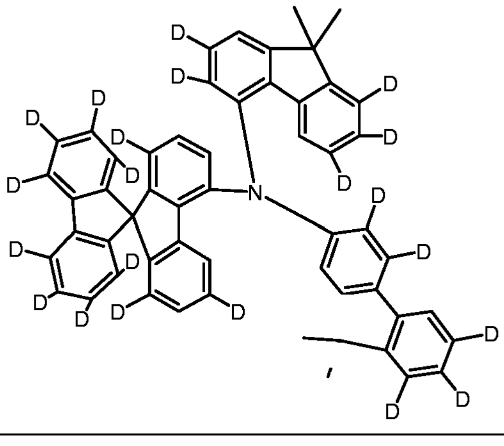 | 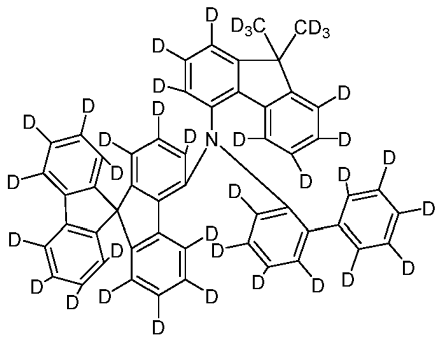 |
| H5 | H6 |

(fortgesetzt)

| | |
|---|---|
| 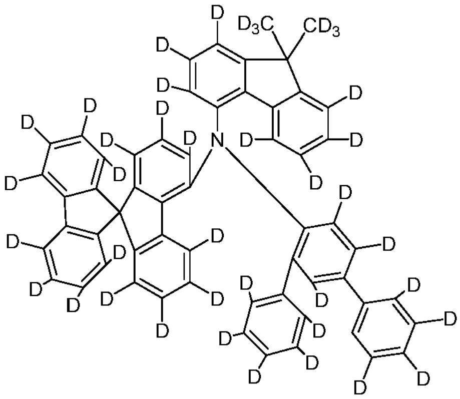 | 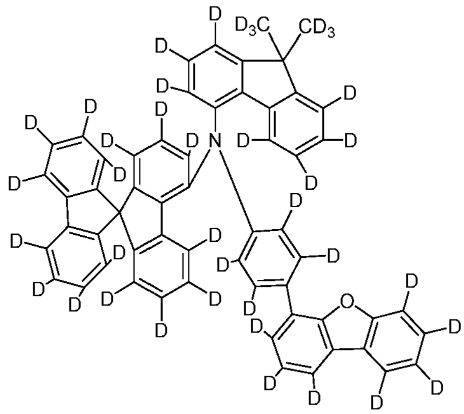 |
| H7 | H8 |
| 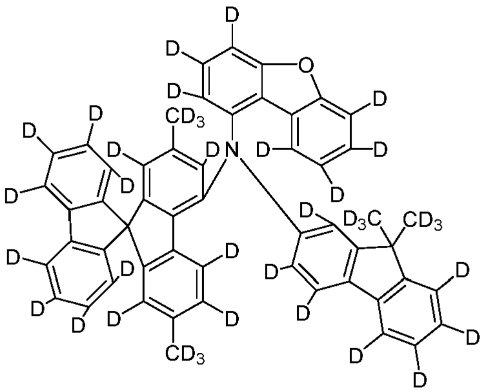 | 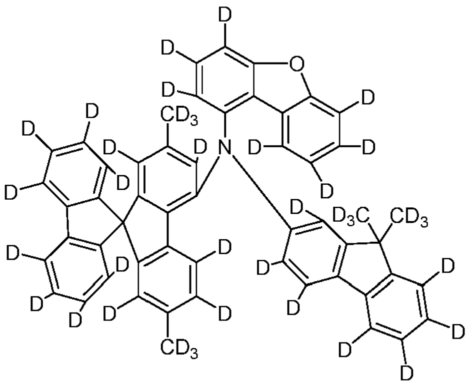 |
| H9 | H10 |
| 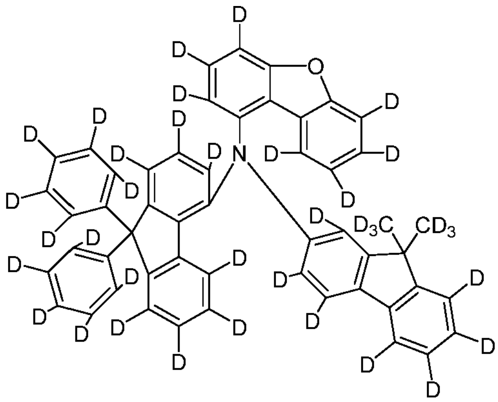 | 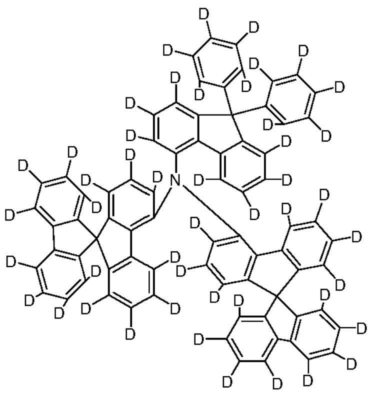 |
| H11 | H12 |

(fortgesetzt)

| | |
|---|---|
| 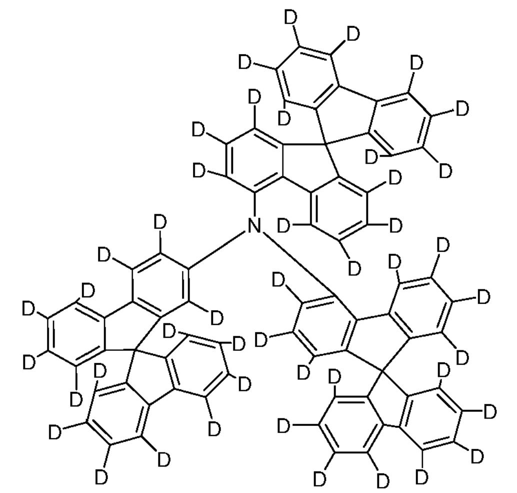 | 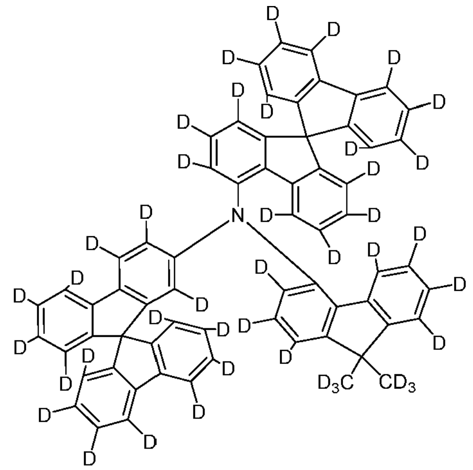 |
| H13 | H14 |
| 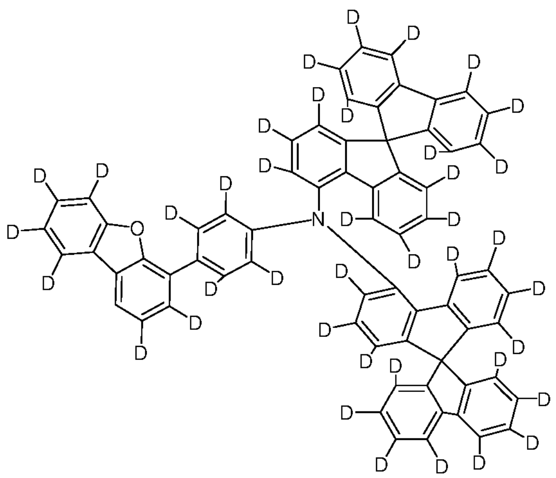 | |
| H15. | |

Die Herstellung der Verbindungen der Formel (2) oder der bevorzugten Verbindungen der Formeln (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9), sowie der Verbindungen der Tabelle 3 und Verbindungen **H1** bis **H15** ist dem Fachmann bekannt. Die Verbindungen können nach dem Fachmann bekannten Syntheseschritten, wie z. B. Bromierung, Suzuki-Kupplung, Additions- und Cyclisierungsreaktionen etc., dargestellt werden. Die Einführung der teilweise deuterierten oder vollständig deuterierten Substituenten kann nacheinander währen der Synthese der Verbindungen der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9) erfolgen oder alternativ kann zunächst die nicht deuterierte Verbindung hergestellt werden und anschließend eine Deuterierung durchgeführt werden, die zu teilweise deuterierten oder vollständig deuterierten Verbindungen führt. Reaktionsbedingungen sind dem Fachmann hinlänglich bekannt. Ein geeignetes Syntheseverfahren zur Herstellung von Spirobifluorenyl-Verbindungen als Hostmaterial 2 ist in Schema 4 dargestellt, wobei die verwendeten Symbole und Indizes stellvertretend für die Synthese des Grundgerüsts gewählt sind. Der Fachmann ist in der Lage, dieses Schema 4 auf die Synthese des Hostmaterials 2, wie zuvor beschrieben, entsprechend anzupassen.

Für die Synthese dieser Hostmaterialien 2 in Schema 4, wird von Biphenyl-Derivaten ausgegangen, die in den beiden Positionen ortho zur Bindung zwischen den Phenylgruppen Halogengruppen aufweisen (X). Diese können durch Suzuki-Reaktion hergestellt werden. Die Biphenyl-Derivate sind stellvertretend mit mindestens einem organischen Rest R substituiert, der entsprechend der Beschreibung angepasst werden kann. In einem folgenden Schritt werden sie in einer Additions- und folgenden Cyclisierungsreaktion mit einem Fluorenon-Derivat zu einem Spirobifluoren umgesetzt, das ein Halogenatom in der Position 4 aufweist (Schema 3). X ist ein Halogenatom, bevorzugt Cl, Br oder I, besonders bevorzugt Cl oder Br, und Y ist I.

Schema 4:

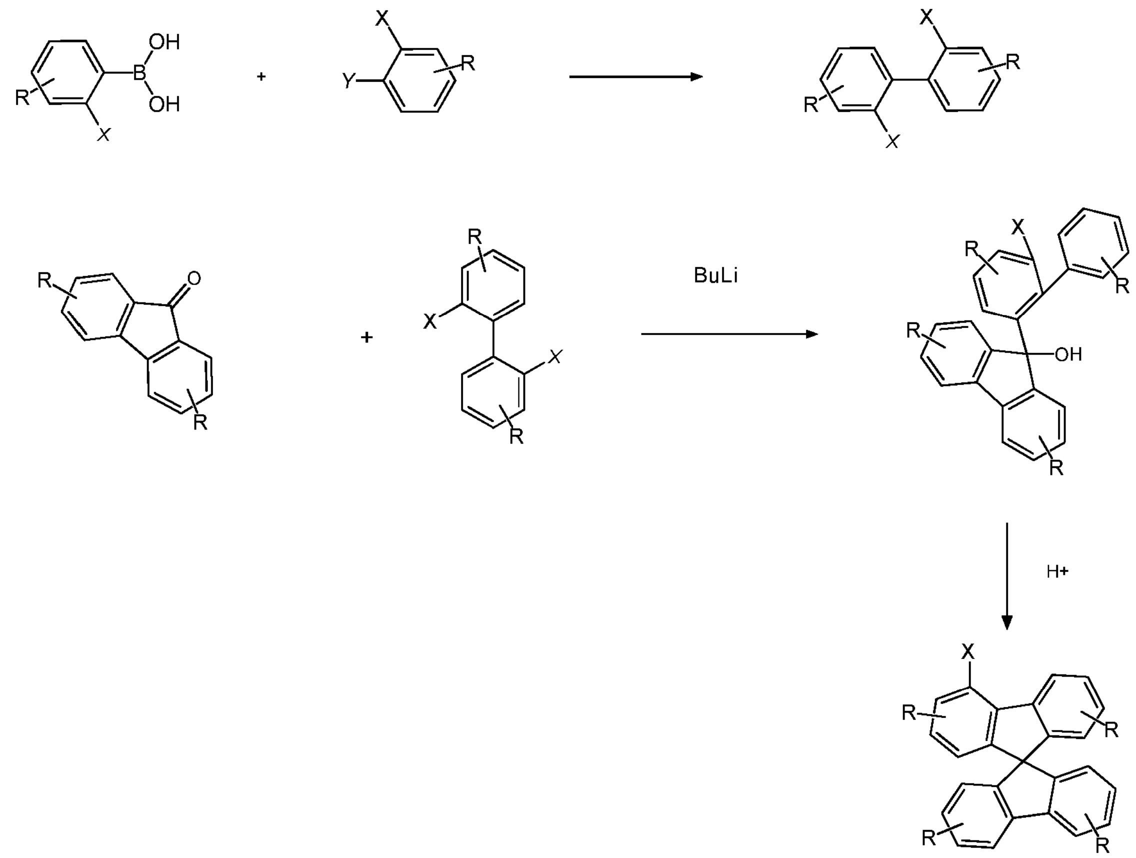


In einem folgenden Schritt können die in Schema 4 erhaltenen Intermediate a) in einer Buchwald-Kupplung mit einem sekundären Amin umgesetzt werden, oder b) in einer Suzuki-Kupplung mit einem Triarylamin umgesetzt werden, oder c) in einem zweischrittigen Verfahren zunächst in einer Suzuki-Kupplung mit einem Aromaten oder Heteroaromaten umgesetzt werden und anschließend in einer Buchwald-Kupplung mit einem sekundären Amin umgesetzt werden.

Geeignete Reaktionsbedingungen für Deuterierungen sind in den folgenden Schemata 5 bis 11 angegeben, wobei jeweils die Literatur oder Patentliteratur angegeben ist, in der Details beschrieben sind. Die angegebene Literatur bzw. Patentliteratur wird dadurch per Referenz in die Beschreibung aufgenommen. Weitere Details zur Deuterierung werden im Ausführungsteil beschrieben.

Ein geeignetes Verfahren zur Deuterierung eines Arylamins oder eines Heteroarylamins durch Austausch eines oder mehrerer H-Atome gegen D-Atome, ist eine Behandlung des zu deuterierenden Arylamins oder Hetroarylamins in Gegenwart eines Platinkatalysators oder Palladiumkatalysators und einer Deuteriumquelle. Der Begriff "Deuteriumquelle" bedeutet jede Verbindung, die ein oder mehrere D-Atome enthält und diese unter geeigneten Bedingungen freisetzen kann.

Der Platinkatalysator ist vorzugsweise trockenes Platin auf Kohle, vorzugsweise 5% trockenes Platin auf Kohle. Der Palladiumkatalysator ist vorzugsweise trockenes Palladium auf Kohle, vorzugsweise 5% trockenes Palladium auf Kohle. Eine geeignete Deuteriumquelle ist $D_2O$, Benzol-d6, Chloroform-d, Acetonitril-d3, Aceton-d6, Essigsäured4, Methanol-d4, Toluol-d8. Eine bevorzugte Deuteriumquelle ist $D_2O$ oder eine Kombination aus $D_2O$ und einem vollständig deuterierten organischen Lösungsmittel. Eine besonders bevorzugte Deuteriumquelle ist die Kombination aus $D_2O$ mit einem vollständig deuterierten organischen Lösungsmittel, wobei das vollständig deuterierte Lösungsmittel hier nicht eingeschränkt ist. Besonders geeignete vollständig deuterierte Lösungsmittel sind Benzen-d6 und Toluol-d8. Eine besonders bevorzugte Deuteriumquelle ist eine Kombination von $D_2O$ und Toluol-d8. Die Reaktion wird vorzugsweise unter Erhitzen durchgeführt, stärker bevorzugt unter Erhitzen auf Temperaturen zwischen 100 °C und 200 °C. Weiterhin wird die Reaktion vorzugsweise unter Druck durchgeführt.

Schema 5: X bedeutet einen beliebigen Substituenten

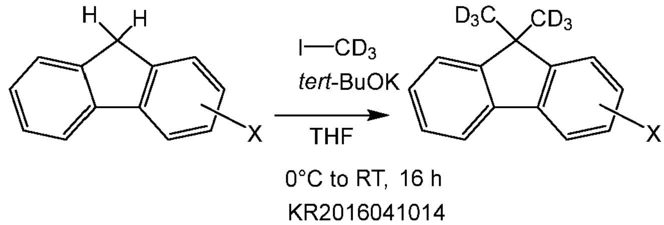


Schema 6:

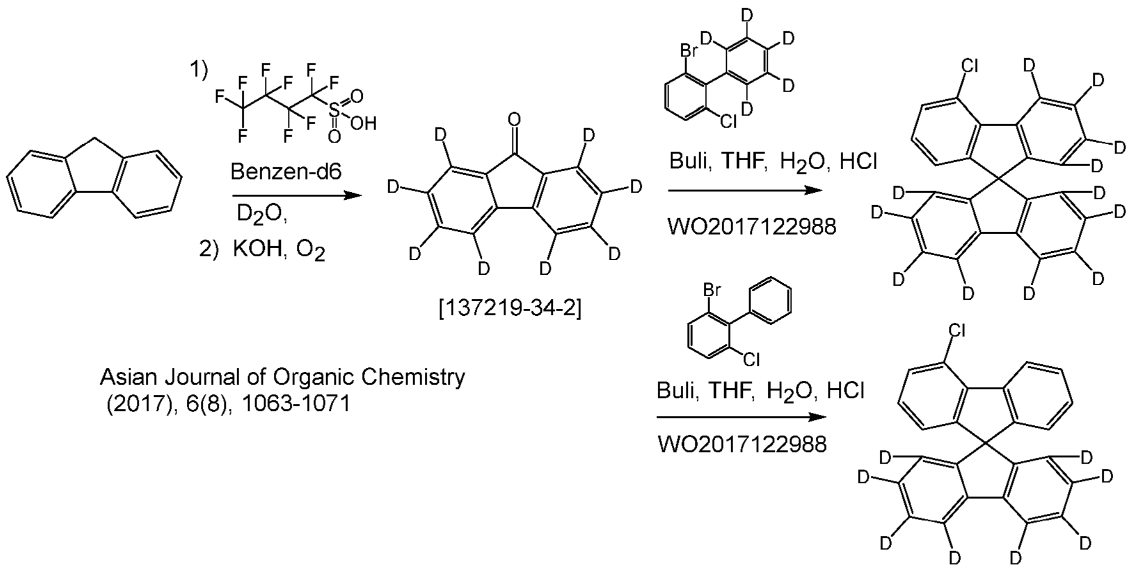


Schema 7:

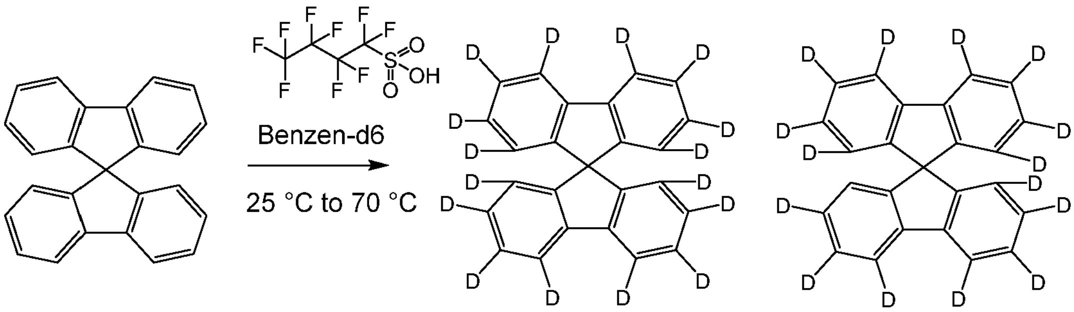


Asian Journal of Organic Chemistry
(2017), 6(8), 1063-1071

Schema 8:

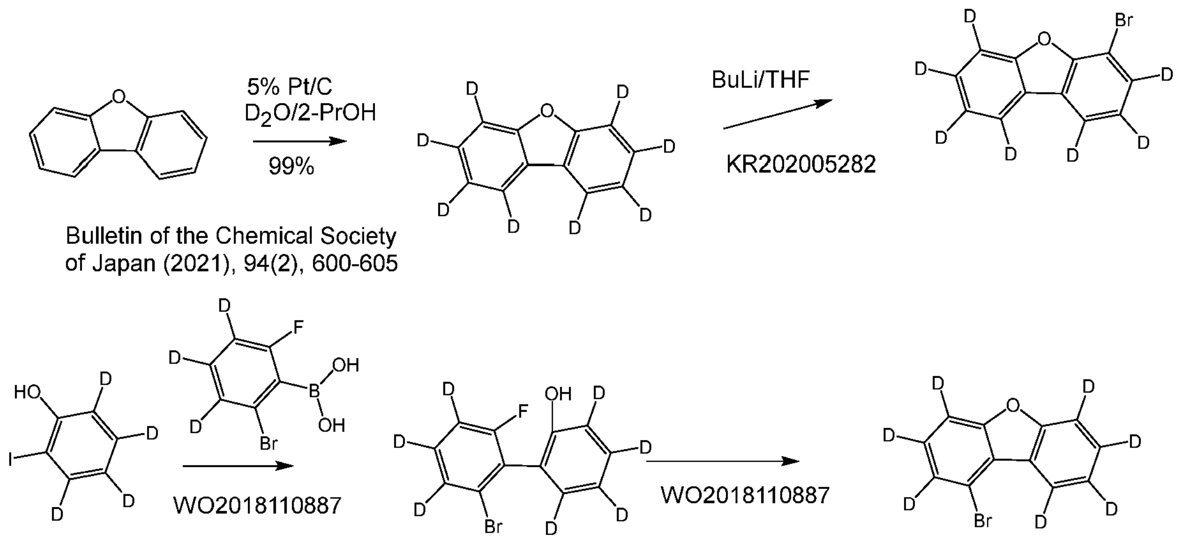


Schema 9: Deuterierung eines Monoamins:

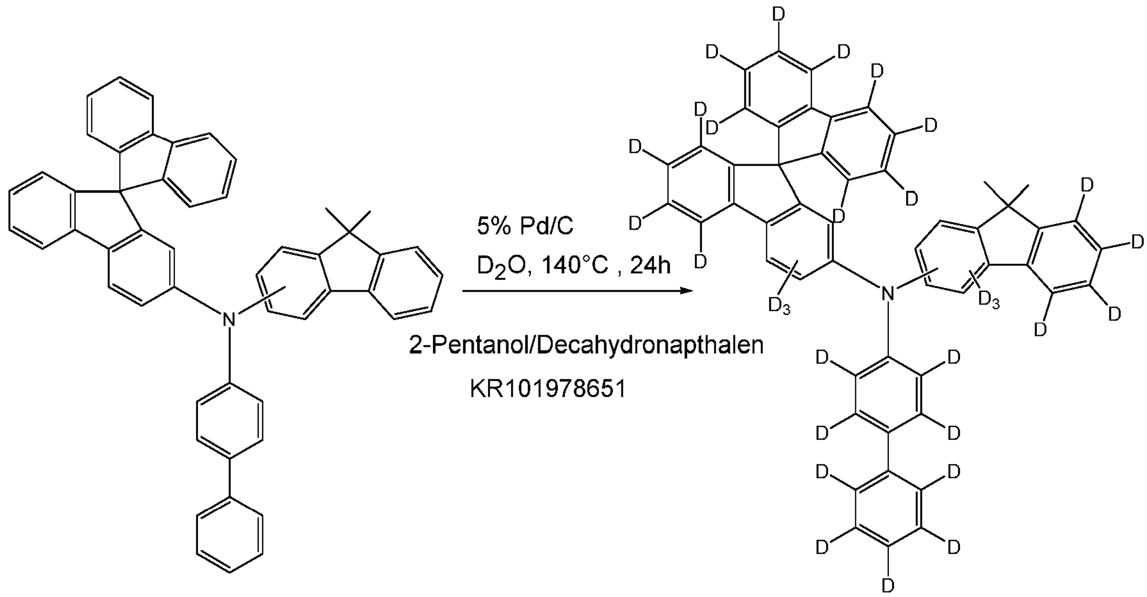

Schema 10:

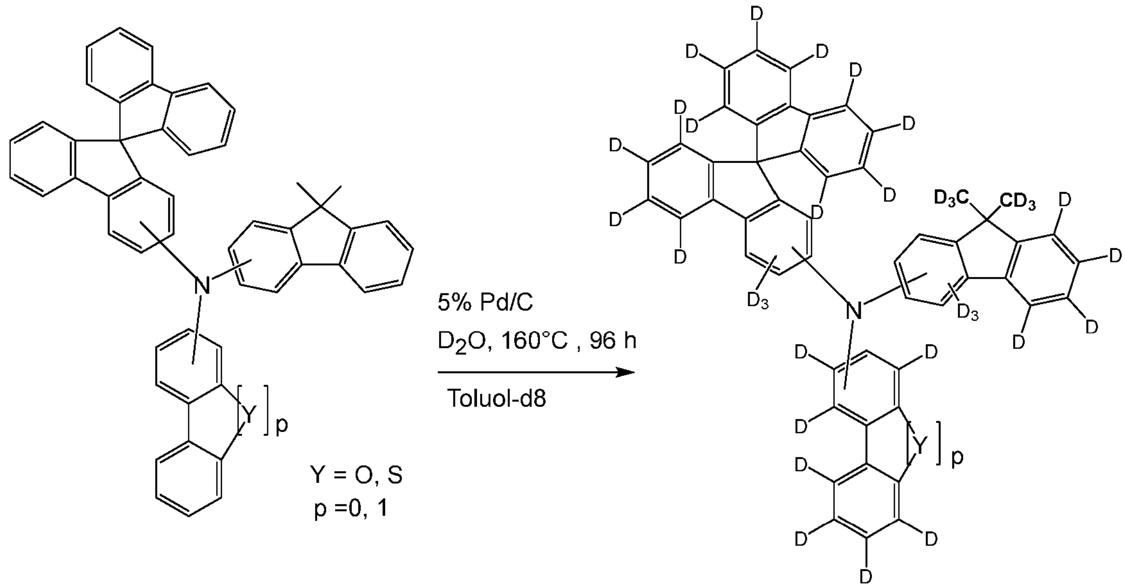


Schema 11: n und m kennzeichnet den Grad der Deuterierung, wobei pro N-gebundener Substituent mindestens ein D enthalten ist

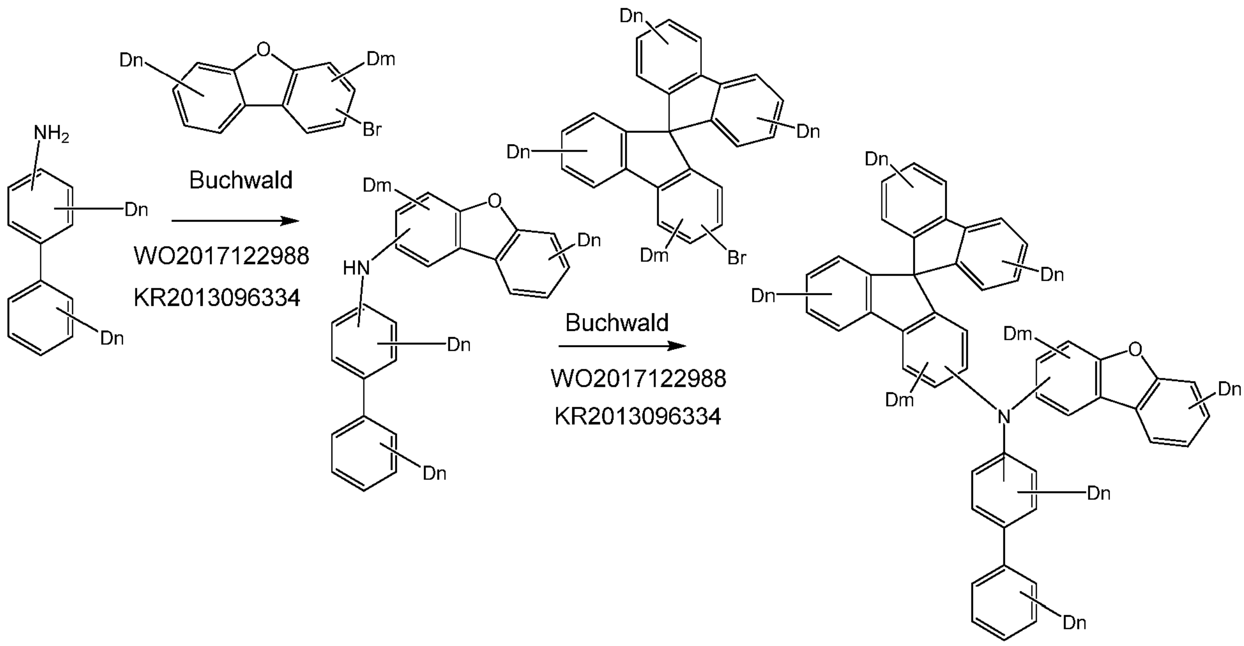


Die vorstehend genannten Hostmaterialien der Formel (1) sowie deren bevorzugt beschriebene Ausführungsformen oder die Verbindungen der Tabelle 1 und der Verbindungen **E1** bis **E51** können in der erfindungsgemäßen Vorrichtung beliebig mit den genannten Hostmaterialien der Formeln (2), (2a), (2b), (2c), (2d), (2e), (3), (3a), (3b), (3c), (3d), (3e), (3f), (3g), (3h), (3i), (3j), (3k), (3l), (3m), (3n), (3o), (4), (5), (6), (7), (8) oder (9) sowie deren bevorzugt beschriebene Ausführungsformen oder den Verbindungen der Tabelle 3 oder den Verbindungen **H1** bis **H15** kombiniert werden.

Ein weiterer Gegenstand der Erfindung sind ebenfalls Mischungen enthaltend mindestens eine Verbindung der Formel (1) als Hostmaterial 1 und mindestens eine Verbindung der Formel (2) als Hostmaterial 2,

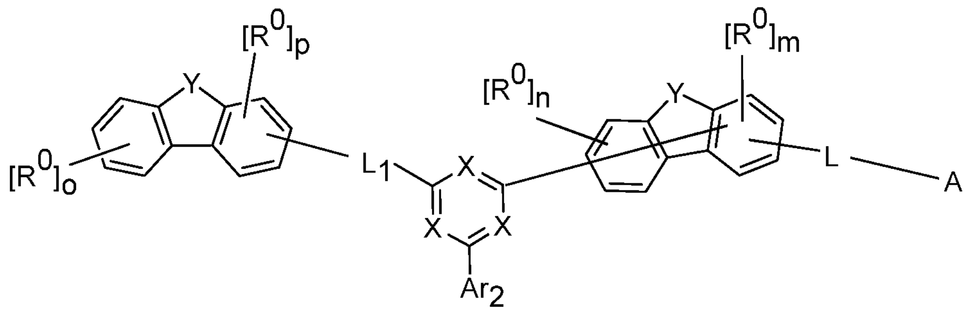

Formel (1) ,

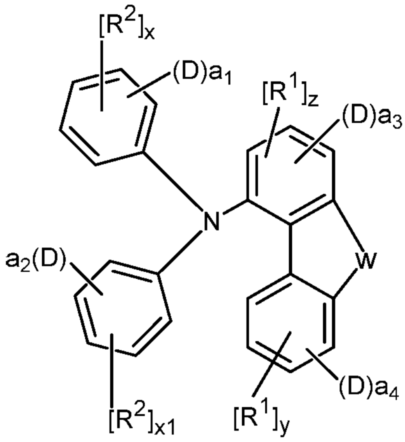

Formel (2),

wobei für die verwendeten Symbole und Indizes gilt:

A ist

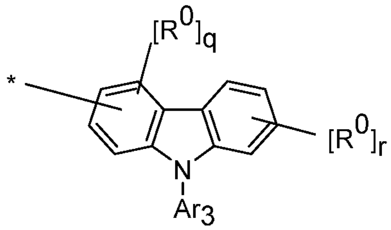

oder

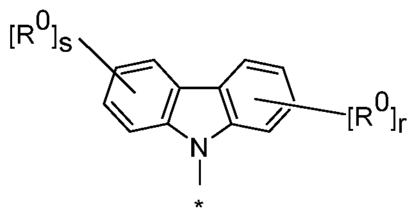

,

X ist bei jedem Auftreten gleich oder verschieden $CR^0$ oder N, wobei mindestens ein Symbol X für N steht;

Y ist bei jedem Auftreten gleich oder verschieden ausgewählt aus O oder S;

* kennzeichnet die Bindungsstelle an die Formel (1);

L und $L_1$ sind bei jedem Auftreten gleich oder verschieden eine Einfachbindung oder ein aromatisches oder heteroaromatisches Ringsystem mit 5 bis 30 aromatischen Ringatomen;

W ist O, S, $C(R)_2$;

R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;

$R^0$ ist bei jedem Auftreten unabhängig voneinander D, ein unsubstituiertes oder teilweise oder vollständig deuteriertes aromatisches Ringsystem mit 6 bis 18 C-Atomen oder ein unsubstituiertes oder teilweise

oder vollständig deuteriertes Dibenzofuran, Dibenzothiophen oder über C gebundenes N-Aryl-Carbazol;

$Ar_1$ ist bei jedem Auftreten gleich oder verschieden ein aromatisches oder heteroaromatisches Ringsystem mit 5 bis 30 aromatischen Ringatomen, das mit einem oder mehreren nicht-aromatischen Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$Ar_2$ ist jeweils unabhängig voneinander bei jedem Auftreten eine Aryl- oder Heteroarylgruppe mit 5 bis 40 aromatischen Ringatomen, die mit einem oder mehreren Resten R' substituiert sein kann;

$Ar_3$ ist jeweils unabhängig voneinander bei jedem Auftreten ein aromatisches Ringsystem mit 6 bis 40 aromatischen Ringatomen oder ein heteroaromatisches Ringsystem mit 5 bis 40 aromatischen Ringatomen, das mit einem oder mehreren Resten R' substituiert sein kann;

Aryl ist bei jedem Auftreten gleich oder verschieden ein aromatisches oder heteroaromatisches Ringsystem mit 5 bis 30 aromatischen Ringatomen, das mit einem oder mehreren nicht-aromatischen Resten R' substituiert sein kann;

R' ist bei jedem Auftreten gleich oder verschieden ausgewählt aus der Gruppe bestehend aus D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C={}^CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten R' ein monocyclisches oder polycyclisches, aliphatisches, aromatisches oder heteroaromatisches Ringsystem bilden können, das mit einem oder mehreren Resten $R^3$ substituiert sein kann;

$R^1$ ist bei jedem Auftreten gleich oder verschieden ausgewählt aus der Gruppe bestehend aus F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, die jeweils mit einem oder mehreren Resten R' substituiert sein kann, wobei eine oder mehrere nicht-benachbarte $CH_2$-Gruppen durch R'C=CR', $Si(R')_2$, C=O, C=S, C=NR', P(=O)(R'), SO, $SO_2$, NR', O, S oder CONR' ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C={}^CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

$R^3$ ist bei jedem Auftreten gleich oder verschieden ausgewählt aus der Gruppe bestehend aus D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

n, m, p, q sind jeweils unabhängig voneinander 0, 1, 2 oder 3;

| | |
|---|---|
| o, r, s | sind jeweils unabhängig voneinander 0, 1, 2, 3 oder 4; |
| x, x1 | sind bei jedem Auftreten unabhängig 0, 1, 2, 3 oder 4; |
| y, z | sind jeweils unabhängig voneinander 0, 1 oder 2; |
| a1, a2 | sind jeweils unabhängig voneinander 1, 2, 3, 4 oder 5; |
| a3 | ist 0, 1, 2 oder 3; |
| a4 | ist 0, 1, 2, 3 oder 4; und a1+a2+a3+a4 ist 3, 4, 5, 6, 7, 8, 9, 10, 11, 12, 13, 14, 15, 16 oder 17. |

Die Ausführungen hinsichtlich der Hostmaterialien der Formeln (1) und (2) sowie deren bevorzugten Ausführungsformen gilt entsprechend auch für die erfindungsgemäße Mischung.

Besonders bevorzugte Mischungen der Hostmaterialien der Formel (1) mit den Hostmaterialien der Formel (2) für die erfindungsgemäße Vorrichtung erhält man durch Kombination der Verbindungen **E1** bis **E51** mit den Verbindungen der Tabelle 3.

Ganz besonders bevorzugte Mischungen der Hostmaterialien der Formel (1) mit den Hostmaterialien der Formel (2) für die erfindungsgemäße Vorrichtung erhält man durch Kombination der Verbindungen **E1** bis **E51** mit den Verbindungen **H1** bis **H15** wie im Folgenden in Tabelle 5 gezeigt.

Tabelle 5:

| | | | | | | | | |
|---|---|---|---|---|---|---|---|---|
| M1 | **E1** | **H1** | M2 | **E2** | **H1** | M3 | **E3** | **H1** |
| M4 | **E4** | **H1** | M5 | **E5** | **H1** | M6 | **E6** | **H1** |
| M7 | **E7** | **H1** | M8 | **E8** | **H1** | M9 | **E9** | **H1** |
| M10 | **E10** | **H1** | M11 | **E11** | **H1** | M12 | **E12** | **H1** |
| M13 | **E13** | **H1** | M14 | **E14** | **H1** | M15 | **E15** | **H1** |
| M16 | **E16** | **H1** | M17 | **E17** | **H1** | M18 | **E18** | **H1** |
| M19 | **E19** | **H1** | M20 | **E20** | **H1** | M21 | **E21** | **H1** |
| M22 | **E22** | **H1** | M23 | **E23** | **H1** | M24 | **E24** | **H1** |
| M25 | **E25** | **H1** | M26 | **E26** | **H1** | M27 | **E27** | **H1** |
| M28 | **E28** | **H1** | M29 | **E29** | **H1** | M30 | **E30** | **H1** |
| M31 | **E31** | **H1** | M32 | **E32** | **H1** | M33 | **E33** | **H1** |
| M34 | **E34** | **H1** | M35 | **E35** | **H1** | M36 | **E36** | **H1** |
| M37 | **E37** | **H1** | M38 | **E38** | **H1** | M39 | **E39** | **H1** |
| M40 | **E40** | **H1** | M41 | **E41** | **H1** | M42 | **E42** | **H1** |
| M43 | **E43** | **H1** | M44 | **E44** | **H1** | M45 | **E45** | **H1** |
| M46 | **E46** | **H1** | M47 | **E47** | **H1** | M48 | **E48** | **H1** |
| M49 | **E49** | **H1** | M50 | **E50** | **H1** | M51 | **E51** | **H1** |
| M52 | **E1** | **H2** | M53 | **E2** | **H2** | M54 | **E3** | **H2** |
| M55 | **E4** | **H2** | M56 | **E5** | **H2** | M57 | **E6** | **H2** |
| M58 | **E7** | **H2** | M59 | **E8** | **H2** | M60 | **E9** | **H2** |
| M61 | **E10** | **H2** | M62 | **E11** | **H2** | M63 | **E12** | **H2** |
| M64 | **E13** | **H2** | M65 | **E14** | **H2** | M66 | **E15** | **H2** |
| M67 | **E16** | **H2** | M68 | **E17** | **H2** | M69 | **E18** | **H2** |
| M70 | **E19** | **H2** | M71 | **E20** | **H2** | M72 | **E21** | **H2** |
| M73 | **E22** | **H2** | M74 | **E23** | **H2** | M75 | **E24** | **H2** |
| M76 | **E25** | **H2** | M77 | **E26** | **H2** | M78 | **E27** | **H2** |
| M79 | **E28** | **H2** | M80 | **E29** | **H2** | M81 | **E30** | **H2** |
| M82 | **E31** | **H2** | M83 | **E32** | **H2** | M84 | **E33** | **H2** |
| M85 | **E34** | **H2** | M86 | **E35** | **H2** | M87 | **E36** | **H2** |

(fortgesetzt)

| | | | | | | | | |
|---|---|---|---|---|---|---|---|---|
| M88 | **E37** | **H2** | M89 | **E38** | **H2** | M90 | **E39** | **H2** |
| M91 | **E40** | **H2** | M92 | **E41** | **H2** | M93 | **E42** | **H2** |
| M94 | **E43** | **H2** | M95 | **E44** | **H2** | M96 | **E45** | **H2** |
| M97 | **E46** | **H2** | M98 | **E47** | **H2** | M99 | **E48** | **H2** |
| M100 | **E49** | **H2** | M101 | **E50** | **H2** | M102 | **E51** | **H2** |
| M103 | **E1** | **H3** | M104 | **E2** | **H3** | M105 | **E3** | **H3** |
| M106 | **E4** | **H3** | M107 | **E5** | **H3** | M108 | **E6** | **H3** |
| M109 | **E7** | **H3** | M110 | **E8** | **H3** | M111 | **E9** | **H3** |
| M112 | **E10** | **H3** | M113 | **E11** | **H3** | M114 | **E12** | **H3** |
| M115 | **E13** | **H3** | M116 | **E14** | **H3** | M117 | **E15** | **H3** |
| M118 | **E16** | **H3** | M119 | **E17** | **H3** | M120 | **E18** | **H3** |
| M121 | **E19** | **H3** | M122 | **E20** | **H3** | M123 | **E21** | **H3** |
| M124 | **E22** | **H3** | M125 | **E23** | **H3** | M126 | **E24** | **H3** |
| M127 | **E25** | **H3** | M128 | **E26** | **H3** | M129 | **E27** | **H3** |
| M130 | **E28** | **H3** | M131 | **E29** | **H3** | M132 | **E30** | **H3** |
| M133 | **E31** | **H3** | M134 | **E32** | **H3** | M135 | **E33** | **H3** |
| M136 | **E34** | **H3** | M137 | **E35** | **H3** | M138 | **E36** | **H3** |
| M139 | **E37** | **H3** | M140 | **E38** | **H3** | M141 | **E39** | **H3** |
| M142 | **E40** | **H3** | M143 | **E41** | **H3** | M144 | **E42** | **H3** |
| M145 | **E43** | **H3** | M146 | **E44** | **H3** | M147 | **E45** | **H3** |
| M148 | **E46** | **H3** | M149 | **E47** | **H3** | M150 | **E48** | **H3** |
| M151 | **E49** | **H3** | M152 | **E50** | **H3** | M153 | **E51** | **H3** |
| M154 | **E1** | **H4** | M155 | **E2** | **H4** | M156 | **E3** | **H4** |
| M157 | **E4** | **H4** | M158 | **E5** | **H4** | M159 | **E6** | **H4** |
| M160 | **E7** | **H4** | M161 | **E8** | **H4** | M162 | **E9** | **H4** |
| M163 | **E10** | **H4** | M164 | **E11** | **H4** | M165 | **E12** | **H4** |
| M166 | **E13** | **H4** | M167 | **E14** | **H4** | M168 | **E15** | **H4** |
| M169 | **E16** | **H4** | M170 | **E17** | **H4** | M171 | **E18** | **H4** |
| M172 | **E19** | **H4** | M173 | **E20** | **H4** | M174 | **E21** | **H4** |
| M175 | **E22** | **H4** | M176 | **E23** | **H4** | M177 | **E24** | **H4** |
| M178 | **E25** | **H4** | M179 | **E26** | **H4** | M180 | **E27** | **H4** |
| M181 | **E28** | **H4** | M182 | **E29** | **H4** | M183 | **E30** | **H4** |
| M184 | **E31** | **H4** | M185 | **E32** | **H4** | M186 | **E33** | **H4** |
| M187 | **E34** | **H4** | M188 | **E35** | **H4** | M189 | **E36** | **H4** |
| M190 | **E37** | **H4** | M191 | **E38** | **H4** | M192 | **E39** | **H4** |
| M193 | **E40** | **H4** | M194 | **E41** | **H4** | M195 | **E42** | **H4** |
| M196 | **E43** | **H4** | M197 | **E44** | **H4** | M198 | **E45** | **H4** |
| M199 | **E46** | **H4** | M200 | **E47** | **H4** | M201 | **E48** | **H4** |
| M202 | **E49** | **H4** | M203 | **E50** | **H4** | M204 | **E51** | **H4** |
| M205 | **E1** | **H5** | M206 | **E2** | **H5** | M207 | **E3** | **H5** |

(fortgesetzt)

| | | | | | | | | |
|---|---|---|---|---|---|---|---|---|
| M208 | **E4** | **H5** | M209 | **E5** | **H5** | M210 | **E6** | **H5** |
| M211 | **E7** | **H5** | M212 | **E8** | **H5** | M213 | **E9** | **H5** |
| M214 | **E10** | **H5** | M215 | **E11** | **H5** | M216 | **E12** | **H5** |
| M217 | **E13** | **H5** | M218 | **E14** | **H5** | M219 | **E15** | **H5** |
| M220 | **E16** | **H5** | M221 | **E17** | **H5** | M222 | **E18** | **H5** |
| M223 | **E19** | **H5** | M224 | **E20** | **H5** | M225 | **E21** | **H5** |
| M226 | **E22** | **H5** | M227 | **E23** | **H5** | M228 | **E24** | **H5** |
| M229 | **E25** | **H5** | M230 | **E26** | **H5** | M231 | **E27** | **H5** |
| M232 | **E28** | **H5** | M233 | **E29** | **H5** | M234 | **E30** | **H5** |
| M235 | **E31** | **H5** | M236 | **E32** | **H5** | M237 | **E33** | **H5** |
| M238 | **E34** | **H5** | M239 | **E35** | **H5** | M240 | **E36** | **H5** |
| M241 | **E37** | **H5** | M242 | **E38** | **H5** | M243 | **E39** | **H5** |
| M244 | **E40** | **H5** | M245 | **E41** | **H5** | M246 | **E42** | **H5** |
| M247 | **E43** | **H5** | M248 | **E44** | **H5** | M249 | **E45** | **H5** |
| M250 | **E46** | **H5** | M251 | **E47** | **H5** | M252 | **E48** | **H5** |
| M253 | **E49** | **H5** | M254 | **E50** | **H5** | M255 | **E51** | **H5** |
| M256 | **E1** | **H6** | M257 | **E2** | **H6** | M258 | **E3** | **H6** |
| M259 | **E4** | **H6** | M260 | **E5** | **H6** | M261 | **E6** | **H6** |
| M262 | **E7** | **H6** | M263 | **E8** | **H6** | M264 | **E9** | **H6** |
| M265 | **E10** | **H6** | M266 | **E11** | **H6** | M267 | **E12** | **H6** |
| M268 | **E13** | **H6** | M269 | **E14** | **H6** | M270 | **E15** | **H6** |
| M271 | **E16** | **H6** | M272 | **E17** | **H6** | M273 | **E18** | **H6** |
| M274 | **E19** | **H6** | M275 | **E20** | **H6** | M276 | **E21** | **H6** |
| M277 | **E22** | **H6** | M278 | **E23** | **H6** | M279 | **E24** | **H6** |
| M280 | **E25** | **H6** | M281 | **E26** | **H6** | M282 | **E27** | **H6** |
| M283 | **E28** | **H6** | M284 | **E29** | **H6** | M285 | **E30** | **H6** |
| M286 | **E31** | **H6** | M287 | **E32** | **H6** | M288 | **E33** | **H6** |
| M289 | **E34** | **H6** | M290 | **E35** | **H6** | M291 | **E36** | **H6** |
| M292 | **E37** | **H6** | M293 | **E38** | **H6** | M294 | **E39** | **H6** |
| M295 | **E40** | **H6** | M296 | **E41** | **H6** | M297 | **E42** | **H6** |
| M298 | **E43** | **H6** | M299 | **E44** | **H6** | M300 | **E45** | **H6** |
| M301 | **E46** | **H6** | M302 | **E47** | **H6** | M303 | **E48** | **H6** |
| M304 | **E49** | **H6** | M305 | **E50** | **H6** | M306 | **E51** | **H6** |
| M307 | **E1** | **H7** | M308 | **E2** | **H7** | M309 | **E3** | **H7** |
| M310 | **E4** | **H7** | M311 | **E5** | **H7** | M312 | **E6** | **H7** |
| M313 | **E7** | **H7** | M314 | **E8** | **H7** | M315 | **E9** | **H7** |
| M316 | **E10** | **H7** | M317 | **E11** | **H7** | M318 | **E12** | **H7** |
| M319 | **E13** | **H7** | M320 | **E14** | **H7** | M321 | **E15** | **H7** |
| M322 | **E16** | **H7** | M323 | **E17** | **H7** | M324 | **E18** | **H7** |
| M325 | **E19** | **H7** | M326 | **E20** | **H7** | M327 | **E21** | **H7** |

(fortgesetzt)

| | | | | | | | | |
|---|---|---|---|---|---|---|---|---|
| M328 | **E22** | **H7** | M329 | **E23** | **H7** | M330 | **E24** | **H7** |
| M331 | **E25** | **H7** | M332 | **E26** | **H7** | M333 | **E27** | **H7** |
| M334 | **E28** | **H7** | M335 | **E29** | **H7** | M336 | **E30** | **H7** |
| M337 | **E31** | **H7** | M338 | **E32** | **H7** | M339 | **E33** | **H7** |
| M340 | **E34** | **H7** | M341 | **E35** | **H7** | M342 | **E36** | **H7** |
| M343 | **E37** | **H7** | M344 | **E38** | **H7** | M345 | **E39** | **H7** |
| M346 | **E40** | **H7** | M347 | **E41** | **H7** | M348 | **E42** | **H7** |
| M349 | **E43** | **H7** | M350 | **E44** | **H7** | M351 | **E45** | **H7** |
| M352 | **E46** | **H7** | M353 | **E47** | **H7** | M354 | **E48** | **H7** |
| M355 | **E49** | **H7** | M356 | **E50** | **H7** | M357 | **E51** | **H7** |
| M358 | **E1** | **H8** | M359 | **E2** | **H8** | M360 | **E3** | **H8** |
| M361 | **E4** | **H8** | M362 | **E5** | **H8** | M363 | **E6** | **H8** |
| M364 | **E7** | **H8** | M365 | **E8** | **H8** | M366 | **E9** | **H8** |
| M367 | **E10** | **H8** | M368 | **E11** | **H8** | M369 | **E12** | **H8** |
| M370 | **E13** | **H8** | M371 | **E14** | **H8** | M372 | **E15** | **H8** |
| M373 | **E16** | **H8** | M374 | **E17** | **H8** | M375 | **E18** | **H8** |
| M376 | **E19** | **H8** | M377 | **E20** | **H8** | M378 | **E21** | **H8** |
| M379 | **E22** | **H8** | M380 | **E23** | **H8** | M381 | **E24** | **H8** |
| M382 | **E25** | **H8** | M383 | **E26** | **H8** | M384 | **E27** | **H8** |
| M385 | **E28** | **H8** | M386 | **E29** | **H8** | M387 | **E30** | **H8** |
| M388 | **E31** | **H8** | M389 | **E32** | **H8** | M390 | **E33** | **H8** |
| M391 | **E34** | **H8** | M392 | **E35** | **H8** | M393 | **E36** | **H8** |
| M394 | **E37** | **H8** | M395 | **E38** | **H8** | M396 | **E39** | **H8** |
| M397 | **E40** | **H8** | M398 | **E41** | **H8** | M399 | **E42** | **H8** |
| M400 | **E43** | **H8** | M401 | **E44** | **H8** | M402 | **E45** | **H8** |
| M403 | **E46** | **H8** | M404 | **E47** | **H8** | M405 | **E48** | **H8** |
| M406 | **E49** | **H8** | M407 | **E50** | **H8** | M408 | **E51** | **H8** |
| M409 | **E1** | **H9** | M410 | **E2** | **H9** | M411 | **E3** | **H9** |
| M412 | **E4** | **H9** | M413 | **E5** | **H9** | M414 | **E6** | **H9** |
| M415 | **E7** | **H9** | M416 | **E8** | **H9** | M417 | **E9** | **H9** |
| M418 | **E10** | **H9** | M419 | **E11** | **H9** | M420 | **E12** | **H9** |
| M421 | **E13** | **H9** | M422 | **E14** | **H9** | M423 | **E15** | **H9** |
| M424 | **E16** | **H9** | M425 | **E17** | **H9** | M426 | **E18** | **H9** |
| M427 | **E19** | **H9** | M428 | **E20** | **H9** | M429 | **E21** | **H9** |
| M430 | **E22** | **H9** | M431 | **E23** | **H9** | M432 | **E24** | **H9** |
| M433 | **E25** | **H9** | M434 | **E26** | **H9** | M435 | **E27** | **H9** |
| M436 | **E28** | **H9** | M437 | **E29** | **H9** | M438 | **E30** | **H9** |
| M439 | **E31** | **H9** | M440 | **E32** | **H9** | M441 | **E33** | **H9** |
| M442 | **E34** | **H9** | M443 | **E35** | **H9** | M444 | **E36** | **H9** |
| M445 | **E37** | **H9** | M446 | **E38** | **H9** | M447 | **E39** | **H9** |

(fortgesetzt)

| | | | | | | | | |
|---|---|---|---|---|---|---|---|---|
| M448 | **E40** | **H9** | M449 | **E41** | **H9** | M450 | **E42** | **H9** |
| M451 | **E43** | **H9** | M452 | **E44** | **H9** | M453 | **E45** | **H9** |
| M454 | **E46** | **H9** | M455 | **E47** | **H9** | M456 | **E48** | **H9** |
| M457 | **E49** | **H9** | M458 | **E50** | **H9** | M459 | **E51** | **H9** |
| M460 | **E1** | **H10** | M461 | **E2** | **H10** | M462 | **E3** | **H10** |
| M463 | **E4** | **H10** | M464 | **E5** | **H10** | M465 | **E6** | **H10** |
| M466 | **E7** | **H10** | M467 | **E8** | **H10** | M468 | **E9** | **H10** |
| M469 | **E10** | **H10** | M470 | **E11** | **H10** | M471 | **E12** | **H10** |
| M472 | **E13** | **H10** | M473 | **E14** | **H10** | M474 | **E15** | **H10** |
| M475 | **E16** | **H10** | M476 | **E17** | **H10** | M477 | **E18** | **H10** |
| M478 | **E19** | **H10** | M479 | **E20** | **H10** | M480 | **E21** | **H10** |
| M481 | **E22** | **H10** | M482 | **E23** | **H10** | M483 | **E24** | **H10** |
| M484 | **E25** | **H10** | M485 | **E26** | **H10** | M486 | **E27** | **H10** |
| M487 | **E28** | **H10** | M488 | **E29** | **H10** | M489 | **E30** | **H10** |
| M490 | **E31** | **H10** | M491 | **E32** | **H10** | M492 | **E33** | **H10** |
| M493 | **E34** | **H10** | M494 | **E35** | **H10** | M495 | **E36** | **H10** |
| M496 | **E37** | **H10** | M497 | **E38** | **H10** | M498 | **E39** | **H10** |
| M499 | **E40** | **H10** | M500 | **E41** | **H10** | M501 | **E42** | **H10** |
| M502 | **E43** | **H10** | M503 | **E44** | **H10** | M504 | **E45** | **H10** |
| M505 | **E46** | **H10** | M506 | **E47** | **H10** | M507 | **E48** | **H10** |
| M508 | **E49** | **H10** | M509 | **E50** | **H10** | M510 | **E51** | **H10** |
| M511 | **E1** | **H11** | M512 | **E2** | **H11** | M513 | **E3** | **H11** |
| M514 | **E4** | **H11** | M515 | **E5** | **H11** | M516 | **E6** | **H11** |
| M517 | **E7** | **H11** | M518 | **E8** | **H11** | M519 | **E9** | **H11** |
| M520 | **E10** | **H11** | M521 | **E11** | **H11** | M522 | **E12** | **H11** |
| M523 | **E13** | **H11** | M524 | **E14** | **H11** | M525 | **E15** | **H11** |
| M526 | **E16** | **H11** | M527 | **E17** | **H11** | M528 | **E18** | **H11** |
| M529 | **E19** | **H11** | M530 | **E20** | **H11** | M531 | **E21** | **H11** |
| M532 | **E22** | **H11** | M533 | **E23** | **H11** | M534 | **E24** | **H11** |
| M535 | **E25** | **H11** | M536 | **E26** | **H11** | M537 | **E27** | **H11** |
| M538 | **E28** | **H11** | M539 | **E29** | **H11** | M540 | **E30** | **H11** |
| M541 | **E31** | **H11** | M542 | **E32** | **H11** | M543 | **E33** | **H11** |
| M544 | **E34** | **H11** | M545 | **E35** | **H11** | M546 | **E36** | **H11** |
| M547 | **E37** | **H11** | M548 | **E38** | **H11** | M549 | **E39** | **H11** |
| M550 | **E40** | **H11** | M551 | **E41** | **H11** | M552 | **E42** | **H11** |
| M553 | **E43** | **H11** | M554 | **E44** | **H11** | M555 | **E45** | **H11** |
| M556 | **E46** | **H11** | M557 | **E47** | **H11** | M558 | **E48** | **H11** |
| M559 | **E49** | **H11** | M560 | **E50** | **H11** | M561 | **E51** | **H11** |
| M562 | **E1** | **H12** | M563 | **E2** | **H12** | M564 | **E3** | **H12** |
| M565 | **E4** | **H12** | M566 | **E5** | **H12** | M567 | **E6** | **H12** |

(fortgesetzt)

| | | | | | | | | |
|---|---|---|---|---|---|---|---|---|
| M568 | **E7** | **H12** | M569 | **E8** | **H12** | M570 | **E9** | **H12** |
| M571 | **E10** | **H12** | M572 | **E11** | **H12** | M573 | **E12** | **H12** |
| M574 | **E13** | **H12** | M575 | **E14** | **H12** | M576 | **E15** | **H12** |
| M577 | **E16** | **H12** | M578 | **E17** | **H12** | M579 | **E18** | **H12** |
| M580 | **E19** | **H12** | M581 | **E20** | **H12** | M582 | **E21** | **H12** |
| M583 | **E22** | **H12** | M584 | **E23** | **H12** | M585 | **E24** | **H12** |
| M586 | **E25** | **H12** | M587 | **E26** | **H12** | M588 | **E27** | **H12** |
| M589 | **E28** | **H12** | M590 | **E29** | **H12** | M591 | **E30** | **H12** |
| M592 | **E31** | **H12** | M593 | **E32** | **H12** | M594 | **E33** | **H12** |
| M595 | **E34** | **H12** | M596 | **E35** | **H12** | M597 | **E36** | **H12** |
| M598 | **E37** | **H12** | M599 | **E38** | **H12** | M600 | **E39** | **H12** |
| M601 | **E40** | **H12** | M602 | **E41** | **H12** | M603 | **E42** | **H12** |
| M604 | **E43** | **H12** | M605 | **E44** | **H12** | M606 | **E45** | **H12** |
| M607 | **E46** | **H12** | M608 | **E47** | **H12** | M609 | **E48** | **H12** |
| M610 | **E49** | **H12** | M611 | **E50** | **H12** | M612 | **E51** | **H12** |
| M613 | **E1** | **H13** | M614 | **E2** | **H13** | M615 | **E3** | **H13** |
| M616 | **E4** | **H13** | M617 | **E5** | **H13** | M618 | **E6** | **H13** |
| M619 | **E7** | **H13** | M620 | **E8** | **H13** | M621 | **E9** | **H13** |
| M622 | **E10** | **H13** | M623 | **E11** | **H13** | M624 | **E12** | **H13** |
| M625 | **E13** | **H13** | M626 | **E14** | **H13** | M627 | **E15** | **H13** |
| M628 | **E16** | **H13** | M629 | **E17** | **H13** | M630 | **E18** | **H13** |
| M631 | **E19** | **H13** | M632 | **E20** | **H13** | M633 | **E21** | **H13** |
| M634 | **E22** | **H13** | M635 | **E23** | **H13** | M636 | **E24** | **H13** |
| M637 | **E25** | **H13** | M638 | **E26** | **H13** | M639 | **E27** | **H13** |
| M640 | **E28** | **H13** | M641 | **E29** | **H13** | M642 | **E30** | **H13** |
| M643 | **E31** | **H13** | M644 | **E32** | **H13** | M645 | **E33** | **H13** |
| M646 | **E34** | **H13** | M647 | **E35** | **H13** | M648 | **E36** | **H13** |
| M649 | **E37** | **H13** | M650 | **E38** | **H13** | M651 | **E39** | **H13** |
| M652 | **E40** | **H13** | M653 | **E41** | **H13** | M654 | **E42** | **H13** |
| M655 | **E43** | **H13** | M656 | **E44** | **H13** | M657 | **E45** | **H13** |
| M658 | **E46** | **H13** | M659 | **E47** | **H13** | M660 | **E48** | **H13** |
| M661 | **E49** | **H13** | M662 | **E50** | **H13** | M663 | **E51** | **H13** |
| M664 | **E1** | **H14** | M665 | **E2** | **H14** | M666 | **E3** | **H14** |
| M667 | **E4** | **H14** | M668 | **E5** | **H14** | M669 | **E6** | **H14** |
| M670 | **E7** | **H14** | M671 | **E8** | **H14** | M672 | **E9** | **H14** |
| M673 | **E10** | **H14** | M674 | **E11** | **H14** | M675 | **E12** | **H14** |
| M676 | **E13** | **H14** | M677 | **E14** | **H14** | M678 | **E15** | **H14** |
| M679 | **E16** | **H14** | M680 | **E17** | **H14** | M681 | **E18** | **H14** |
| M682 | **E19** | **H14** | M683 | **E20** | **H14** | M684 | **E21** | **H14** |
| M685 | **E22** | **H14** | M686 | **E23** | **H14** | M687 | **E24** | **H14** |

(fortgesetzt)

| | | | | | | | | |
|---|---|---|---|---|---|---|---|---|
| M688 | **E25** | **H14** | M689 | **E26** | **H14** | M690 | **E27** | **H14** |
| M691 | **E28** | **H14** | M692 | **E29** | **H14** | M693 | **E30** | **H14** |
| M694 | **E31** | **H14** | M695 | **E32** | **H14** | M696 | **E33** | **H14** |
| M697 | **E34** | **H14** | M698 | **E35** | **H14** | M699 | **E36** | **H14** |
| M700 | **E37** | **H14** | M701 | **E38** | **H14** | M702 | **E39** | **H14** |
| M703 | **E40** | **H14** | M704 | **E41** | **H14** | M705 | **E42** | **H14** |
| M706 | **E43** | **H14** | M707 | **E44** | **H14** | M708 | **E45** | **H14** |
| M709 | **E46** | **H14** | M710 | **E47** | **H14** | M711 | **E48** | **H14** |
| M712 | **E49** | **H14** | M713 | **E50** | **H14** | M714 | **E51** | **H14** |
| M715 | **E1** | **H15** | M716 | **E2** | **H15** | M717 | **E3** | **H15** |
| M718 | **E4** | **H15** | M719 | **E5** | **H15** | M720 | **E6** | **H15** |
| M721 | **E7** | **H15** | M722 | **E8** | **H15** | M723 | **E9** | **H15** |
| M724 | **E10** | **H15** | M725 | **E11** | **H15** | M726 | **E12** | **H15** |
| M727 | **E13** | **H15** | M728 | **E14** | **H15** | M729 | **E15** | **H15** |
| M730 | **E16** | **H15** | M731 | **E17** | **H15** | M732 | **E18** | **H15** |
| M733 | **E19** | **H15** | M734 | **E20** | **H15** | M735 | **E21** | **H15** |
| M736 | **E22** | **H15** | M737 | **E23** | **H15** | M738 | **E24** | **H15** |
| M739 | **E25** | **H15** | M740 | **E26** | **H15** | M741 | **E27** | **H15** |
| M742 | **E28** | **H15** | M743 | **E29** | **H15** | M744 | **E30** | **H15** |
| M745 | **E31** | **H15** | M746 | **E32** | **H15** | M747 | **E33** | **H15** |
| M748 | **E34** | **H15** | M749 | **E35** | **H15** | M750 | **E36** | **H15** |
| M751 | **E37** | **H15** | M752 | **E38** | **H15** | M753 | **E39** | **H15** |
| M754 | **E40** | **H15** | M755 | **E41** | **H15** | M756 | **E42** | **H15** |
| M757 | **E43** | **H15** | M758 | **E44** | **H15** | M759 | **E45** | **H15** |
| M760 | **E46** | **H15** | M761 | **E47** | **H15** | M762 | **E48** | **H15** |
| M763 | **E49** | **H15** | M764 | **E50** | **H15** | M765 | **E51** | **H15** |

Die Konzentration des elektronentransportierenden Hostmaterials der Formel (1), wie zuvor beschrieben oder bevorzugt beschrieben, in der erfindungsgemäßen Mischung oder in der lichtemittierenden Schicht der erfindungsgemäßen Vorrichtung liegt im Bereich von 5 Gew.-% bis 90 Gew.-%, bevorzugt im Bereich von 10 Gew.-% bis 85 Gew.-%, mehr bevorzugt im Bereich von 20 Gew.-% bis 85 Gew.-%, noch mehr bevorzugt im Bereich von 30 Gew.-% bis 80 Gew.-%, ganz besonders bevorzugt im Bereich von 20 Gew.-% bis 60 Gew.-% und am meisten bevorzugt im Bereich von 30 Gew.-% bis 50 Gew.-%, bezogen auf die gesamte Mischung oder bezogen auf die gesamte Zusammensetzung der lichtemittierenden Schicht.

Die Konzentration des lochtransportierenden Hostmaterials der Formel (2), wie zuvor beschrieben oder als bevorzugt beschrieben, in der erfindungsgemäßen Mischung oder in der lichtemittierenden Schicht der erfindungsgemäßen Vorrichtung liegt im Bereich von 10 Gew.-% bis 95 Gew.-%, bevorzugt im Bereich von 15 Gew.-% bis 90 Gew.-%, mehr bevorzugt im Bereich von 15 Gew.-% bis 80 Gew.-%, noch mehr bevorzugt im Bereich von 20 Gew.-% bis 70 Gew.-%, ganz besonders bevorzugt im Bereich von 40 Gew.-% bis 80 Gew.-% und am meisten bevorzugt im Bereich von 50 Gew.-% bis 70 Gew.-%, bezogen auf die gesamte Mischung oder bezogen auf die gesamte Zusammensetzung der lichtemittierenden Schicht.

Die vorliegende Erfindung betrifft auch eine Mischung, die neben den vorstehend genannten Hostmaterialien 1 und 2, wie zuvor beschrieben oder bevorzugt beschrieben, insbesondere Mischungen M1 bis M765, mindestens noch einen phosphoreszierenden Emitter enthält.

Die vorliegende Erfindung betrifft auch eine organische elektrolumineszierende Vorrichtung, wie zuvor beschrieben oder bevorzugt beschrieben, wobei die lichtemittierende Schicht neben den vorstehend genannten Hostmaterialien 1 und 2, wie zuvor beschrieben oder bevorzugt beschrieben, insbesondere den Materialkombinationen M1 bis M765, mindestens noch einen phosphoreszierenden Emitter enthält.

Vom Begriff phosphoreszierende Emitter sind typischerweise Verbindungen umfasst, bei denen die Lichtemission durch einen spin-verbotenen Übergang aus einem angeregten Zustand mit höherer Spinmultiplizität, also einem Spinzustand > 1, erfolgt, beispielsweise durch einen Übergang aus einem Triplett-Zustand oder einem Zustand mit einer noch höheren Spinquantenzahl, beispielsweise einem Quintett-Zustand. Bevorzugt wird hierbei ein Übergang aus einem Triplett-Zustand verstanden.

Als phosphoreszierende Emitter (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten. Im Sinne der vorliegenden Erfindung werden alle lumineszierenden Verbindungen, die die oben genannten Metalle enthalten, als phosphoreszierende Emitter angesehen.

Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind.

Bevorzugte phosphoreszierende Emitter gemäß der vorliegenden Erfindung entsprechen der Formel (IIIa),

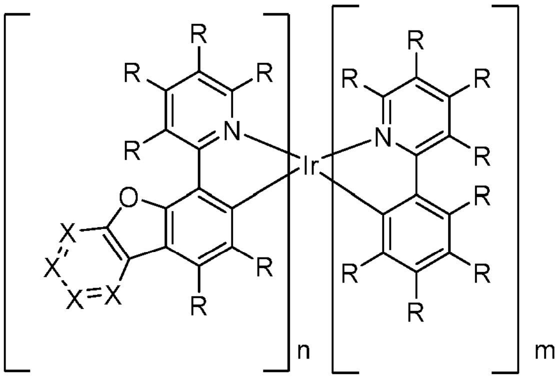

Formel (IIIa),

wobei die Symbole und Indizes für diese Formel (IIIa) die Bedeutung haben:

n+m ist 3, n ist 1 oder 2, m ist 2 oder 1,
X ist N oder CR,
R ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 7 C-Atomen, die teilweise oder vollständig mit Deuterium substituiert sein kann.

Ein weiterer Gegenstand der Erfindung ist demzufolge eine organische elektrolumineszierende Vorrichtung, wie zuvor beschrieben oder bevorzugt beschrieben, dadurch gekennzeichnet, dass die lichtemittierende Schicht neben den Hostmaterialien 1 und 2 mindestens einen phosphoreszierenden Emitter enthält, der der Formel (IIIa) entspricht, wie zuvor beschrieben.

In Emittern der Formel (IIIa) ist n bevorzugt 1 und m ist bevorzugt 2.

In Emittern der Formel (IIIa) ist bevorzugt ein X ausgewählt aus N und die anderen X bedeuten CR.

In Emittern der Formel (IIIa) ist mindestens ein R bevorzugt unterschiedlich von H. In Emittern der Formel (IIIa) sind bevorzugt zwei R unterschiedlich von H und haben eine der sonst zuvor für die Emitter der Formel (IIIa) angegebenen Bedeutungen.

Bevorzugte phosphoreszierende Emitter gemäß der vorliegenden Erfindung entsprechen den Formeln (I), (II), (III), (IV) oder (V),

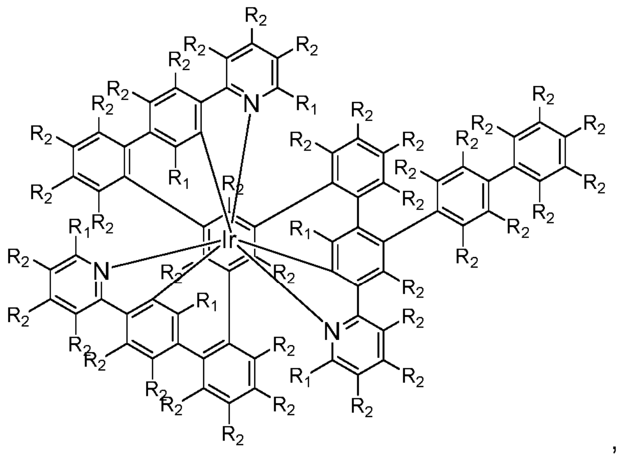

Formel (I) ,

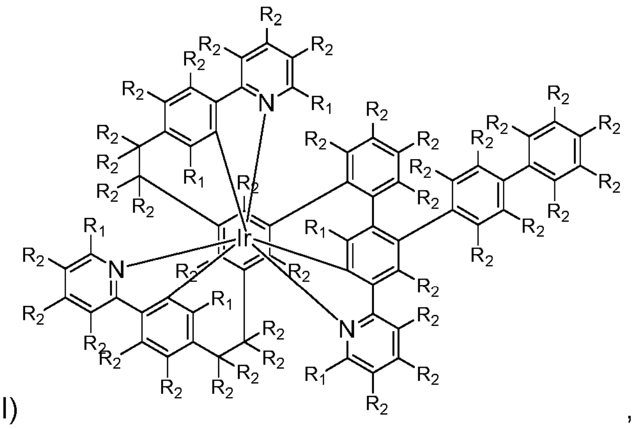

Formel (II) ,

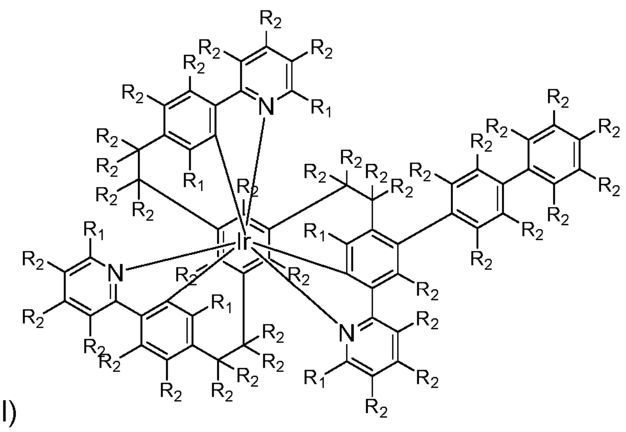

Formel (III) ,

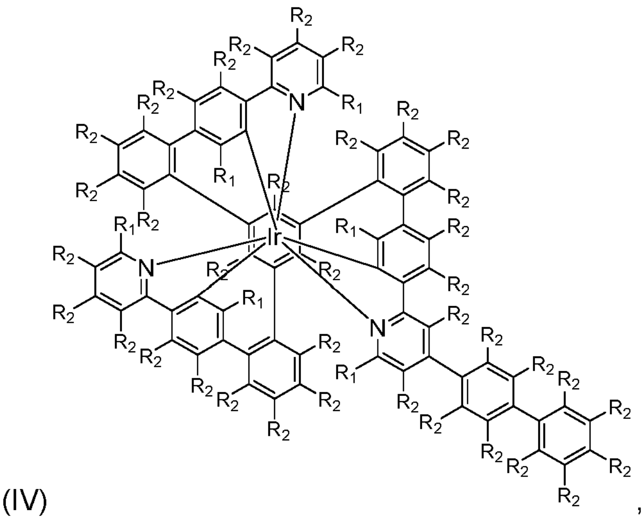

Formel (IV) ,

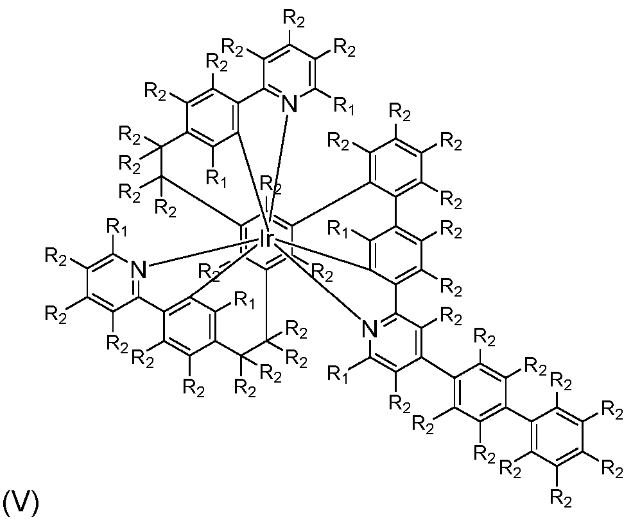

Formel (V) ,

wobei die Symbole und Indizes für diese Formeln (I), (II), (III), (IV) und (V) die Bedeutung haben:

$R_1$ ist H oder D, $R_2$ ist H, D oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 10 C-Atomen, die teilweise oder vollständig mit Deuterium substituiert sein kann.

Bevorzugte phosphoreszierende Emitter gemäß der vorliegenden Erfindung entsprechen den Formeln (VI), (VII) oder (VIII),

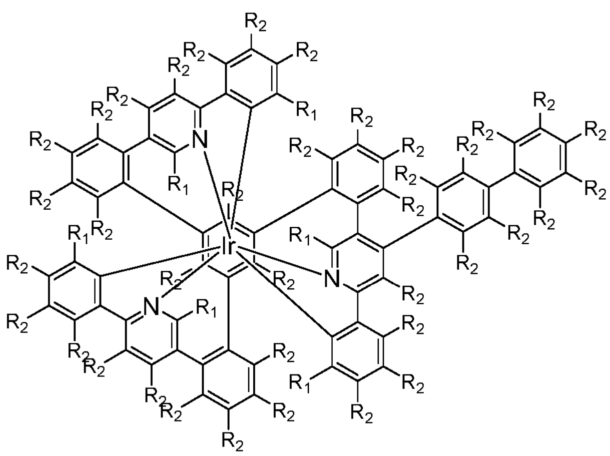

Formel (VI) ,

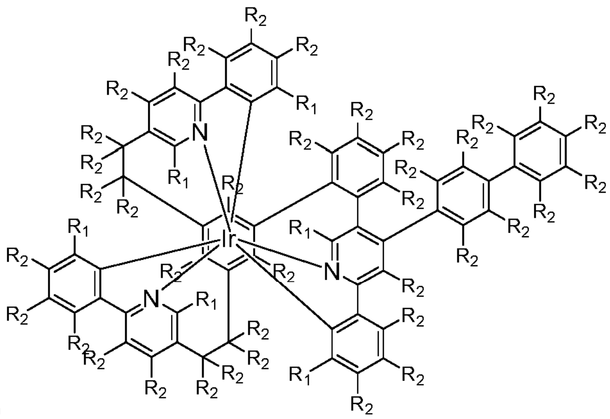

Formel (VII) ,

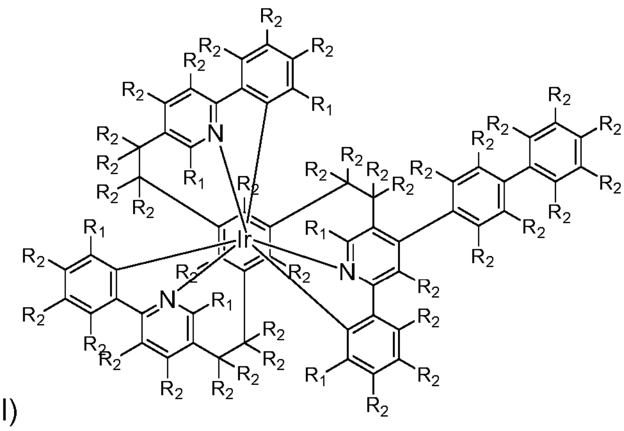

Formel (VIII) ,

wobei die Symbole und Indizes für diese Formeln (VI), (VII) und (VIII) die Bedeutung haben:

$R_1$ ist H oder D, $R_2$ ist H, D, F oder eine verzweigte oder lineare Alkylgruppe mit 1 bis 10 C-Atomen oder eine teilweise oder vollständig deuterierte verzweigte oder lineare Alkylgruppe mit 1 bis 10 C-Atomen oder eine Cycloalkylgruppe mit 4 bis 10 C-Atomen, die teilweise oder vollständig mit Deuterium substituiert sein kann.

Bevorzugte Beispiele von phosphoreszierenden Emittern sind in WO2019007867 auf den Seiten 120 bis 126 in Tabelle 5 und auf den Seiten 127 bis 129 in Tabelle 6 beschrieben. Die Emitter sind durch diese Referenz in die Beschreibung aufgenommen.

Besonders bevorzugte Beispiele von phosphoreszierenden Emittern sind in der folgenden Tabelle 6 aufgeführt.

Tabelle 6:

| | | |
|---|---|---|
| 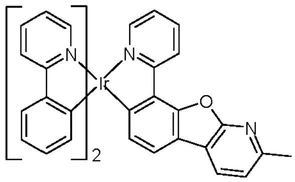 | 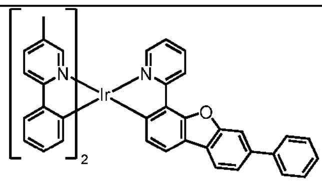 | 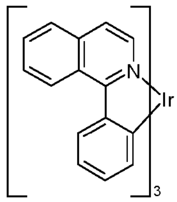 |
| 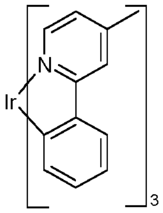 | 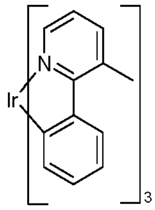 | 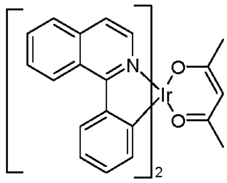 |
| 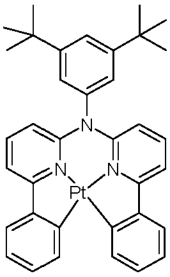 | 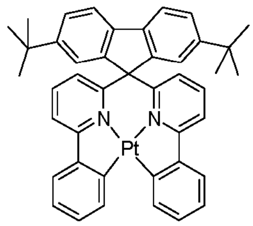 | 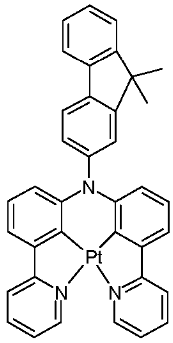 |
| 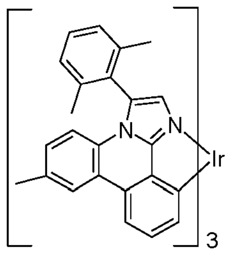 | 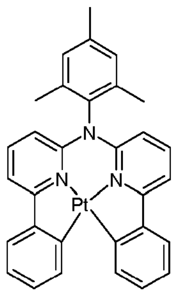 | 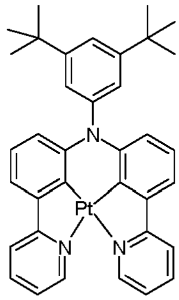 |
| 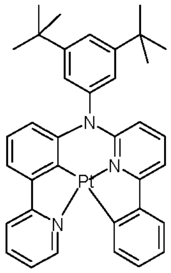 | 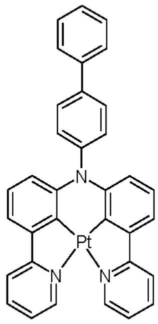 | 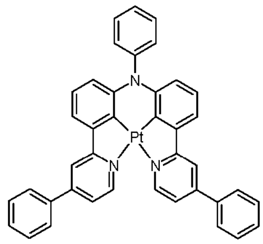 |

| | | |
|---|---|---|
| 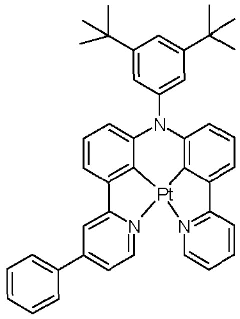 | 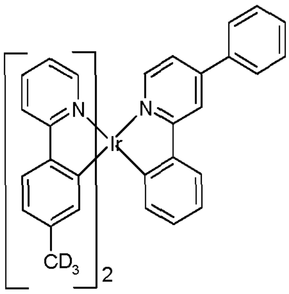 | 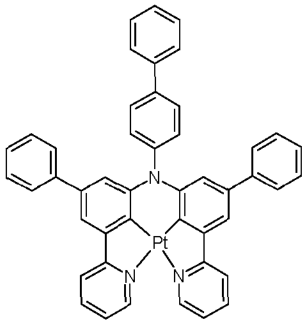 |
| 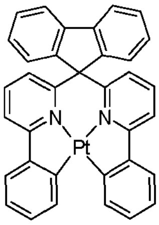 | 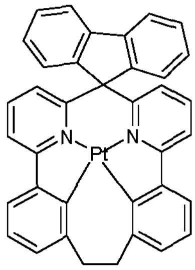 | 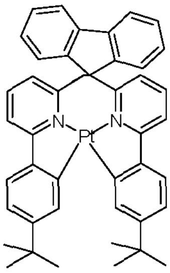 |
| 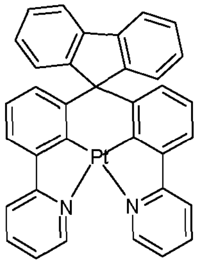 | 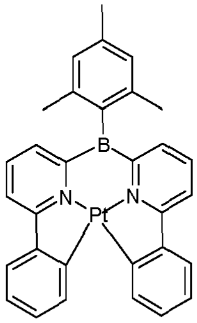 | 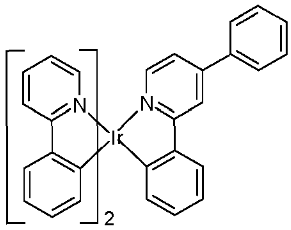 |
| 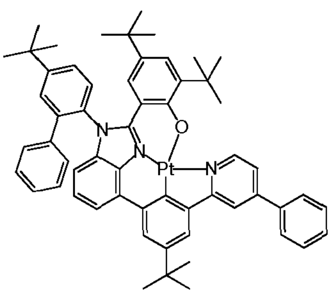 | 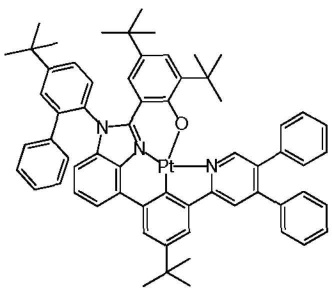 | 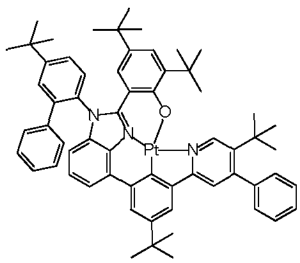 |
| 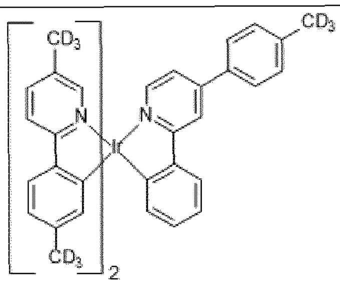 | 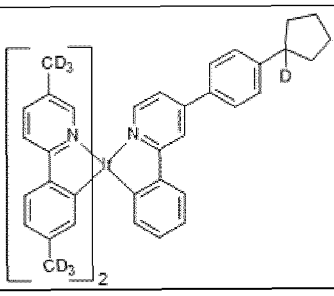 | 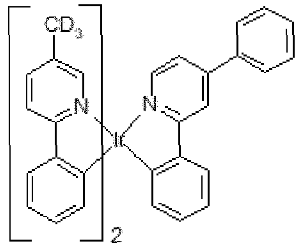 |

| | | |
|---|---|---|
| 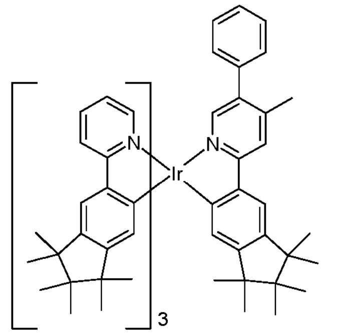 | 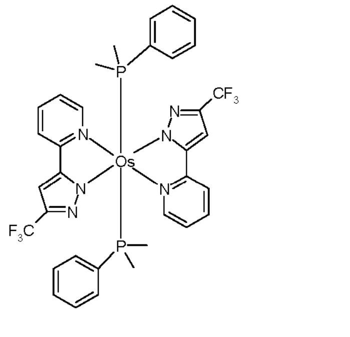 | 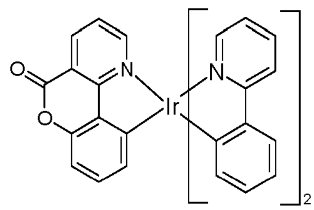 |
| 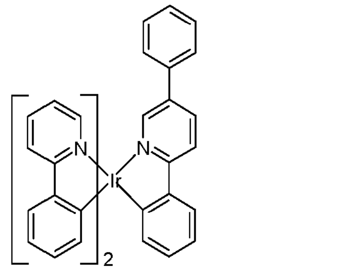 | 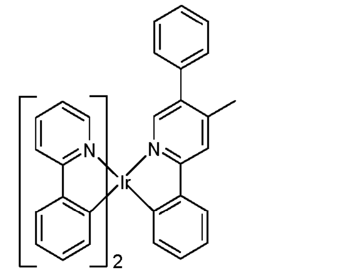 | 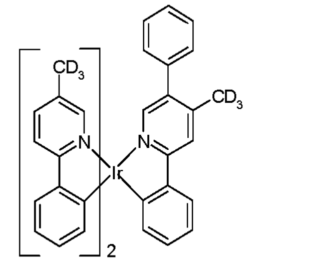 |
| 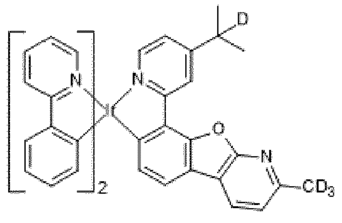 | 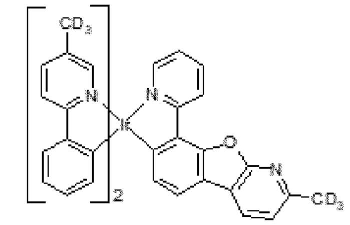 | 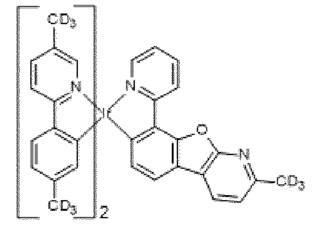 |
| 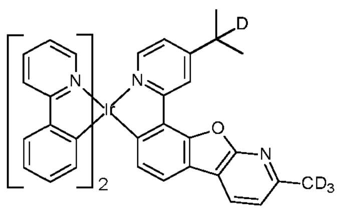 | 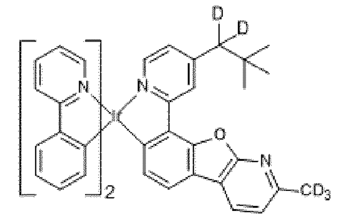 | 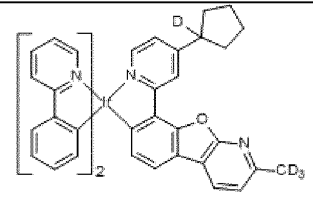 |
| 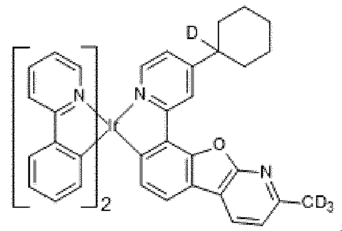 | 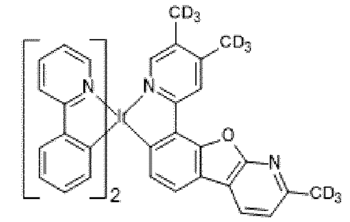 | 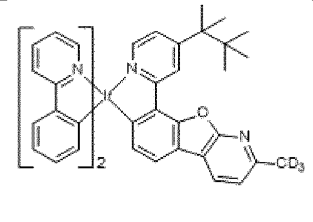 |
| 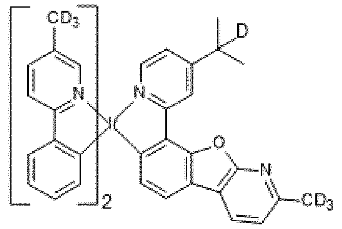 | 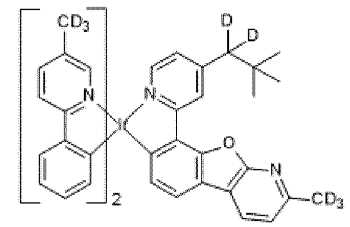 | 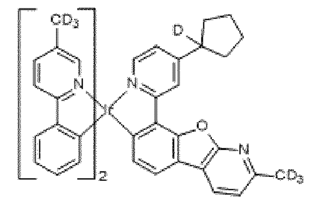 |
| 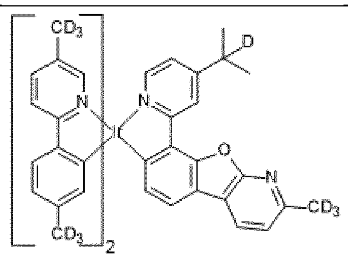 | 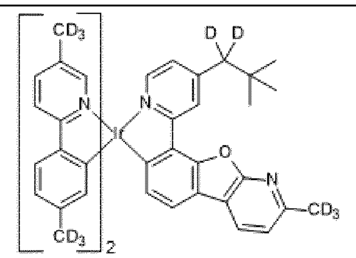 | 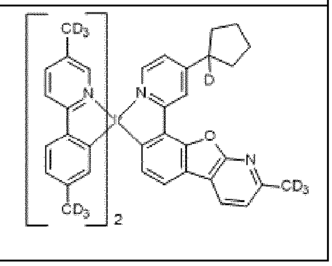 |

| | | |
|---|---|---|
| 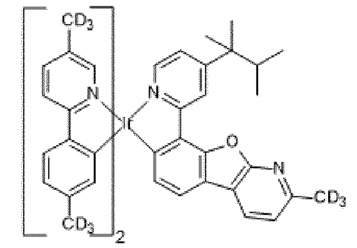 | 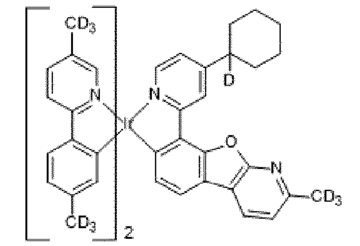 | 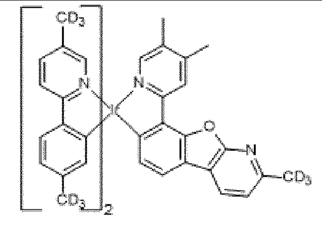 |
| 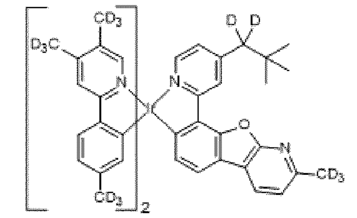 | 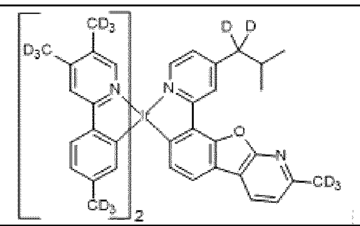 | 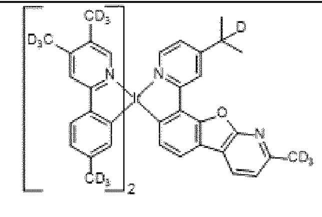 |
| 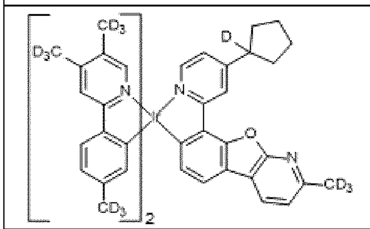 | 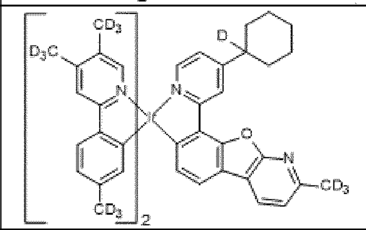 | 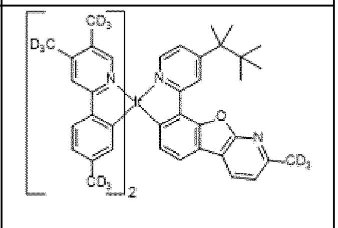 |
| 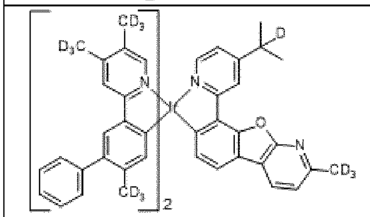 | 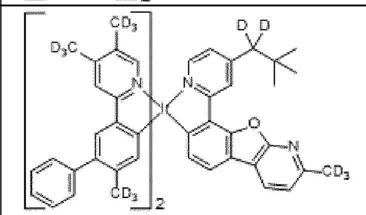 | 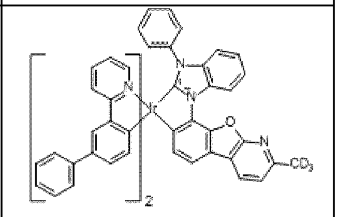 |
| 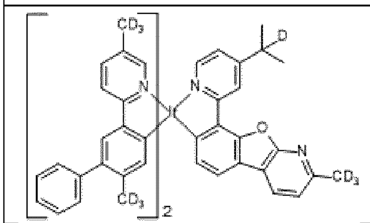 | 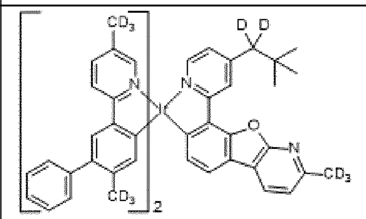 | 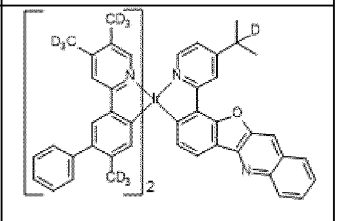 |
| 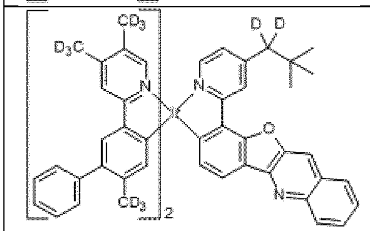 | 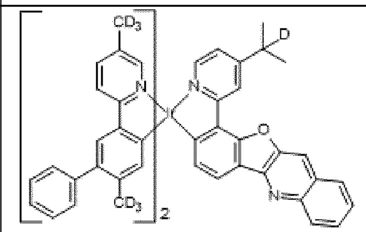 | 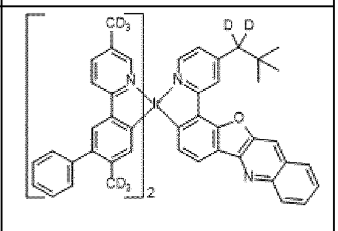 |
| 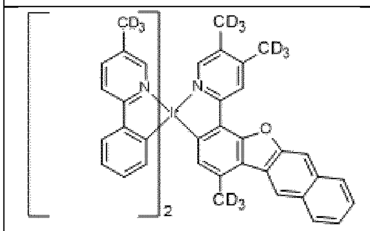 | 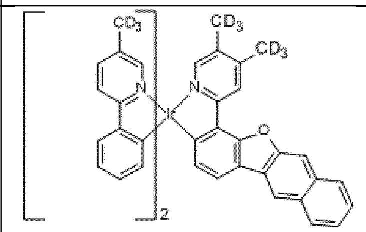 | 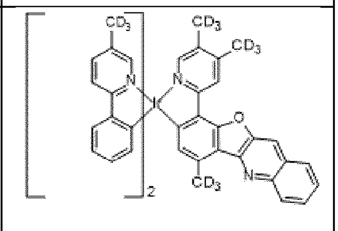 |
| 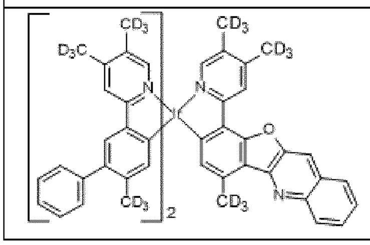 | 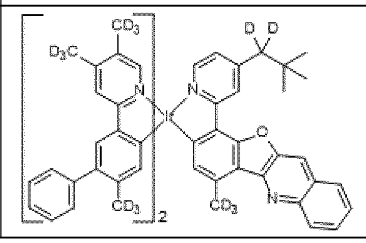 | 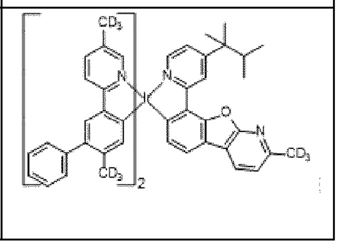 |

| | | |
|---|---|---|
| 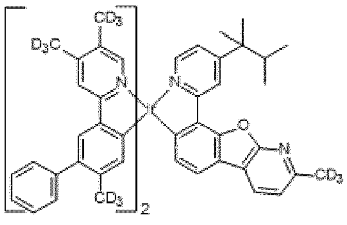 | 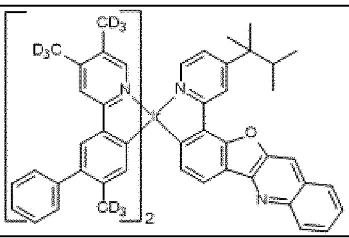 | 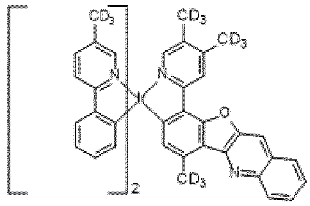 |
| 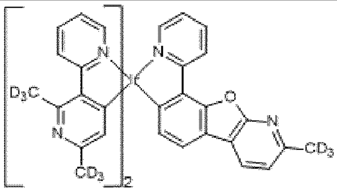 | 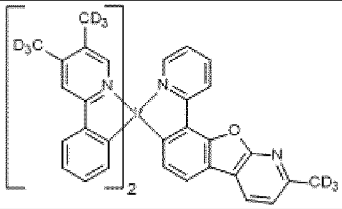 | 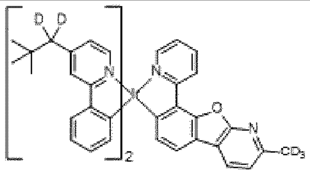 |
| 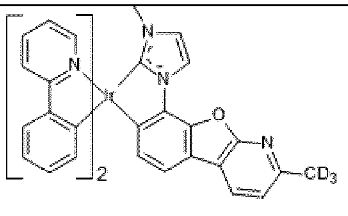 | 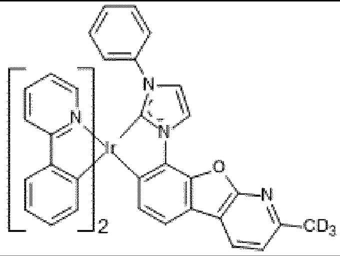 | 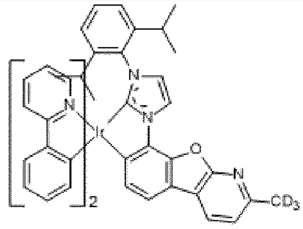 |
| 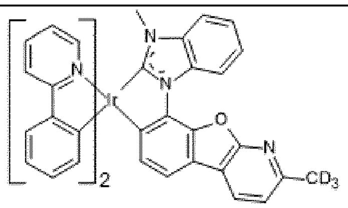 | 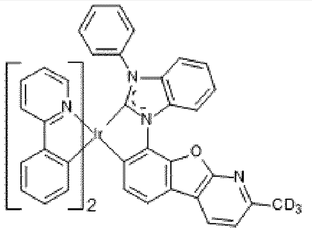 | 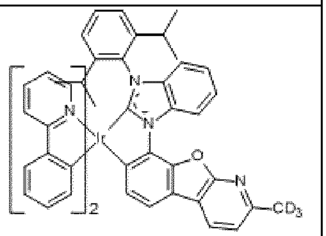 |
| 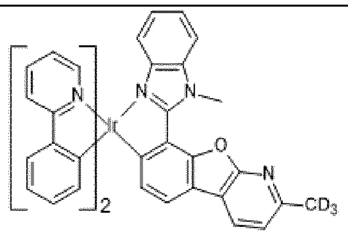 | 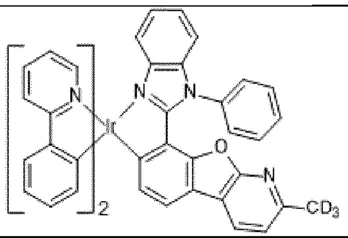 | 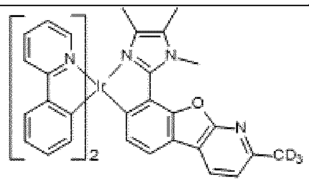 |
| 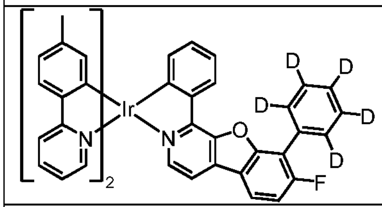 | 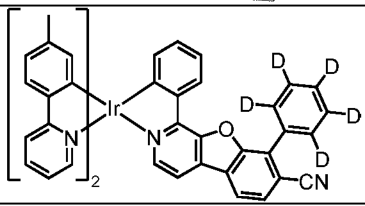 | 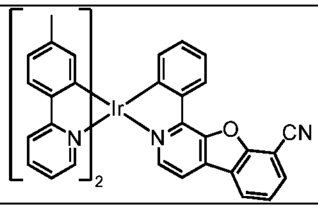 |
| 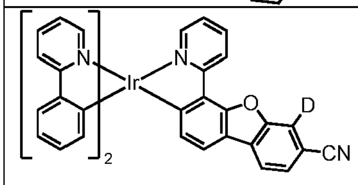 | 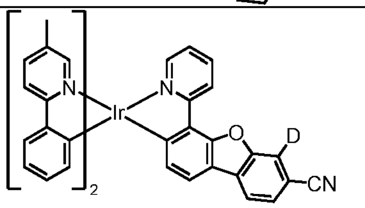 | 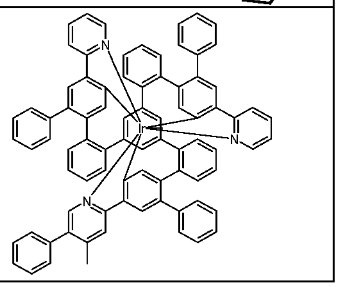 |

| | | |
|---|---|---|
| 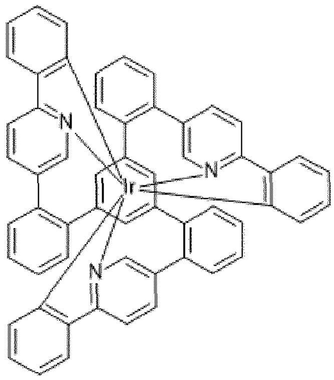 | 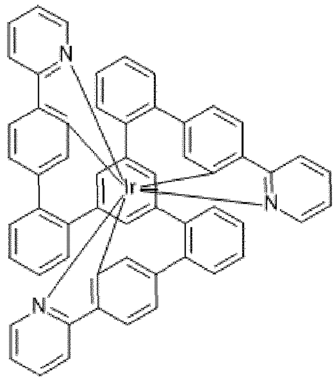 | 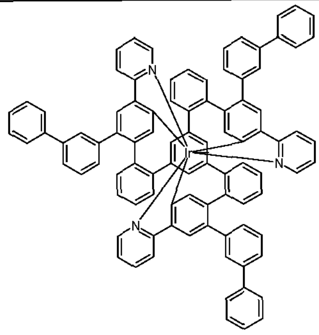 |
| 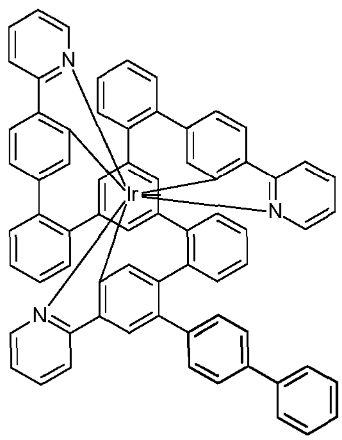 | 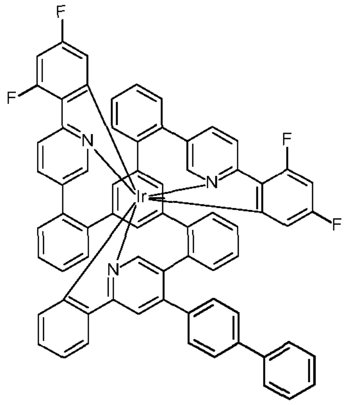 | 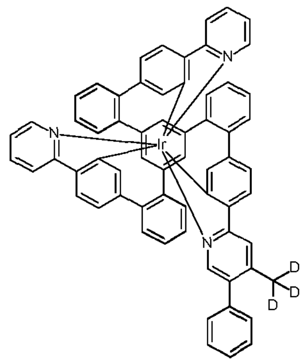 |
| 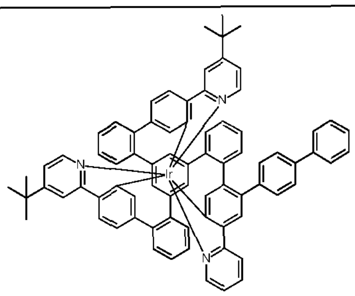 | 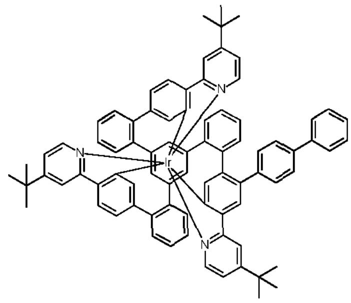 | 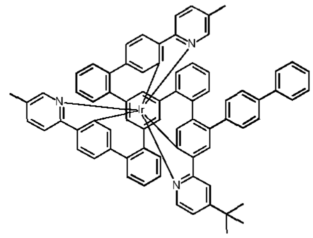 |
| 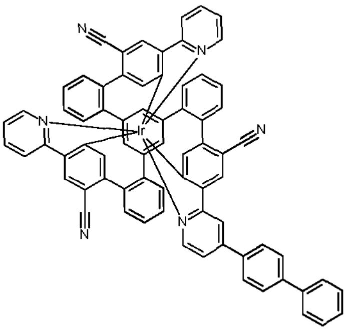 | 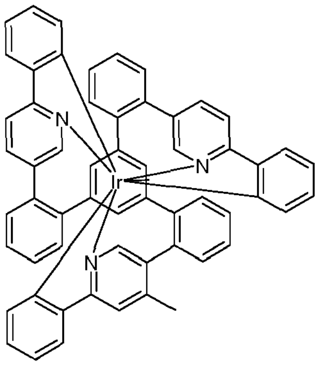 | 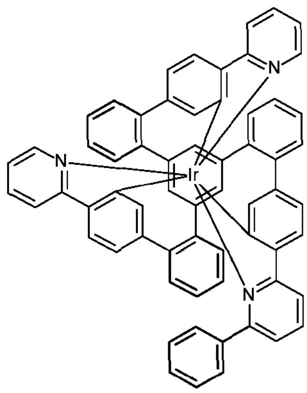 |

| | | |
|---|---|---|
| 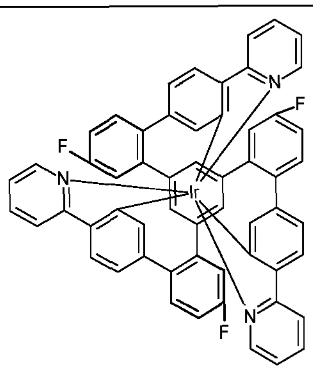 | 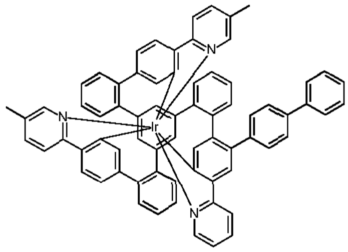 | 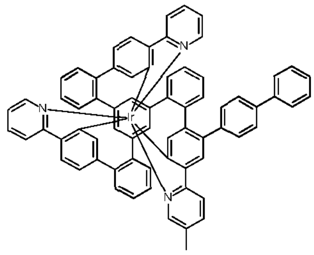 |
| 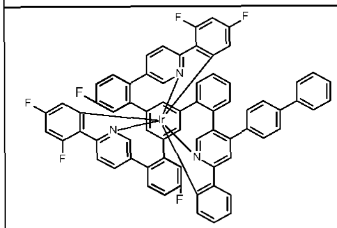 | 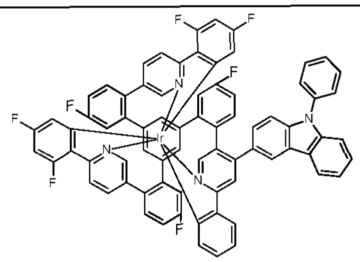 | 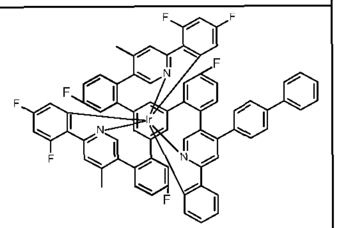 |
| 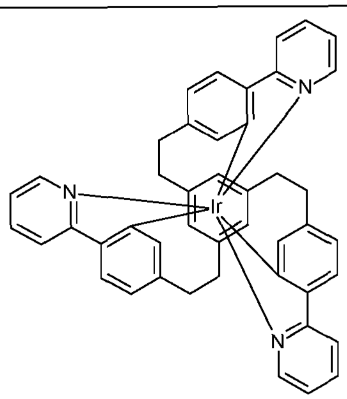 | 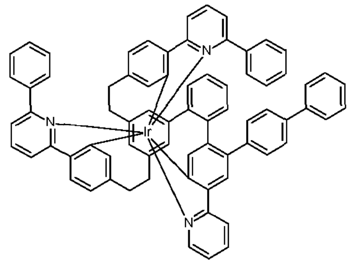 | 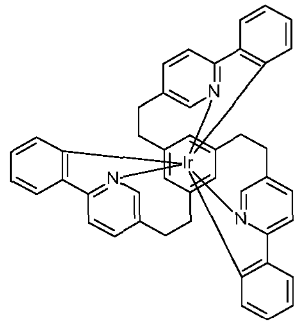 |
| 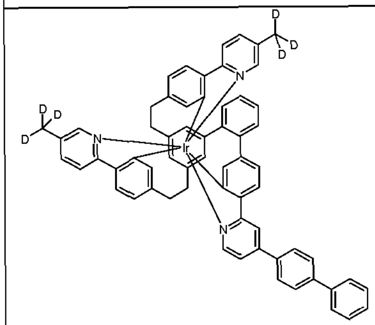 | 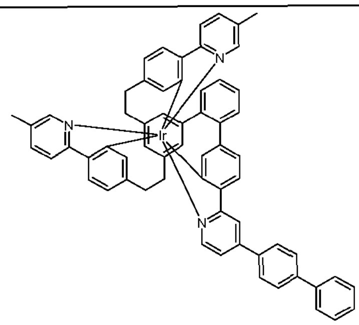 | 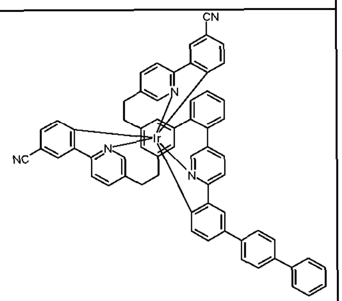 |
| 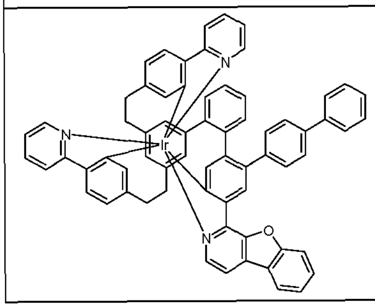 | 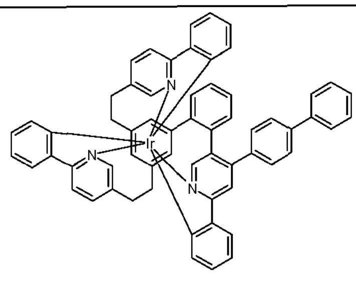 | 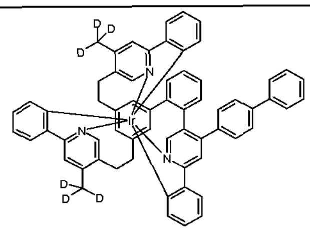 |

| | | |
|---|---|---|
| 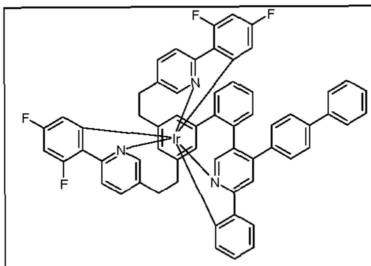 | 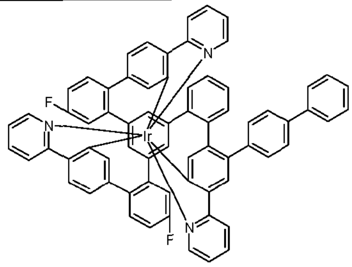 | 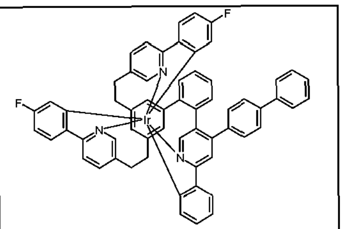 |
| 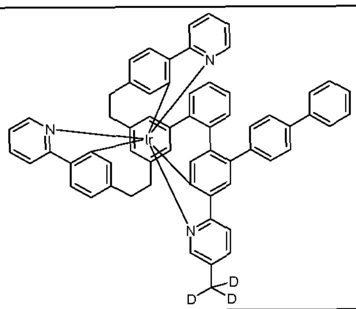 | 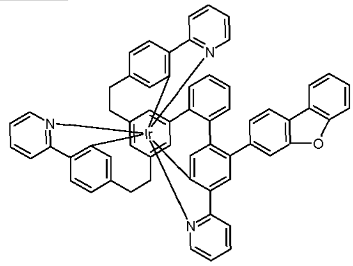 | 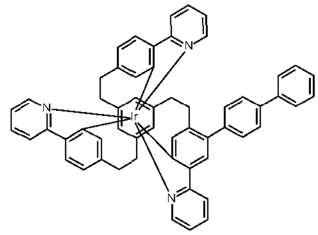 |
| 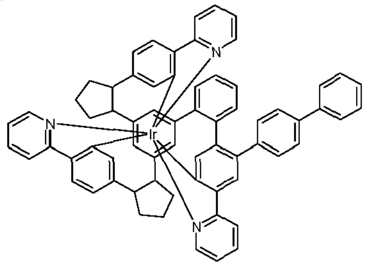 | 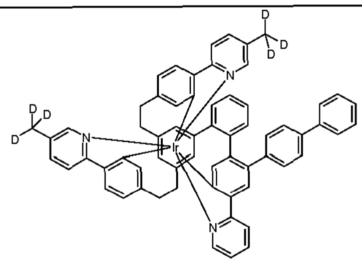 | 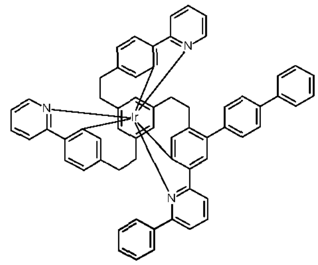 |
| 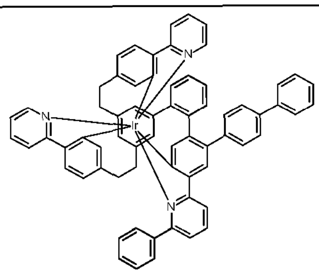 | 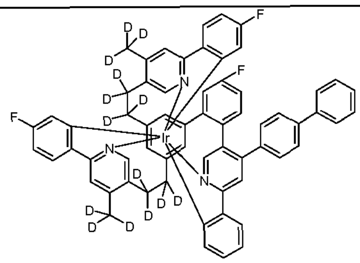 | 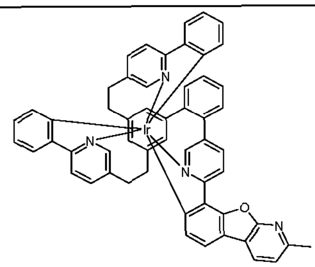 |
| 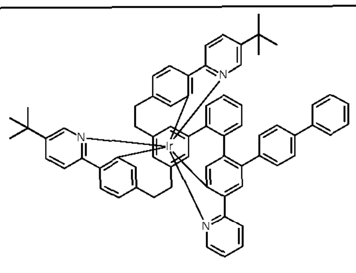 | 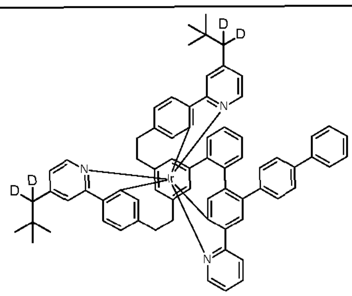 | 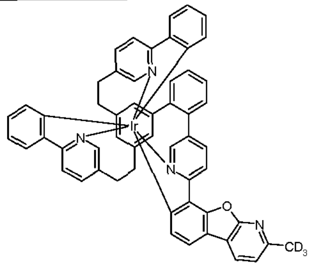 |
| 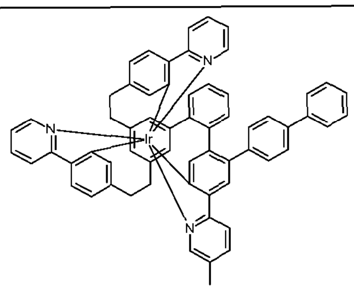 | 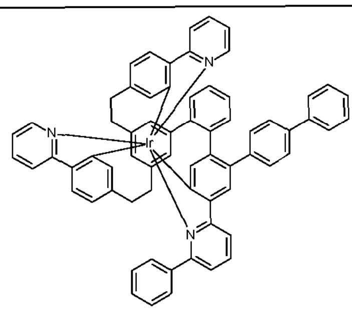 | 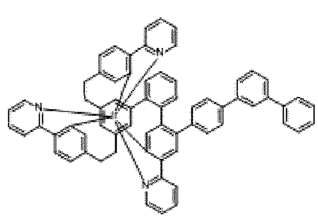 |

| | | |
|---|---|---|
| 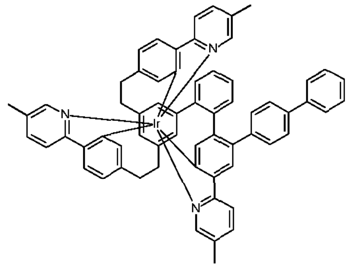 | 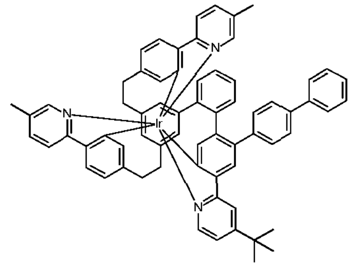 | 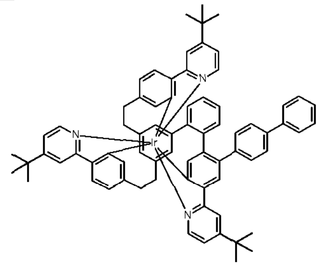 |
| 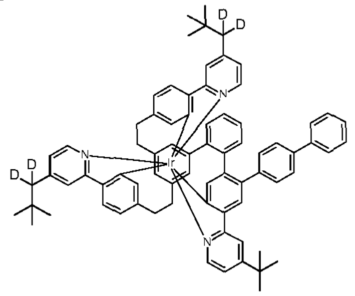 | 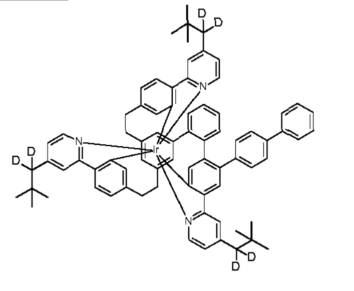 | 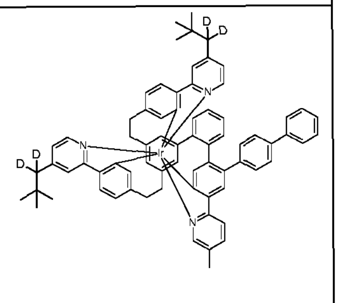 |
| 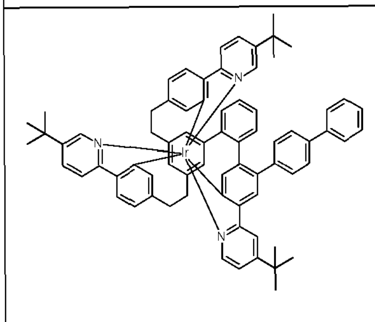 | 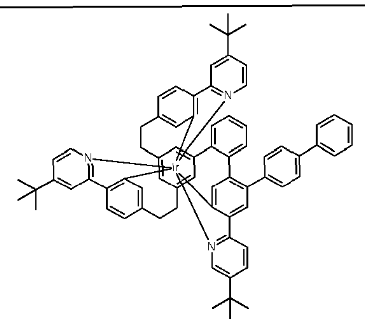 | 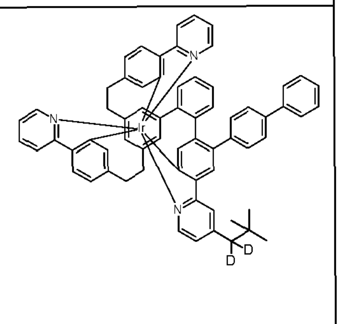 |
| 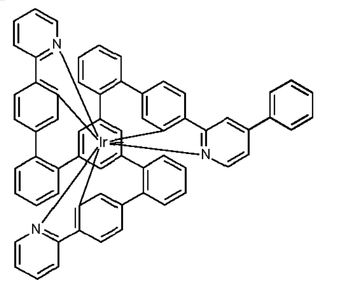 | 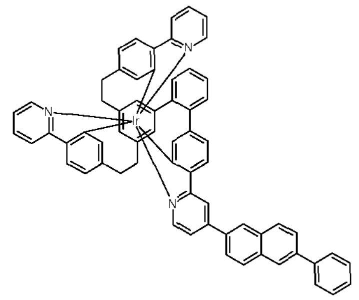 | 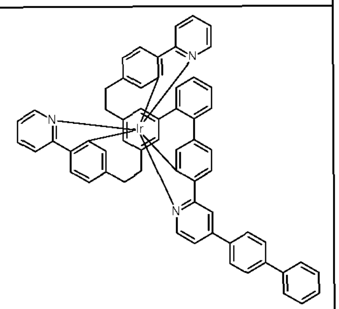 |
| 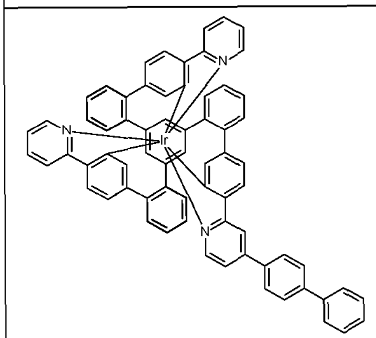 | 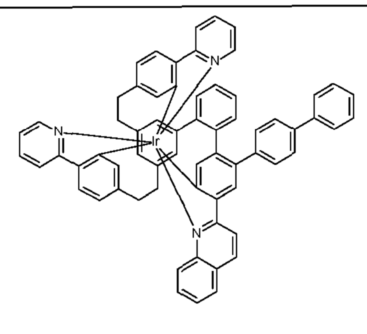 | 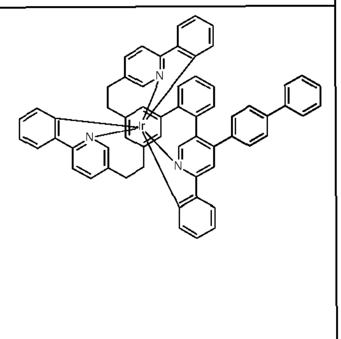 |
| 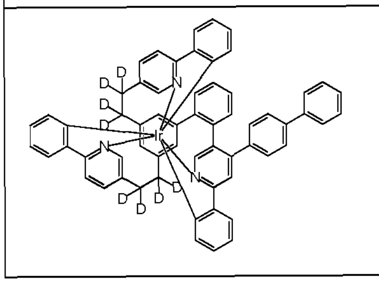 | 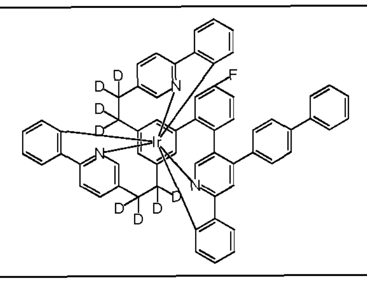 | 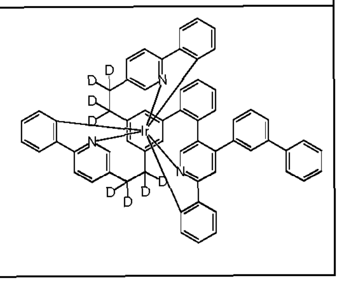 |

| | | |
|---|---|---|
| 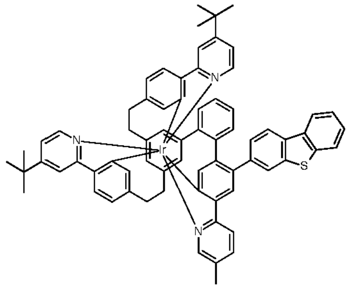 | 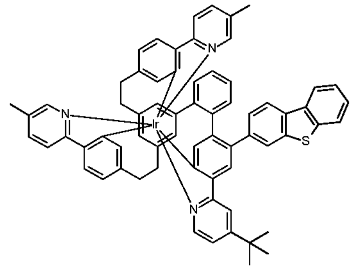 | 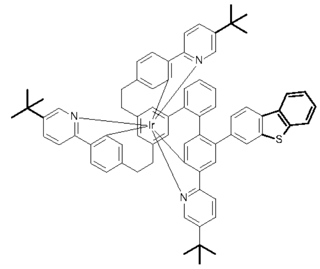 |

In den erfindungsgemäßen Mischungen oder in der lichtemittierenden Schicht der erfindungsgemäßen Vorrichtung wird bevorzugt jede Mischung ausgewählt aus der Summe der Mischungen M1 bis M765 mit einer Verbindung der Formel (IIIa) oder einer Verbindung der Formeln (I) bis (VIII) oder einer Verbindung aus Tabelle 6 kombiniert.

Die lichtemittierende Schicht in der erfindungsgemäßen organischen elektrolumineszierenden Vorrichtung enthaltend mindestens einen phosphoreszierenden Emitter ist bevorzugt eine infra-rot emittierende, gelb, orange, rot, grün, blau oder ultraviolett emittierende Schicht, besonders bevorzugt eine gelb oder grün emittierende Schicht und ganz besonders bevorzugt eine grün emittierende Schicht.

Dabei wird unter einer gelb emittierenden Schicht eine Schicht verstanden, deren Photolumineszenzmaximum im Bereich von 540 bis 570 nm liegt. Unter einer orange emittierenden Schicht wird eine Schicht verstanden, deren Photolumineszenzmaximum im Bereich von 570 bis 600 nm liegt. Unter einer rot emittierenden Schicht wird eine Schicht verstanden, deren Photolumineszenzmaximum im Bereich von 600 bis 750 nm liegt. Unter einer grün emittierenden Schicht wird eine Schicht verstanden, deren Photolumineszenzmaximum im Bereich von 490 bis 540 nm liegt. Unter einer blau emittierenden Schicht wird eine Schicht verstanden, deren Photolumineszenzmaximum im Bereich von 440 bis 490 nm liegt. Dabei wird das Photolumineszenzmaximum der Schicht durch Messung des Photolumineszenzspektrums der Schicht mit einer Schichtdicke von 50 nm bei Raumtemperatur bestimmt, wobei die Schicht die erfindungsgemäße Kombination der Hostmaterialien der Formeln (1) und (2) und den entsprechenden Emitter enthält.

Die Aufnahme des Photolumineszenzspektrums der Schicht erfolgt beispielsweise mit einem handelsüblichen Photolumineszenzspektrometer.

Das Photolumineszenzspektrum des gewählten Emitters wird in der Regel in Sauerstofffreier Lösung, 10-5 molar, gemessen, wobei die Messung bei Raumtemperatur erfolgt und jedes Lösemittel geeignet ist, in dem sich der gewählte Emitter in der genannten Konzentration löst. Besonders geeignete Lösemittel sind üblicherweise Toluol oder 2-Methyl-THF, aber auch Dichlormethan. Gemessen wird mit einem handelsüblichen Photolumineszenzspektrometer. Die Triplettenergie T1 in eV wird aus den Photolumineszenzspektren der Emitter bestimmt. Es wird zunächst das Peakmaximum Plmax. (in nm) des Photolumineszenzspektrums bestimmt. Das Peakmaximum Plmax. (in nm) wird dann in eV umgerechnet gemäß: E(T1 in eV) = 1240/E(T1 in nm) = 1240/PLmax. (in nm).

Bevorzugte phosphoreszierende Emitter sind demzufolge gelbe Emitter, vorzugsweise der Formel (IIIa), der Formeln (I) bis (VIII) oder aus Tabelle 6, deren Triplettenergie $T_1$ bevorzugt bei -2.3 eV bis ~2.1 eV liegt.

Bevorzugte phosphoreszierende Emitter sind demzufolge grüne Emitter, vorzugsweise der Formel (IIIa), der Formeln (I) bis (VIII) oder aus Tabelle 6, deren Triplettenergie $T_1$ bevorzugt bei -2.5 eV bis -2.3 eV liegt.

Besonders bevorzugte phosphoreszierende Emitter sind demzufolge grüne Emitter, vorzugsweise der Formel (IIIa), der Formeln (I) bis (VIII) oder aus Tabelle 6, wie zuvor beschrieben, deren Triplettenergie $T_1$ bevorzugt bei -2.5 eV bis -2.3 eV liegt.

Ganz besonders bevorzugt werden grüne Emitter, vorzugsweise der Formel (IIIa), der Formeln (I) bis (VIII) oder aus Tabelle 6, wie zuvor beschrieben, für die erfindungsgemäße Mischung bzw. erfindungsgemäße emittierende Schicht ausgewählt.

In der lichtemittierenden Schicht der erfindungsgemäßen Vorrichtung können auch fluoreszierende Emitter enthalten sein.

Bevorzugte fluoreszierende emittierende Verbindungen sind ausgewählt aus der Klasse der Arylamine, wobei bevorzugt mindestens eines der aromatischen oder heteroaromatischen Ringsysteme des Arylamins ein kondensiertes Ringsystem, besonders bevorzugt mit mindestens 14 aromatischen Ringatomen ist. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte emittierende Verbindungen sind Indenofluorenamine

bzw. - diamine, Benzoindenofluorenamine bzw. -diamine, und Dibenzoindenofluorenamine bzw. -diamine, sowie Indenofluorenderivate mit kondensierten Arylgruppen. Ebenfalls bevorzugt sind Pyren-Arylamine. Ebenfalls bevorzugt sind Benzoindenofluoren-Amine, Benzofluoren-Amine, erweiterte Benzoindenofluorene, Phenoxazine, und Fluoren-Derivate, die mit Furan-Einheiten oder mit Thiophen-Einheiten verbunden sind.

In einer weiteren bevorzugten Ausführungsform der Erfindung kann die mindestens eine lichtemittierende Schicht der organischen elektrolumineszierenden Vorrichtung neben den Hostmaterialien 1 und 2, wie zuvor beschrieben oder als bevorzugt beschrieben, weitere Hostmaterialien oder Matrixmaterialien umfassen, sogenannte Mixed-Matrix-Systeme. Die Mixed-Matrix-Systeme umfassen bevorzugt drei oder vier verschiedene Matrixmaterialien, besonders bevorzugt drei verschiedene Matrixmaterialien (das heißt, eine weitere Matrixkomponente zusätzlich zu den Hostmaterialien 1 und 2, wie zuvor beschrieben). Besonders geeignete Matrixmaterialien, welche in Kombination als Matrixkomponente eines Mixed-Matrix-Systems verwendet werden können, sind ausgewählt aus *wide-band*-gap-Materialien, bipolaren Hostmaterialien, Elektronentransportmaterialien (ETM) und Lochtransportmaterialien (HTM).

Unter *wide-band-gap*-Material wird hierin ein Material im Sinne der Offenbarung von US 7,294,849 verstanden, das durch eine Bandlücke von mindestens 3.5 eV charakterisiert ist, wobei unter Bandlücke der Abstand zwischen HOMO und LUMO-Energie eines Materials verstanden wird.

Bevorzugt wird das Mixed-Matrix-System auf einen Emitter der Formel (IIIa), der Formeln (I) bis (VIII) oder aus Tabelle 6 optimiert.

Gemäß einer Ausführungsform der vorliegenden Erfindung enthält die Mischung neben den Bestandteilen elektronentransportierendes Hostmaterial der Formel (1) und lochtransportierendes Hostmaterial der Formel (2) keine weiteren Bestandteile, das heißt, funktionellen Materialien. Es handelt sich um Materialmischungen, die als solche zur Herstellung der lichtemittierenden Schicht, verwendet werden. Man bezeichnet diese Mischungen auch als Premix-Systeme, die als einzige Materialquelle bei der Aufdampfung der Hostmaterialien für die lichtemittierende Schicht verwendet wird und die ein konstantes Mischungsverhältnis bei der Aufdampfung haben. Dadurch lässt sich auf einfache und schnelle Art und Weise das Aufdampfen einer Schicht mit gleichmäßiger Verteilung der Komponenten erreichen, ohne dass eine präzise Ansteuerung einer Vielzahl an Materialquellen notwendig ist.

Gemäß einer alternativen Ausführungsform der vorliegenden Erfindung enthält die Mischung neben den Bestandteilen elektronentransportierendes Hostmaterial der Formel (1) und lochtransportierendes Hostmaterial der Formel (2) noch den phosphoreszierenden Emitter, wie zuvor beschrieben. Bei geeignetem Mischungsverhältnis bei der Aufdampfung kann auch diese Mischung als einzige Materialquelle verwendet werden, wie zuvor beschrieben.

Die Komponenten bzw. Bestandteile der lichtemittierenden Schicht der erfindungsgemäßen Vorrichtung können somit durch Aufdampfen oder aus Lösung prozessiert werden. Die Materialkombination der Hostmaterialien 1 und 2, wie zuvor beschrieben oder bevorzugt beschrieben, gegebenenfalls mit dem phosphoreszierenden Emitter, wie zuvor beschrieben oder bevorzugt beschrieben, werden dazu in einer Formulierung bereitgestellt, die mindestens ein Lösemittel enthält. Diese Formulierungen können beispielsweise Lösungen, Dispersionen oder Emulsionen sein. Es kann bevorzugt sein, hierfür Mischungen aus zwei oder mehr Lösemitteln zu verwenden.

Ein weiterer Gegenstand der vorliegenden Erfindung ist daher eine Formulierung enthaltend eine erfindungsgemäße Mischung an Hostmaterialien 1 und 2, wie zuvor beschrieben, gegebenenfalls in Kombination mit einem phosphoreszierenden Emitter, wie zuvor beschrieben oder bevorzugt beschrieben, und mindestens ein Lösemittel.

Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, $\alpha$-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan oder Mischungen dieser Lösemittel.

Die Formulierung kann dabei auch mindestens eine weitere organische oder anorganische Verbindung enthalten, die ebenfalls in der lichtemittierenden Schicht der erfindungsgemäßen Vorrichtung eingesetzt wird, insbesondere eine weitere emittierende Verbindung und/oder ein weiteres Matrixmaterial. Geeignete emittierende Verbindungen und weitere Matrixmaterialien wurden vorstehend bereits aufgeführt.

Die lichtemittierende Schicht in der erfindungsgemäßen Vorrichtung gemäß den bevorzugten Ausführungsformen und der emittierenden Verbindung enthält vorzugsweise zwischen 99,9 und 1 Vol.-%, weiter vorzugsweise zwischen 99 und 10 Vol.-%, besonders bevorzugt zwischen 98 und 60 Vol.-%, ganz besonders bevorzugt zwischen 97 und 80 Vol.-% an Matrixmaterial aus mindestens einer Verbindung der Formel (1) und mindestens einer Verbindung der Formel (2) gemäß den bevorzugten Ausführungsformen, bezogen auf die gesamte Zusammensetzung aus Emitter und Matrixmaterial. Entsprechend enthält die lichtemittierende Schicht in der erfindungsgemäßen Vorrichtung vorzugsweise

zwischen 0,1 und 99 Vol.-%, weiter vorzugsweise zwischen 1 und 90 Vol.-%, besonders bevorzugt zwischen 2 und 40 Vol.-%, ganz besonders bevorzugt zwischen 3 und 20 Vol.-% des Emitters bezogen auf die gesamte Zusammensetzung der aus Emitter und Matrixmaterial bestehenden lichtemittierenden Schicht. Werden die Verbindungen aus Lösung verarbeitet, so werden statt der oben angegebenen Mengen in Vol.-% bevorzugt die entsprechenden Mengen in Gew.-% verwendet.

Die lichtemittierende Schicht in der erfindungsgemäßen Vorrichtung gemäß den bevorzugten Ausführungsformen und der emittierenden Verbindung enthält vorzugsweise das Matrixmaterial der Formel (1) und das Matrixmaterial der Formel (2) in einem Volumenprozentverhältnis zwischen 3:1 und 1:3, bevorzugt zwischen 1:2.5 und 1:1, besonders bevorzugt zwischen 1:2 und 1:1. Werden die Verbindungen aus Lösung verarbeitet, so werden statt des oben angegebenen Verhältnisses in Vol.-% bevorzugt das entsprechende Verhältnis in Gew.-% verwendet.

Die vorliegende Erfindung betrifft auch eine organische elektrolumineszierende Vorrichtung, wie zuvor beschrieben oder bevorzugt beschrieben, wobei die organische Schicht eine Lochinjektionsschicht (HIL) und/oder eine Lochtransportschicht (HTL) enthält, deren lochinjizierendes Material und lochtransportierendes Material zur Klasse der Arylamine gehört. Bevorzugte Verbindungen mit Lochtransportfunktion, die nicht einer der Formeln für das Hostmaterial 2 entsprechen, vorzugsweise zur Verwendung in einer Lochinjektionsschicht, einer Lochtransportschicht, einer Elektronenblockierschicht und/oder als zusätzliches Matrixmaterial in der erfindungsgemäßen emittierenden Schicht, sind in der folgenden Tabelle 7 gezeigt. Die Verbindungen der Tabelle 7 sind, wie die Strukturen zeigen, nicht deuterierte Verbindungen.

Tabelle 7:

| | |
|---|---|
| 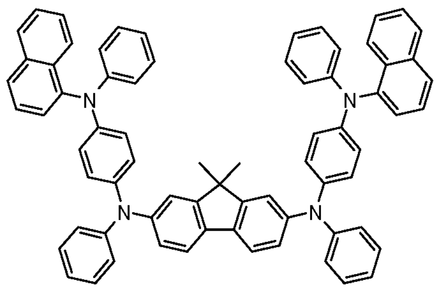 | 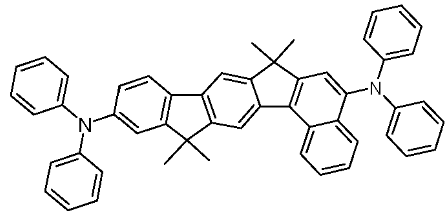 |
| HT-1 | HT-2 |
| 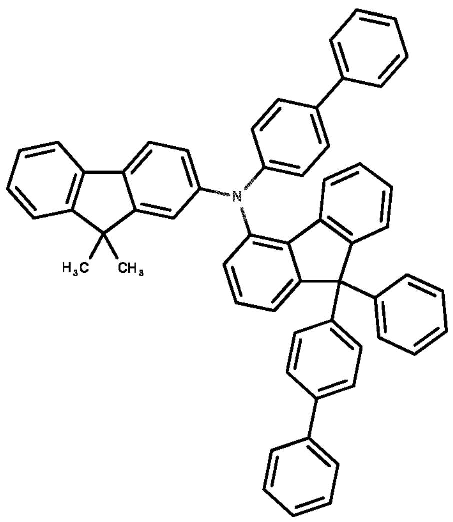 | 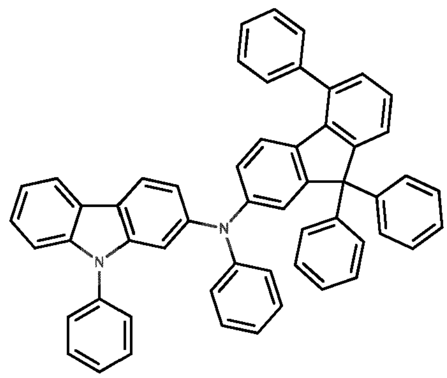 |
| HT-3 | HT-4 |

(fortgesetzt)

| | |
|---|---|
| 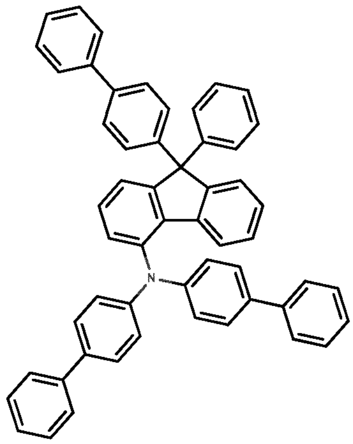 | 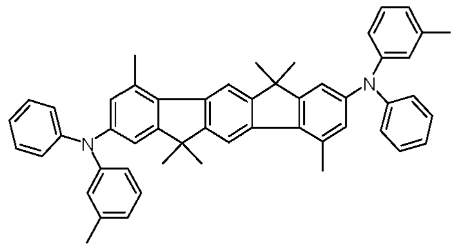 |
| HT-5 | HT-6 |
| 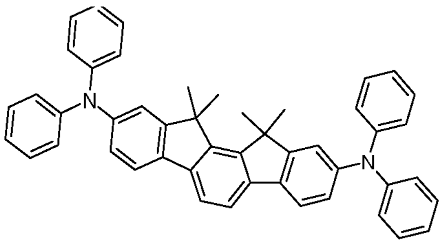 | 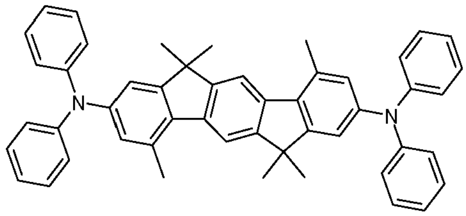 |
| HT-7 | HT-8 |
| 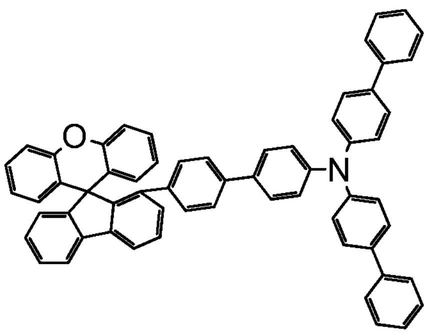 | 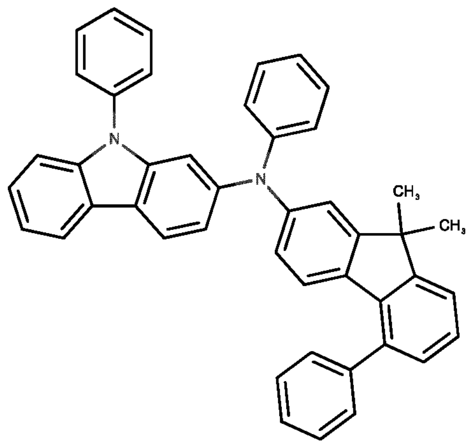 |
| HT-9 | HT-10 |

(fortgesetzt)

| | |
|---|---|
| 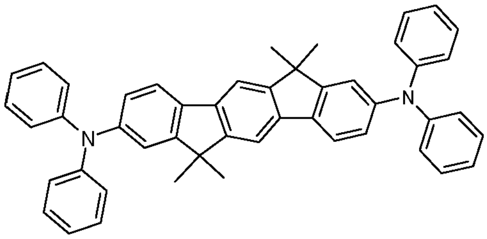 | 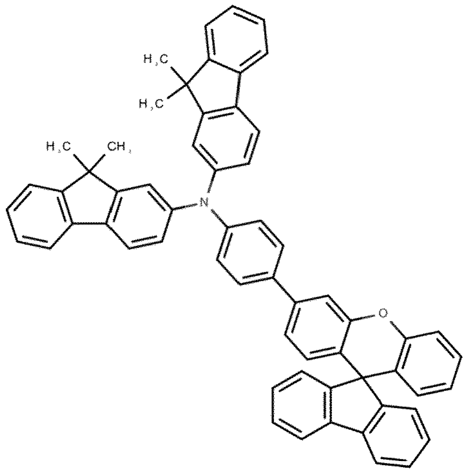 |
| HT-11 | HT-12 |
| 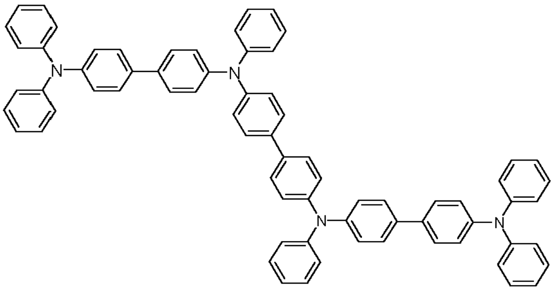 | 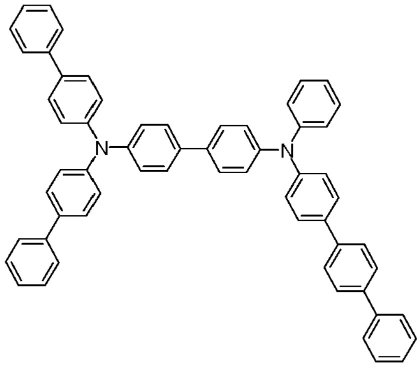 |
| HT-13 | HT-14 |
| 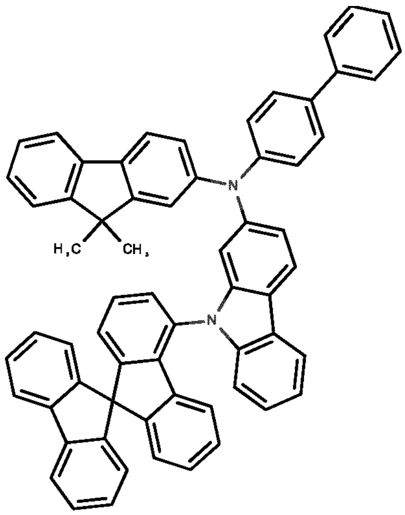 | 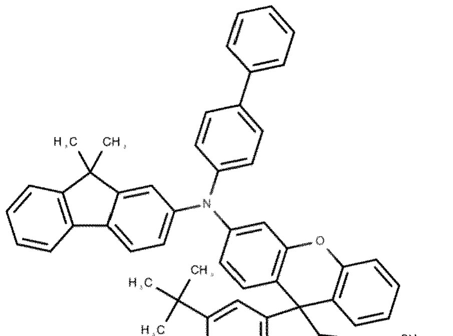 |
| HT-15 | HT-16 |

(fortgesetzt)

| | |
|---|---|
| 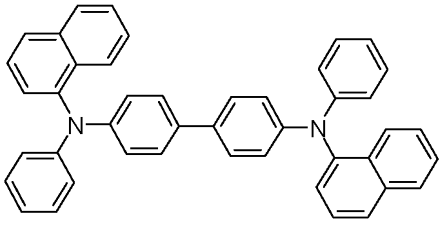 | 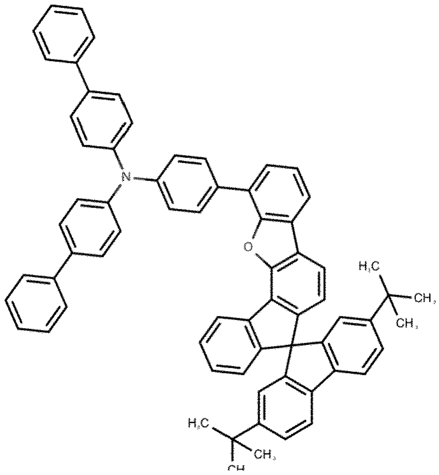 |
| HT-17 | HT-18 |
| 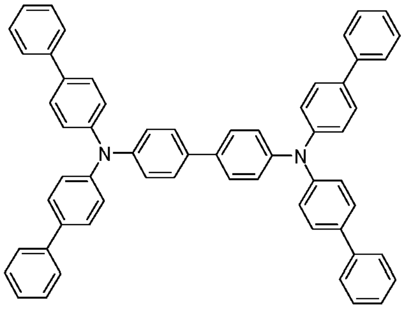 | 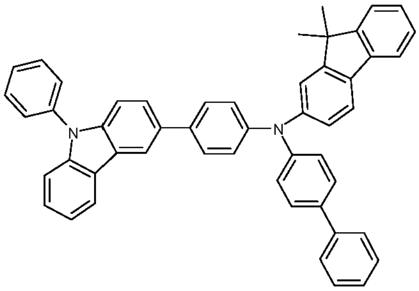 |
| HT-19 | HT-20 |
| 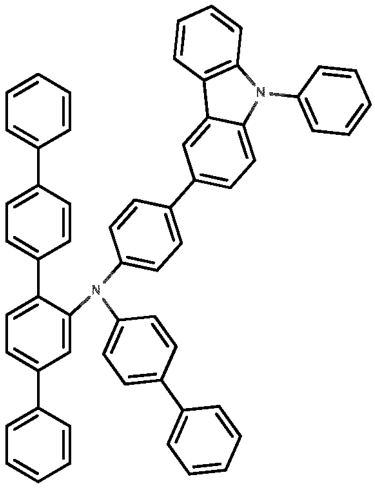 | 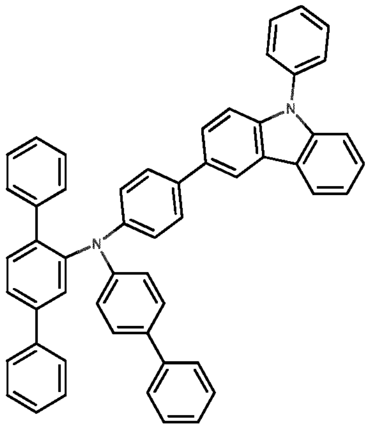 |
| HT-21 | HT-22 |

(fortgesetzt)

| | |
|---|---|
| 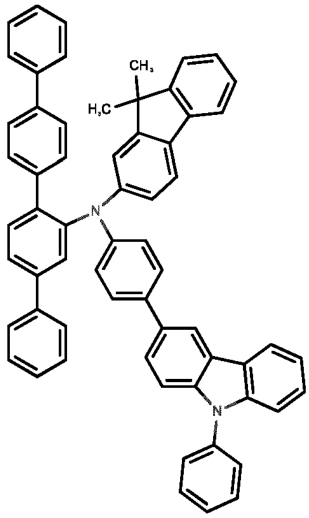 | 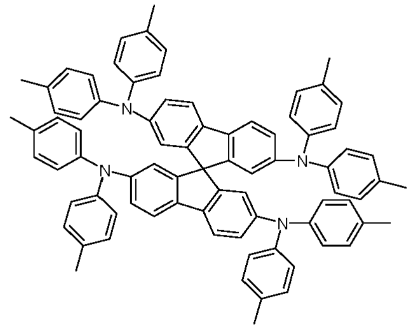 |
| HT-23 | HT-24 |
| 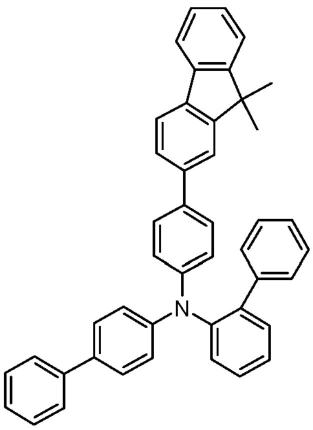 | 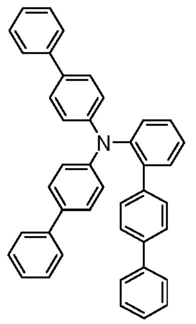 |
| HT-25 | HT-26 |
| 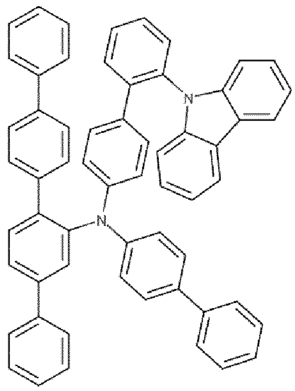 | 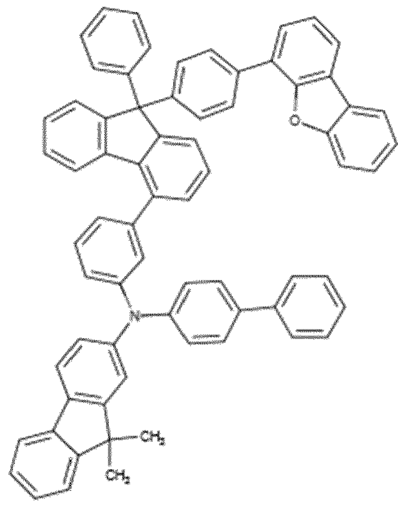 |
| HT-27 | HT-28 |

(fortgesetzt)

| | |
|---|---|
| 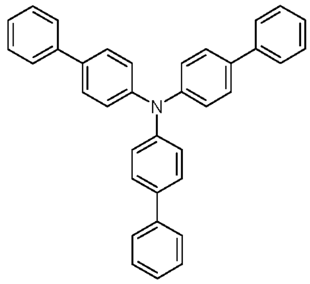 | 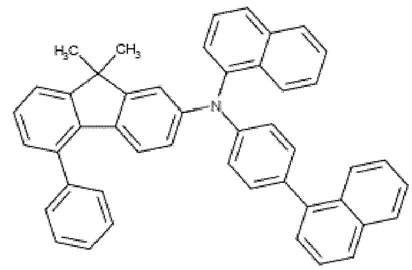 |
| HT-29 | HT-30 |
| 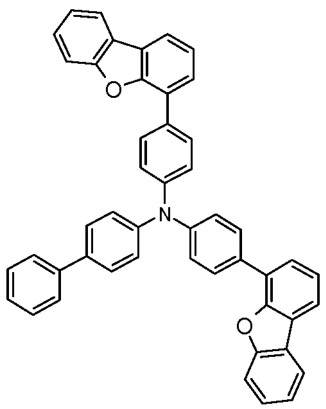 | 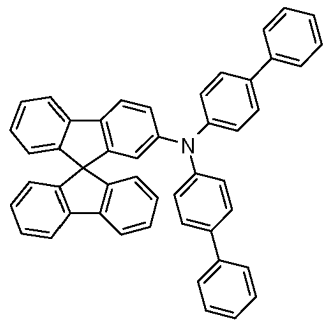 |
| HT-31 | HT-32 |
| 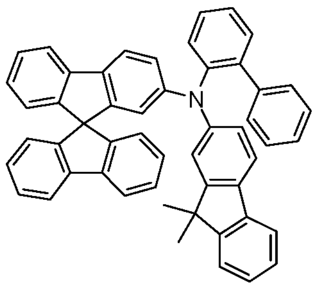 | 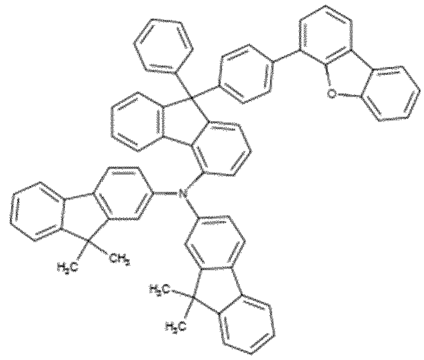 |
| HT-33 | HT-34 |
| 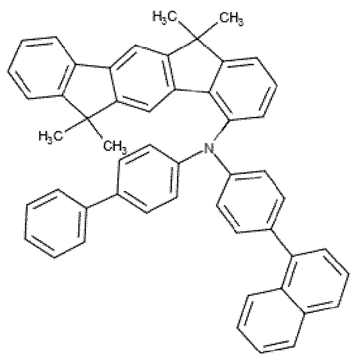 | 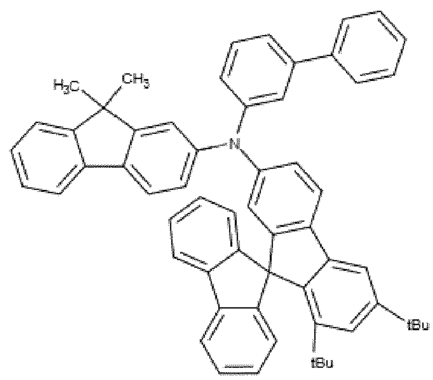 |
| HT-35 | HT-36 |

(fortgesetzt)

| | |
|---|---|
| 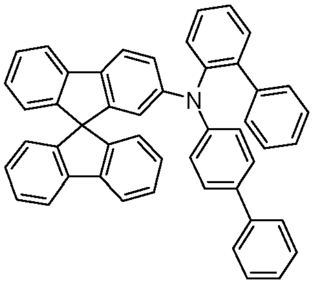 | 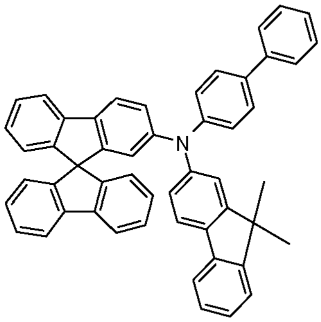 |
| HT-37 | HT-38 |
| 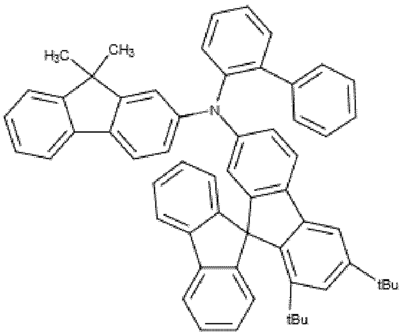 | 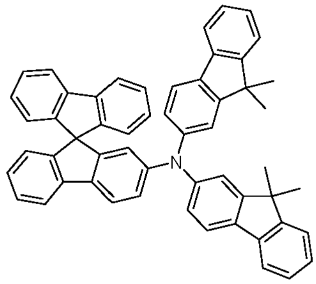 |
| HT-39 | HT-40 |
| 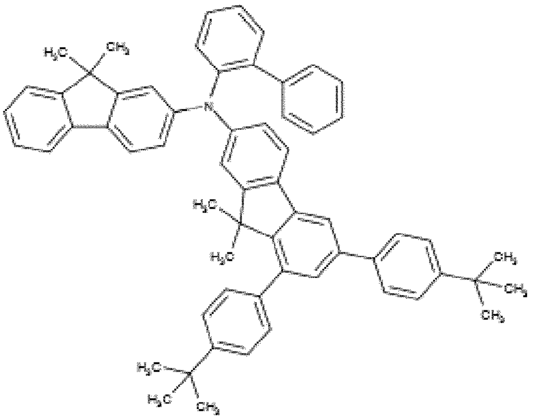 | 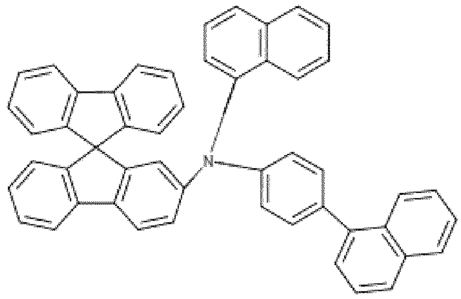 |
| HT-41 | HT-42 |
| 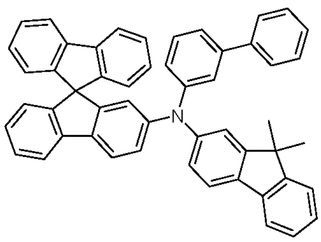 | 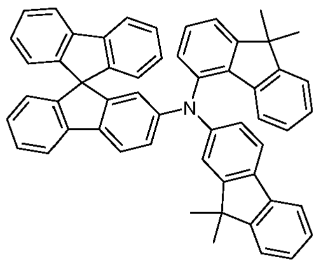 |
| HT-43 | HT-44 |

(fortgesetzt)

| | |
|---|---|
| 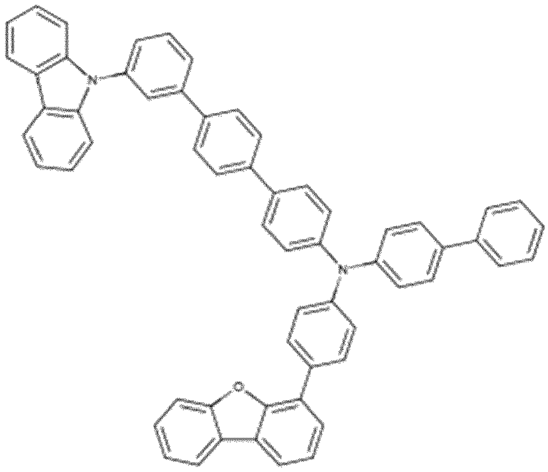 | 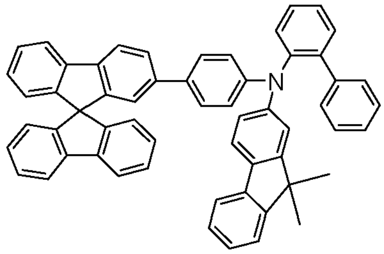 |
| HT-45 | HT-46 |
| 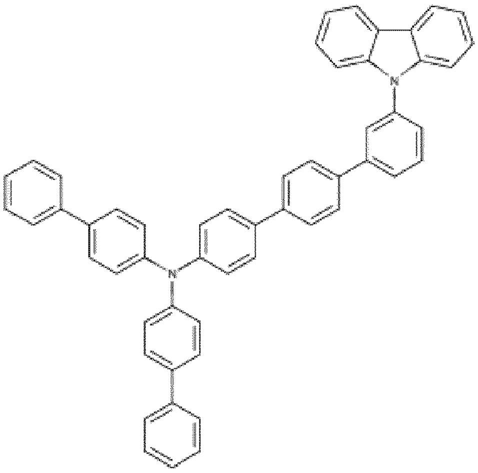 | 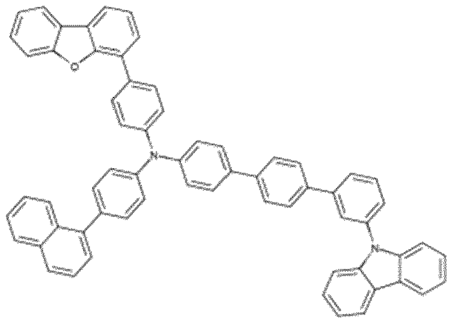 |
| HT-47 | HT-48 |
| 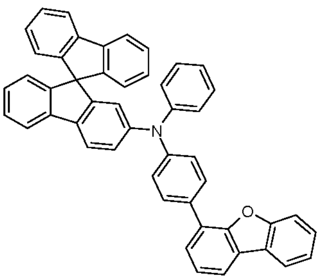 | 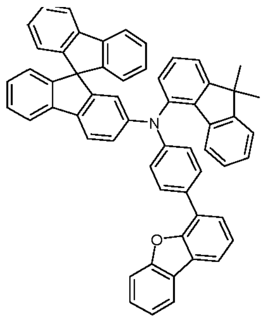 |
| HT-49 | HT-50 |

(fortgesetzt)

| | |
|---|---|
| 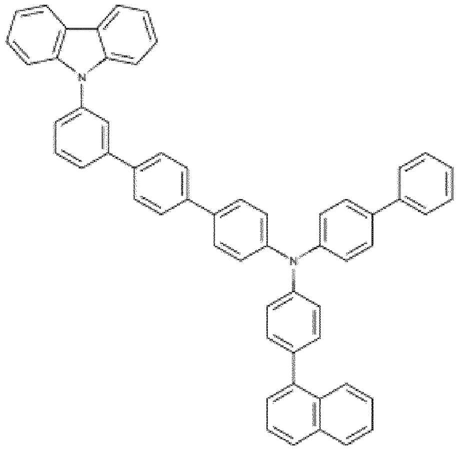 | 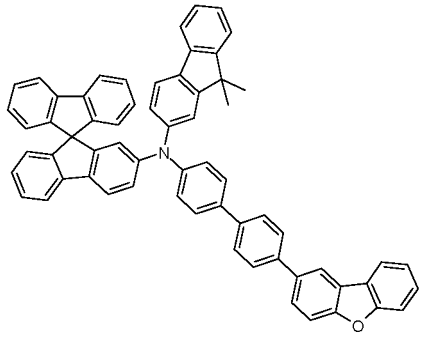 |
| HT-51 | HT-52 |
| 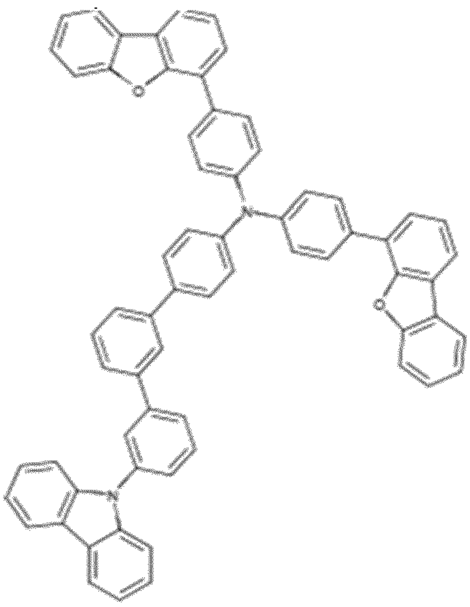 | 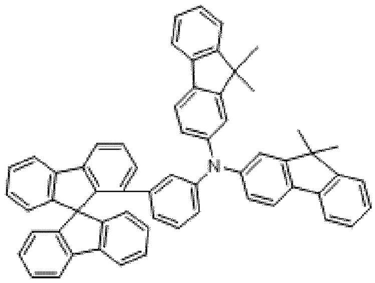 |
| HT-53 | HT-54 |
| 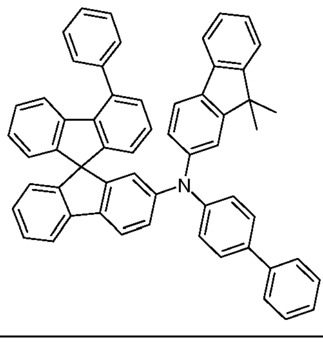 | 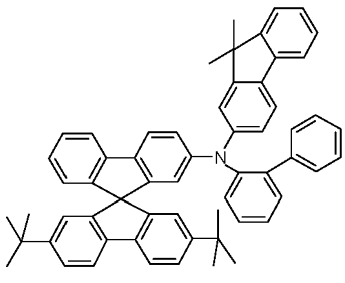 |
| HT-55 | HT-56 |

(fortgesetzt)

| | |
|---|---|
| 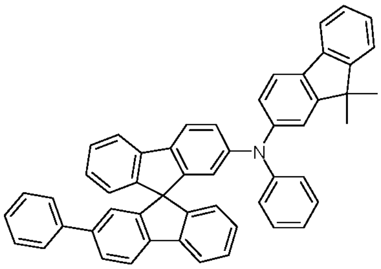 | 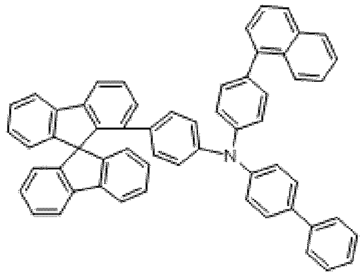 |
| HT-57 | HT-58 |
| 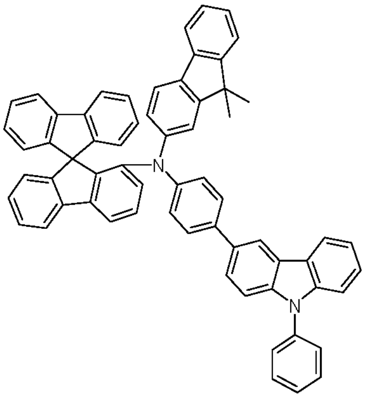 | 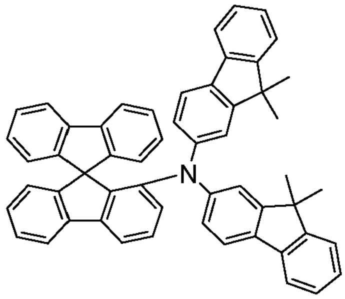 |
| HT-59 | HT-60 |
| 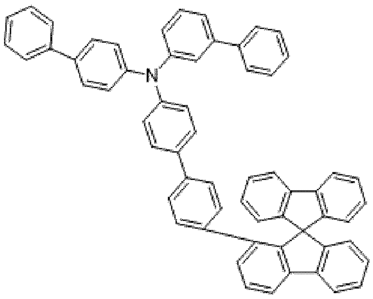 | 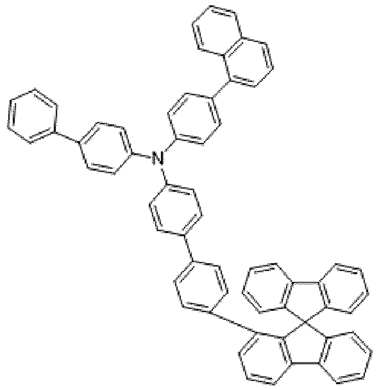 |
| HT-61 | HT-62 |
| 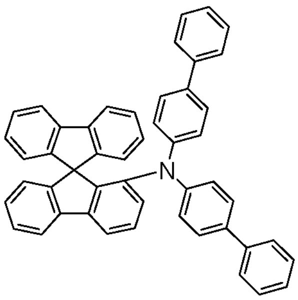 | 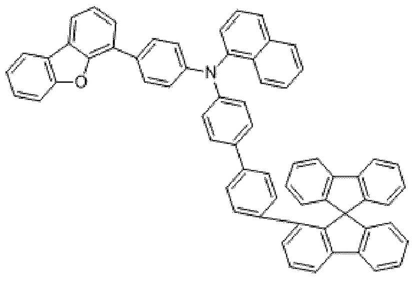 |
| HT-63 | HT-64 |

(fortgesetzt)

| | |
|---|---|
| 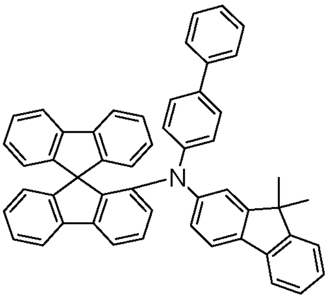 | 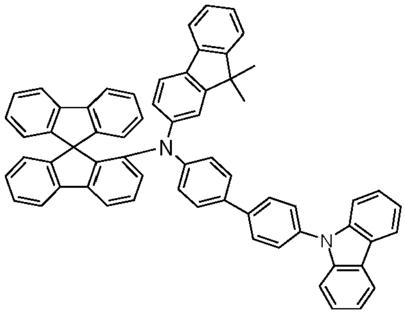 |
| HT-65 | HT-66 |
| 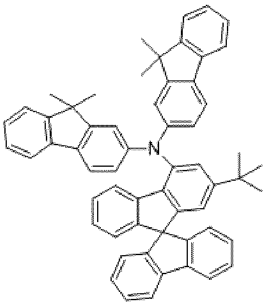 | 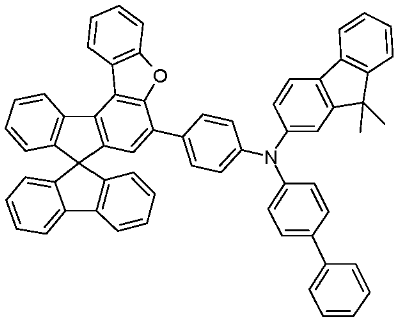 |
| HT-67 | HT-68 |
| 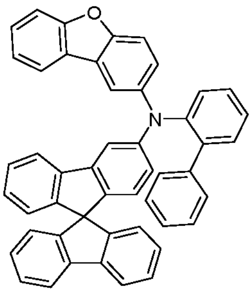 | 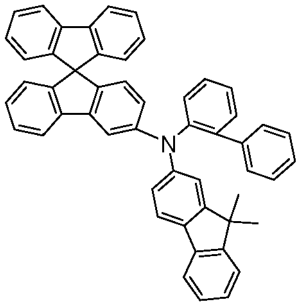 |
| HT-69 | HT-70 |
| 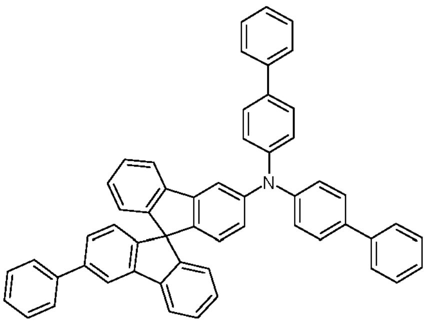 | 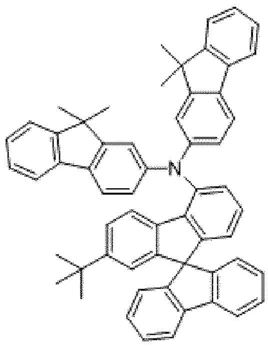 |
| HT-71 | HT-72 |

(fortgesetzt)

| | |
|---|---|
| 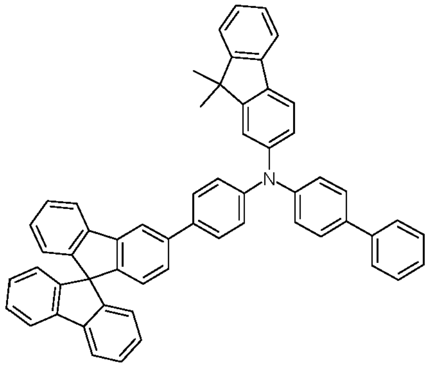 | 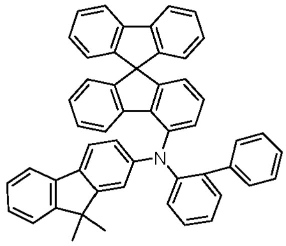 |
| HT-73 | HT-74 |
| 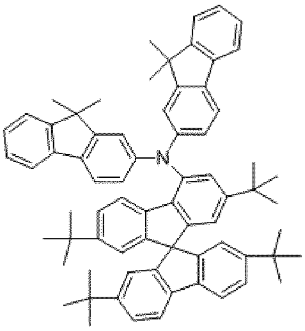 | 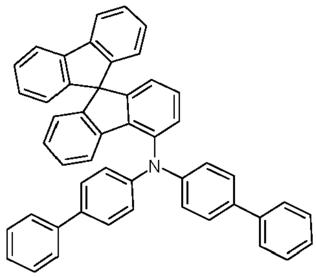 |
| HT-75 | HT-76 |
| 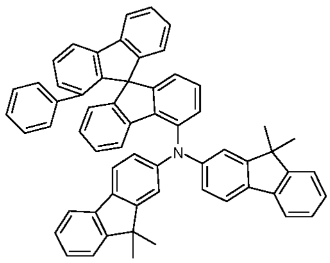 | 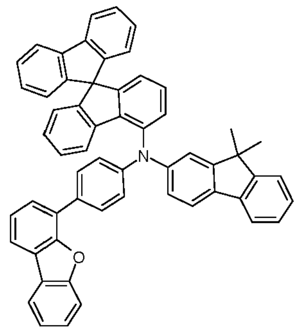 |
| HT-77 | HT-78 |
| 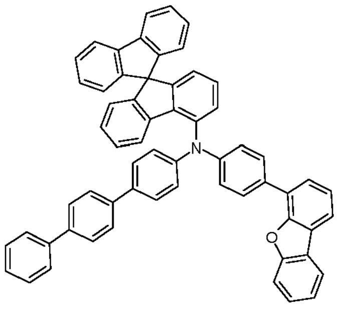 | 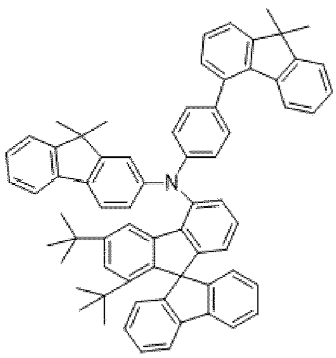 |
| HT-79 | HT-80 |

(fortgesetzt)

| | |
|---|---|
| 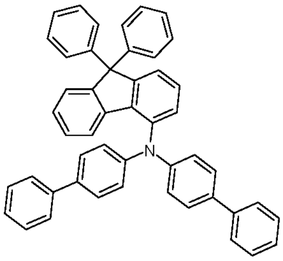 | 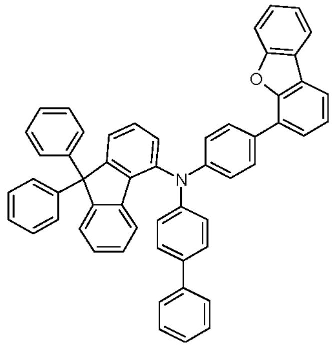 |
| HT-81 | HT-82 |
| 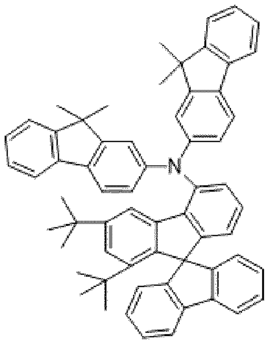 | 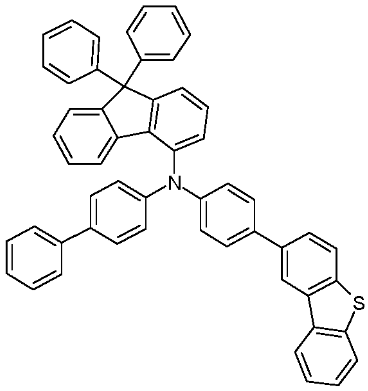 |
| HT-83 | HT-84 |
| 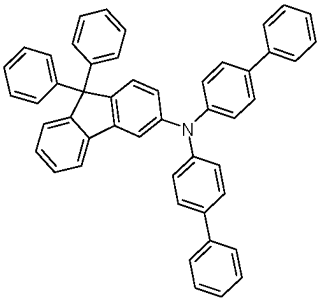 | 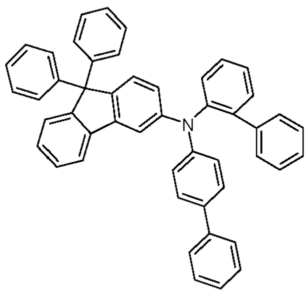 |
| HT-85 | HT-86 |
| 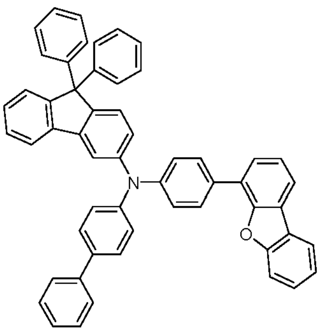 | 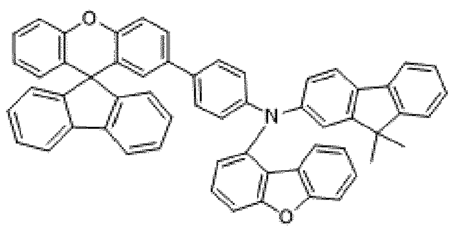 |
| HT-87 | HT-88 |

(fortgesetzt)

| | |
|---|---|
| 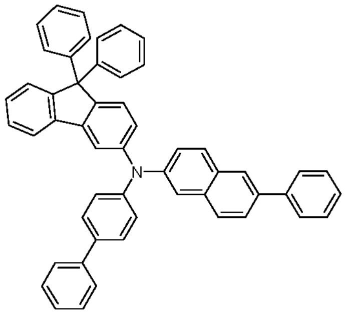 | 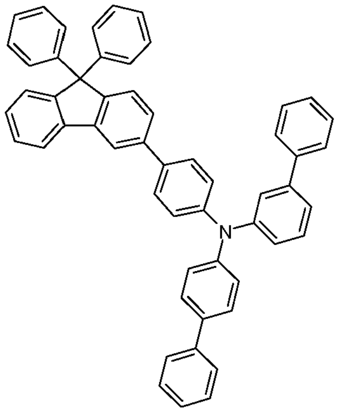 |
| HT-89 | HT-90 |
| 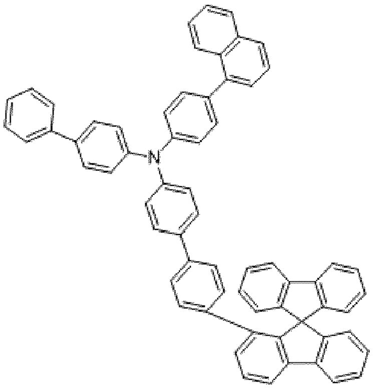 | 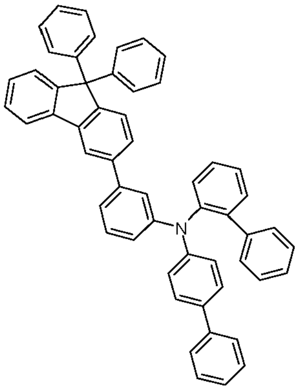 |
| HT-91 | HT-92 |
| 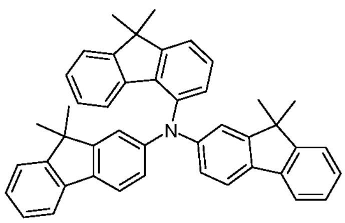 | 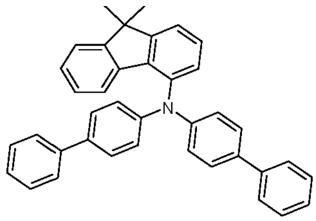 |
| HT-93 | HT-94 |
| 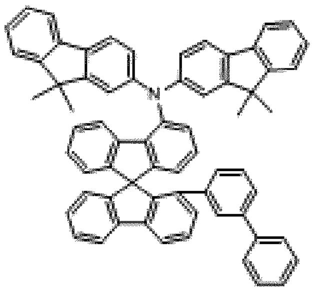 | 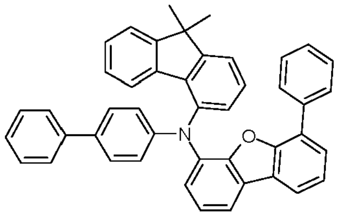 |
| HT-95 | HT-96 |

(fortgesetzt)

| | |
|---|---|
| 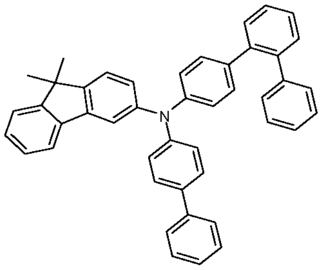 | 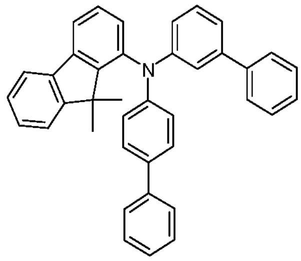 |
| HT-97 | HT-98 |
| 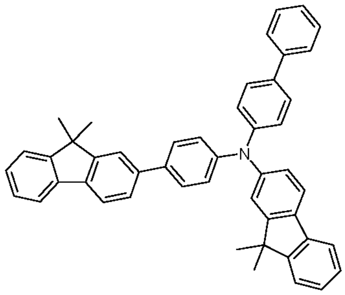 | 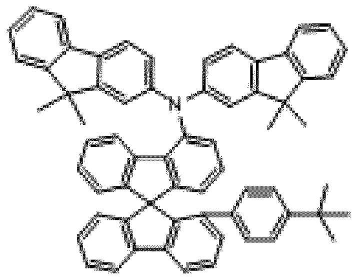 |
| HT-99 | HT-100 |
| 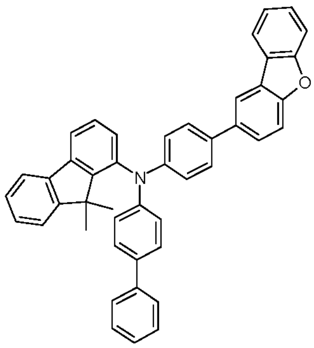 | 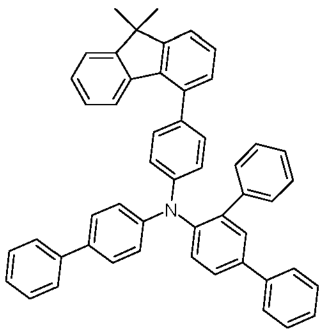 |
| HT-101 | HT-102 |
| 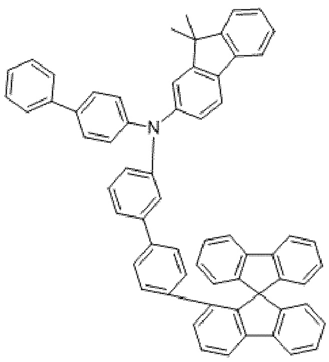 | 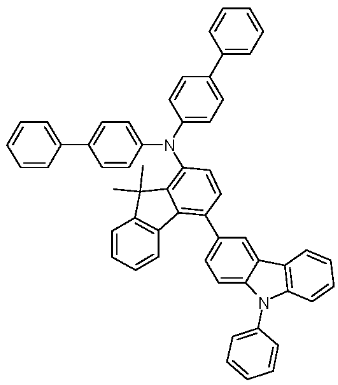 |
| HT-103 | HT-104 |

(fortgesetzt)

| | |
|---|---|
| 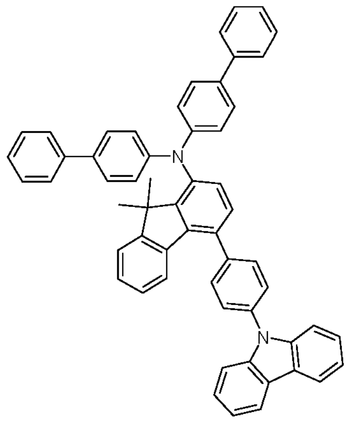 | 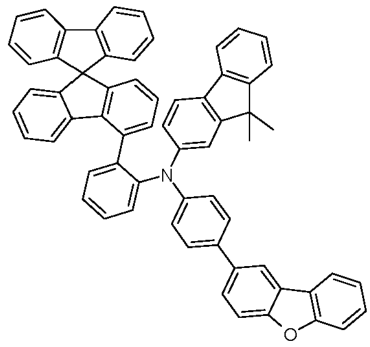 |
| HT-105 | HT-106 |
| 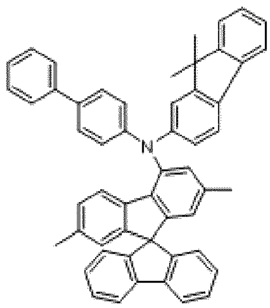 | 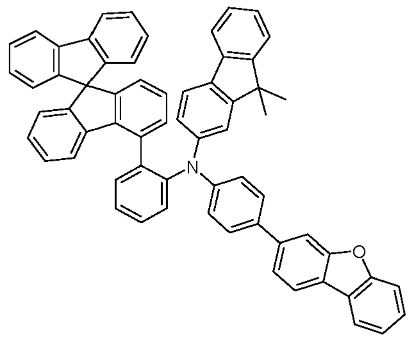 |
| HT-107 | HT-108 |
| 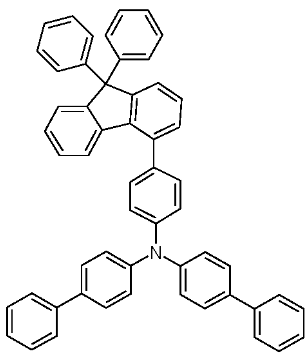 | 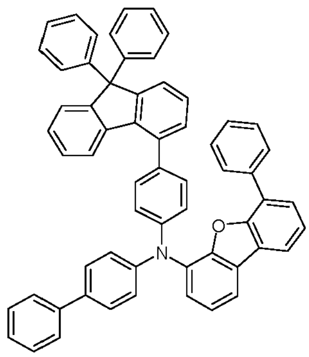 |
| HT-109 | HT-110 |

Die Abfolge der Schichten in der erfindungsgemäßen organischen Elektrolumineszenzvorrichtung ist bevorzugt die folgende:
Anode / Lochinjektionsschicht / Lochtransportschicht / emittierende Schicht / Elektronentransportschicht / Elektroneninjektionsschicht / Kathode.

Diese Abfolge der Schichten ist eine bevorzugte Abfolge.

Dabei soll erneut darauf hingewiesen werden, dass nicht alle der genannten Schichten vorhanden sein müssen, und/oder dass zusätzlich weitere Schichten vorhanden sein können.

Die erfindungsgemäße organische Elektrolumineszenzvorrichtung kann mehrere emittierende Schichten enthalten. Mindestens eine der emittierenden Schichten ist die erfindungsgemäße lichtemittierende Schicht enthaltend mindestens eine Verbindung der Formel (1) als Hostmaterial 1 und mindestens eine Verbindung der Formel (2) als Hostmaterial 2, wie zuvor beschrieben oder bevorzugt beschrieben. Besonders bevorzugt weisen diese Emissionsschichten in diesem Fall insgesamt mehrere Emissionsmaxima zwischen 380 nm und 750 nm auf, so dass insgesamt weiße Emission resultiert.

Als Materialien für die Elektronentransportschicht können alle Materialien verwendet werden, wie sie gemäß

dem Stand der Technik als Elektronentransportmaterialien in der Elektronentransportschicht verwendet werden. Insbesondere eignen sich Aluminiumkomplexe, beispielsweise $Alq_3$, Zirkoniumkomplexe, beispielsweise $Zrq_4$, Benzimidazolderviate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate.

Als Kathode der erfindungsgemäßen Vorrichtung eignen sich Metalle mit geringer Austrittsarbeit, Metalllegierungen oder mehrlagige Strukturen aus verschiedenen Metallen, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z.

B. LiF, $Li_2O$, $BaF_2$, MgO, NaF, CsF, $Cs_2CO_3$, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/$NiO_X$, Al/$PtO_X$) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die erfindungsgemäße organische elektrolumineszierende Vorrichtung wird bei der Herstellung entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

Die Herstellung der erfindungsgemäßen Vorrichtung ist hierbei nicht eingeschränkt. Es ist möglich, dass eine oder mehrere organische Schichten, auch die lichtemittierende Schicht, mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.

Bevorzugt ist die erfindungsgemäße organische Elektrolumineszenzvorrichtung dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist die erfindungsgemäße organische Elektrolumineszenzvorrichtung dadurch gekennzeichnet, dass eine oder mehrere organische Schichten enthaltend die erfindungsgemäße Zusammensetzung aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Hostmaterialien 1 und 2 und phosphoreszierende Emitter nötig. Das Verarbeiten aus Lösung hat den Vorteil, dass beispielsweise die lichtemittierende Schicht sehr einfach und kostengünstig aufgebracht werden kann. Diese Technik eignet sich insbesondere für die Massenproduktion organischer elektrolumineszierender Vorrichtungen.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können auf organische Elektrolumineszenzvorrichtungen angewandt werden.

Ein weiterer Gegenstand der Erfindung ist daher ein Verfahren zur Herstellung der erfindungsgemäßen organischen elektrolumineszierenden Vorrichtung, wie zuvor beschrieben oder bevorzugt beschrieben, dadurch gekennzeichnet, dass die organische Schicht, vorzugsweise die lichtemittierende Schicht, die Lochinjektionsschicht und/oder Lochtransportschicht, durch Gasphasenabscheidung, insbesondere mit einem Sublimationsverfahren und/oder mit einem OVPD (Organic Vapour Phase Deposition) Verfahren und/oder mit Hilfe einer Trägergassublimation, oder aus Lösung, insbesondere durch Spincoating oder mit einem Druckverfahren, aufgebracht wird.

Bei der Herstellung mittels Gasphasenabscheidung bestehen grundsätzlich zwei Möglichkeiten, wie die erfindungsgemäße organische Schicht, bevorzugt die lichtemittierende Schicht, auf ein beliebiges Substrat bzw. die vorherige Schicht aufgebracht bzw. aufgedampft werden kann. Zum einen können die verwendeten Materialien jeweils in einer Materialquelle vorgelegt und schließlich aus den verschiedenen Materialquellen verdampft werden ("co-evaporation"). Zum anderen können die verschiedenen Materialien vorgemischt ("premixed", Premix-Systeme) und das Gemisch in einer einzigen Materialquelle vorgelegt werden, aus der es schließlich verdampft wird ("premix-evaporation"). Dadurch lässt sich auf einfache und schnelle Art und Weise das Aufdampfen der lichtemittierenden Schicht mit gleichmäßiger Verteilung der Komponenten erreichen, ohne dass eine präzise Ansteuerung einer Vielzahl an Materialquellen notwendig ist.

Ein weiterer Gegenstand der Erfindung ist demzufolge ein Verfahren zur Herstellung der erfindungsgemäßen Vorrichtung, dadurch gekennzeichnet, dass die mindestens eine Verbindung der Formel (1), wie zuvor beschrieben oder als bevorzugt beschrieben, und die mindestens eine Verbindung der Formel (2), wie zuvor beschrieben oder als bevorzugt beschrieben, nacheinander oder gleichzeitig aus mindestens zwei Materialquellen, gegebenenfalls mit dem mindestens einen phosphoreszierenden Emitter, wie zuvor beschrieben oder bevorzugt beschrieben, aus der Gasphase abgeschieden werden und die lichtemittierende Schicht bilden.

In einer bevorzugten Ausführungsform der vorliegenden Erfindung wird die lichtemittierende Schicht mittels Gasphasenabscheidung aufgebracht, wobei die Bestandeile der Zusammensetzung vorgemischt und aus einer einzigen Materialquelle verdampft werden.

Ein weiterer Gegenstand der Erfindung ist demzufolge ein Verfahren zur Herstellung der erfindungsgemäßen Vorrichtung, dadurch gekennzeichnet, dass die mindestens eine Verbindung der Formel (1) und die mindestens eine Verbindung der Formel (2) als Mischung, nacheinander oder gleichzeitig mit dem mindestens einen phosphoreszierenden Emitter, aus der Gasphase abgeschieden werden und die lichtemittierende Schicht bilden.

Ein weiterer Gegenstand der Erfindung ist ein Verfahren zur Herstellung der erfindungsgemäßen Vorrichtung, wie zuvor beschrieben oder bevorzugt beschrieben, dadurch gekennzeichnet, dass die mindestens eine Verbindung der Formel (1) und die mindestens eine Verbindung der Formel (2), wie zuvor beschrieben oder bevorzugt beschrieben, zusammen mit dem mindestens einen phosphoreszierenden Emitter, aus Lösung aufgebracht werden, um die lichtemittierende Schicht zu bilden.

Die erfindungsgemäßen Vorrichtungen zeichnen sich durch folgende überraschende Vorteile gegenüber dem Stand der Technik aus:

Die Verwendung der beschriebenen Materialkombination der Hostmaterialien 1 und 2, wie zuvor beschrieben, führt insbesondere zu einer Steigerung der Lebensdauer der Vorrichtungen.

Es ist bekannt, dass die C-D-Bindung kürzer ist als die C-H-Bindung als Ergebnis der Anharmonizität des Bindungsdehnungspotentials ( M. L. Allinger und H. L. Flanagan, J. Computa nationale Chem. 1983, 4(3), 399). Das bedeutet, dass die chemische Bindung von Kohlenstoff mit Deuterium stärker, stabiler ist und langsamer reagiert als die chemische Kohlenstoff-Wasserstoff-Bindung. Bei Verwendung eines deuterierte organischen Systems im Vergleich zu dem nicht-deuterierten organischen System wird in der Regel eine bessere thermische Stabilität und eine längere Lebensdauer für die optoelektronische Vorrichtung erwartet. Der Ersatz labiler C-H-Bindungen durch C-D-Bindungen in einem organischen funktionalen Material erhöht die Lebensdauer der entsprechenden Vorrichtung in der Regel um den Faktor 1,5-3 ohne Verlust von Effizienz.

Wie im nachfolgend angegebenen Beispiel ersichtlich, lässt sich durch Vergleich der Daten für OLEDs mit Kombinationen aus dem Stand der Technik feststellen, dass die erfindungsgemäßen Kombinationen an Matrixmaterialien in der EML zu Vorrichtungen führen, deren Lebensdauer und/oder Leuchtkraft signifikant erhöht sind, unabhängig von der Emitterkonzentration, wobei der Fachmann eine solche Erhöhung der Lebensdauer nicht erwartet. Gleichzeitig sind die erfindungsgemäßen Vorrichtungen thermisch stabiler und die nicht erwünschte Nebenreaktion einer Carbazolbildung des Hostmaterials 2 durch Cyclisierungsreaktion in der lichtemittierenden Schicht während des Betriebs der Vorrichtung wird deutlich verringert.

Die Vorteile der Kombination der Hostmaterialien 1 und 2, wie zuvor beschrieben, begründen sich auch durch die spezielle strukturelle Auswahl dieser Hostmaterialien 1 und 2 aus dem Stand der Technik, insbesondere der Auswahl des Hostmaterials 2 bzw. der bevorzugten Ausführungsformen des Hostmaterials 2, wobei die Deuterierung diesen Effekt noch zusätzlich verstärkt.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbarte Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn, dass sich bestimmte Merkmale und/oder Schritte sich gegenseitig ausschließen. Dies gilt insbesondere für bevorzugte

Merkmale der vorliegenden Erfindung. Gleichermaßen können Merkmale nicht wesentlicher Kombinationen separat verwendet werden (und nicht in Kombination).

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen.

Beispiele

Allgemeine Methoden:

In allen quantenchemischen Berechnungen wird das Programmpaket Gaussian16 (Rev. B.01) verwendet. Der neutrale Singulettgrundzustand wird auf dem B3LYP/6-31G(d)-Niveau optimiert. HOMO- und LUMO-Werte werden auf dem B3LYP/6-31G(d)-Niveau für die mit B3LYP/6-31G(d) optimierte Grundzustandsenergie bestimmt. Daraufhin werden TD-DFT-Singulett- und Triplettanregungen (vertikale Anregungen) mit der gleichen Methode (B3LYP/6-31G(d)) und der optimierten Grundzustandsgeometrie berechnet. Die Standardeinstellungen für SCF- und Gradientenkonvergenz werden verwendet.

Aus der Energierechnung erhält man das HOMO als das letzte mit zwei Elektronen besetze Orbital (Alpha occ. eigenvalues) und LUMO als das erste unbesetzte Orbital (Alpha virt. eigenvalues) in Hartree-Einheiten, wobei HEh und LEh für die HOMO Energie in Hartree-Einheiten beziehungsweise für die LUMO-Energie in Hartree-Einheiten steht. Daraus wird der anhand von Cyclovoltammetriemessungen kalibrierte HOMO- und LUMO-Wert in Elektronenvolt wie folgt bestimmt:

$$HOMOcorr = 0.90603 * HOMO - 0.84836$$

$$LUMOcorr = 0.99687 * LUMO - 0.72445$$

Das Triplett-Niveau T1 eines Materials ist definiert als die relative Anregungsenergie (in eV) des Triplettzustands mit der niedrigsten Energie, der sich aus der quantenchemischen Energierechnung ergibt.

Das Singulett-Niveau S1 eines Materials ist definiert als die relative Anregungsenergie (in eV) des Singulettzustands mit der zweitniedrigsten Energie, der sich aus der quantenchemischen Energierechnung ergibt.

Der energetisch niedrigste Singulettzustand wird als S0 bezeichnet.

Die hierin beschriebene Methode ist unabhängig von dem verwendeten Softwarepaket und liefert immer dieselben Ergebnisse. Beispiele oft benutzter Programme für diesen Zweck sind "Gaussian09" (Gaussian Inc.) und Q-Chem 4.1 (Q-Chem, Inc.). Vorliegend

wird zur Berechnung der Energien das Programmpaket "Gaussian16 (Rev. B.01)" verwendet.

Synthesebeispiele

Die nachfolgenden Synthesen werden, sofern nicht anders angegeben, unter einer Schutzgasatmosphäre in getrockneten Lösungsmitteln durchgeführt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

Synthesebeispiel 1:

**Synthon S1a**

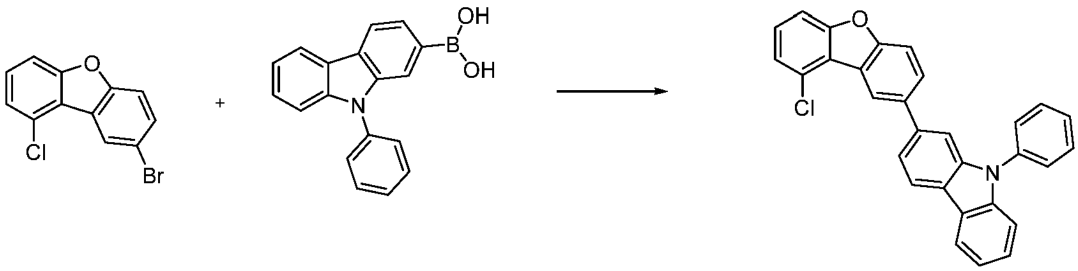

1-Chlor-8-bromdibenzofuran (100 g, 353.6 mmol) [CAS-2225909-61-3] und B-(9-phenyl-9H-carbazol-2-yl) boronsäure (106.6 g, 371.3 mmol) [1001911-63-2] werden in Toluol (800 mL), 1,4-Dioxan (800 mL) und Wasser (400 mL) unter inerter Atmosphäre vorgelegt, mit $Na_2CO_3$ und (74.95 g, 0.71 mol) Tetrakis(triphenylphosphin)palladium(0) (4.09 g, 3.54 mmol) versetzt und 16 h unter Rückfluss gerührt. Nach dem Abkühlen saugt man den Ansatz über eine mit Celite gefüllte Fritte ab und arbeitet den Ansatz extraktiv mit Toluol und Wasser auf. Die die wässrige Phase wird 2 Mal mit Toluol (je 500 mL) extrahiert und die vereinigten organischen Phasen über $Na_2SO_4$ getrocknet. Das Lösemittel wird am Rotationsverdampfer entfernt und das Rohprodukt wird mit Ethanol (1200 mL) aufgeschlämmt und 2 h unter Rückfluss gerührt. Der Feststoff wird abgesaugt, mit Ethanol gewaschen und im Vakuumtrockenschrank getrocknet.

Ausbeute: 138.5 g (312.2 mmol, 88%), 97%ig nach $^1$H-NMR

Analog können folgende Verbindungen dargestellt werden. Zur Aufreinigung kann auch Säulen-chro-mar-tographie verwendet werden, oder zur Umkristallisation oder Heiß-ex¬trak¬tion können andere gängige Lösungsmittel wie Ethanol, Butanol, Aceton, Ethylacetat, Acetonitril, Toluol, Xylol, Dichlormethan, Methanol, Tetrahydrofuran, n Butylacetat, 1,4-Dioxan oder zur Umkristallisation Hoch-sieder wie Dimethylsulfoxid, N,N Dimethyl-formamid, N,N-Di¬methyl-acet¬amid, N-Methylpyrrolidon, etc. verwendet werden.

| Edukt 1 | Edukt 2 | Produkt | Ausbeute |
|---|---|---|---|
| 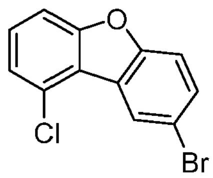 CAS-2225909-61-3 | 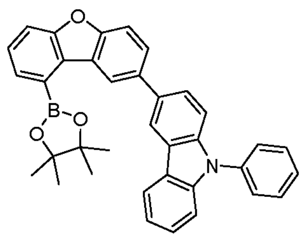 CAS-2239299-50-2 | 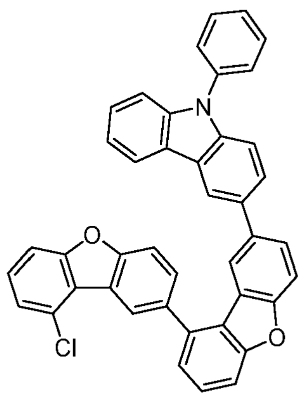 S2a | 63% |
| 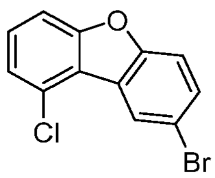 CAS-2225909-61-3 | 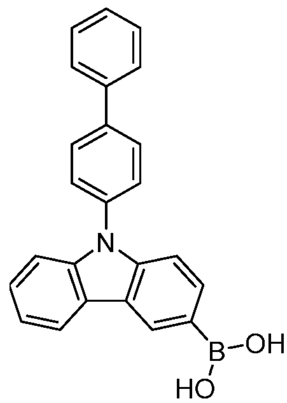 CAS-1028648-22-7 | 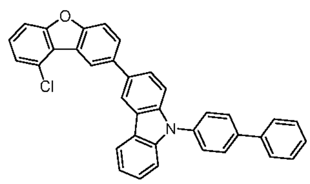 S3a | 62% |

(fortgesetzt)

| Edukt 1 | Edukt 2 | Produkt | Ausbeute |
|---|---|---|---|
| 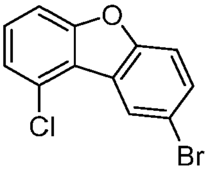 CAS-2225909-61-3 | 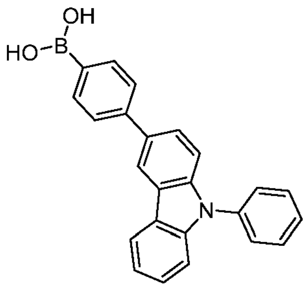 CAS-1240963-55-6 | 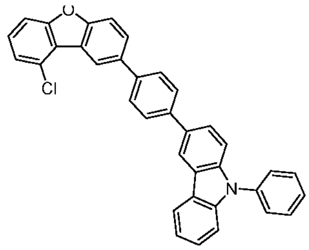 S4a | 71% |
| 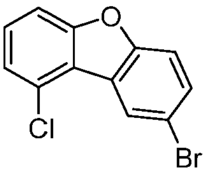 CAS-2225909-61-3 | 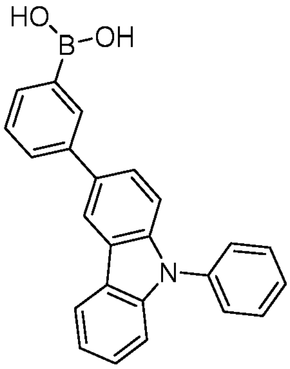 CAS-854952-60-6 | 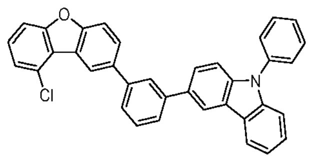 S5a | 77% |
| 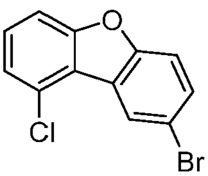 CAS-2225909-61-3 | 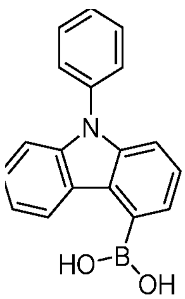 CAS-1370555-65-9 | 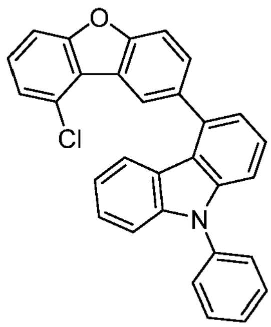 S6a | 56% |
| 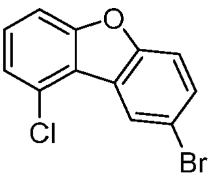 CAS-2225909-61-3 | 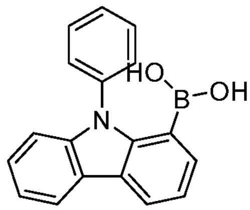 CAS-1333002-41-7 | 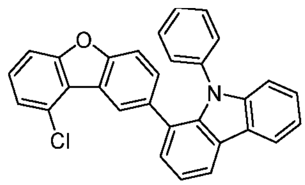 S7a | 52% |

(fortgesetzt)

| Edukt 1 | Edukt 2 | Produkt | Ausbeute |
|---|---|---|---|
| 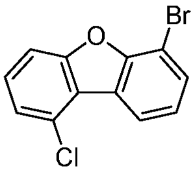 CAS- 2144800-21-3 | 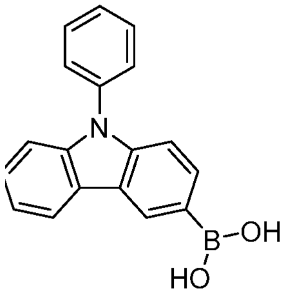 CAS-854952-58-2 | 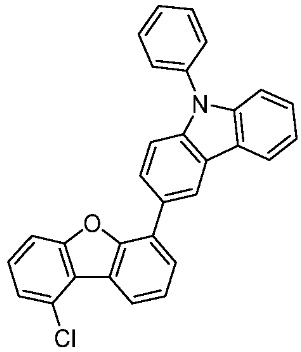 S8a | 69% |
| 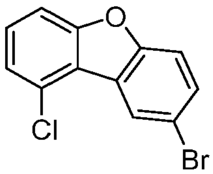 CAS-2225909-61-3 | 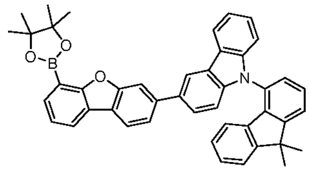 | 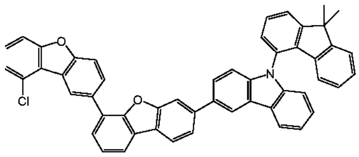 **S9a** | 67% |
| 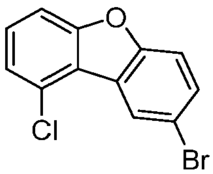 CAS-2225909-61-3 | 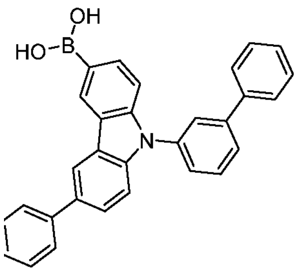 | 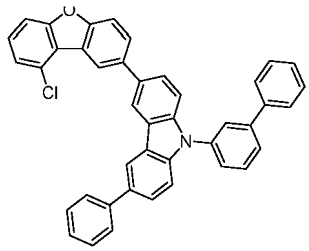 S10a | 52% |
| 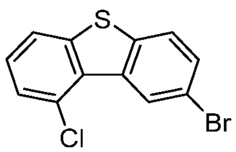 CAS-2055864-36-1 | 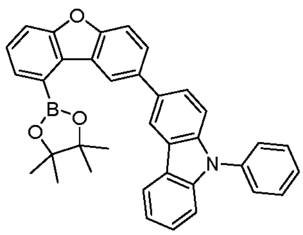 CAS-2239299-50-2 | 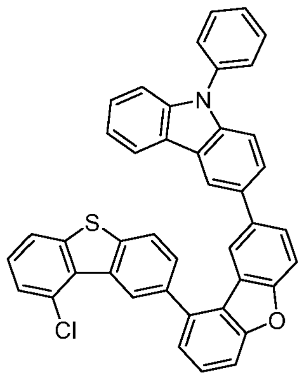 S11a | 72% |
| 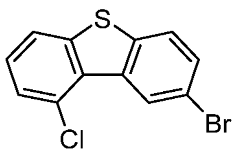 CAS-2055864-36-1 | 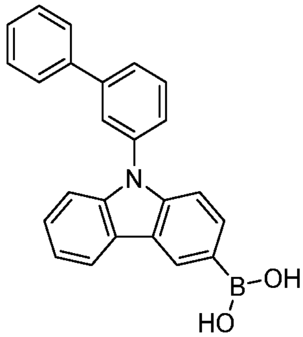 CAS-1416814-68-0 | 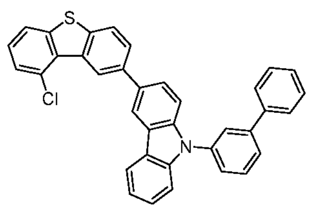 S12a | 80% |

(fortgesetzt)

| Edukt 1 | Edukt 2 | Produkt | Ausbeute |
|---|---|---|---|
| 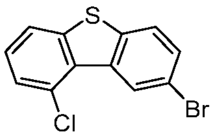 CAS-2055864-36-1 | 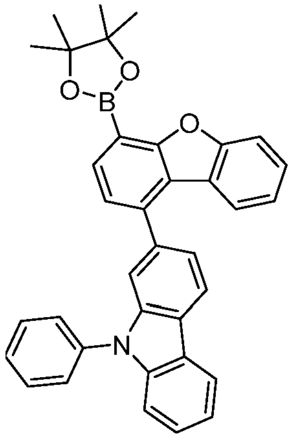 | 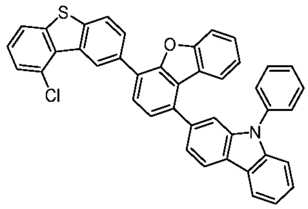 S13a | 73% |

**S1b**:

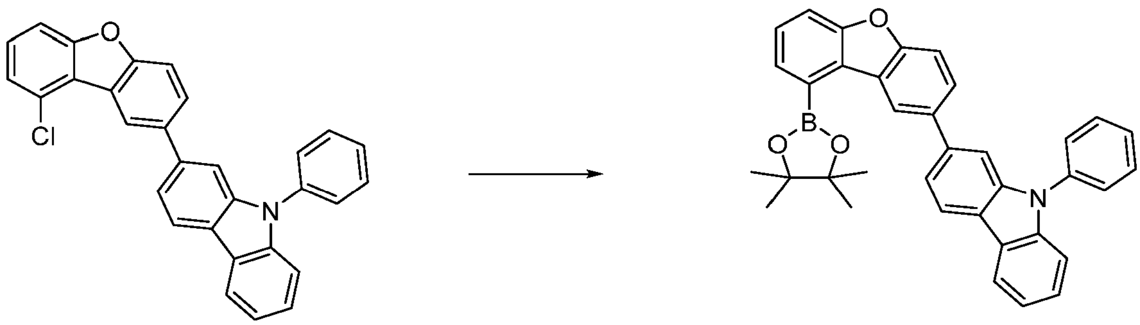

S1a (124.30 g, 280 mmol) und 4,4,5,5-Tetramethyl-2-(4,4,5,5-tetramethyl-1,3,2-dioxaborolan-2-yl)-1,3,2-dioxaborolan ( 76.20 g, 300 mmol) werden in 1,4-Dioxan (2000 mL) unter inerter Atmosphäre vorgelegt und mit Kaliumacetat (82.33 g, 1.40 mol) und trans-Dichlorbis(tricyclohexylphos-phin)palladium(II) (6.21 g, 83.9 mmol) versetzt und für 32 h unter Rückfluss gerührt. Nach dem Abkühlen wird das Lösungsmittel am Rotationsverdampfer abrotiert, der Rückstand wird extraktiv mit Toluol/Wasser aufgearbeitet, die organische Phase über $Na_2SO_4$ getrocknet. Das Rohprodukt wird mit Ethanol (1100 mL) unter Rückfluss ausgerührt, der Feststoff nach dem Abkühlen abgesaugt und mit Ethanol gewaschen.

Ausbeute: 113.5 g (212.5 mmol, 76%), 95%ig nach $^1$H-NMR.

Analog können folgende Verbindungen dargestellt werden. Zur Aufreinigung kann auch Säulen-chro¬ma¬tographie verwendet werden, oder zur Umkristallisation oder Heiß-ex¬trak¬tion können andere gängige Lösungsmittel wie Ethanol, Butanol, Aceton, Ethylacetat, Acetonitril, Toluol, Xylol, Dichlormethan, Methanol, Tetrahydrofuran, n Butylacetat, 1,4-Dioxan oder zur Umkristallisation Hoch-sieder wie Dimethylsulfoxid, N,N Dimethyl-formamid, N,N-Di¬methyl-acet¬amid, N-Methylpyrrolidon, etc. verwendet werden.

| Edukt 1 | Produkt | Ausbeute |
|---|---|---|
| 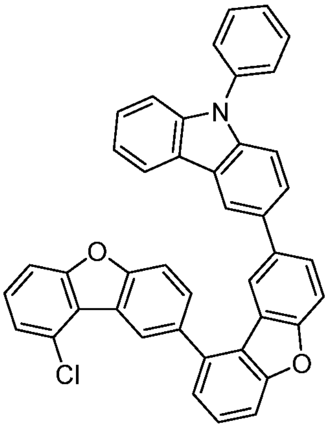 S2a | 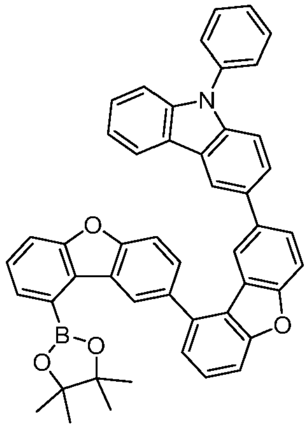 S2b | 79% |
| 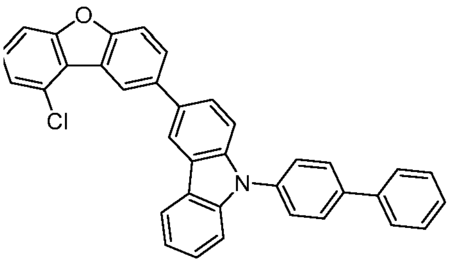 S3a | 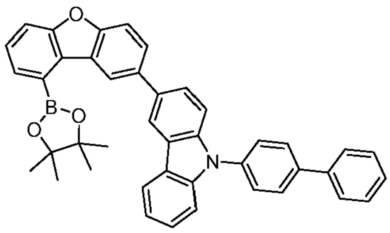 S3b | 70% |
| 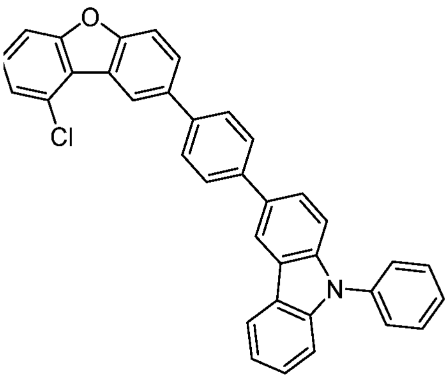 S4a | 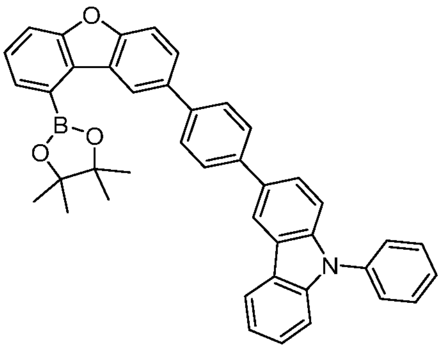 S4b | 66% |
| 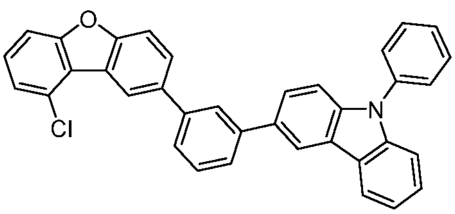 S5a | 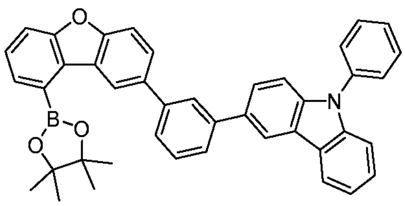 S5b | 67% |

(fortgesetzt)

| Edukt 1 | Produkt | Ausbeute |
|---|---|---|
| 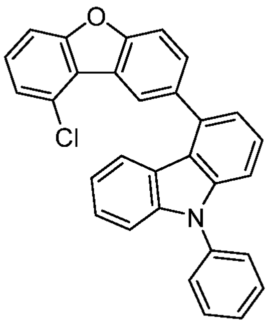 S6a | 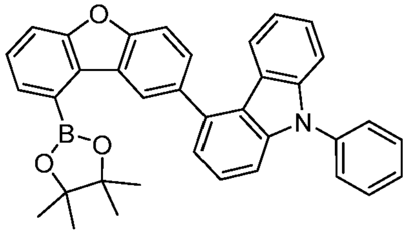 S6b | 72% |
| 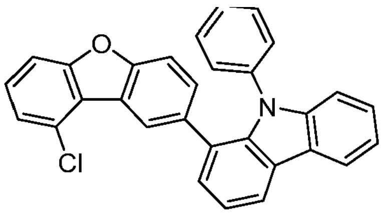 S7a | 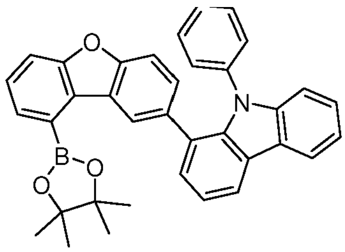 S7b | 64% |
| 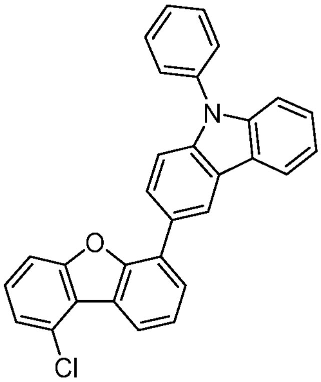 S8a | 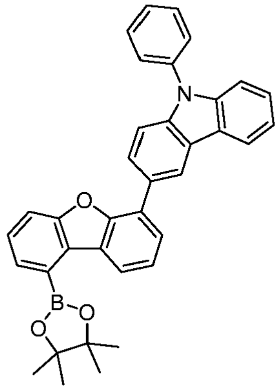 S8b | 78% |
| 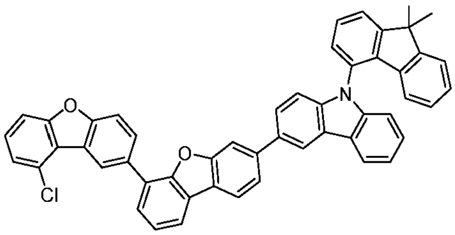 S9a | 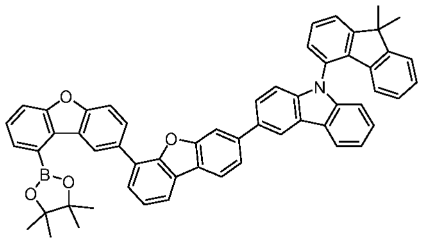 S9b | 59% |

(fortgesetzt)

| Edukt 1 | Produkt | Ausbeute |
|---|---|---|
| 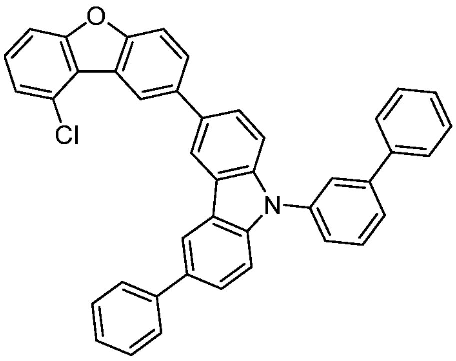 S10a | 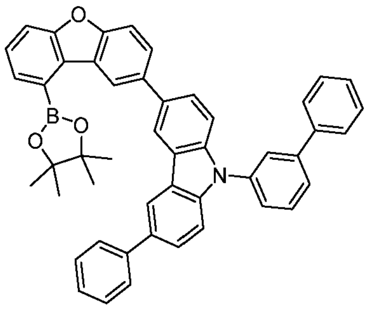 S10b | 71% |
| 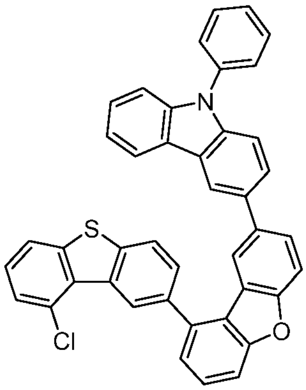 S11a | 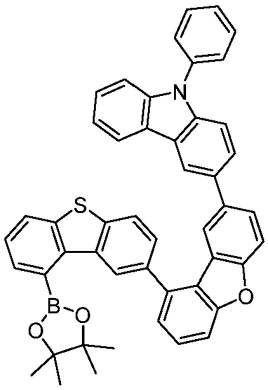 S11b | 67% |
| 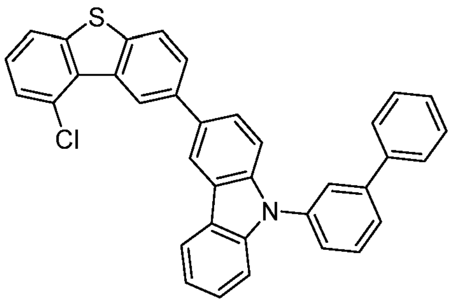 S12a | 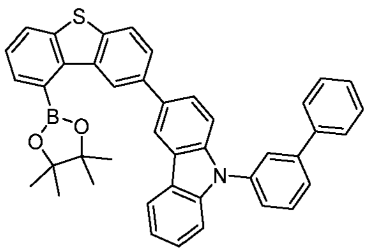 S12b | 80% |
| 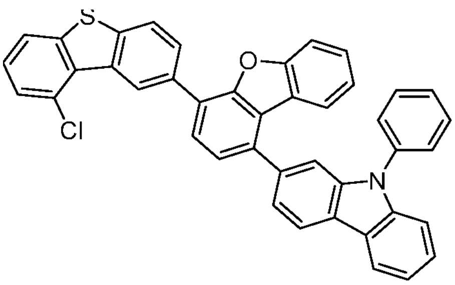 S13a | 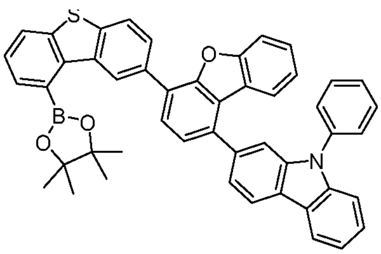 S13b | 82% |

**E1**

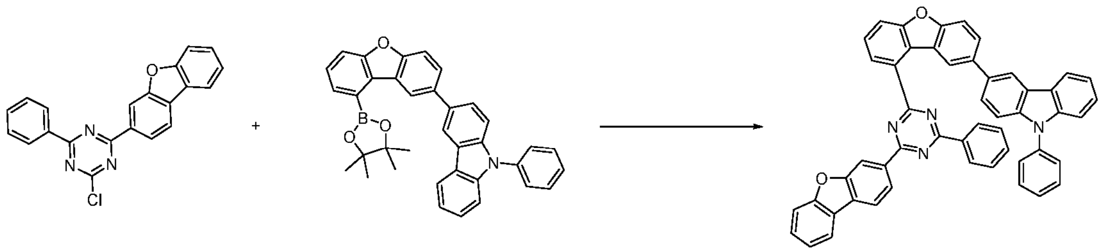

9-Phenyl-3-[9-(4,4,5,5-tetramethyl-[1,3,2]dioxaborolan-2-yl)-dibenzofuran-2-yl]-9H-carbazol (22.00 g, 41.1 mmol) [2239299-50-2], 2-chloro-4-{8-oxatricyclo[7.4.0.0$^{2}$,7]trideca-1(13),2(7),3,5,9,11-hexaen-5-yl}-6-phenyl-1,3,5-triazin (14.70 g, 41.1 mmol) [CAS-2142681-84-1] werden in THF (650 mL) und Wasser (250 mL) unter inerter Atmosphäre vorgelegt, mit $Na_2CO_3$ (9.58 g, 90.4 mmol) und Tetrakis(triphenylphosphin)palladium(0) (710 mg, 0.62 mmol) versetzt und für 16 h unter Rückfluss gerührt. Nach dem Abkühlen wird der Ansatz extraktiv mit Toluol/Wasser aufgearbeitet, die wässrige Phase drei Mal mit Toluol (je 250 mL) extrahiert und die vereinigten organischen Phasen über $Na_2SO_4$ getrocknet. Das Rohprodukt wir zwei Mal mit Heptan/Toluol heißextrahiert, zwei Mal aus n-Butylacetat umkristallisiert und abschließend im Hochvakuum sublimiert.

Ausbeute: 15.5 g (21.2 mmol, 52%); Reinheit > 99.9% nach HPLC.

Analog können weitere Verbindungen dargestellt werden, bei denen S1b bis S13b oder kommerziell verfügbare Verbindungen, wie die Verbindungen mit den CAS-Nummern CAS-2239299-50-2, CAS-2299272-36-7 mit Triazinderivaten entsprechend zu den Verbindungen E2 bis E38 umgesetzt wird.

Weitere Triazinderivate und Dibenzofuranderivate, die für diese Synthesen verwendet werden können, sind beispielsweise in der folgenden Tabelle aufgeführt.

| | | |
|---|---|---|
| 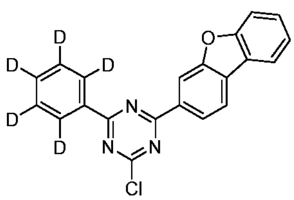 | 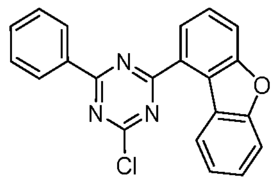 | 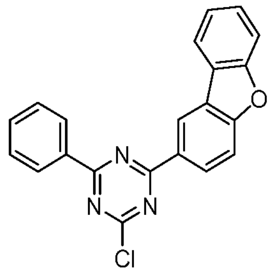 |
| CAS- 2226747-65-3 | CAS-1883265-32-4 | CAS-1618107-00-8 |
| 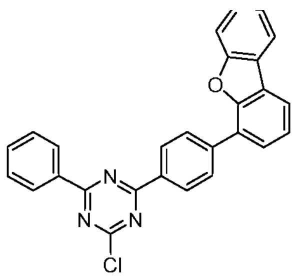 | 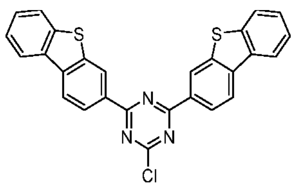 | 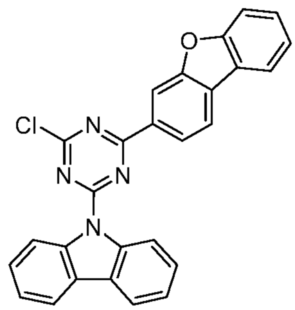 |
| CAS-2074632-09-8 | CAS-2172944-02-2 | CAS-2260688-95-5 |
| 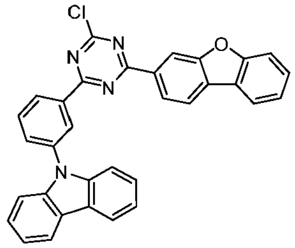 | 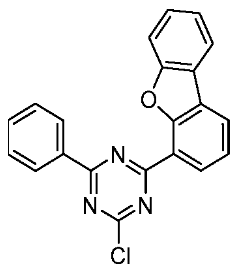 | 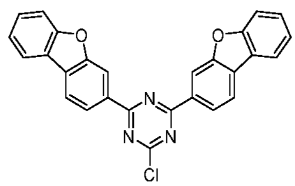 |

(fortgesetzt)

| | | |
|---|---|---|
| | CAS-1472729-25-1 | CAS-2251105-15-2 |
| 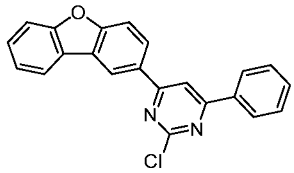 | 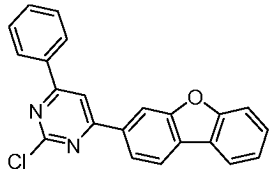 | |
| CAS-1421599-32-7 | CAS-2286234-09-9 | |
| 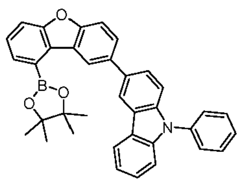 | 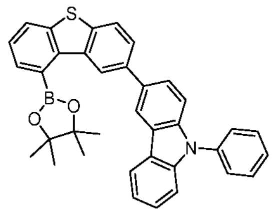 | |
| CAS-2239299-50-2 | CAS-2299272-36-7 | |

Hierbei kann als Katalysatorsystem (Palladiumquelle und Ligand) auch $Pd_2(dba)_3$ mit SPhos [657408-07-6] oder Bis(triphenylphosphin)-palladium(II)chlorid [13965-03-2] verwendet werden. Zur Aufreinigung kann auch Säulen-chro¬-ma¬tographie verwendet werden, oder zur Umkristallisation oder Heißex¬trak¬tion können andere gängige Lösungsmittel wie Ethanol, Butanol, Aceton, Ethylacetat, Acetonitril, Toluol, Xylol, Dichlormethan, Methanol, Tetrahydrofuran, n Butylacetat, 1,4-Dioxan oder zur Umkristallisation Hoch-sieder wie Dimethylsulfoxid, N,N Dimethyl-formamid, N,N-Di¬methyl-acet¬amid, N-Methylpyrrolidon, etc. verwendet werden.

Synthesebeispiel 2:

**a) 1-Bromo-8-iodo-dibenzofuran**

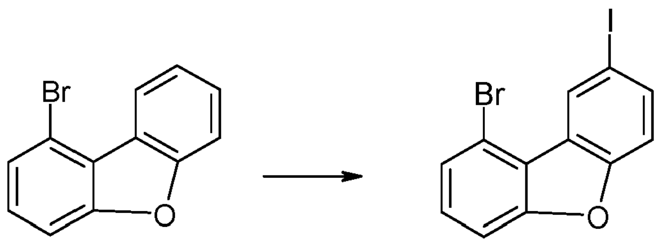

20 g (80 mmol) Dibenzofuran-1-boronsäure, 2.06 g (40,1 mmol) Iod, 3,13 g (17,8 mmol) Iodsäure, 80 ml Essigsäure und 5 ml Schwefelsäure und 5 ml Wasser und 2ml Chloroform werden 3 Stunden bei 65° gerührt. Nach Erkalten wird die Mischung mit Wasser versetzt, der ausgefallene Feststoff abgesagt und dreimal mit Wasser gewaschen.

Der Rückstand wird aus Toluol und aus Dichlormethan/Heptan umkristallisiert. Die Ausbeute beträgt 25,6 g (68 mmol), entsprechend 85 % der Theorie.

**b) 9-(9-Bromodibenzofuran-2-yl)-3-phenyl-carbazol**

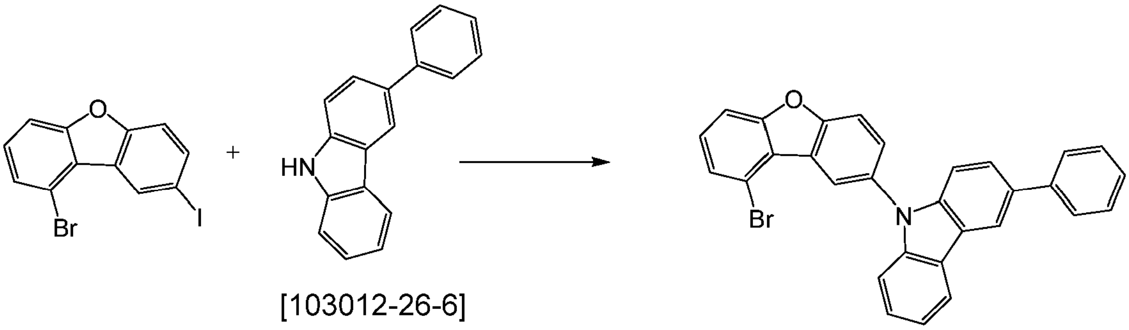

[103012-26-6]

37 g (100 mmol) 3-Phenylcarbazol, 48,5 g (200 mmol) 1-Bromo-8-iodo-dibenzofuran und 2.3 g (20 mmol) L-Prolin werden in 100 ml bei 150 °C für 30 h gerührt Die Lösung wird mit Wasser verdünnt, mit Essigester zweimal extrahiert, die vereinigten organischen Phasen über $Na_2SO_4$ getrocknet und einrotiert. Der Rückstand wird chromatographisch (EtOAc/Hexan: 2/3) gereinigt. Die Ausbeute beträgt 29 g (60mmol) 60 % der Theorie.

Analog dazu werden die folgenden Verbindungen hergestellt:

| | Edukt 1 | Edukt 2 | Produkt | Ausbeute |
|---|---|---|---|---|
| 1b | 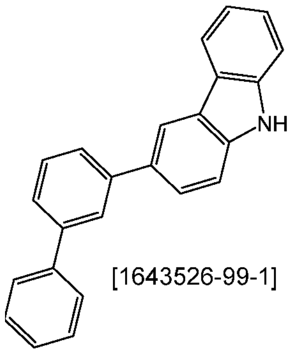 [1643526-99-1] | 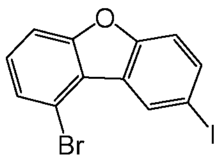 | 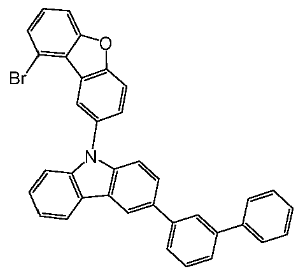 | 57% |
| 2b | 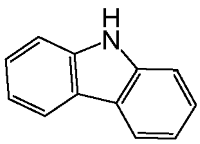 | 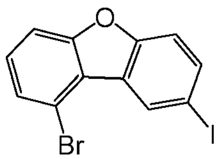 | 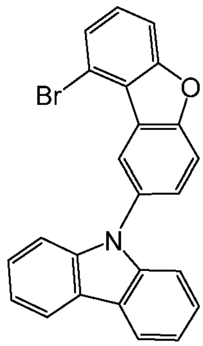 | 61% |

**c) 8-(3-Phenylcarbazol-9-yl)dibenzofuran-1-yl]boronsäure**

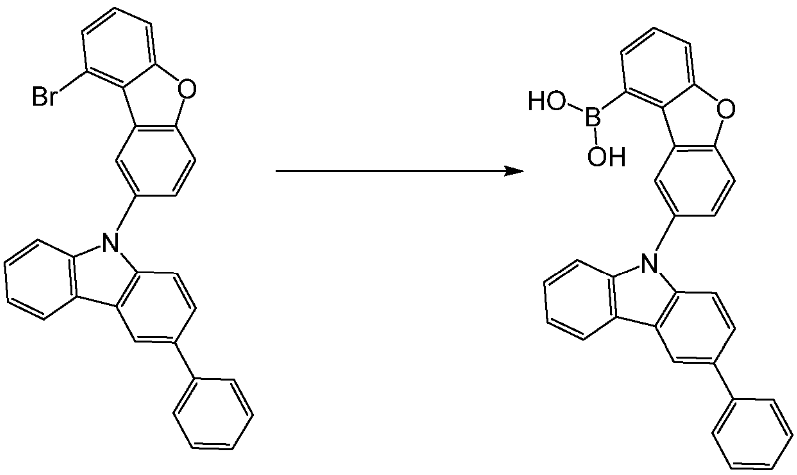

35 g (73 mol) 9-(9-Bromodibenzofuran-2-yl)-3-phenyl-carbazole werden in 150 mL trockenem THF gelöst und auf -78°C gekühlt. Bei dieser Temperatur wird mit 30 mL (76 mmol / 2.5 M in Hexan) n-Butyllithium innerhalb von ca. 5 min. versetzt und anschließend für 2.5h bei -78°C nachgerührt. Bei dieser Temperatur wird mit 15 g (146 mmol) Borsäuretrimethylester versetzt und die Reaktion langsam auf Raumtemperatur kommen gelassen (ca. 18h). Die Reaktionslösung wird mit Wasser gewaschen und der ausgefallene Feststoff und die organische Phase mit Toluol azeotrop getrocknet. Das Rohprodukt wird aus Toluol/Methylenchlorid bei ca. 40°C ausgerührt und abgesaugt. Ausbeute: 29 g (64 mmol), 90 % der Theorie.

Analog dazu werden die folgenden Verbindungen hergestellt:

| | **Edukt 1** | **Produkt** | **Ausbeute** |
|---|---|---|---|
| 1c | 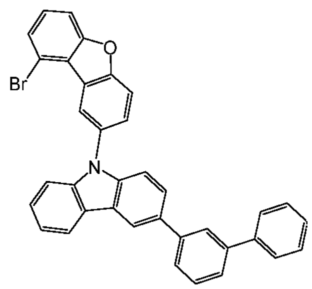 | 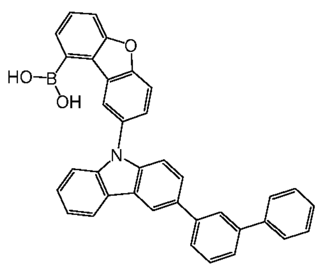 | 95% |
| 2c | 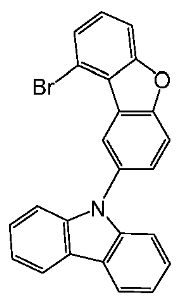 | 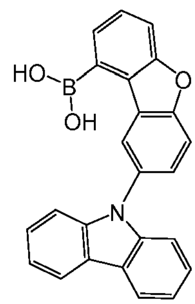 | 89% |

d) 9-[9-(4-Dibenzofuran-3-yl-6-phenyl-1,3,5-triazin-2-yl)dibenzofuran-2-yl]-3-phenyl-carbazol

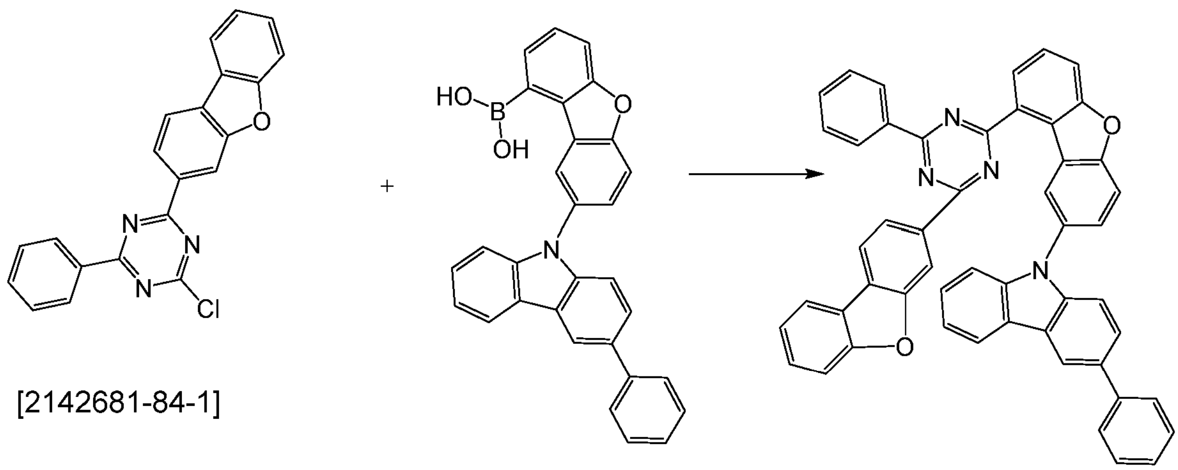

[2142681-84-1]

39.3g (110 mmol) 8-(3-Phenylcarbazol-9-yl)dibenzofuran-1-yl]boronsäure, 29.5 g (110.0 mmol), 2-Chlor-4,6-diphenyl-1,3,5-triazin und 21 g (210.0 mmol) Natriumcarbonat werden in 500 mL Ethylenglycoldiaminether und 500 mL Wasser suspendiert. Zu dieser Suspension werden 913 mg (3.0 mmol) Tri-o-tolylphosphin und dann 112 mg (0.5 mmol) Palladium(II)acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockene eingeengt. Der Rückstand wird aus Toluol und aus Dichlormethan /Heptan umkristallisiert. Die Ausbeute beträgt 71g (98 mmol), entsprechend 89% der Theorie.

Analog dazu werden die folgenden Verbindungen hergestellt:

| | Edukt 1 | Edukt 2 | Produkt | Ausbeute |
|---|---|---|---|---|
| 1d | 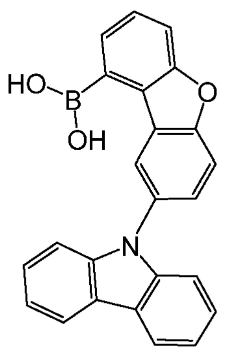 | 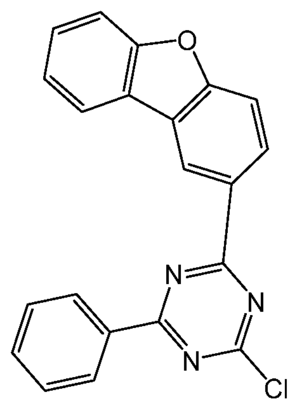 [1618107-00-8] | 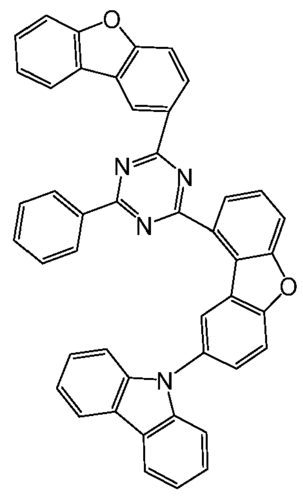 | 75% |
| 2d | 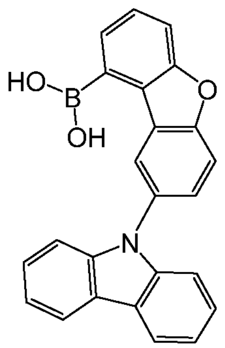 | 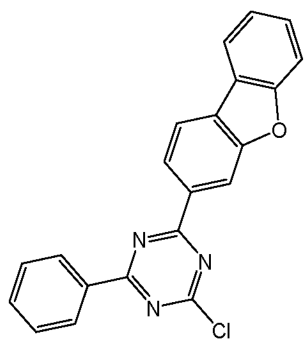 [2142681-84-1] | 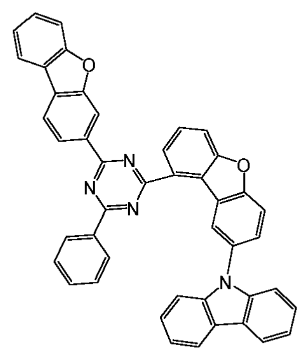 E39 | 71% |

| | | | | |
|---|---|---|---|---|
| 3d | 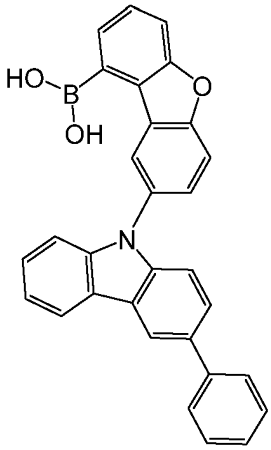 | 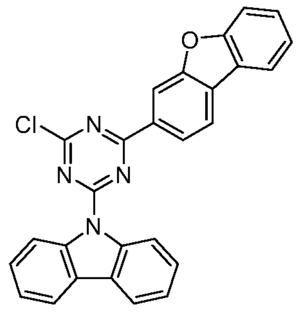 [2260688-95-5] | 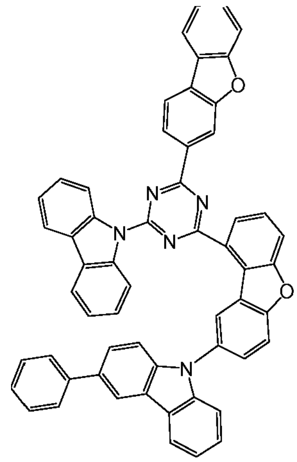 E49 | 63% |
| 4d | 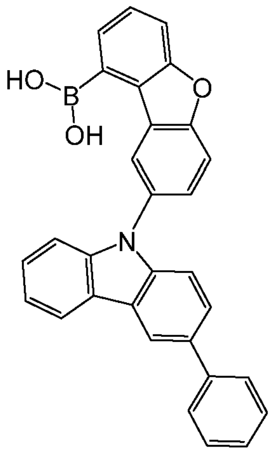 | 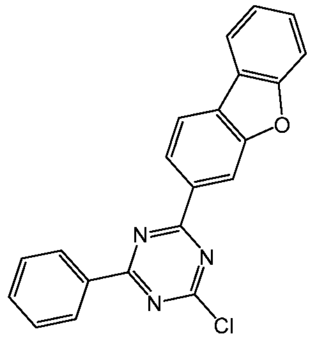 [2142681-84-1] | 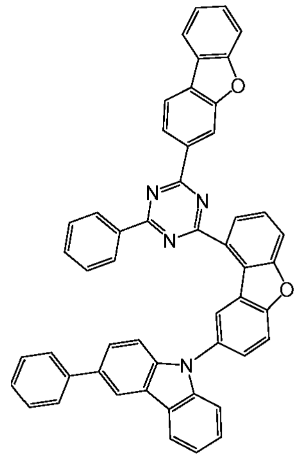 E43 | 67% |
| 5d | 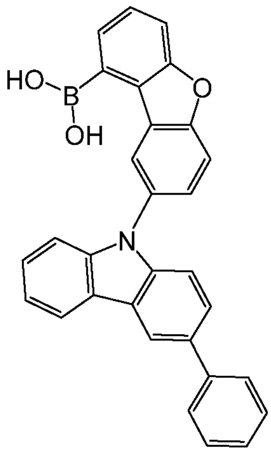 | 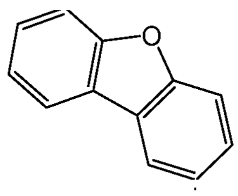 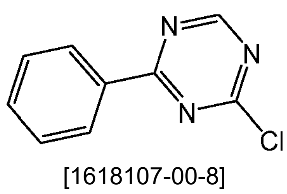 [1618107-00-8] | 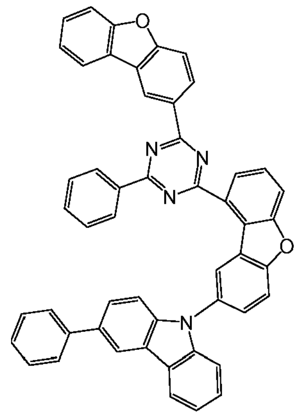 E41 | 80% |

| | | | | |
|---|---|---|---|---|
| 6d | 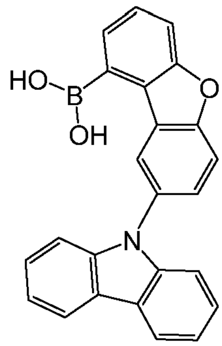 | 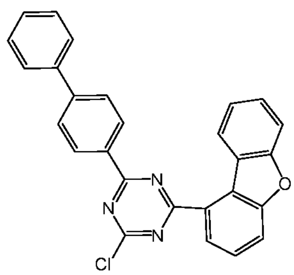 [1883265-34-6] | 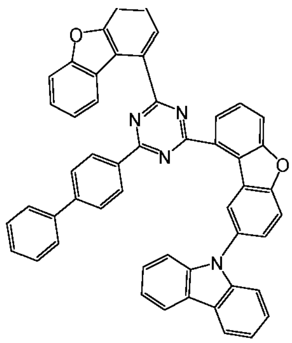 E44 | 77% |
| 7d | 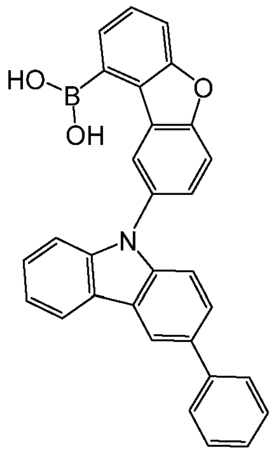 | 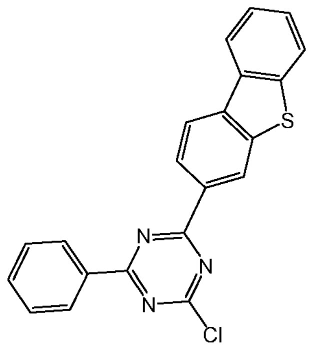 [2172889-29-9] | 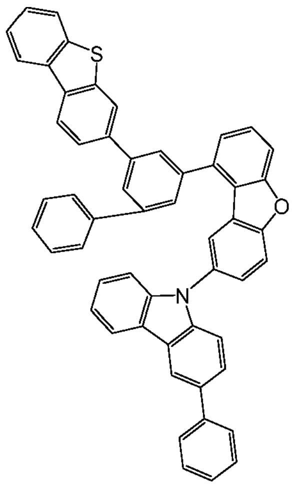 | 79% |
| 8d | 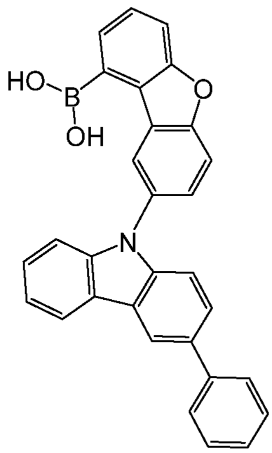 | 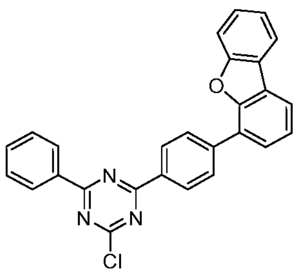 [2074632-09-89 | 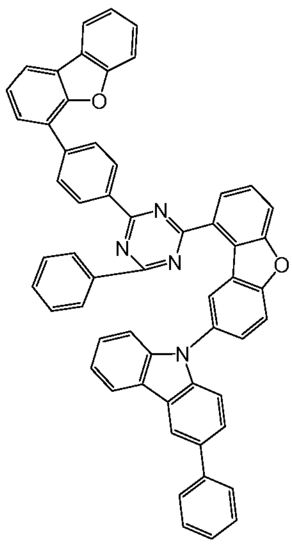 | 76% |

Synthesebeispiel 3:

Allgemeine Deuterierung:

Die Ausgangsverbindung wird in einer Mischung aus deuteriertem Wasser (99% Deuteriumatom) und Toluol-d8 (99% Deuteriumatom) gelöst und 96 Stunden lang unter Druck in Gegenwart von trockenem Platin auf Kohle (5%) als Katalysator auf 160°C erhitzt. Nach dem Abkühlen des Reaktionsgemisches werden die Phasen getrennt und die wässrige Phase zweimal mit dem Tetrahydrofuran-Toluol-Gemisch extrahiert. Die rekombinierten organischen Phasen werden mit einer Natriumchloridlösung gewaschen, über Natriumsulfat getrocknet und filtriert. Das Lösungsmittel wird im Vakuum entfernt, um die rohe deuterierte Verbindung als Feststoff zu liefern. Die Verbindung wird durch Extraktion,

Kristallisation und Sublimation weiter gereinigt.

**Beispiel A: 1,1',2',3',4',5',6,6',7',8,8'-Undecadeuterio-N-(2,3,6,7,8-pentadeuterio-9,9-dimethyl-fluoren-4-yl)-N-(3,4,6,7,8-pentadeuterio-9,9-dimethyl-fluoren-2-yl)-9,9'-spirobi[fluoren]-4-amin**

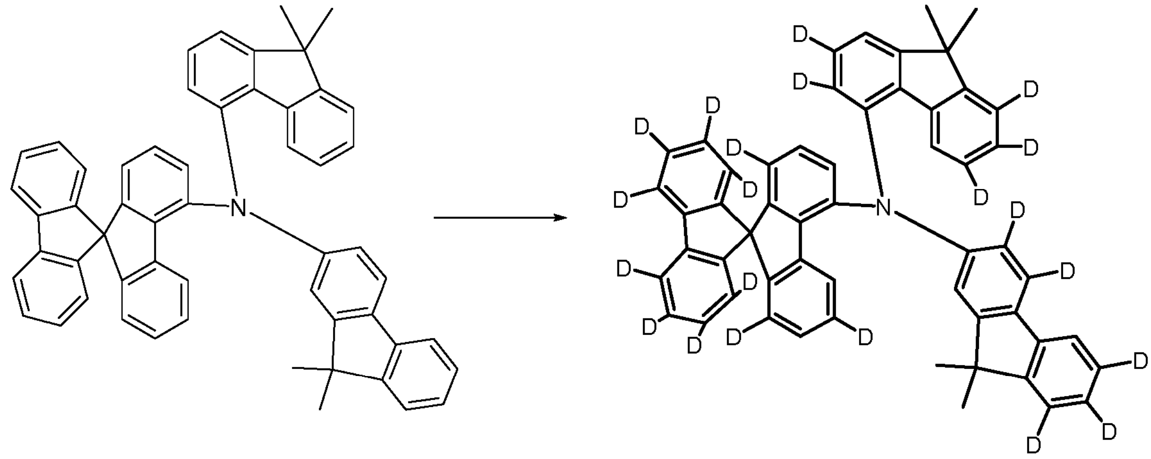

H5

Es wird N-(9,9-Dimethylfluoren-2-yl)-N-(9,9-dimethylfluoren-4-yl)-9,9'-spirobi[fluoren]-4'-amin (22,8 g, 32 mmol), Toluol-d8 (231 g, 2,31 mol), deuteriertes Wasser (1300 g, 64,9 mol) und trockenes Platin auf Kohle (5%) (30 g) 24 h bei 130°C gerührt. Das Rohprodukt wird durch zweimaliges Extrahieren mit einer Mischung aus Heptan und Toluol (4:1) und zweimaliges Sublimieren weiter gereinigt.

Ausbeute: 21,2g (28 mmol, 90 %) mit einer Reinheit von > 99,9 %. Die Identität wird durch HPLC-MS und 1H-NMR bestätigt.

**Beispiel B: 1,2,3,5,6,7,8-Heptadeuterio-N-[1,2,3,5,6,7,8-heptadeuterio-9,9-bis(trideuteriomethyl)fluoren-4-yl]-9,9-bis(trideuteriomethyl)-N-[2,3,5-trideuterio-4-(2,3,4,5,6-pentadeuteriophenyl)phenyl]fluoren-4-amin**

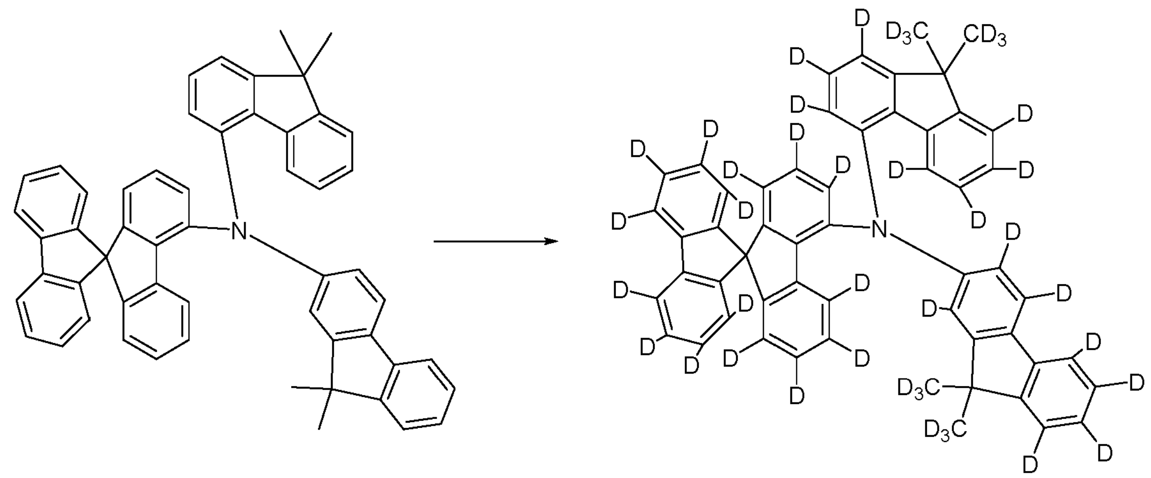

H2

Es wird N-(9,9-Dimethylfluoren-2-yl)-N-(9,9-dimethylfluoren-4-yl)-9,9'-spirobi[fluoren]-4'-amin (22.8 g, 31,8 mmol), Toluol-d8 (231 g, 2,31 mol), deuteriertes Wasser (1300 g, 64,9 mol) und trockenes Platin auf Kohle (5%) (30 g) 96 h bei 160°C gerührt. Das Rohprodukt wird durch zweimaliges Extrahieren mit einer Mischung aus Heptan und Toluol (4:1) und zweimaliges Sublimieren weiter gereinigt.

Ausbeute: 21,9 g (28,9 mmol, 95 %) mit einer Reinheit von > 99,9 %. Die Identität wird durch HPLC-MS bestätigt.

Analog dazu können die folgenden Verbindungen hergestellt werden: Die Ausbeute liegt in allen Fällen zwischen 40% und 90%.

| | Edukt | Produkt |
|---|---|---|
| 1 | 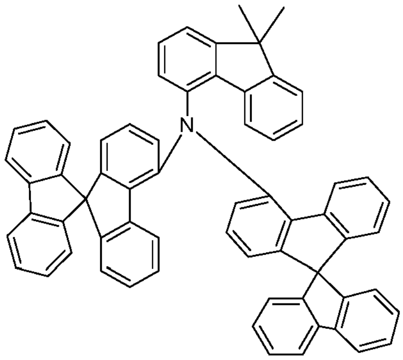 | 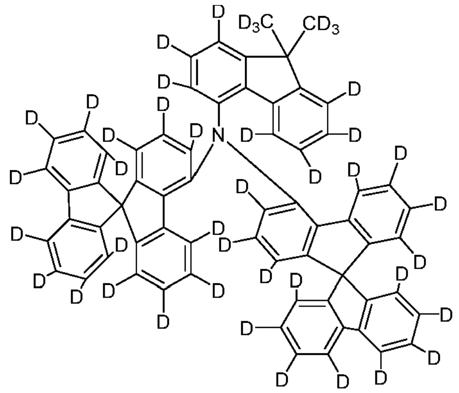 H1 |
| 2 | 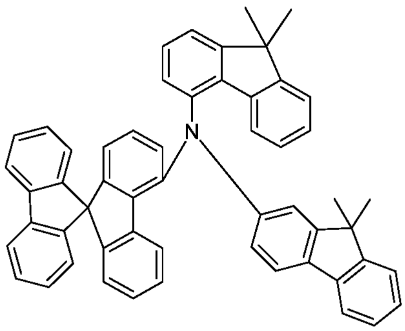 | 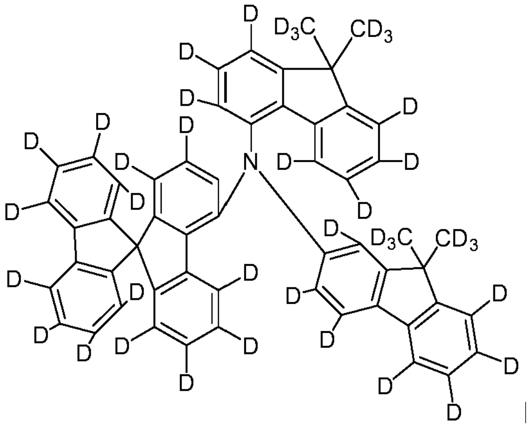 H3 |
| 3 | 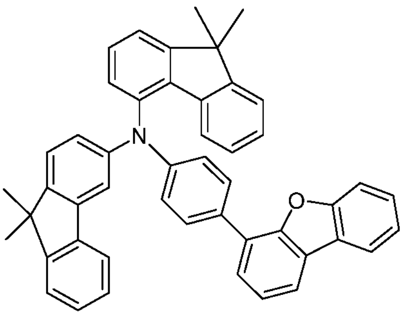 | 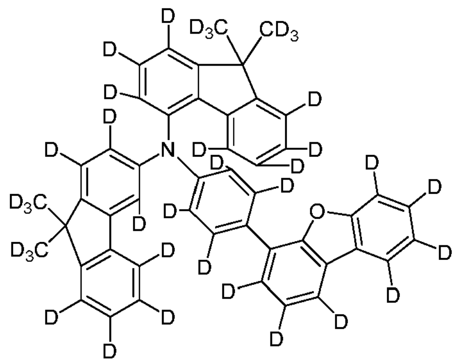 H4 |

(fortgesetzt)

| | Edukt | Produkt |
|---|---|---|
| 4 | 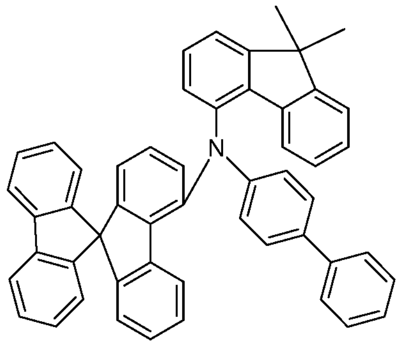 | 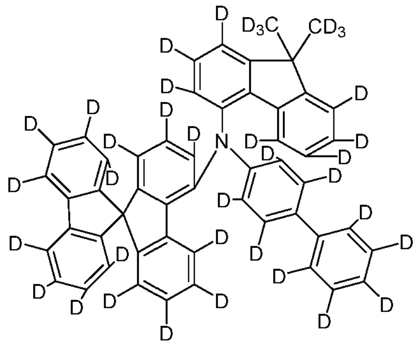 |
| 5 | 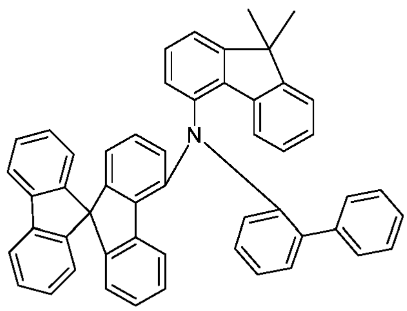 | 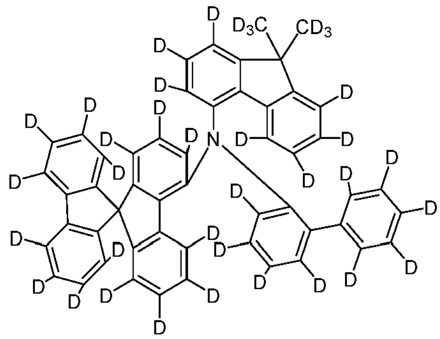 H6 |
| 6 | 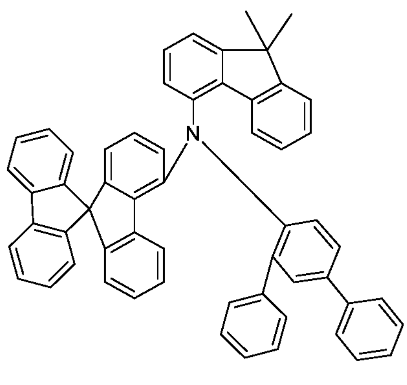 | 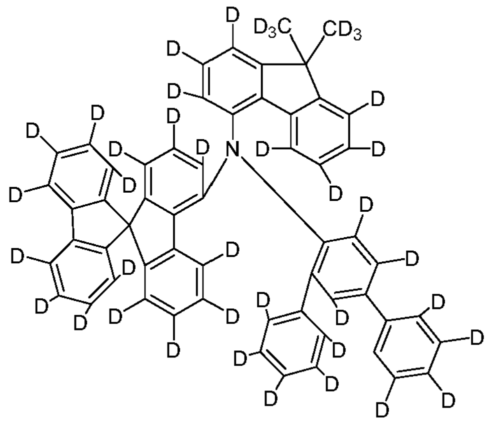 H7 |
| 7 | 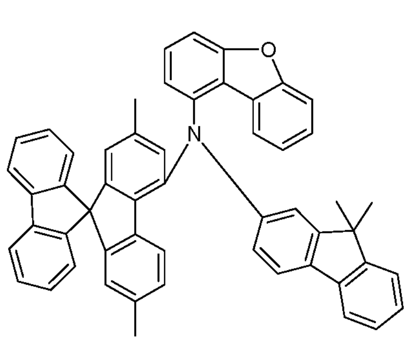 | 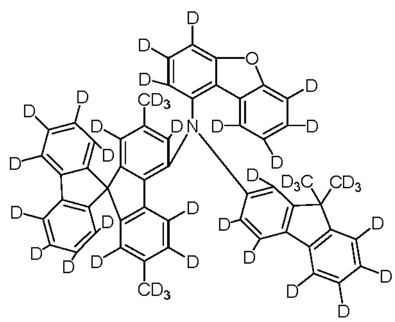 H9 |

(fortgesetzt)

| | Edukt | Produkt |
|---|---|---|
| 8 | 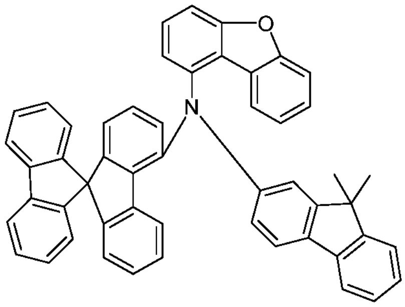 | 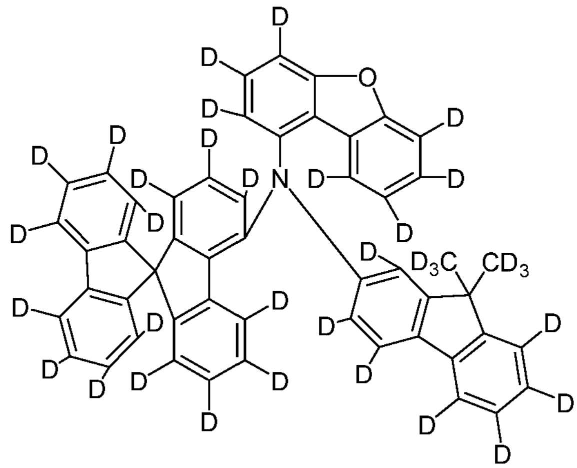<br>H10 |
| 9 | 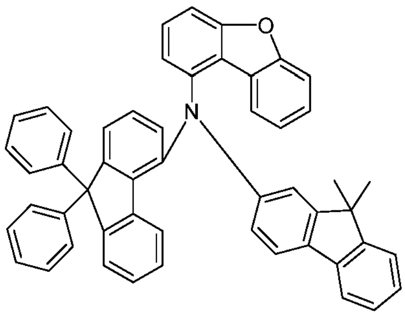 | 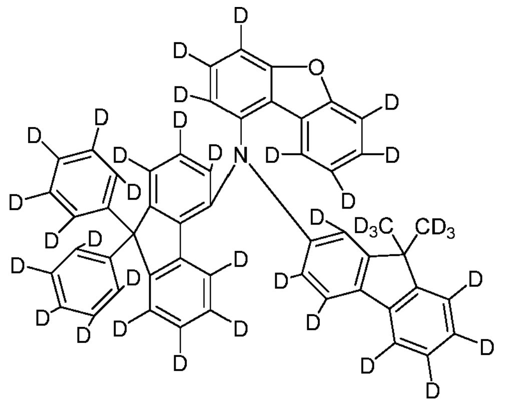<br>H11 |
| 10 | 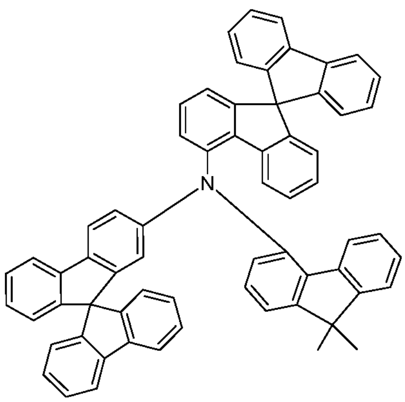 | 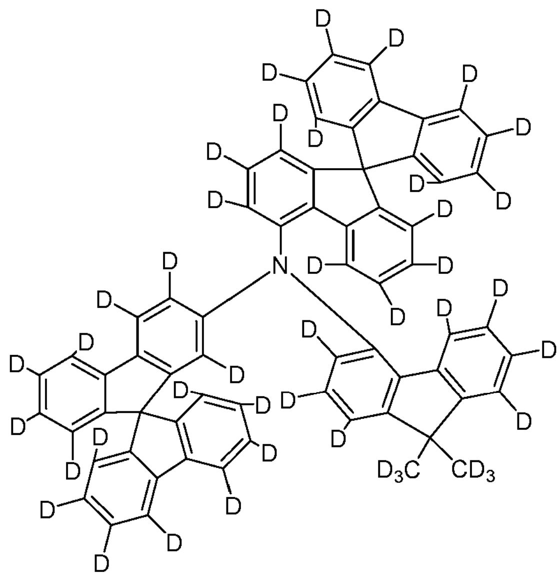<br>H14 |

(fortgesetzt)

| | Edukt | Produkt |
|---|---|---|
| 11 | 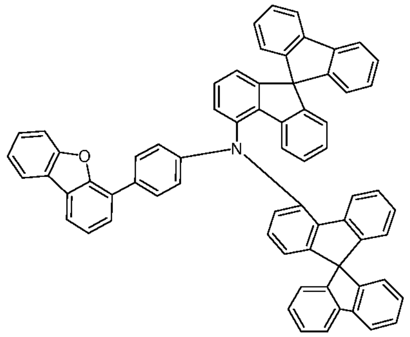 | 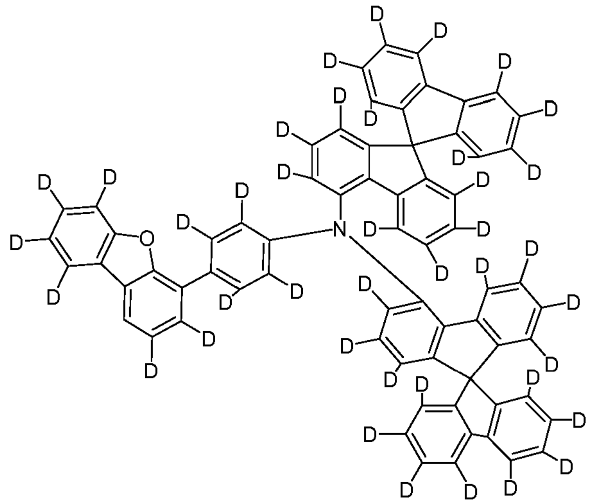 H15 |
| 12 | 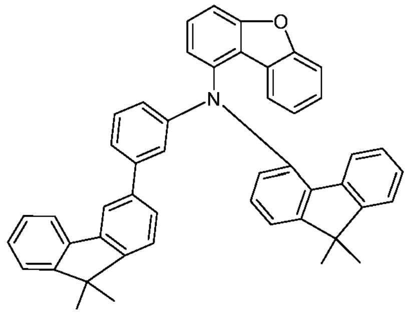 | 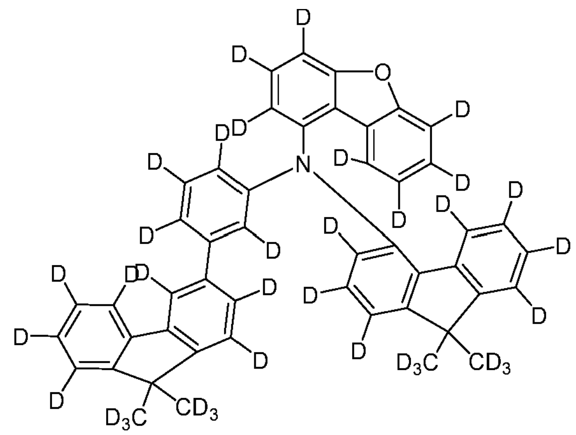 |

**Herstellung der OLEDs**

In den folgenden Beispielen V1 bis V4 und B1 bis B15 (siehe Tabellen 8 und 9) werden die Daten verschiedener OLEDs vorgestellt.

**Vorbehandlung für die Beispiele V1- B15:** Glasplättchen, die mit strukturiertem ITO (Indium Zinn Oxid) der Dicke 50 nm beschichtet sind, werden vor der Beschichtung mit einem Sauerstoffplasma, gefolgt von einem Argonplasma, behandelt. Diese mit Plasma behandelten Glasplättchen bilden die Substrate, auf welche die OLEDs aufgebracht werden.

Die OLEDs haben prinzipiell folgenden Schichtaufbau: Substrat / Lochinjektionsschicht (HIL) / Lochtransportschicht (HTL) / Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 8 zu entnehmen. Die zur Herstellung der OLEDs benötigten Materialien sind in Tabelle 10 gezeigt, sofern nicht zuvor beschrieben.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie E1:SdT1:TEG1 (32%:60%:8%) bedeutet hierbei, dass das Material E1 in einem Volumenanteil von 32%, SdT1 in einem Anteil von 60% und TEG1 in einem Anteil von 8% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Spannung und die externe Quanteneffizienz (EQE, gemessen in Prozent) in Abhängigkeit der Leuchtdichte, berechnet aus

Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 9 bezeichnet hierbei die Spannung, die für eine Leuchtdichte von 1000 cd/$m^2$ benötigt wird. SE1000 bezeichnet die Stromeffizienz, die bei 1000 cd/$m^2$ erreicht wird.

EQE1000 schließlich bezeichnet die externe Quanteneffizienz bei einer Betriebsleuchtdichte von 1000 cd/$m^2$. Als Lebensdauer LD wird die Zeit definiert, nach der die Leuchtdichte bei Betrieb mit konstanter Stromdichte $j_0$ von der Startleuchtdichte auf einen gewissen Anteil L1 absinkt. Eine Angabe L1=80% in Tabelle 9 bedeutet, dass die in Spalte LD angegebene Lebensdauer der Zeit entspricht, nach der die Leuchtdichte auf 80% ihres Anfangswertes absinkt.

Die Daten der verschiedenen OLEDs sind in Tabelle 9 zusammengefasst. Die Beispiele V1 bis V4 sind Vergleichsbeispiele gemäß dem Stand der Technik, die Beispiele B1-B15 zeigen Daten von erfindungsgemäßen OLEDs.

Im Folgenden werden einige der Beispiele näher erläutert, um die Vorteile der erfindungsgemäßen OLEDs zu verdeutlichen.

**Verwendung von erfindungsgemäßen Mischungen in der Emissionsschicht phosphoreszenter OLEDs**

Die erfindungsgemäßen Materialien ergeben beim Einsatz als Matrixmaterial in Kombination mit deuteriertem Monoamine in der Emissionsschicht (EML) in phosphoreszierenden OLEDs wesentliche Verbesserungen gegenüber dem Stand der Technik, vor allem bezüglich der Lebensdauer und der externen Quanteneffizienz der OLEDs. Durch Einsatz der erfindungsgemäßen Materialkombinationen lässt sich eine Verbesserung der EQE um ca. 5-10% gegenüber den Verbindungen aus dem Stand der Technik SdT1, und Steigerung des Lebensdauer um 30-100% beobachten (Vergleich der Beispiele V2, mit Beispiel B2 und Vergleich von V4 mit B6).

Tabelle 8: Aufbau der OLEDs

| Bsp | HIL Dicke | HTL Dicke | EBL Dicke | EML Dicke | HBL Dicke | ETL Dicke | EIL Dicke |
|---|---|---|---|---|---|---|---|
| V1 | SpMA1:PD1 (95%:5%) 20nm | SpMA 1 230n m | SpMA3 20nm | E1:SdT1:TEG1 (32%:60%:8%) 40nm | ST2 5nm | ST2:LiQ (50%:50% ) 40nm | LiQ 1nm |
| V1 | SpMA1:PD1 (95%:5%) 20nm | SpMA 1 230n m | SpMA3 20nm | E1:SdT2:TEG1 (32%:60%:8%) 40nm | ST2 5nm | ST2:LiQ (50%:50% ) 40nm | LiQ 1nm |
| B1 | SpMA1:PD1 (95%:5%) 20nm | SpMA 1 230n m | SpMA3 20nm | E1:H5:TEG1 (32%:60%:8%) 40nm | ST2 5nm | ST2:LiQ (50%:50% ) 40nm | LiQ 1nm |
| B2 | SpMA1:PD1 (95%:5%) 20nm | SpMA 1 230n m | SpMA3 20nm | E1:H2:TEG1 (32%:60%:8%) 40nm | ST2 5nm | ST2:LiQ (50%:50% ) 40nm | LiQ 1nm |
| B3 | SpMA1:PD1 (95%:5%) 20nm | SpMA 1 230n m | SpMA3 20nm | E1:H1:TEG2 (32%:60%:8%) 40nm | ST2 5nm | ST2:LiQ (50%:50% ) 40nm | LiQ 1nm |
| B4 | SpMA1:PD1 (95%:5%) 20nm | SpMA 1 230n m | SpMA3 20nm | E1:H2:TEG2 (32%:60%:8%) 40nm | ST2 5nm | ST2:LiQ (50%:50% ) 40nm | LiQ 1nm |
| V3 | SpMA1:PD1 (95%:5%) 20nm | SpMA 1 230n m | SpMA3 20nm | E39:SdT1:TEG1 (32%:60%:8%) 40nm | ST2 5nm | ST2:LiQ (50%:50% ) 40nm | LiQ 1nm |

(fortgesetzt)

| Bsp | HIL Dicke | HTL Dicke | EBL Dicke | EML Dicke | HBL Dicke | ETL Dicke | EIL Dicke |
|---|---|---|---|---|---|---|---|
| V4 | SpMA1:PD1 (95%:5%) 20nm | SpMA 1 230n m | SpMA3 20nm | E39:SdT2:TEG1 (32%:60%:8%) 40nm | ST2 5nm | ST2:LiQ (50%:50% ) 40nm | LiQ 1nm |
| B5 | SpMA1:PD1 (95%:5%) 20nm | SpMA 1 230n m | SpMA3 20nm | E39:H5;TEG1 (32%:60%:8%) 40nm | ST2 5nm | ST2:LiQ (50%:50% ) 40nm | LiQ 1nm |
| B6 | SpMA1:PD1 (95%:5%) 20nm | SpMA 1 230n m | SpMA3 20nm | E39:H2:TEG1 (32%:60%:8%) 40nm | ST2 5nm | ST2:LiQ (50%:50% ) 40nm | LiQ 1nm |
| B7 | SpMA1:PD1 (95%:5%) 20nm | SpMA 1 230n m | SpMA3 20nm | E39:H2:TEG2 (32%:60%:8%) 40nm | ST2 5nm | ST2:LiQ (50%:50% ) 40nm | LiQ 1nm |
| B8 | SpMA1:PD1 (95%:5%) 20nm | SpMA 1 230n m | SpMA3 20nm | E39:H1:TEG1 (32%:60%:8%) 40nm | ST2 5nm | ST2:LiQ (50%:50% ) 40nm | LiQ 1nm |
| B9 | SpMA1:PD1 (95%:5%) 20nm | SpMA 1 230n m | SpMA3 20nm | E2: H2:TEG1 (32%:60%:8%) 40nm | ST2 5nm | ST2:LiQ (50%:50% ) 40nm | LiQ 1nm |
| B10 | SpMA1:PD1 (95%:5%) 20nm | SpMA 1 230n m | SpMA3 20nm | E3: H4:TEG1 (32%:60%:8%) 40nm | ST2 5nm | ST2:LiQ (50%:50% ) 40nm | LiQ 1nm |
| B11 | SpMA1:PD1 (95%:5%) 20nm | SpMA 1 240n m | SpMA3 20nm | E26: H10:TEG1 (32%:60%:8%) 40nm | ST2 5nm | ST2:LiQ (50%:50% ) 40nm | LiQ 1nm |
| B12 | SpMA1:PD1 (95%:5%) 20nm | SpMA 1 230n m | SpMA3 20nm | E35: H11:TEG1 (32%:60%:8%) 40nm | ST2 5nm | ST2:LiQ (50%:50% ) 40nm | LiQ 1nm |
| B13 | SpMA1:PD1 (95%:5%) 20nm | SpMA 1 230n m | SpMA3 20nm | E40: H2:TEG1 (32%:60%:8%) 40nm | ST2 5nm | ST2:LiQ (50%:50% ) 40nm | LiQ 1nm |
| B14 | SpMA1:PD1 (95%:5%) 20nm | SpMA 1 240n m | SpMA3 20nm | E40: H1:TEG1 (32%:60%:8%) 40nm | ST2 5nm | ST2:LiQ (50%:50% ) 40nm | LiQ 1nm |
| B15 | SpMA1:PD1 (95%:5%) 20nm | SpMA 1 240n m | SpMA3 20nm | E46: H1:TEG1 (32%:60%:8%) 40nm | ST2 5nm | ST2:LiQ (50%:50% ) 40nm | LiQ 1nm |

Tabelle 9: Daten der OLEDs

| Bsp. | U1000 (V) | EQE1000 (%) | CIE x/y bei 1000 cd/m$^2$ | $j_0$ (mA/cm$^2$) | L1 (%) | LD (h) |
|---|---|---|---|---|---|---|
| V1 | 4.4 | 19.1 | 0.33/0.63 | 40 | 80 | 350 |
| V2 | 4.2 | 21.9 | 0.33/0.63 | 40 | 80 | 630 |
| B1 | 4.1 | 21.4 | 0.34/0.62 | 40 | 80 | 980 |
| B2 | 4.0 | 23.0 | 0.35/0.63 | 40 | 80 | 1270 |
| B3 | 4.0 | 20.8 | 0.34/0.63 | 40 | 80 | 1212 |
| B4 | 4.1 | 22.7 | 0.35/0.63 | 40 | 80 | 1189 |
| V3 | 4.6 | 18.0 | 0.34/0.63 | 40 | 80 | 340 |
| V4 | 4.2 | 20.7 | 0.34/0.63 | 40 | 80 | 620 |
| B5 | 4.3 | 21.3 | 0.35/0.63 | 40 | 80 | 965 |
| B6 | 4.1 | 23.0 | 0.34/0.63 | 40 | 80 | 1244 |
| B7 | 4.0 | 20.3 | 0.33/0.63 | 40 | 80 | 1214 |
| B8 | 4.0 | 22.5 | 0.34/0.63 | 40 | 80 | 1202 |
| B9 | 4.2 | 22.8 | 0.35/0.63 | 40 | 80 | 1100 |
| B10 | 4.1 | 22.1 | 0.34/0.63 | 40 | 80 | 1067 |
| B11 | 4.2 | 22.3 | 0.34/0.62 | 40 | 80 | 1190 |
| B12 | 4.2 | 23.0 | 0.34/0.62 | 40 | 80 | 1022 |
| B13 | 4.0 | 23.3 | 0.34/0.63 | 40 | 80 | 1130 |
| B14 | 4.1 | 22.1 | 0.35/0.62 | 40 | 80 | 1007 |
| B15 | 4.1 | 23.2 | 0.33/0.63 | 40 | 80 | 1201 |

Tabelle 10: Strukturformeln der Materialien für die OLEDs

| | |
|---|---|
| 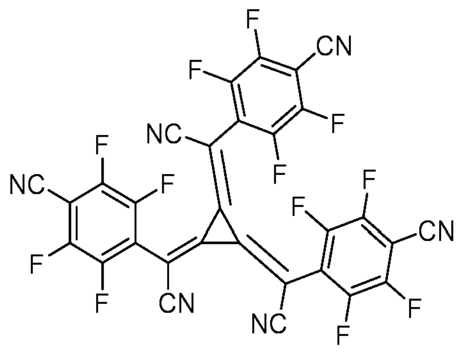 | 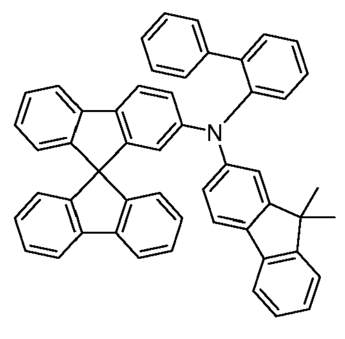 |
| PD1 | SpMA1 |
| 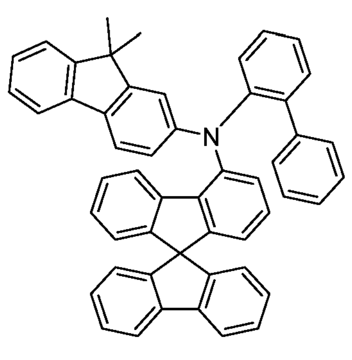 | 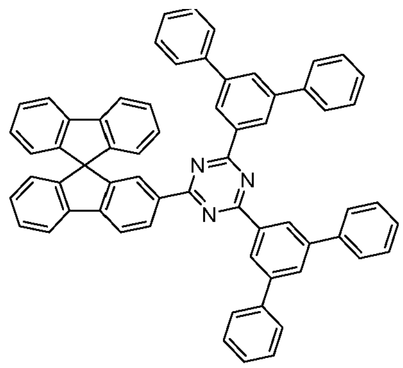 |

(fortgesetzt)

| SpMA3 | ST2 |
|---|---|
| 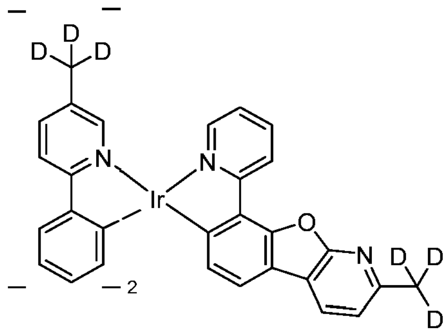 | 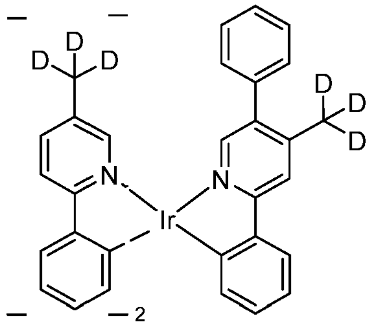 |
| TEG1 | TEG2 |
| 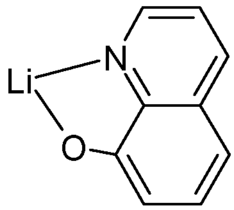 | 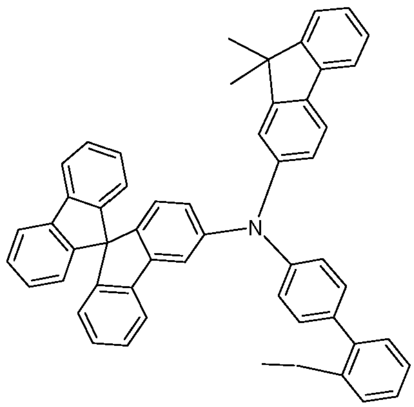 1450933-37-5 |
| LiQ | SdT1 (WO2021107728 ) |
| 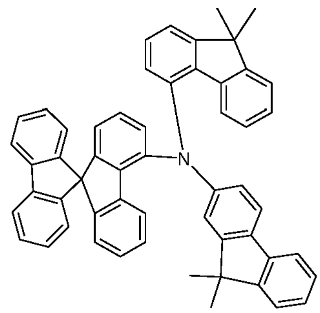 2647462-04-0 | |
| SdT2 (WO2021107728 ) | |

**Patentansprüche**

1. Organische elektrolumineszierende Vorrichtung umfassend eine Anode, eine Kathode und mindestens eine organische Schicht, enthaltend mindestens eine lichtemittierende Schicht, wobei die mindestens eine lichtemittierende Schicht mindestens eine Verbindung der Formel (1) als Hostmaterial 1 und mindestens eine Verbindung der Formel (2) als Hostmaterial 2 enthält,

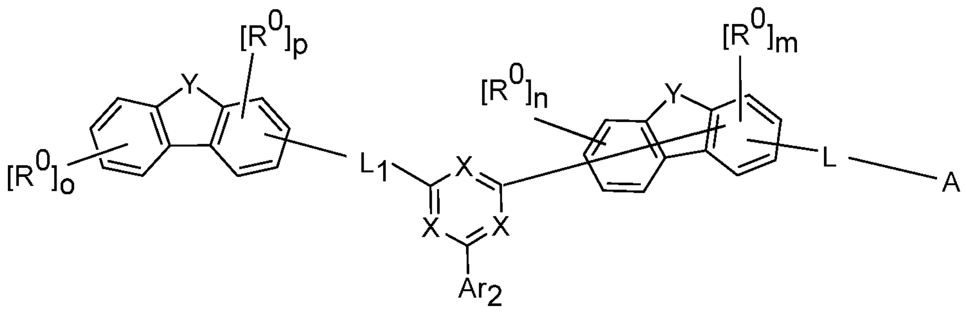

Formel (1)

,

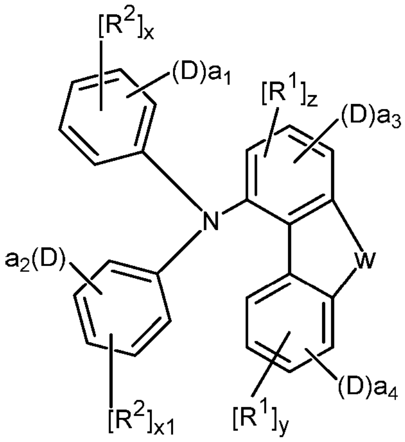

Formel (2),

wobei für die verwendeten Symbole und Indizes gilt:

A ist

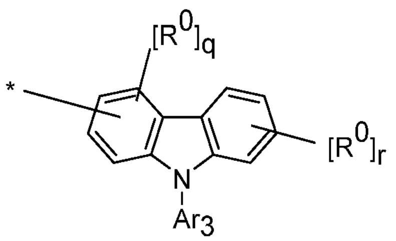

oder

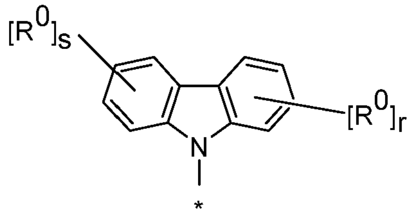

,

X ist bei jedem Auftreten gleich oder verschieden $CR^0$ oder N, wobei mindestens ein Symbol X für N steht;

Y ist bei jedem Auftreten gleich oder verschieden ausgewählt aus O oder S;

* kennzeichnet die Bindungsstelle an die Formel (1);

L und $L_1$ sind bei jedem Auftreten gleich oder verschieden eine Einfachbindung oder ein aromatisches oder heteroaromatisches Ringsystem mit 5 bis 30 aromatischen Ringatomen;

W ist O, S, $C(R)_2$;

R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;

$R^0$ ist bei jedem Auftreten unabhängig voneinander D, ein unsubstituiertes oder teilweise oder vollständig

deuteriertes aromatisches Ringsystem mit 6 bis 18 C-Atomen oder ein unsubstituiertes oder teilweise oder vollständig deuteriertes Dibenzofuran, Dibenzothiophen oder über C gebundenes N-Aryl-Carbazol;

$Ar_1$ ist bei jedem Auftreten gleich oder verschieden ein aromatisches oder heteroaromatisches Ringsystem mit 5 bis 30 aromatischen Ringatomen, das mit einem oder mehreren nicht-aromatischen Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$Ar_2$ ist jeweils unabhängig voneinander bei jedem Auftreten eine Aryl- oder Heteroarylgruppe mit 5 bis 40 aromatischen Ringatomen, die mit einem oder mehreren Resten R' substituiert sein kann;

$Ar_3$ ist jeweils unabhängig voneinander bei jedem Auftreten ein aromatisches Ringsystem mit 6 bis 40 aromatischen Ringatomen oder ein heteroaromatisches Ringsystem mit 5 bis 40 aromatischen Ringatomen, das mit einem oder mehreren Resten R' substituiert sein kann;

Aryl ist bei jedem Auftreten gleich oder verschieden ein aromatisches oder heteroaromatisches Ringsystem mit 5 bis 30 aromatischen Ringatomen, das mit einem oder mehreren nicht-aromatischen Resten R' substituiert sein kann;

R' ist bei jedem Auftreten gleich oder verschieden ausgewählt aus der Gruppe bestehend aus D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten R' ein monocyclisches oder polycyclisches, aliphatisches, aromatisches oder heteroaromatisches Ringsystem bilden können, das mit einem oder mehreren Resten $R^3$ substituiert sein kann;

$R^1$ ist bei jedem Auftreten gleich oder verschieden ausgewählt aus der Gruppe bestehend aus F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, die jeweils mit einem oder mehreren Resten R' substituiert sein kann, wobei eine oder mehrere nicht-benachbarte $CH_2$-Gruppen durch R'C=CR', $Si(R')_2$, C=O, C=S, C=NR', P(=O)(R'), SO, $SO_2$, NR', O, S oder CONR' ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

$R^3$ ist bei jedem Auftreten gleich oder verschieden ausgewählt aus der Gruppe bestehend aus D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

n, m, p, q sind jeweils unabhängig voneinander 0, 1, 2 oder 3;

o, r, s sind jeweils unabhängig voneinander 0, 1, 2, 3 oder 4;

x, x1 sind bei jedem Auftreten unabhängig 0, 1, 2, 3 oder 4;

y, z sind jeweils unabhängig voneinander 0, 1 oder 2;

a1, a2 sind jeweils unabhängig voneinander 1, 2, 3, 4 oder 5;
a3 ist 0, 1, 2 oder 3;
a4 ist 0, 1, 2, 3 oder 4; und
a1+a2+a3+a4 ist 3, 4, 5, 6, 7, 8, 9, 10, 11, 12, 13, 14, 15, 16 oder 17.

**2.** Organische elektrolumineszierende Vorrichtung nach Anspruch 1, **dadurch gekennzeichnet, dass** im Hostmaterial 1 L ausgewählt ist aus einer Bindung oder den Linkern der Gruppe L-1 bis L-33,

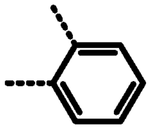
L-1

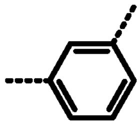
L-2

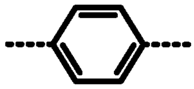
L-3

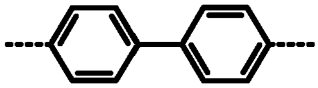
L-4

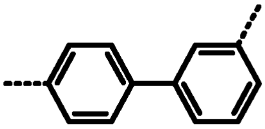
L-5

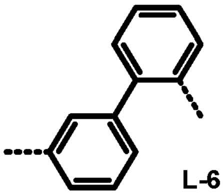
L-6

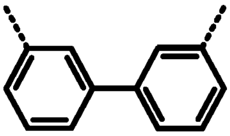
L-7

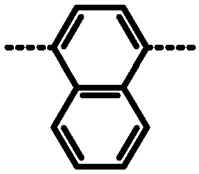
L-8

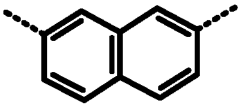
L-9

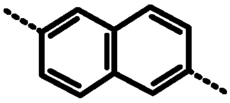
L-10

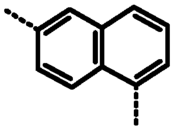
L-11

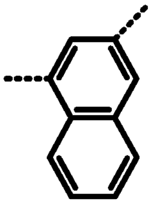
L-12

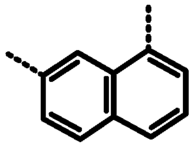
L-13

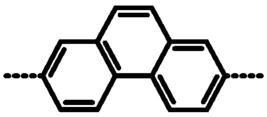
L-14

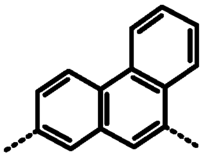
L-15

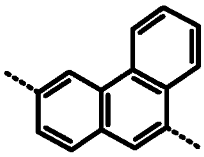
L-16

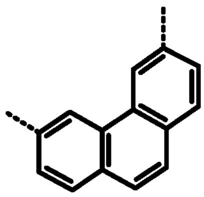
L-17

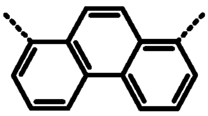
L-18

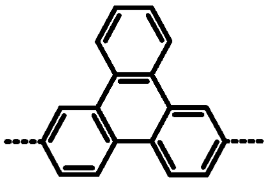
L-19

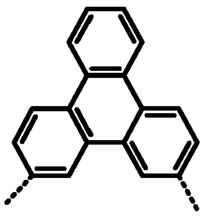
L-20

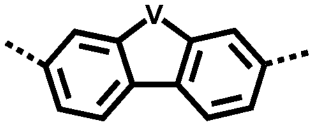

L-21

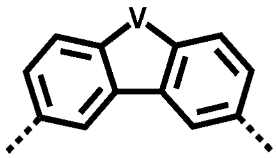

L-22

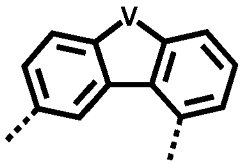

L-23

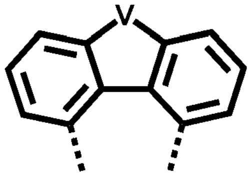

L-24

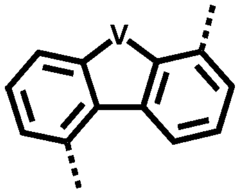

L-25

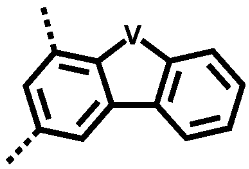

L-26

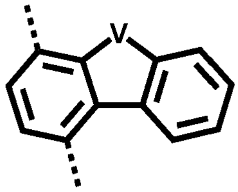

L-27

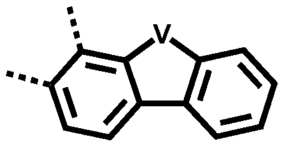

L-28

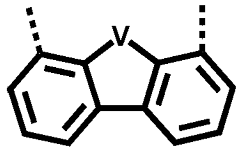

L-29

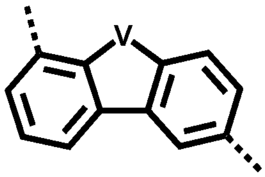

L-30

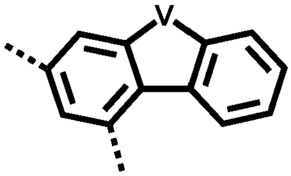

L-31

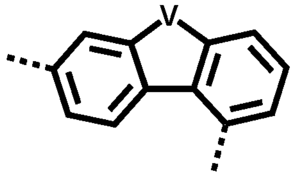

L-32

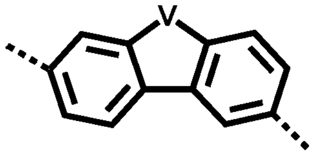

L-33

,

wobei V jeweils unabhängig voneinander O oder S bedeutet.

3. Organische elektrolumineszierende Vorrichtung nach Anspruch 1 oder 2, **dadurch gekennzeichnet, dass** das Hostmaterial 2 der Formel (3) entspricht,

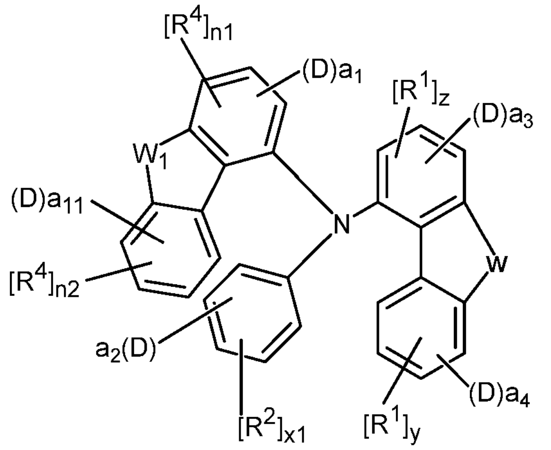

Formel (3),

wobei W, R1, R2, a1, a2, a3, a4, x, y und z eine in Anspruch 1 angegebene Bedeutung haben und für die verwendeten Symbole und Indizes gilt:

$W_1$ ist O, S oder $C(R)_2$, wobei R eine in Anspruch 1 angegebene Bedeutung hat;
$R^4$ ist bei jedem Auftreten gleich oder verschieden ausgewählt aus der Gruppe bestehend aus F, Cl, Br, I, C(=O)$Ar_1$, C(=O)H, C(=O)$R^3$, P(=O)$(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C≡C, $Si(R^3)_2$, $Ge(R^3)_2$, $Sn(R^3)_2$, C=O, C=S, C=Se, C=$NR^3$, P(=O)($R^3$), SO, $SO_2$, NH, $NR^3$, O, S, CONH oder $CONR^3$ ersetzt sein können und wobei ein oder mehrere H-Atome durch D, F, Cl, Br oder I ersetzt sein können, einem aromatischen oder heteroaromatischen Ringsystem mit 5 bis 60 aromatischen Ringatomen, das jeweils mit einem oder mehreren Resten $R^3$ substituiert sein kann, wobei optional zwei oder mehr benachbarte Substituenten $R^4$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^4$ und daran gebundene Substituenten keine Carbazolgruppe enthalten;
$a_{11}$ ist 0, 1, 2, 3 oder 4;
n1 ist 0, 1 oder 2; und
n2 ist 0, 1, 2, 3 oder 4.

4. Organische elektrolumineszierende Vorrichtung nach einem oder mehreren der Ansprüche 1 bis 3, **dadurch gekennzeichnet, dass** im Hostmaterial 1, $L_1$ eine einfache Bindung ist.

5. Organische elektrolumineszierende Vorrichtung nach einem oder mehreren der Ansprüche 1 bis 4, **dadurch gekennzeichnet, dass** das Hostmaterial 2 vollständig deuteriert ist.

6. Organische elektrolumineszierende Vorrichtung nach einem oder mehreren der Ansprüche 1 bis 5, **dadurch gekennzeichnet, dass** es sich um eine Elektrolumineszenzvorrichtung handelt, die ausgewählt ist aus den organischen lichtemittierenden Transistoren (OLETs), organischen Feld-Quench-Devices (OFQDs), organischen lichtemittierenden elektrochemischen Zellen (OLECs, LECs, LEECs), organischen Laserdioden (O-Laser) und den organischen lichtemittierenden Dioden (OLEDs).

7. Organische elektrolumineszierende Vorrichtung nach einem oder mehreren der Ansprüche 1 bis 6, **dadurch gekennzeichnet, dass** diese neben der Lichtemittierenden Schicht (EML), eine Lochinjektionsschicht (HIL), eine Lochtransportschicht (HTL), eine Elektronentransportschicht (ETL), eine Elektroneninjektionsschicht (EIL) und/oder eine Lochblockierschicht (HBL) enthält.

8. Organische elektrolumineszierende Vorrichtung nach einem oder mehreren der Ansprüche 1 bis 7, **dadurch gekennzeichnet, dass** die lichtemittierende Schicht neben dem mindestens einen Hostmaterial 1 und dem mindestens einen Hostmaterial 2 mindestens einen phosphoreszierenden Emitter enthält.

9. Verfahren zur Herstellung einer Vorrichtung nach einem oder mehreren der Ansprüche 1 bis 8, **dadurch gekennzeichnet, dass** die lichtemittierende Schicht durch Gasphasenabscheidung oder aus Lösung aufgebracht wird.

10. Verfahren nach Anspruch 9, **dadurch gekennzeichnet, dass** die mindestens eine Verbindung der Formel (1) und die mindestens eine Verbindung der Formel (2), nacheinander oder gleichzeitig aus mindestens zwei Materialquellen, gegebenenfalls mit dem mindestens einen phosphoreszierenden Emitter, aus der Gasphase abgeschieden werden und die lichtemittierende Schicht bilden.

11. Verfahren nach Anspruch 9, **dadurch gekennzeichnet, dass** die mindestens eine Verbindung der Formel (1) und die mindestens eine Verbindung der Formel (2) als Mischung, nacheinander oder gleichzeitig mit dem mindestens einen phosphoreszierenden Emitter, aus der Gasphase abgeschieden werden und die lichtemittierende Schicht bilden.

12. Verfahren nach Anspruch 9, **dadurch gekennzeichnet, dass** die mindestens eine Verbindung der Formel (1) und die mindestens eine Verbindung der Formel (2) zusammen mit dem mindestens einen phosphoreszierenden Emitter, aus einer Lösung aufgebracht werden, um die lichtemittierende Schicht zu bilden.

13. Mischung enthaltend mindestens eine Verbindung der Formel (1) als Hostmaterial 1 und mindestens eine Verbindung der Formel (2) als Hostmaterial 2,

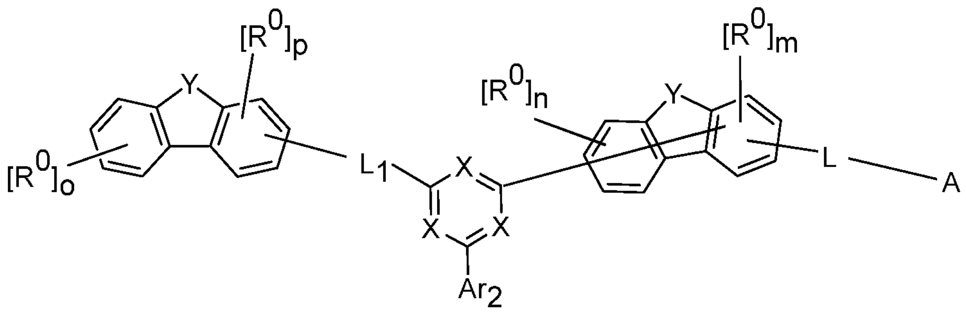

Formel (1)

,

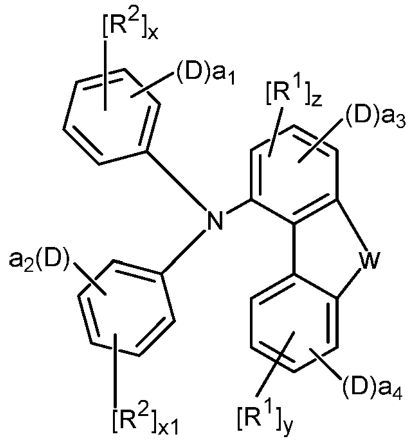

Formel (2),

wobei für die verwendeten Symbole und Indizes gilt:

A ist

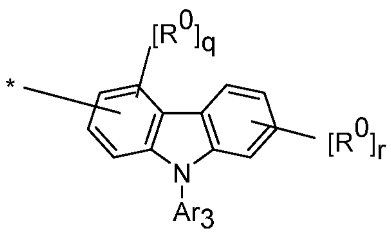

oder

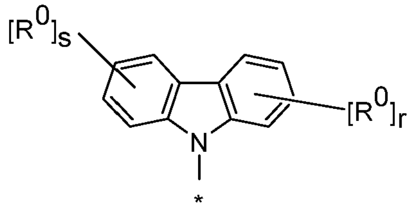

,

X ist bei jedem Auftreten gleich oder verschieden $CR^0$ oder N, wobei mindestens ein Symbol X für N steht;
Y ist bei jedem Auftreten gleich oder verschieden ausgewählt aus O oder S;
* kennzeichnet die Bindungsstelle an die Formel (1);
L und $L_1$ sind bei jedem Auftreten gleich oder verschieden eine Einfachbindung oder ein aromatisches oder heteroaromatisches Ringsystem mit 5 bis 30 aromatischen Ringatomen;
W ist O, S, $C(R)_2$;
R ist jeweils unabhängig voneinander eine geradkettige oder verzweigte Alkylgruppe mit 1 bis 4 C-Atomen, die teilweise oder vollständig deuteriert sein kann, oder ein unsubstituiertes oder teilweise oder vollständig deuteriertes aromatisches Ringsystem mit 6 bis 18 C-Atomen, wobei zwei Substituenten R mit dem C-Atom, an das sie gebunden sind, ein mono- oder polycyclisches, aliphatisches oder aromatisches oder heteroaromatisches unsubstituiertes, teilweise deuteriertes oder vollständig deuteriertes Ringsystem bilden können, das durch ein oder mehrere Substituenten $R^3$ substituiert sein kann, mit der Bedingung, dass das Ringsystem und daran gebundene Substituenten keine Carbazolgruppe enthalten;
$R^0$ ist bei jedem Auftreten unabhängig voneinander D, ein unsubstituiertes oder teilweise oder vollständig

deuteriertes aromatisches Ringsystem mit 6 bis 18 C-Atomen oder ein unsubstituiertes oder teilweise oder vollständig deuteriertes Dibenzofuran, Dibenzothiophen oder über C gebundenes N-Aryl-Carbazol;

$Ar_1$ ist bei jedem Auftreten gleich oder verschieden ein aromatisches oder heteroaromatisches Ringsystem mit 5 bis 30 aromatischen Ringatomen, das mit einem oder mehreren nicht-aromatischen Resten $R^3$ substituiert sein kann; dabei können zwei Reste $Ar_1$, welche an dasselbe N-Atom, P-Atom oder B-Atom binden, auch durch eine Einfachbindung oder eine Brücke, ausgewählt aus $C(R^3)_2$, O oder S, miteinander verbrückt sein;

$Ar_2$ ist jeweils unabhängig voneinander bei jedem Auftreten eine Aryl- oder Heteroarylgruppe mit 5 bis 40 aromatischen Ringatomen, die mit einem oder mehreren Resten R' substituiert sein kann;

$Ar_3$ ist jeweils unabhängig voneinander bei jedem Auftreten ein aromatisches Ringsystem mit 6 bis 40 aromatischen Ringatomen oder ein heteroaromatisches Ringsystem mit 5 bis 40 aromatischen Ringatomen, das mit einem oder mehreren Resten R' substituiert sein kann;

Aryl ist bei jedem Auftreten gleich oder verschieden ein aromatisches oder heteroaromatisches Ringsystem mit 5 bis 30 aromatischen Ringatomen, das mit einem oder mehreren nicht-aromatischen Resten R' substituiert sein kann;

R' ist bei jedem Auftreten gleich oder verschieden ausgewählt aus der Gruppe bestehend aus D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H-Atome durch F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten R' ein monocyclisches oder polycyclisches, aliphatisches, aromatisches oder heteroaromatisches Ringsystem bilden können, das mit einem oder mehreren Resten $R^3$ substituiert sein kann;

$R^1$ ist bei jedem Auftreten gleich oder verschieden ausgewählt aus der Gruppe bestehend aus F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenylgruppe mit 2 bis 20 C-Atomen, die jeweils mit einem oder mehreren Resten R' substituiert sein kann, wobei eine oder mehrere nicht-benachbarte $CH_2$-Gruppen durch R'C=CR', $Si(R')_2$, C=O, C=S, C=NR', P(=O)(R'), SO, $SO_2$, NR', O, S oder CONR' ersetzt sein können und wobei ein oder mehrere H-Atome durch D, F, Cl, Br, I, CN oder $NO_2$ ersetzt sein können;

$R^2$ ist bei jedem Auftreten gleich oder verschieden ausgewählt aus der Gruppe bestehend aus F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^3$ substituiert sein kann, wobei eine oder mehrere nicht-benachbarte $CH_2$-Gruppen durch HC=CH, $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH oder $CONR^3$ ersetzt sein können und wobei ein oder mehrere H- Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^3$ substituiert sein kann, einer Aryloxy- oder Heteroaryloxygruppe mit 5 bis 60 aromatischen Ringatomen, die mit einem oder mehreren Resten $R^3$ substituiert sein kann, oder einer Kombination dieser Systeme, wobei optional zwei oder mehr benachbarte Substituenten $R^2$ ein monocyclisches oder polycyclisches, aliphatisches, aromatisches oder heteroaromatisches Ringsystem bilden können, das mit einem oder mehreren Resten $R^3$ substituiert sein kann, mit der Bedingung, dass $R^2$ und daran gebundene Substituenten keine Carbazolgruppe enthalten;

-$R^3$ ist bei jedem Auftreten gleich oder verschieden ausgewählt aus der Gruppe bestehend aus D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann; dabei können zwei oder mehr benachbarte Substituenten $R^3$ miteinander ein mono- oder polycyclisches, aliphatisches Ringsystem bilden;

n, m, p, q sind jeweils unabhängig voneinander 0, 1, 2 oder 3;

o, r, s sind jeweils unabhängig voneinander 0, 1, 2, 3 oder 4;

x, x1 sind bei jedem Auftreten unabhängig 0, 1, 2, 3 oder 4;

y, z sind jeweils unabhängig voneinander 0, 1 oder 2;

a1, a2 sind jeweils unabhängig voneinander 1, 2, 3, 4 oder 5;
a3 ist 0, 1, 2 oder 3;
a4 ist 0, 1, 2, 3 oder 4; und
a1+a2+a3+a4 ist 3, 4, 5, 6, 7, 8, 9, 10, 11, 12, 13, 14, 15, 16 oder 17.

**14.** Mischung nach Anspruch 13, **dadurch gekennzeichnet, dass** die Mischung aus mindestens einer Verbindung der Formel (1), mindestens einer Verbindung der Formel (2) und einem phosphoreszierenden Emitter besteht.

**15.** Formulierung enthaltend eine Mischung nach Anspruch 13 oder 14 sowie mindestens ein Lösemittel.

## Claims

**1.** Organic electroluminescent device comprising an anode, a cathode and at least one organic layer, comprising at least one light-emitting layer, where the at least one light-emitting layer comprises at least one compound of the formula (1) as host material 1 and at least one compound of the formula (2) as host material 2,

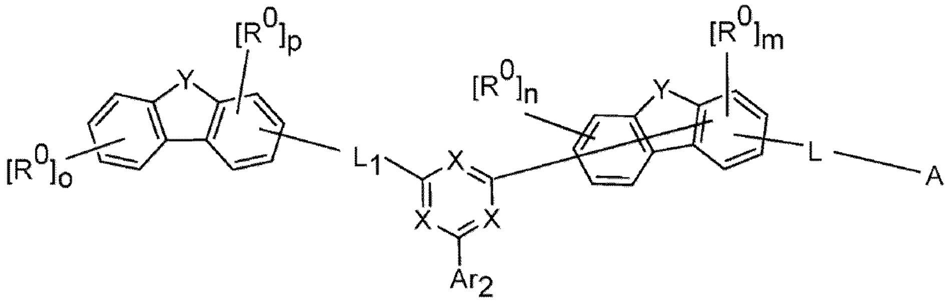

,

formula (1)

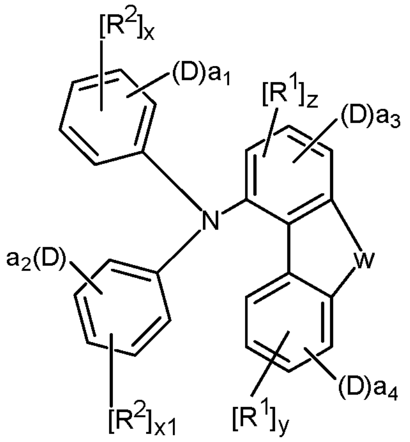

formula (2),

where the following applies to the symbols and indices used:

A is

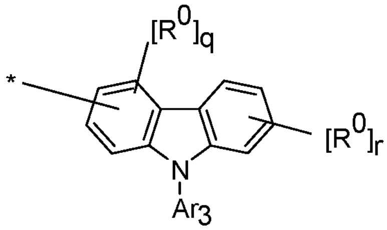

or

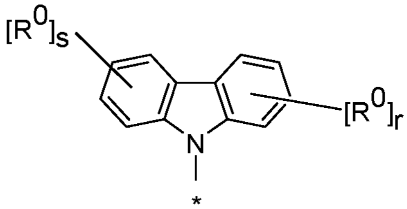

,

X is on each occurrence, identically or differently, $CR^0$ or N, where at least one symbol X stands for N;
Y is selected on each occurrence, identically or differently, from O or S;
* denotes the bonding site to the formula (1);
L and $L_1$ are on each occurrence, identically or differently, a single bond or an aromatic or heteroaromatic ring system having 5 to 30 aromatic ring atoms;
W is O, S, $C(R)_2$;
R is in each case, independently of one another, a straight-chain or branched alkyl group having 1 to 4 C atoms, which may be partially or fully deuterated, or an unsubstituted or partially or fully deuterated aromatic ring system having 6 to 18 C atoms, where two substituents R with the C atom to which they are bonded may form a mono- or polycyclic, aliphatic or aromatic or heteroaromatic unsubstituted, partially deuterated or fully deuterated ring system, which may be substituted by one or more substituents $R^3$, with the condition that the ring system and substituents bonded thereto do not contain a carbazole group;
$R^0$ is on each occurrence, independently of one another, D, an unsubstituted or partially or fully deuterated aromatic ring system having 6 to 18 C atoms or an unsubstituted or partially or fully deuterated dibenzofuran, dibenzothiophene, or N-arylcarbazole bonded via C;
$Ar_1$ is on each occurrence, identically or differently, an aromatic or heteroaromatic ring system having 5 to 30 aromatic ring atoms, which may be substituted by one or more non-aromatic radicals $R^3$; two radicals $Ar_1$ that are bonded to the same N atom, P atom or B atom may also be bridged to one another by a single bond or a bridge selected from $C(R^3)_2$, O or S;
$Ar_2$ is in each case independently of one another, on each occurrence, an aryl or heteroaryl group having 5 to 40 aromatic ring atoms, which may be substituted by one or more radicals R';
$Ar_3$ is in each case independently of one another, on each occurrence, an aromatic ring system having 6 to 40 aromatic ring atoms or a heteroaromatic ring system having 5 to 40 aromatic ring atoms, which may be substituted by one or more radicals R';
aryl is on each occurrence, identically or differently, an aromatic or heteroaromatic ring system having 5 to 30 aromatic ring atoms, which may be substituted by one or more non-aromatic radicals R';
R' is selected on each occurrence, identically or differently, from the group consisting of D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by F, Cl, Br, I, CN or $NO_2$, an aromatic or heteroaromatic ring system having 5 to 60 aromatic ring atoms, which may in each case be substituted by one or more radicals $R^3$, an aryloxy or heteroaryloxy group having 5 to 60 aromatic ring atoms, which may be substituted by one or more radicals $R^3$, or a combination of these systems, where two or more adjacent substituents R' may optionally form a monocyclic or polycyclic, aliphatic, aromatic or heteroaromatic ring system, which may be substituted by one or more radicals $R^3$;
$R^1$ is selected on each occurrence, identically or differently, from the group consisting of F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, a straight-chain alkyl, alkoxy or thioalkyl group having 1 to 20 C atoms or a branched or cyclic alkyl, alkoxy or thioalkyl group having 3 to 20 C atoms or an alkenyl group having 2 to 20 C atoms, which may in each case be substituted by one or more radicals R', where one or more non-adjacent $CH_2$ groups may be replaced by R'C=CR', $Si(R')_2$, C=O, C=S, C=NR', P(=O)(R'), SO, $SO_2$, NR', O, S or CONR' and where one or more H atoms may be replaced by D, F, Cl, Br, I, CN or $NO_2$;
$R^2$ is selected on each occurrence, identically or differently, from the group consisting of F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^3$, an aryl-oxy or heteroaryloxy group having 5 to 60 aromatic ring atoms, which may be substituted by one or more radicals $R^3$, or a combination of these systems, where two or more adjacent substituents $R^2$ may optionally form a monocyclic or polycyclic, aliphatic, aromatic or heteroaromatic ring system, which may be substituted by one or more radicals $R^3$, with the condition that $R^2$ and substituents bonded thereto do not contain a carbazole group;
$R^3$ is selected on each occurrence, identically or differently, from the group consisting of D, F, CN, an aliphatic hydrocarbon radical having 1 to 20 C atoms or an aromatic or heteroaromatic ring system having 5 to 30 aromatic ring atoms, in which one or more H atoms may be replaced by D, F, Cl, Br, I or CN and which may be substituted by

one or more alkyl groups, in each case having 1 to 4 carbon atoms; two or more adjacent substituents $R^3$ may form a mono- or polycyclic, aliphatic ring system with one another;

n, m, p, q are in each case, independently of one another, 0, 1, 2 or 3;
o, r, s are in each case, independently of one another, 0, 1, 2, 3 or 4;
x, x1 are on each occurrence, independently, 0, 1, 2, 3 or 4;
y, z are in each case, independently of one another, 0, 1 or 2;
$a_1$, $a_2$ are in each case, independently of one another, 1, 2, 3, 4 or 5;
$a_3$ is 0, 1, 2 or 3;
$a_4$ is 0, 1, 2, 3 or 4; and
$a_1+a_2+a_3+a_4$ is 3, 4, 5, 6, 7, 8, 9, 10, 11, 12, 13, 14, 15, 16 or 17.

2. Organic electroluminescent device according to Claim 1, **characterised in that**, in host material 1, L is selected from a bond or the linkers from group L-1 to L-33,

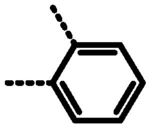
L-1

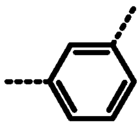
L-2

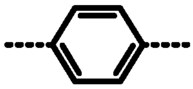
L-3

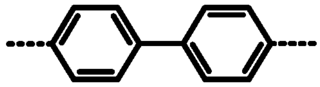
L-4

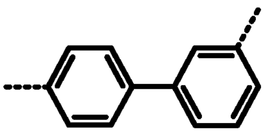
L-5

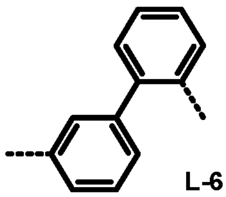
L-6

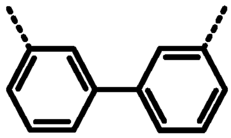
L-7

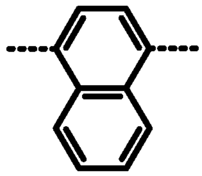
L-8

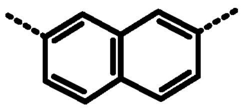
L-9

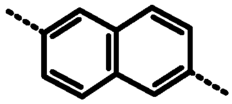
L-10

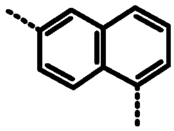
L-11

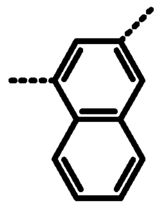
L-12

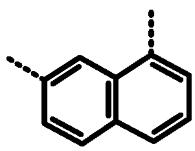
L-13

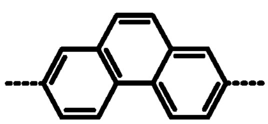
L-14

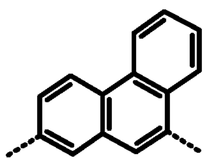
L-15

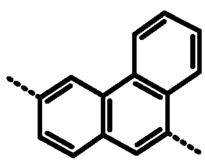
L-16

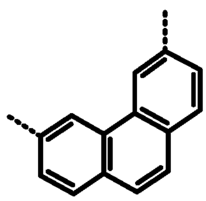
L-17

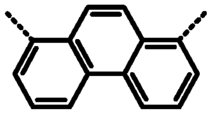

L-18

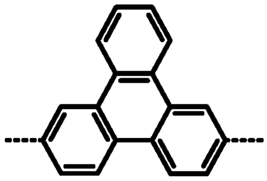

L-19

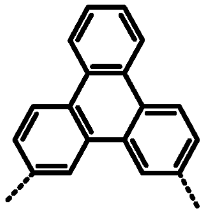

L-20

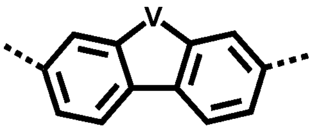

L-21

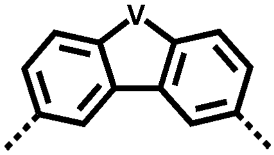

L-22

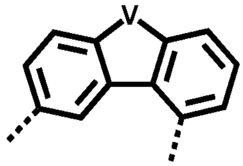

L-23

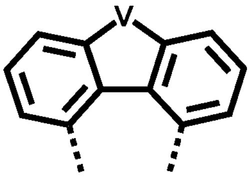

L-24

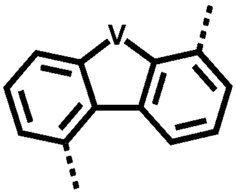

L-25

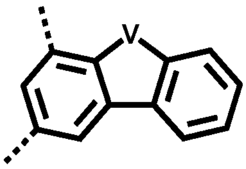

L-26

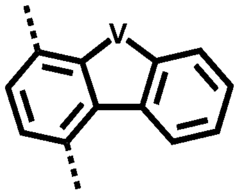

L-27

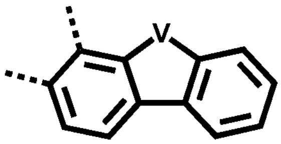

L-28

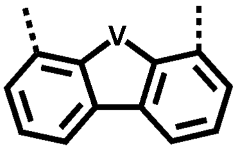

L-29

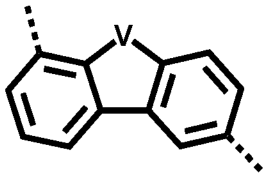

L-30

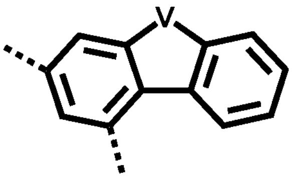

L-31

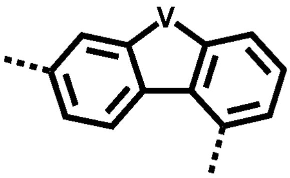

L-32

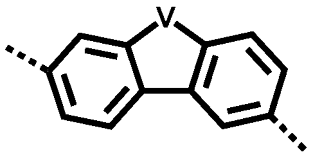

L-33

,

where V in each case, independently of one another, denotes O or S.

3. Organic electroluminescent device according to Claim 1 or 2, **characterised in that** host material 2 corresponds to the formula (3),

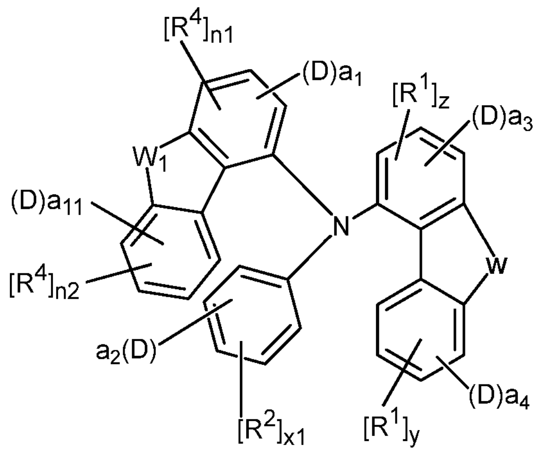

formula (3)

where W, $R^1$, $R^2$, $a_1$, $a_2$, $a_3$, $a_4$, x, y and z have a meaning indicated in Claim 1 and the following applies to the symbols and indices used:

$W_1$ is O, S or $C(R)_2$, where R has a meaning indicated in Claim 1;
$R^4$ is selected on each occurrence, identically or differently, from the group consisting of F, Cl, Br, I, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by D, F, Cl, Br or I, an aromatic or heteroaromatic ring system having 5 to 60 aromatic ring atoms, which may in each case be substituted by one or more radicals $R^3$, where two or more adjacent substituents $R^4$ may optionally form a monocyclic or polycyclic, aliphatic, aromatic or heteroaromatic ring system, which may be substituted by one or more radicals $R^3$, with the condition that $R^4$ and substituents bonded thereto do not contain a carbazole group;
$a_{11}$ is 0, 1, 2, 3 or 4;
n1 is 0, 1 or 2; and
n2 is 0, 1, 2, 3 or 4.

**4.** Organic electroluminescent device according to one or more of Claims 1 to 3, **characterised in that**, in host material 1, $L_1$ is a single bond.

**5.** Organic electroluminescent device according to one or more of Claims 1 to 4, **characterised in that** host material 2 is fully deuterated.

**6.** Organic electroluminescent device according to one or more of Claims 1 to 5, **characterised in that** it is an electroluminescent device selected from organic light-emitting transistors (OLETs), organic field-quench devices (OFQDs), organic light-emitting electrochemical cells (OLECs, LECs, LEECs), organic laser diodes (O-lasers) and organic light-emitting diodes (OLEDs).

**7.** Organic electroluminescent device according to one or more of Claims 1 to 6, **characterised in that**, besides the light-emitting layer (EML), it comprises a hole-injection layer (HIL), a hole-transport layer (HTL), an electron-transport layer (ETL), an electron-injection layer (EIL) and/or a hole-blocking layer (HBL).

**8.** Organic electroluminescent device according to one or more of Claims 1 to 7, **characterised in that**, besides the at least one host material 1 and the at least one host material 2, the light-emitting layer comprises at least one phosphorescent emitter.

**9.** Process for the production of a device according to one or more of Claims 1 to 8, **characterised in that** the light-emitting layer is applied by gas-phase deposition or from solution.

**10.** Process according to Claim 9, **characterised in that** the at least one compound of the formula (1) and the at least one compound of the formula (2) are deposited from the gas phase, successively or simultaneously from at least two

material sources, optionally with the at least one phosphorescent emitter, and form the light-emitting layer.

**11.** Process according to Claim 9, **characterised in that** the at least one compound of the formula (1) and the at least one compound of the formula (2) are deposited from the gas phase as a mixture, successively or simultaneously with the at least one phosphorescent emitter, and form the light-emitting layer.

**12.** Process according to Claim 9, **characterised in that** the at least one compound of the formula (1) and the at least one compound of the formula (2) are applied from a solution together with the least one phosphorescent emitter in order to form the light-emitting layer.

**13.** Mixture comprising at least one compound of the formula (1) as host material 1 and at least one compound of the formula (2) as host material 2,

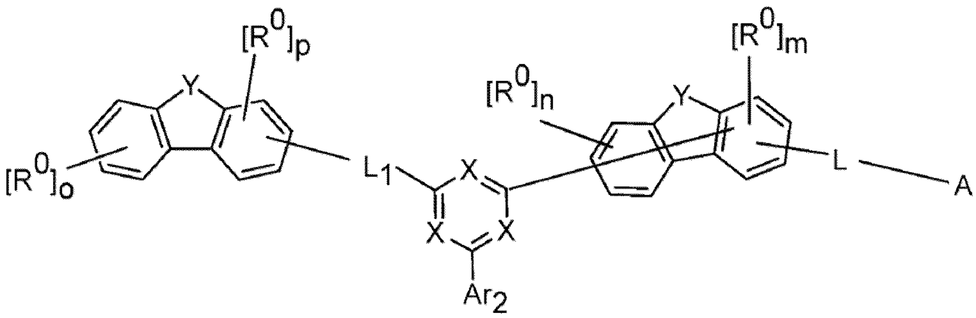

,

formula (1)

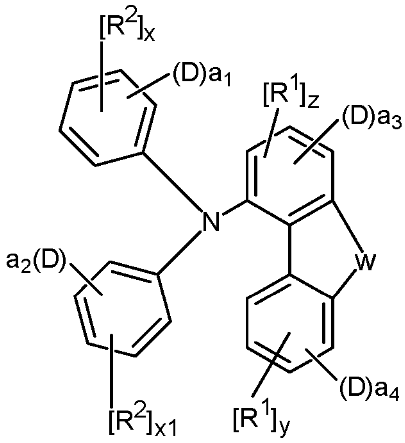

formula (2)

where the following applies to the symbols and indices used:

A is

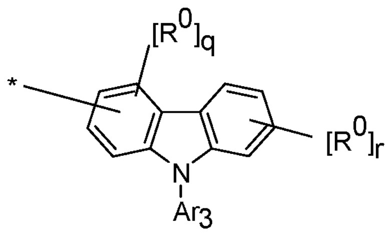

or

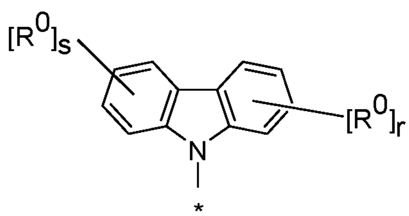

,

X is on each occurrence, identically or differently, $CR^0$ or N, where at least one symbol X stands for N;
Y is selected on each occurrence, identically or differently, from O or S;
* denotes the bonding site to the formula (1);

L and $L_1$ are on each occurrence, identically or differently, a single bond or an aromatic or heteroaromatic ring system having 5 to 30 aromatic ring atoms;
W is O, S, $C(R)_2$;
R is in each case, independently of one another, a straight-chain or branched alkyl group having 1 to 4 C atoms, which may be partially or fully deuterated, or an unsubstituted or partially or fully deuterated aromatic ring system having 6 to 18 C atoms, where two substituents R with the C atom to which they are bonded may form a mono- or polycyclic, aliphatic or aromatic or heteroaromatic unsubstituted, partially deuterated or fully deuterated ring system, which may be substituted by one or more substituents $R^3$, with the condition that the ring system and substituents bonded thereto do not contain a carbazole group;
$R^0$ is on each occurrence, independently of one another, D, an unsubstituted or partially or fully deuterated aromatic ring system having 6 to 18 C atoms or an unsubstituted or partially or fully deuterated dibenzofuran, dibenzothiophene, or N-arylcarbazole bonded via C;
$Ar_1$ is on each occurrence, identically or differently, an aromatic or heteroaromatic ring system having 5 to 30 aromatic ring atoms, which may be substituted by one or more non-aromatic radicals $R^3$; two radicals $Ar_1$ that are bonded to the same N atom, P atom or B atom may also be bridged to one another by a single bond or a bridge selected from $C(R^3)_2$, O or S;
$Ar_2$ is in each case independently of one another, on each occurrence, an aryl or heteroaryl group having 5 to 40 aromatic ring atoms, which may be substituted by one or more radicals R';
$Ar_3$ is in each case independently of one another, on each occurrence, an aromatic ring system having 6 to 40 aromatic ring atoms or a heteroaromatic ring system having 5 to 40 aromatic ring atoms, which may be substituted by one or more radicals R';
aryl is on each occurrence, identically or differently, an aromatic or heteroaromatic ring system having 5 to 30 aromatic ring atoms, which may be substituted by one or more non-aromatic radicals R';
R' is selected on each occurrence, identically or differently, from the group consisting of D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by F, Cl, Br, I, CN or $NO_2$, an aromatic or heteroaromatic ring system having 5 to 60 aromatic ring atoms, which may in each case be substituted by one or more radicals $R^3$, an aryloxy or heteroaryloxy group having 5 to 60 aromatic ring atoms, which may be substituted by one or more radicals $R^3$, or a combination of these systems, where two or more adjacent substituents R' may optionally form a monocyclic or polycyclic, aliphatic, aromatic or heteroaromatic ring system, which may be substituted by one or more radicals $R^3$;
$R^1$ is selected on each occurrence, identically or differently, from the group consisting of F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, a straight-chain alkyl, alkoxy or thioalkyl group having 1 to 20 C atoms or a branched or cyclic alkyl, alkoxy or thioalkyl group having 3 to 20 C atoms or an alkenyl group having 2 to 20 C atoms, which may in each case be substituted by one or more radicals R', where one or more non-adjacent $CH_2$ groups may be replaced by R'C=CR', $Si(R')_2$, C=O, C=S, C=NR', P(=O)(R'), SO, $SO_2$, NR', O, S or CONR' and where one or more H atoms may be replaced by D, F, Cl, Br, I, CN or $NO_2$;
$R^2$ is selected on each occurrence, identically or differently, from the group consisting of F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^3$, where one or more non-adjacent $CH_2$ groups may be replaced by HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH or $CONR^3$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^3$, an aryloxy or heteroaryloxy group having 5 to 60 aromatic ring atoms, which may be substituted by one or more radicals $R^3$, or a combination of these systems, where two or more adjacent substituents $R^2$ may optionally form a monocyclic or polycyclic, aliphatic, aromatic or heteroaromatic ring system, which may be substituted by one or more radicals $R^3$, with the condition that $R^2$ and substituents bonded thereto do not contain a carbazole group;
$R^3$ is selected on each occurrence, identically or differently, from the group consisting of D, F, CN, an aliphatic hydrocarbon radical having 1 to 20 C atoms or an aromatic or heteroaromatic ring system having 5 to 30 aromatic ring atoms, in which one or more H atoms may be replaced by D, F, Cl, Br, I or CN and which may be substituted by one or more alkyl groups, in each case having 1 to 4 carbon atoms; two or more adjacent substituents $R^3$ may form a mono- or polycyclic, aliphatic ring system with one another;
n, m, p, q are in each case, independently of one another, 0, 1, 2 or 3;

o, r, s are in each case, independently of one another, 0, 1, 2, 3 or 4;
x, x1 are on each occurrence, independently, 0, 1, 2, 3 or 4;
y, z are in each case, independently of one another, 0, 1 or 2;
$a_1$, $a_2$ are in each case, independently of one another, 1, 2, 3, 4 or 5;
$a_3$ is 0, 1, 2 or 3;
$a_4$ is 0, 1, 2, 3 or 4; and
$a_1+a_2+a_3+a_4$ is 3, 4, 5, 6, 7, 8, 9, 10, 11, 12, 13, 14, 15, 16 or 17.

**14.** Mixture according to Claim 13, **characterised in that** the mixture consists of at least one compound of the formula (1), at least one compound of the formula (2) and a phosphorescent emitter.

**15.** Formulation comprising a mixture according to Claim 13 or 14 and at least one solvent.

## Revendications

**1.** Dispositif électroluminescent organique comprenant une anode, une cathode et au moins une couche organique, comprenant au moins une couche émettrice de lumière, où la au moins une couche émettrice de lumière comprend au moins un composé de formule (1) comme matériau hôte 1 et au moins un composé de formule (2) comme matériau hôte 2,

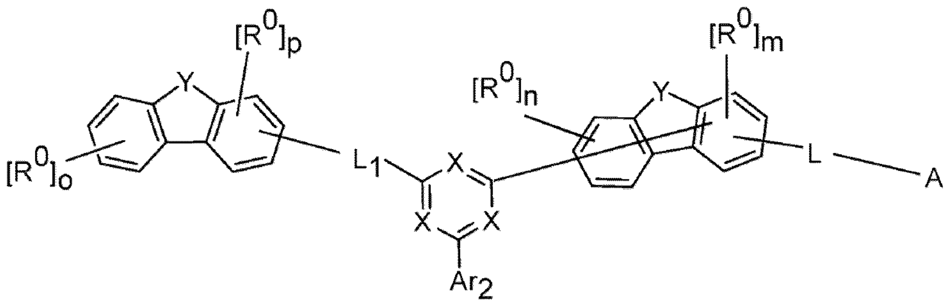

,

formule (1)

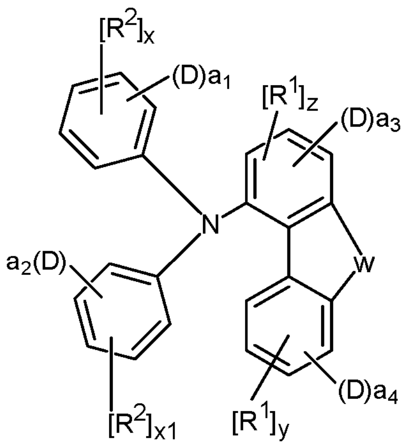

formule (2),

dans lesquelles ce qui suit s'applique aux symboles et indices utilisés :

A est

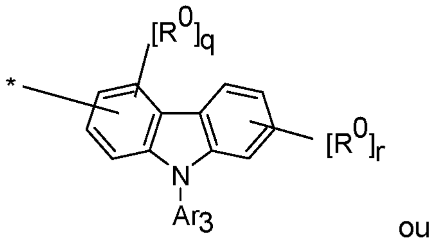

ou

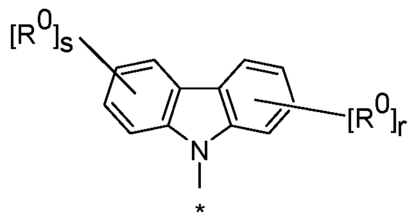

,

X est à chaque occurrence, de manière identique ou différente, $CR^0$ ou N, où au moins un symbole X représente N ;

Y est choisi à chaque occurrence, de manière identique ou différente, parmi O ou S ;

* désigne le site de liaison à la formule (1) ;

L et $L_1$ sont à chaque occurrence, de manière identique ou différente, une liaison simple ou un noyau aromatique ou hétéroaromatique ayant de 5 à 30 atomes de cycle aromatique ;

W est O, S, $C(R)_2$ ;

R est dans chaque cas, indépendamment les uns des autres, un groupement alkyle à chaîne linéaire ou ramifiée ayant de 1 à 4 atomes de C, qui peut être partiellement ou totalement deutérié, ou un noyau aromatique non substitué ou partiellement ou totalement deutérié ayant de 6 à 18 atomes de C, où deux substituants R, conjointement avec l'atome de C auquel ils sont liés, peuvent former un noyau aliphatique ou aromatique ou hétéroaromatique, mono- ou polycyclique, non substitué, partiellement deutérié ou totalement deutérié, qui peut être substitué par un ou plusieurs substituants $R^3$, à condition que le noyau et les substituants y étant liés ne contiennent pas de groupement carbazole ;

$R^0$ est à chaque occurrence, indépendamment les uns des autres, D, un noyau aromatique non substitué ou partiellement ou totalement deutérié ayant de 6 à 18 atomes de C ou un groupement dibenzofurane, dibenzothiophène, ou N-arylcarbazole lié via C, non substitué ou partiellement ou totalement deutérié ;

$Ar_1$ est à chaque occurrence, de manière identique ou différente, un noyau aromatique ou hétéroaromatique ayant de 5 à 30 atomes de cycle aromatique, qui peut être substitué par un ou plusieurs radicaux $R^3$ non aromatiques ; deux radicaux $Ar_1$ qui sont liés au même atome de N, atome de P ou atome de B peuvent également être pontés l'un avec l'autre par une liaison simple ou un pont choisi parmi $C(R^3)_2$, O ou S ;

$Ar_2$ est dans chaque cas indépendamment les uns des autres, à chaque occurrence, un groupement aryle ou hétéroaryle ayant de 5 à 40 atomes de cycle aromatique, qui peut être substitué par un ou plusieurs radicaux R' ;

$Ar_3$ est dans chaque cas indépendamment les uns des autres, à chaque occurrence, un noyau aromatique ayant de 6 à 40 atomes de cycle aromatique ou un noyau hétéroaromatique ayant de 5 à 40 atomes de cycle aromatique, qui peut être substitué par un ou plusieurs radicaux R' ;

aryle est à chaque occurrence, de manière identique ou différente, un noyau aromatique ou hétéroaromatique ayant de 5 à 30 atomes de cycle aromatique, qui peut être substitué par un ou plusieurs radicaux R' non aromatiques ;

R' est choisi à chaque occurrence, de manière identique ou différente, dans le groupe constitué par D, F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par F, Cl, Br, I, CN ou $NO_2$, un noyau aromatique ou hétéroaromatique ayant de 5 à 60 atomes de cycle aromatique, qui peut dans chaque cas être substitué par un ou plusieurs radicaux $R^3$, un groupement aryloxy ou hétéroaryloxy ayant de 5 à 60 atomes de cycle aromatique, qui peut être substitué par un ou plusieurs radicaux $R^3$, ou une combinaison de ces systèmes, où deux, ou plus, substituants R' adjacents peuvent éventuellement former un noyau aliphatique, aromatique ou hétéroaromatique, monocyclique ou polycyclique, qui peut être substitué par un ou plusieurs radicaux $R^3$ ;

$R^1$ est choisi à chaque occurrence, de manière identique ou différente, dans le groupe constitué par F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, un groupement alkyle, alcoxy ou thioalkyle à chaîne linéaire ayant de 1 à 20 atomes de C ou un groupement alkyle, alcoxy ou thioalkyle ramifié ou cyclique ayant de 3 à 20 atomes de C ou un groupement alcényle ayant de 2 à 20 atomes de C, qui peut dans chaque cas être substitué par un ou plusieurs radicaux R', où un ou plusieurs groupements $CH_2$ non adjacents peuvent être remplacés par R'C=CR', $Si(R')_2$, C=O, C=S, C=NR', P(=O)(R'), SO, $SO_2$, NR', O, S ou CONR' et où un ou plusieurs atomes de H peuvent être remplacés par D, F, Cl, Br, I, CN ou $NO_2$ ;

$R^2$ est choisi à chaque occurrence, de manière identique ou différente, dans le groupe constitué par F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par D, F, Cl, Br, I, CN ou $NO_2$, un noyau aromatique ou hétéroaromatique ayant de 5 à 60 atomes de cycle aromatique, qui peut dans chaque cas être substitué par un ou plusieurs radicaux $R^3$, un groupement aryloxy ou hétéroaryloxy ayant de 5 à 60 atomes de cycle aromatique, qui peut être substitué par un ou plusieurs radicaux $R^3$, ou une combinaison de ces systèmes, où deux, ou plus, substituants $R^2$ adjacents peuvent éventuellement former un noyau aliphatique, aromatique ou hétéroaromatique, monocyclique ou polycyclique, qui peut être substitué par un ou plusieurs radicaux $R^3$, à condition que $R^2$ et les substituants y étant liés ne contiennent pas de groupement carbazole ;
$R^3$ est choisi à chaque occurrence, de manière identique ou différente, dans le groupe constitué par D, F, CN, un radical hydrocarboné aliphatique ayant de 1 à 20 atomes de C ou un noyau aromatique ou hétéroaromatique ayant de 5 à 30 atomes de cycle aromatique, où un ou plusieurs atomes de H peuvent être remplacés par D, F, Cl, Br, I ou CN et qui peut être substitué par un ou plusieurs groupements alkyle, dans chaque cas ayant de 1 à 4 atomes de carbone ; deux, ou plus, substituants $R^3$ adjacents peuvent former un noyau aliphatique mono- ou polycyclique les uns avec les autres ;

n, m, p, q valent dans chaque cas, indépendamment les uns des autres, 0, 1, 2 ou 3 ;
o, r, s valent dans chaque cas, indépendamment les uns des autres, 0, 1, 2, 3 ou 4 ;
x, x1 valent à chaque occurrence, indépendamment, 0, 1, 2, 3 ou 4 ;
y, z valent dans chaque cas, indépendamment l'un de l'autre, 0, 1 ou 2 ;
$a_1$, $a_2$ valent dans chaque cas, indépendamment l'un de l'autre, 1, 2, 3, 4 ou 5 ;
$a_3$ vaut 0, 1, 2 ou 3 ;
$a_4$ vaut 0, 1, 2, 3 ou 4 ; et
$a_1+a_2+a_3+a_4$ vaut 3, 4, 5, 6, 7, 8, 9, 10, 11, 12, 13, 14, 15, 16 ou 17.

**2.** Dispositif électroluminescent organique selon la revendication 1, **caractérisé en ce que**, dans le matériau hôte 1, L est choisi parmi une liaison ou les bras de liaison choisis parmi les groupements L-1 à L-33,

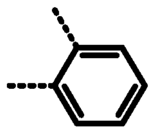
L-1

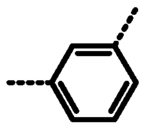
L-2

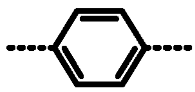
L-3

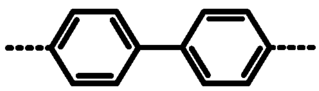
L-4

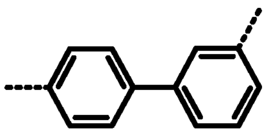
L-5

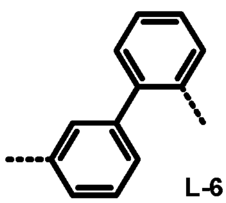
L-6

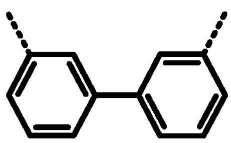
L-7

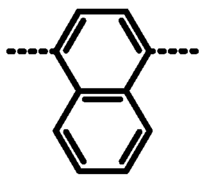
L-8

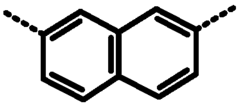

L-9

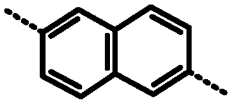

L-10

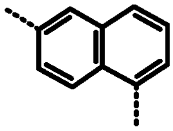

L-11

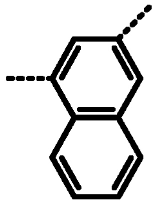

L-12

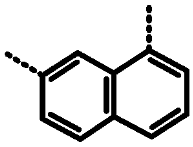

L-13

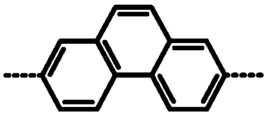

L-14

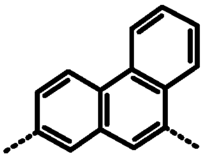

L-15

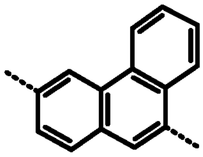

L-16

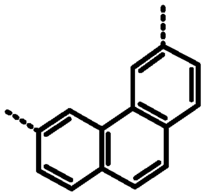

L-17

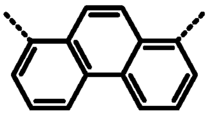

L-18

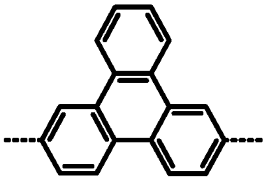

L-19

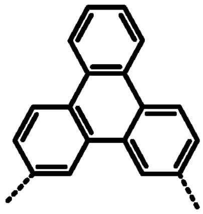

L-20

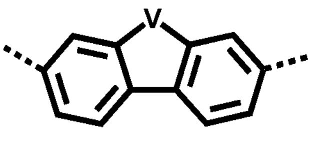

L-21

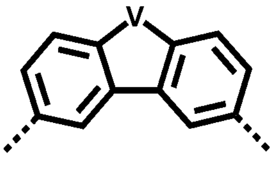

L-22

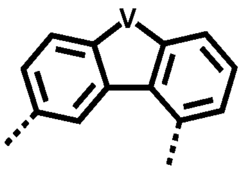

L-23

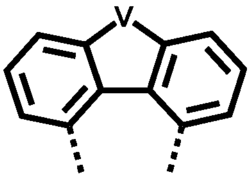

L-24

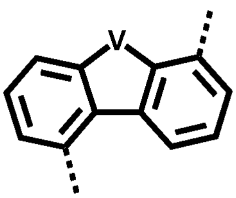

L-25

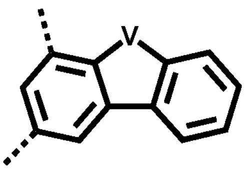

L-26

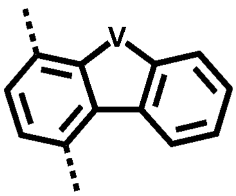

L-27

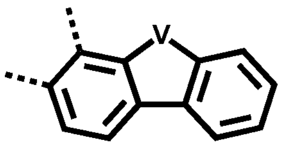 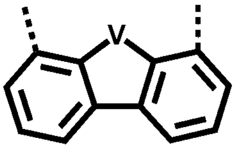 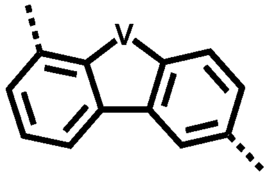

L-28 L-29 L-30

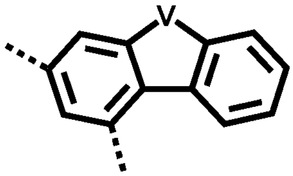 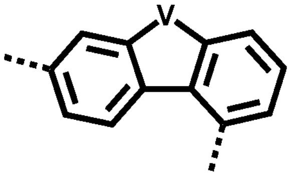 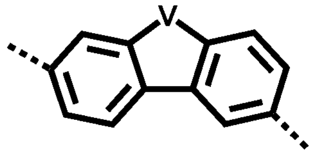

L-31 L-32 L-33 ,

où V dans chaque cas, indépendamment les uns des autres, désigne O ou S.

3. Dispositif électroluminescent organique selon la revendication 1 ou 2, **caractérisé en ce que** le matériau hôte 2 correspond à la formule (3),

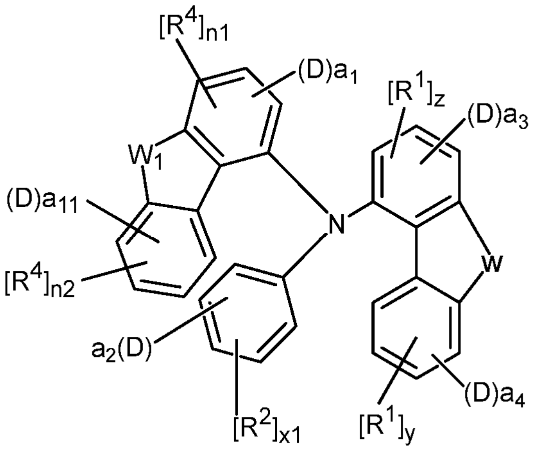

formule (3)

dans laquelle W, $R^1$, $R^2$, $a_1$, $a_2$, $a_3$, $a_4$, x, y et z revêtent une signification indiquée selon la revendication 1 et ce qui suit s'applique aux symboles et indices utilisés :

$W_1$ est O, S ou $C(R)_2$, où R revêt une signification indiquée selon la revendication 1 ;
$R^4$ est choisi à chaque occurrence, de manière identique ou différente, dans le groupe constitué par F, Cl, Br, I, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par D, F, Cl, Br ou I, un noyau aromatique ou hétéroaromatique ayant de 5 à 60 atomes de cycle aromatique, qui peut dans chaque cas être substitué par un ou plusieurs radicaux $R^3$, où deux, ou plus, substituants $R^4$ adjacents peuvent éventuellement former un noyau aliphatique, aromatique ou hétéroaromatique, monocyclique ou polycyclique, qui peut être substitué par un ou plusieurs radicaux $R^3$, à condition que $R^4$ et les substituants y étant liés ne contiennent pas de groupement carbazole ;
$a_{11}$ vaut 0, 1, 2, 3 ou 4 ;
n1 vaut 0, 1 ou 2 ; et
n2 vaut 0, 1, 2, 3 ou 4.

4. Dispositif électroluminescent organique selon l'une ou plusieurs parmi les revendications 1 à 3, **caractérisé en ce que**, dans le matériau hôte1, $L_1$ est une liaison simple.

5. Dispositif électroluminescent organique selon l'une ou plusieurs parmi les revendications 1 à 4, **caractérisé en ce que** le matériau hôte 2 est totalement deutérié.

6. Dispositif électroluminescent organique selon l'une ou plusieurs parmi les revendications 1 à 5, **caractérisé en ce qu'**il s'agit d'un dispositif électroluminescent choisi parmi les transistors organiques émetteurs de lumière (OLET), les dispositifs organiques à extinction de champ (OFQD), les cellules électrochimiques organiques émettrices de lumière (OLEC, LEC, LEEC), les diodes laser organiques (O-lasers) et les diodes électroluminescentes organiques (OLED).

7. Dispositif électroluminescent organique selon l'une ou plusieurs parmi les revendications 1 à 6, **caractérisé en ce que**, outre la couche émettrice de lumière (EML), il comprend une couche d'injection de trous (HIL), une couche de transport de trous (HTL), une couche de transport d'électrons (ETL), une couche d'injection d'électrons (EIL) et/ou une couche de blocage de trous (HBL).

8. Dispositif électroluminescent organique selon l'une ou plusieurs parmi les revendications 1 à 7, **caractérisé en ce que**, outre le au moins un matériau hôte 1 et le au moins un matériau hôte 2, la couche émettrice de lumière comprend au moins un émetteur phosphorescent.

9. Procédé de production d'un dispositif selon l'une ou plusieurs parmi les revendications 1 à 8, **caractérisé en ce que** la couche émettrice de lumière est appliquée par dépôt en phase gazeuse ou à partir d'une solution.

10. Procédé selon la revendication 9, **caractérisé en ce que** le au moins un composé de formule (1) et le au moins un composé de formule (2) sont déposés à partir de la phase gazeuse successivement ou simultanément à partir d'au moins deux sources de matériau, éventuellement avec le au moins un émetteur phosphorescent, et forment la couche émettrice de lumière.

11. Procédé selon la revendication 9, **caractérisé en ce que** le au moins un composé de formule (1) et le au moins un composé de formule (2) sont déposés à partir de la phase gazeuse sous forme de mélange, successivement ou simultanément avec le au moins un émetteur phosphorescent, et forment la couche émettrice de lumière.

12. Procédé selon la revendication 9, **caractérisé en ce que** le au moins un composé de formule (1) et le au moins un composé de formule (2) sont appliqués à partir d'une solution conjointement avec le au moins un émetteur phosphorescent, afin de former la couche émettrice de lumière.

13. Mélange comprenant au moins un composé de formule (1) comme matériau hôte 1 et au moins un composé de formule (2) comme matériau hôte 2,

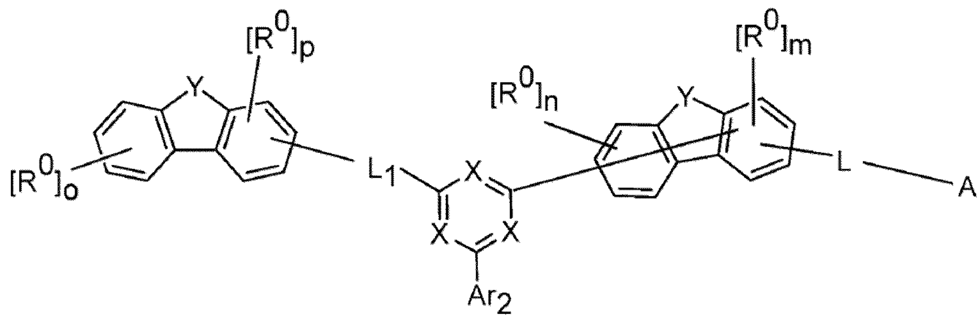
,

formule (1)

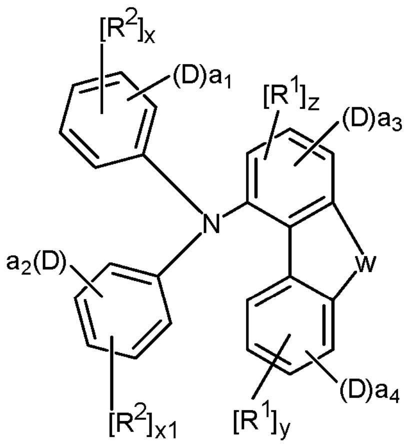

formule (2)

dans lesquelles ce qui suit s'applique aux symboles et indices utilisés :

A est

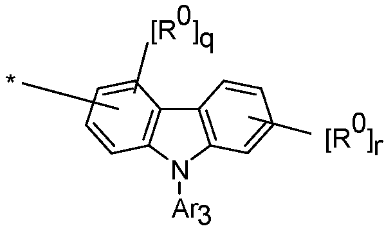

ou

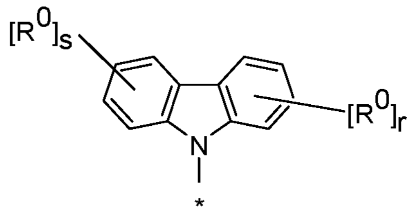

,

X est à chaque occurrence, de manière identique ou différente, $CR^0$ ou N, où au moins un symbole X représente N ;

Y est choisi à chaque occurrence, de manière identique ou différente, parmi O ou S ;

* désigne le site de liaison à la formule (1) ;

L et $L_1$ sont à chaque occurrence, de manière identique ou différente, une liaison simple ou un noyau aromatique ou hétéroaromatique ayant de 5 à 30 atomes de cycle aromatique ;

W est O, S, $C(R)_2$ ;

R est dans chaque cas, indépendamment les uns des autres, un groupement alkyle à chaîne linéaire ou ramifiée ayant de 1 à 4 atomes de C, qui peut être partiellement ou totalement deutérié, ou un noyau aromatique non substitué ou partiellement ou totalement deutérié ayant de 6 à 18 atomes de C, où deux substituants R, conjointement avec l'atome de C auquel ils sont liés, peuvent former un noyau aliphatique ou aromatique ou hétéroaromatique, mono- ou polycyclique, non substitué, partiellement deutérié ou totalement deutérié, qui peut être substitué par un ou plusieurs substituants $R^3$, à condition que le noyau et les substituants y étant liés ne contiennent pas de groupement carbazole ;

$R^0$ est à chaque occurrence, indépendamment les uns des autres, D, un noyau aromatique non substitué ou partiellement ou totalement deutérié ayant de 6 à 18 atomes de C ou un groupement dibenzofurane, dibenzothiophène, ou N-arylcarbazole lié via C, non substitué ou partiellement ou totalement deutérié ;

$Ar_1$ est à chaque occurrence, de manière identique ou différente, un noyau aromatique ou hétéroaromatique ayant de 5 à 30 atomes de cycle aromatique, qui peut être substitué par un ou plusieurs radicaux $R^3$ non aromatiques ; deux radicaux $Ar_1$ qui sont liés au même atome de N, atome de P ou atome de B peuvent également être pontés l'un avec l'autre par une liaison simple ou un pont choisi parmi $C(R^3)_2$, O ou S ;

$Ar_2$ est dans chaque cas indépendamment les uns des autres, à chaque occurrence, un groupement aryle ou hétéroaryle ayant de 5 à 40 atomes de cycle aromatique, qui peut être substitué par un ou plusieurs radicaux R' ;

$Ar_3$ est dans chaque cas indépendamment les uns des autres, à chaque occurrence, un noyau aromatique ayant de 6 à 40 atomes de cycle aromatique ou un noyau hétéroaromatique ayant de 5 à 40 atomes de cycle aromatique, qui peut être substitué par un ou plusieurs radicaux R' ; aryle est à chaque occurrence, de manière identique ou différente, un noyau aromatique ou hétéroaromatique ayant de 5 à 30 atomes de cycle aromatique, qui peut être substitué par un ou plusieurs radicaux R' non aromatiques ;

R' est choisi à chaque occurrence, de manière identique ou différente, dans le groupe constitué par D, F, Cl, Br, I, CN, $NO_2$, $N(Ar_1)_2$, $NH_2$, $N(R^3)_2$, $C(=O)Ar_1$, $C(=O)H$, $C(=O)R^3$, $P(=O)(Ar_1)_2$, un groupement alkyle, alcoxy ou

thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par F, Cl, Br, I, CN ou $NO_2$, un noyau aromatique ou hétéroaromatique ayant de 5 à 60 atomes de cycle aromatique, qui peut dans chaque cas être substitué par un ou plusieurs radicaux $R^3$, un groupement aryloxy ou hétéroaryloxy ayant de 5 à 60 atomes de cycle aromatique, qui peut être substitué par un ou plusieurs radicaux $R^3$, ou une combinaison de ces systèmes, où deux, ou plus, substituants R' adjacents peuvent éventuellement former un noyau aliphatique, aromatique ou hétéroaromatique, monocyclique ou polycyclique, qui peut être substitué par un ou plusieurs radicaux $R^3$ ;

$R^1$ est choisi à chaque occurrence, de manière identique ou différente, dans le groupe constitué par F, Cl, Br, I, CN, $NO_2$, C(=O)R', $P(=O)(Ar_1)_2$, $P(Ar_1)_2$, $B(Ar_1)_2$, $Si(Ar_1)_3$, $Si(R')_3$, un groupement alkyle, alcoxy ou thioalkyle à chaîne linéaire ayant de 1 à 20 atomes de C ou un groupement alkyle, alcoxy ou thioalkyle ramifié ou cyclique ayant de 3 à 20 atomes de C ou un groupement alcényle ayant de 2 à 20 atomes de C, qui peut dans chaque cas être substitué par un ou plusieurs radicaux R', où un ou plusieurs groupements $CH_2$ non adjacents peuvent être remplacés par R'C=CR', $Si(R')_2$, C=O, C=S, C=NR', P(=O)(R'), SO, $SO_2$, NR', O, S ou CONR' et où un ou plusieurs atomes de H peuvent être remplacés par D, F, Cl, Br, I, CN ou $NO_2$ ;

$R^2$ est choisi à chaque occurrence, de manière identique ou différente, dans le groupe constitué par F, Cl, Br, I, CN, $NO_2$, $N(Ar_1)_2$, $NH_2$, $N(R^3)_2$, $C(=O)Ar_1$, C(=O)H, $C(=O)R^3$, $P(=O)(Ar_1)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, qui peut dans chaque cas être substitué par un ou plusieurs radicaux $R^3$, où un ou plusieurs groupements $CH_2$ non adjacents peuvent être remplacés par HC=CH, $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, NH, $NR^3$, O, S, CONH ou $CONR^3$ et où un ou plusieurs atomes de H peuvent être remplacés par D, F, Cl, Br, I, CN ou $NO_2$, un noyau aromatique ou hétéroaromatique ayant de 5 à 60 atomes de cycle aromatique, qui peut dans chaque cas être substitué par un ou plusieurs radicaux $R^3$, un groupement aryloxy ou hétéroaryloxy ayant de 5 à 60 atomes de cycle aromatique, qui peut être substitué par un ou plusieurs radicaux $R^3$, ou une combinaison de ces systèmes, où deux, ou plus, substituants $R^2$ adjacents peuvent éventuellement former un noyau aliphatique, aromatique ou hétéroaromatique, monocyclique ou polycyclique, qui peut être substitué par un ou plusieurs radicaux $R^3$, à condition que $R^2$ et les substituants y étant liés ne contiennent pas de groupement carbazole ;

$R^3$ est choisi à chaque occurrence, de manière identique ou différente, dans le groupe constitué par D, F, CN, un radical hydrocarboné aliphatique ayant de 1 à 20 atomes de C ou un noyau aromatique ou hétéroaromatique ayant de 5 à 30 atomes de cycle aromatique, où un ou plusieurs atomes de H peuvent être remplacés par D, F, Cl, Br, I ou CN et qui peut être substitué par un ou plusieurs groupements alkyle, dans chaque cas ayant de 1 à 4 atomes de carbone ; deux, ou plus, substituants $R^3$ adjacents peuvent former un noyau aliphatique mono- ou polycyclique les uns avec les autres ;

n, m, p, q valent dans chaque cas, indépendamment les uns des autres, 0, 1, 2 ou 3 ;

o, r, s valent dans chaque cas, indépendamment les uns des autres, 0, 1, 2, 3 ou 4 ;

x, x1 valent à chaque occurrence, indépendamment, 0, 1, 2, 3 ou 4 ;

y, z valent dans chaque cas, indépendamment l'un de l'autre, 0, 1 ou 2 ;

$a_1$, $a_2$ valent dans chaque cas, indépendamment l'un de l'autre, 1, 2, 3, 4 ou 5 ;

$a_3$ vaut 0, 1, 2 ou 3 ;

$a_4$ vaut 0, 1, 2, 3 ou 4 ; eta$_1$+$a_2$+$a_3$+$a_4$ vaut 3, 4, 5, 6, 7, 8, 9, 10, 11, 12, 13, 14, 15, 16 ou 17.

**14.** Mélange selon la revendication 13, **caractérisé en ce que** le mélange est constitué d'au moins un composé de formule (1), d'au moins un composé de formule (2) et d'un émetteur phosphorescent.

**15.** Formulation comprenant un mélange selon la revendication 13 ou 14 et au moins un solvant.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2015169412 A
- WO 2016015810 A
- WO 17204556 A
- WO 19190101 A
- US 2017186969 A
- WO 18026197 A
- WO 19151682 A
- WO 20226300 A
- WO 20231197 A
- WO 21096228 A
- WO 2015022051 A
- WO 2017148564 A
- WO 2018083053 A
- CN 112375053
- WO 2021156323 A
- WO 21107728 A
- WO 2021122535 A1
- WO 2021180614 A1
- WO 2017148565 A1
- US 2021028370 A1
- WO 2019007867 A
- US 7294849 B
- WO 2021107728 A
- WO 2647462040 A


### In der Beschreibung aufgeführte Nicht-Patentliteratur


- **B. M. S. ARNOLD et al.** *Appl. Phys. Lett.*, 2008, vol. 92, 053301
- **M. L. ALLINGER** ; **H. L. FLANAGAN**. *J. Computa nationale Chem*, 1983, vol. 4 (3), 399
- *CHEMICAL ABSTRACTS*, 2225909-61-3] und B-(9-ph
- *CHEMICAL ABSTRACTS*, 2225909-61-3
- *CHEMICAL ABSTRACTS*, 2239299-50-2
- *CHEMICAL ABSTRACTS*, 028648-22-7
- *CHEMICAL ABSTRACTS*, 1240963-55-6
- *CHEMICAL ABSTRACTS*, 854952-60-6
- *CHEMICAL ABSTRACTS*, 1370555-65-9
- *CHEMICAL ABSTRACTS*, 1333002-41-7
- *CHEMICAL ABSTRACTS*, 2144800-21-3
- *CHEMICAL ABSTRACTS*, 854952-58-2
- *CHEMICAL ABSTRACTS*, 2055864-36-1
- *CHEMICAL ABSTRACTS*, 1416814-68-0
- *CHEMICAL ABSTRACTS*, 2142681-84-1
- *CHEMICAL ABSTRACTS*, 2299272-36-7
- *CHEMICAL ABSTRACTS*, 2226747-65-3
- *CHEMICAL ABSTRACTS*, 1883265-32-4
- *CHEMICAL ABSTRACTS*, 1618107-00-8
- *CHEMICAL ABSTRACTS*, 2074632-09-8
- *CHEMICAL ABSTRACTS*, 2172944-02-2
- *CHEMICAL ABSTRACTS*, 2260688-95-5
- *CHEMICAL ABSTRACTS*, 1472729-25-1
- *CHEMICAL ABSTRACTS*, 2251105-15-2
- *CHEMICAL ABSTRACTS*, 1421599-32-7
- *CHEMICAL ABSTRACTS*, 2286234-09-9